# EUROPEAN PATENT SPECIFICATION

(11) **EP 4 332 107 B1**
(45) Date of publication and mention of the grant of the patent: **01.10.2025**
(21) Application number: 22816295.4
(22) Date of filing: 18.04.2022
(51) Int. Cl.: C07F 5/02, C09K 11/06, H10K 85/60

(54) **BORON-CONTAINING HETEROAROMATIC COMPOUNDS AND ORGANIC LIGHT-EMITTING DEVICE USING SAME**
BORHALTIGE HETEROAROMATISCHE VERBINDUNGEN UND ORGANISCHE LICHTEMITTIERENDE VORRICHTUNG DAMIT
COMPOSÉS HÉTÉROAROMATIQUES CONTENANT DU BORE ET DISPOSITIF ÉLECTROLUMINESCENT ORGANIQUE LES UTILISANT

(30) Priority: 02.06.2021 KR 20210071681
(43) Date of publication of application: 06.03.2024
(73) Proprietor: LG Chem, Ltd., Yeongdeungpo-gu Seoul 07336 (KR)
(72) Inventor: LIM, Byeong Yun, Daejeon 34122 (KR); LEE, Jaechol, Daejeon 34122 (KR); KIM, Yongwook, Daejeon 34122 (KR); YU, Soyoung, Daejeon 34122 (KR); KIM, Shin Sung, Daejeon 34122 (KR); KIM, Young Kwang, Daejeon 34122 (KR); CHOI, Hyunju, Daejeon 34122 (KR)
(74) Representative: Hoffmann Eitle
(86) International application number: PCT/KR2022/005520
(87) International publication number: WO 2022/255634

(56) References cited:
- WO-A1-2019/164331
- WO-A1-2020/251049
- KR-A- 20190 101 900
- KR-A- 20210 141 902
- KR-B1- 102 094 830
- KR-B1- 102 148 296
- KR-B1- 102 250 355
- DATABASE REAXYS [online] 23 November 2021 (2021-11-23), MATERIAL SCIENCE CO. ET AL: "Polycyclic aromatic compound and organoelectroluminescent device using the same - KR2021/141902 (A)", XP093199479, Database accession no. XRN = 40627399, 40627641

## Description

### [TECHNICAL FIELD]

### Cross-reference to Related Application(s)

This application claims the benefit of Korean Patent Application No. 10-2021-0071681 filed on June 2, 2021 in the Korean Intellectual Property Office.

The present disclosure relates to a novel compound and an organic light emitting device including the same.

### [BACKGROUND OF ART]

In general, an organic light emitting phenomenon refers to a phenomenon where electric energy is converted into light energy by using an organic material. The organic light emitting device using the organic light emitting phenomenon has characteristics such as a wide viewing angle, an excellent contrast, a fast response time, an excellent luminance, driving voltage and response speed, and thus many studies have proceeded.

The organic light emitting device generally has a structure which comprises an anode, a cathode, and an organic material layer interposed between the anode and the cathode. The organic material layer frequently has a multilayered structure that comprises different materials in order to enhance efficiency and stability of the organic light emitting device, and for example, the organic material layer may be formed of a hole injection layer, a hole transport layer, a light emitting layer, an electron transport layer, or an electron injection layer. In the structure of the organic light emitting device, if a voltage is applied between two electrodes, the holes are injected from an anode into the organic material layer and the electrons are injected from the cathode into the organic material layer, and when the injected holes and electrons meet each other, an exciton is formed, and light is emitted when the exciton falls to a ground state again.

WO 2019/164331 A1 discloses a specific heterocyclic compound, and an organic light-emitting device comprising same.

There is a continuing need for the development of new materials for the organic materials used in the organic light emitting devices as described above.

Meanwhile, in recent years, an organic light emitting device prepared using a solution process, particularly an inkjet process, instead of a conventional deposition process has been developed in order to reduce process costs. In the early days, it was attempted to develop an organic light emitting device in which all organic light emitting device layers were coated with a solution process, but there was a limitation in the development with the current technology.

Accordingly, in the present disclosure, there is provided a novel material for an organic light emitting device that can be used in an organic light emitting device and can be used in a solution process at the same time.

### [PRIOR ART LITERATURE]

### [Patent Literature]

(Patent Literature 0001) Korean Unexamined Patent Publication No. 10-2000-0051826

### [DETAILED DESCRIPTION OF THE INVENTION]

### [Technical Problem]

The present disclosure relates to a novel compound and an organic light emitting device including the same.

### [Technical Solution]

In the present disclosure, there is provided a compound represented by the following Chemical Formula 1: 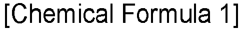 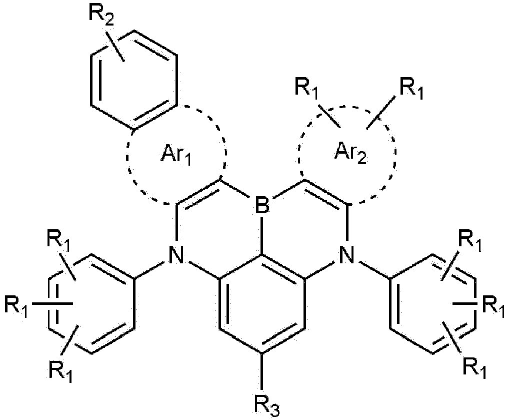 in Chemical Formula 1,
Ar₁ is furan, or thiophene, which is fused with two adjacent rings,
Ar₂ is benzene, benzofuran, or benzothiophene, which is fused with an adjacent ring,
each R₁ is independently hydrogen, deuterium, a substituted or unsubstituted C₁₋₆₀ alkyl, or a substituted or unsubstituted C₆₋₆₀ aryl, or two adjacent R₁s are combined to form -O-(CH₂)ₘ-O-, wherein m is an integer of 1 to 4;
R₂ is hydrogen, deuterium, or a substituted or unsubstituted C₁₋₆₀ alkyl, and
R₃ is hydrogen, deuterium, or a substituted or unsubstituted C₁₋₆₀ alkyl,
provided that the Chemical Formula 1 comprises at least one -O-(CH₂)ₘ-O-formed by combining two adjacent R₁s.

In addition, there is provided an organic light emitting device including: a first electrode; a second electrode that is provided opposite to the first electrode; and one or more organic material layers that are provided between the first electrode and the second electrode, wherein at least one layer of the organic material layers includes the compound represented by the Chemical Formula 1.

### [ADVANTAGEOUS EFFECTS]

The compound represented by the Chemical Formula 1 may be used as a material for an organic material layer of an organic light emitting device, may be used in a solution process, and may improve efficiency, low driving voltage, and/or lifespan of the organic light emitting device.

### [BRIEF DESCRIPTION OF THE DRAWINGS]

FIG. 1 shows an example of an organic light emitting device including a substrate 1, an anode 2, a light emitting layer 3, and a cathode 4.
FIG. 2 shows an example of an organic light emitting device including a substrate 1, an anode 2, a hole injection layer 5, a hole transport layer 6, a light emitting layer 7, an electron injection and transport layer 8, and a cathode 4.

### [DETAILED DESCRIPTION OF THE EMBODIMENTS]

Hereinafter, embodiments of the present disclosure will be described in more detail to facilitate understanding of the invention.

### (Definition of Terms)

As used herein, the notation 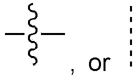 means a bond linked to another substituent group.

As used herein, the term "substituted or unsubstituted" means being unsubstituted or substituted with one or more substituents selected from the group consisting of deuterium; a halogen group; a cyano group; a nitro group; a hydroxyl group; a carbonyl group; an ester group; an imide group; an amino group; a phosphine oxide group; an alkoxy group; an aryloxy group; an alkylthioxy group; an arylthioxy group; an alkylsulfoxy group; an arylsulfoxy group; a silyl group; a boron group; an alkyl group; a cycloalkyl group; an alkenyl group; an aryl group; an aralkyl group; an aralkenyl group; an alkylaryl group; an alkylamine group; an aralkylamine group; a heteroarylamine group; an arylamine group; an arylphosphine group; and heteroaryl containing at least one of N, O and S atoms, or being unsubstituted or substituted with a substituent in which two or more substituents of the above-exemplified substituents are connected. For example, "a substituent in which two or more substituents are connected" may be a biphenyl group. Namely, a biphenyl group may be an aryl group, or it may also be interpreted as a substituent in which two phenyl groups are connected.

In the present disclosure, the carbon number of a carbonyl group is not particularly limited, but is preferably 1 to 40. Specifically, the carbonyl group may be a compound having the following structural formulae, but is not limited thereto.

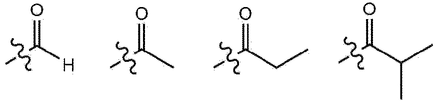

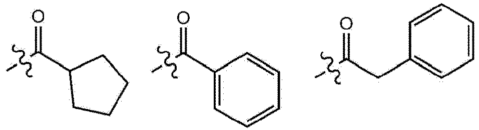

In the present disclosure, an ester group may have a structure in which oxygen of the ester group is substituted by a straight-chain, branched-chain, or cyclic alkyl group having 1 to 25 carbon atoms, or an aryl group having 6 to 25 carbon atoms. Specifically, the ester group may be a compound having the following structural formulae, but is not limited thereto.

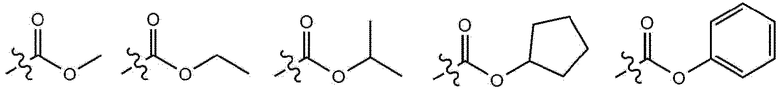

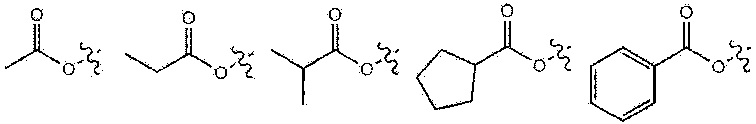

In the present disclosure, the carbon number of an imide group is not particularly limited, but is preferably 1 to 25. Specifically, the imide group may be a compound having the following structural formulae, but is not limited thereto.

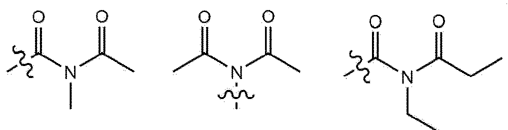

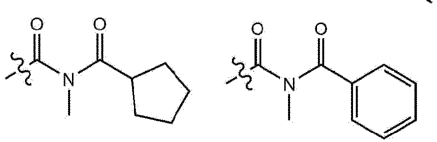

In the present disclosure, a silyl group specifically includes a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group.

In the present disclosure, a boron group specifically includes a trimethylboron group, a triethylboron group, a t-butyldimethylboron group, a triphenylboron group, a phenylboron group.

In the present disclosure, examples of a halogen group include fluorine, chlorine, bromine, or iodine.

In the present disclosure, the alkyl group may be straight-chain, or branched-chain, and the carbon number thereof is not particularly limited, but is preferably 1 to 40. According to one embodiment, the carbon number of the alkyl group is 1 to 20. According to another embodiment, the carbon number of the alkyl group is 1 to 10. According to another embodiment, the carbon number of the alkyl group is 1 to 6. Specific examples of the alkyl group include methyl, ethyl, propyl, n-propyl, isopropyl, butyl, n-butyl, isobutyl, tert-butyl, sec-butyl, 1-methylbutyl, 1-ethyl-butyl, pentyl, n-pentyl, isopentyl, neopentyl, tert-pentyl, hexyl, n-hexyl, 1-methylpentyl, 2-methylpentyl, 4-methyl-2-pentyl, 3,3-dimethylbutyl, 2-ethylbutyl, heptyl, n-heptyl, 1-methylhexyl, cyclopentylmethyl, cyclohexylmethyl, octyl, n-octyl, tert-octyl, 1-methylheptyl, 2-ethylhexyl, 2-propylpentyl, n-nonyl, 2,2-dimethylheptyl, 1-ethyl-propyl, 1,1-dimethyl-propyl, isohexyl, 2-methylpentyl, 4-methylhexyl, 5-methylhexyl.

In the present disclosure, the alkenyl group may be straight-chain or branched-chain, and the carbon number thereof is not particularly limited, but is preferably 2 to 40. According to one embodiment, the carbon number of the alkenyl group is 2 to 20. According to another embodiment, the carbon number of the alkenyl group is 2 to 10. According to another embodiment, the carbon number of the alkenyl group is 2 to 6. Specific examples thereof include vinyl, 1-propenyl, isopropenyl, 1-butenyl, 2-butenyl, 3-butenyl, 1-pentenyl, 2-pentenyl, 3-pentenyl, 3-methyl-1-butenyl, 1,3-butadienyl, allyl, 1-phenylvinyl-1-yl, 2-phenylvinyl-1-yl, 2,2-diphenylvinyl-1-yl, 2-phenyl-2-(naphthyl-1-yl)vinyl-1-yl, 2,2-bis(diphenyl-1-yl)vinyl-1-yl, a stilbenyl group, a styrenyl group.

In the present disclosure, a cycloalkyl group is not particularly limited, but the carbon number thereof is preferably 3 to 60. According to one embodiment, the carbon number of the cycloalkyl group is 3 to 30. According to another embodiment, the carbon number of the cycloalkyl group is 3 to 20. According to another embodiment, the carbon number of the cycloalkyl group is 3 to 6. Specific examples thereof include cyclopropyl, cyclobutyl, cyclopentyl, 3-methylcyclopentyl, 2,3-dimethylcyclopentyl, cyclohexyl, 3-methylcyclohexyl, 4-methylcyclohexyl, 2,3-dimethylcyclohexyl, 3,4,5-trimethylcyclohexyl, 4-tert-butylcyclohexyl, cycloheptyl, cyclooctyl.

In the present disclosure, an aryl group is not particularly limited, but the carbon number thereof is preferably 6 to 60, and it may be a monocyclic aryl group or a polycyclic aryl group. According to one embodiment, the carbon number of the aryl group is 6 to 30. According to one embodiment, the carbon number of the aryl group is 6 to 20. The monocyclic aryl group includes a phenyl group, a biphenyl group, a terphenyl group. The polycyclic aryl group includes a naphthyl group, an anthracenyl group, a phenanthrenyl group, a pyrenyl group, a perylenyl group, a chrysenyl group, a fluorenyl group eto.

In the present disclosure, a fluorenyl group may be substituted, and two substituents may be bonded to each other to form a spiro structure. In the case where the fluorenyl group is substituted, 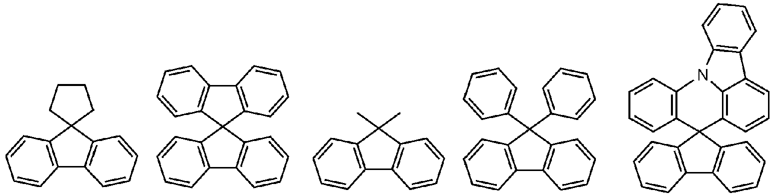 can be formed. However, the structure is not limited thereto.

In the present disclosure, heteroaryl is a heteroaryl containing at least one heteroatom of O, N, Si and S as a heterogeneous element, and the carbon number thereof is not particularly limited, but is preferably 2 to 60. Examples of the heteroaryl include xanthene, thioxanthene, a thiophene group, a furan group, a pyrrole group, an imidazole group, a thiazole group, an oxazol group, an oxadiazol group, a triazol group, a pyridyl group, a bipyridyl group, a pyrimidyl group, a triazine group, an acridyl group, a pyridazine group, a pyrazinyl group, a quinolinyl group, a quinazoline group, a quinoxalinyl group, a phthalazinyl group, a pyridopyrimidinyl group, a pyridopyrazinyl group, a pyrazinopyrazinyl group, an isoquinoline group, an indole group, a carbazole group, a benzoxazole group, a benzoimidazole group, a benzothiazol group, a benzocarbazole group, a benzothiophene group, a dibenzothiophene group, a benzofuranyl group, a phenanthroline group, an isoxazolyl group, a thiadiazolyl group, a phenothiazinyl group, a dibenzofuranyl group.

In the present disclosure, the aryl group in the aralkyl group, the aralkenyl group, the alkylaryl group, the arylamine group and the arylsilyl group is the same as the aforementioned examples of the aryl group. In the present disclosure, the alkyl group in the aralkyl group, the alkylaryl group and the alkylamine group is the same as the aforementioned examples of the alkyl group. In the present disclosure, the heteroaryl in the heteroarylamine can apply the aforementioned description of the heteroaryl. In the present disclosure, the alkenyl group in the aralkenyl group is the same as the aforementioned examples of the alkenyl group. In the present disclosure, the aforementioned description of the aryl group may be applied except that the arylene is a divalent group. In the present disclosure, the aforementioned description of the heteroaryl can be applied except that the heteroarylene is a divalent group. In the present disclosure, the aforementioned description of the aryl group or cycloalkyl group can be applied except that the hydrocarbon ring is not a monovalent group but formed by combining two substituent groups. In the present disclosure, the aforementioned description of the heteroaryl can be applied, except that the heterocycle is not a monovalent group but formed by combining two substituent groups.

### (Compound)

In the present disclosure, there is provided a compound represented by the Chemical Formula 1.

Preferably, the Chemical Formula 1 is represented by any one of the following Chemical Formulae 1-1 to 1-4 depending on the fused position of Ar₁: 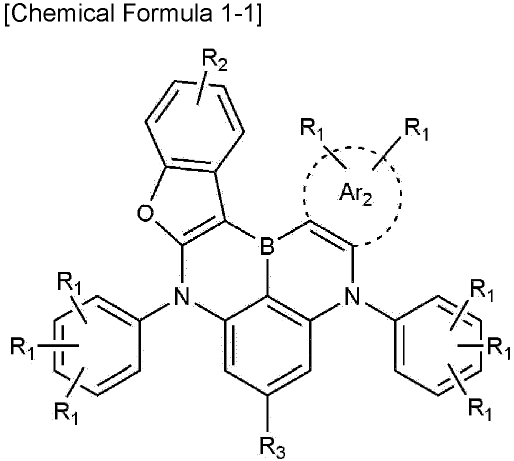 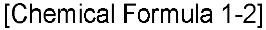 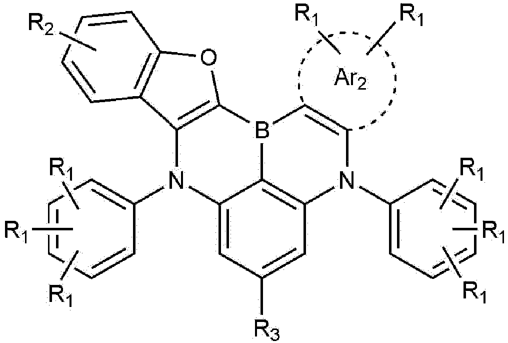 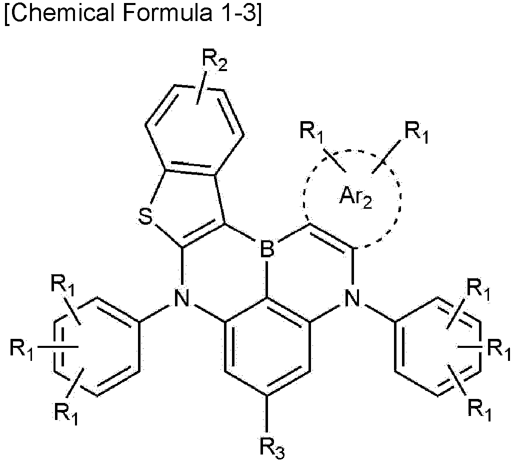 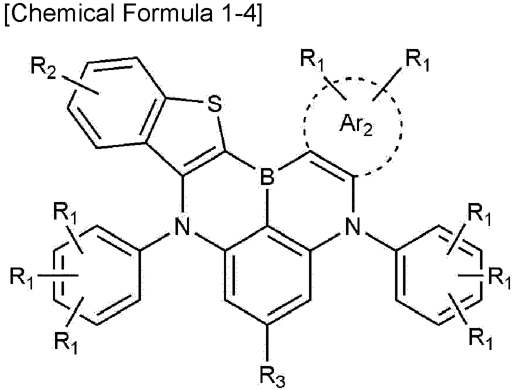 in the Chemical Formulae 1-1 to 1-4,
Ar₂ and R₁ to R₃ are as defined above.

Preferably, the Chemical Formula 1 is represented by any one of the following Chemical Formulae 1-5 to 1-9 depending on the fused position of Ar₂: 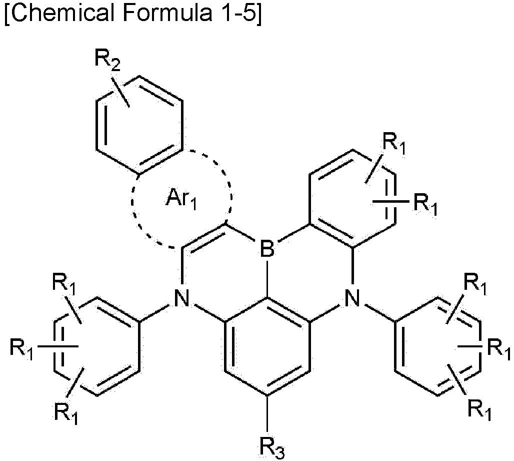 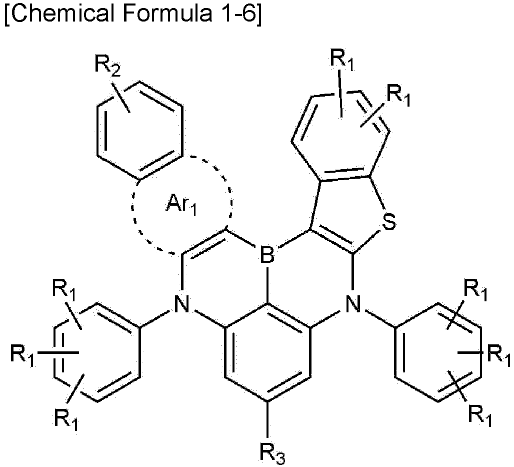 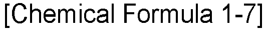 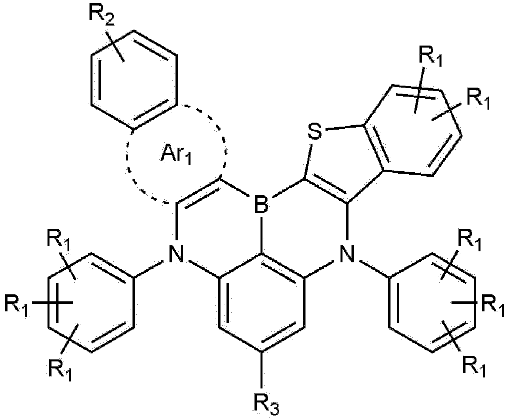 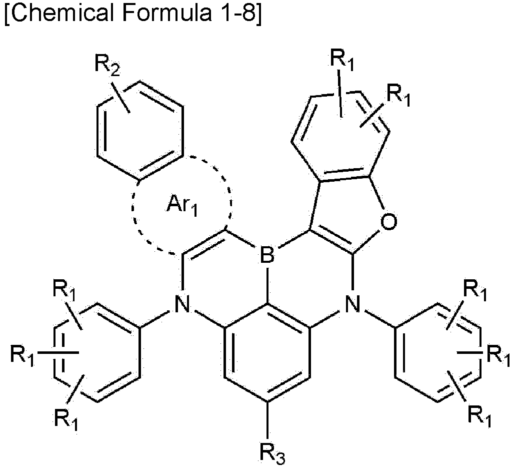 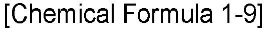 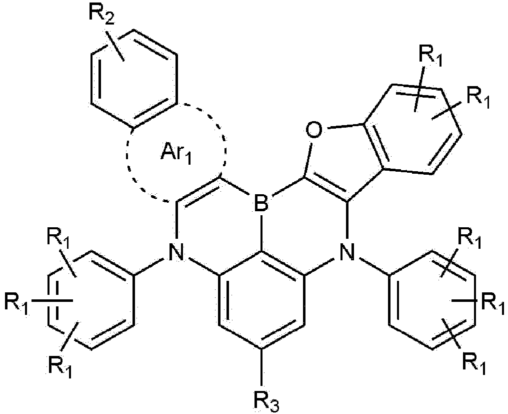 in the Chemical Formulae 1-5 to 1-9,
Ar₁ and R₁ to R₃ are as defined above.

Preferably, each R₁ is independently hydrogen, deuterium, C₁₋₁₀ alkyl, or C₆₋₂₀ aryl, or two adjacent R₁s are combined to form 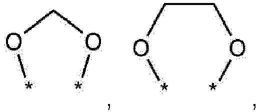 or

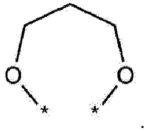

Preferably, each R₁ is independently hydrogen, deuterium, methyl, ethyl, propyl, isopropyl, butyl, isobutyl, tertbutyl, or phenyl, or two adjacent R₁s are combined to form

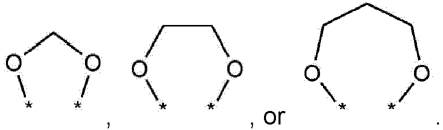

Preferably, R₂ is hydrogen, deuterium, or C₁₋₁₀ alkyl.

Preferably, R₂ is hydrogen, deuterium, methyl, ethyl, propyl, isopropyl, butyl, isobutyl, or tertbutyl.

Preferably, R₃ is hydrogen, deuterium, or C₁₋₁₀ alkyl.

Preferably, R₃ is hydrogen, deuterium, methyl, ethyl, propyl, isopropyl, butyl, isobutyl, or tertbutyl.

Representative examples of the compound represented by the Chemical Formula 1 are as follows:

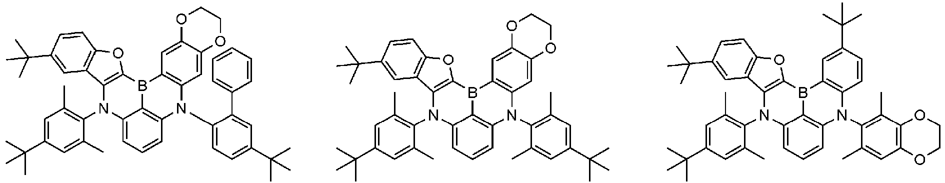

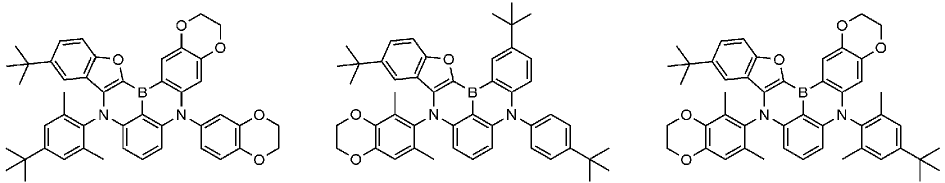

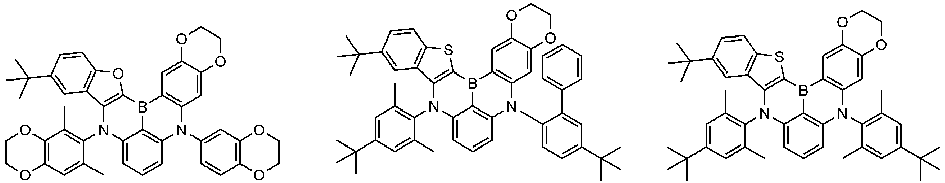

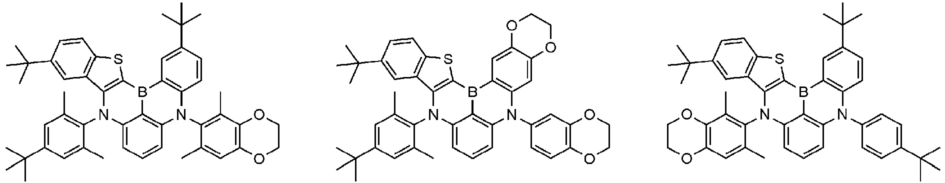

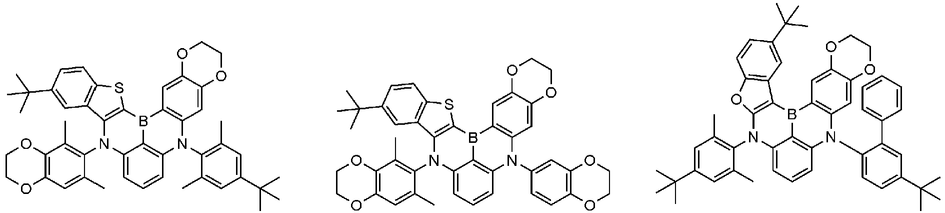

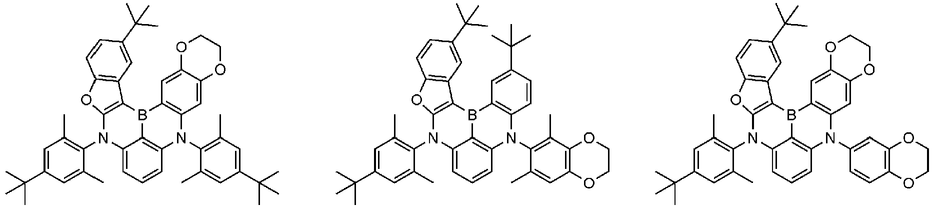

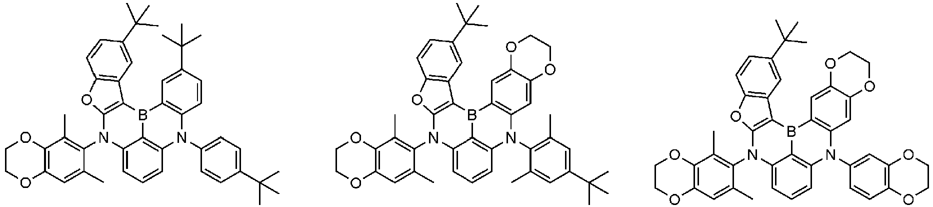

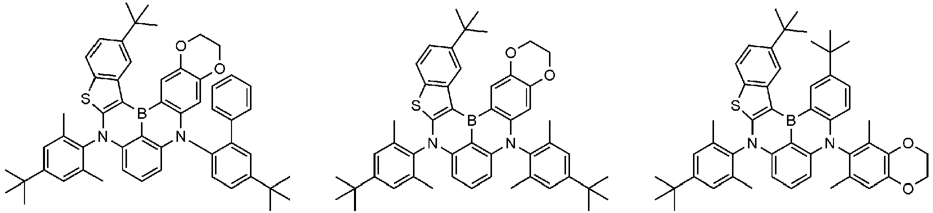

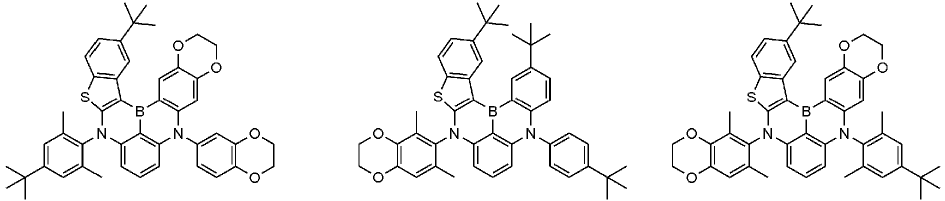

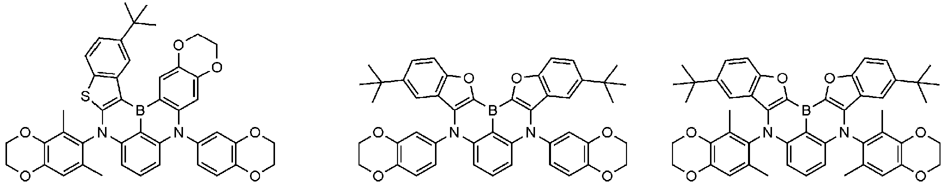

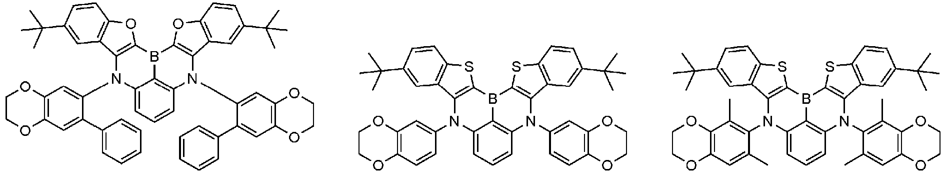

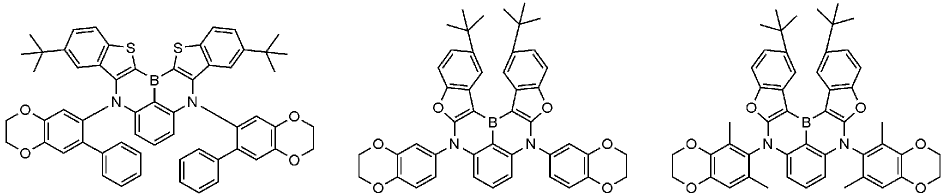

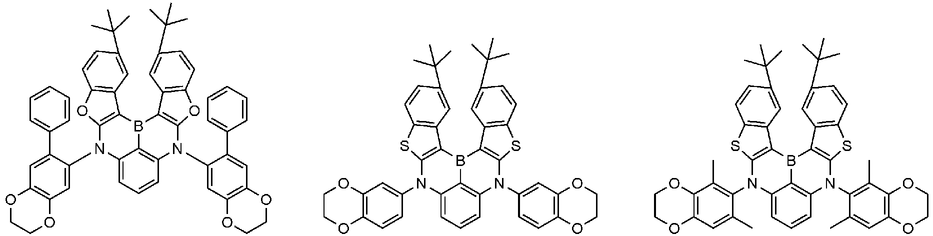

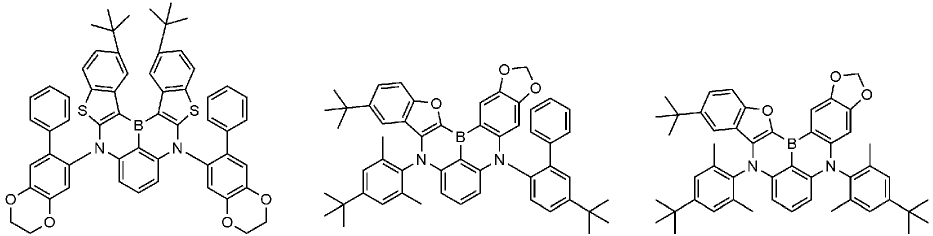

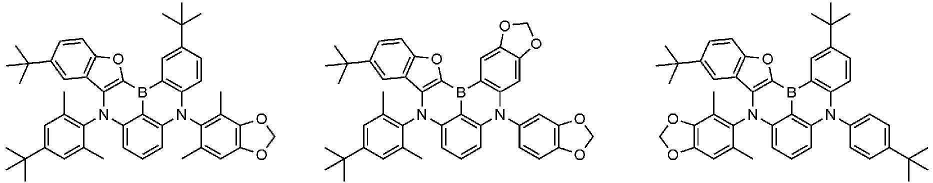

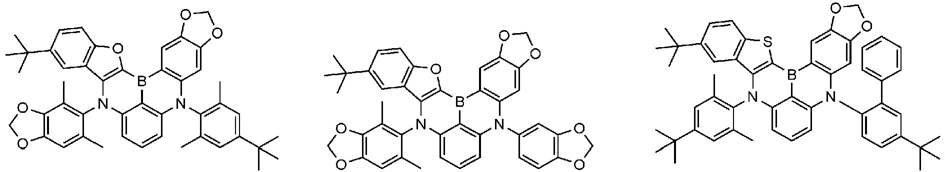

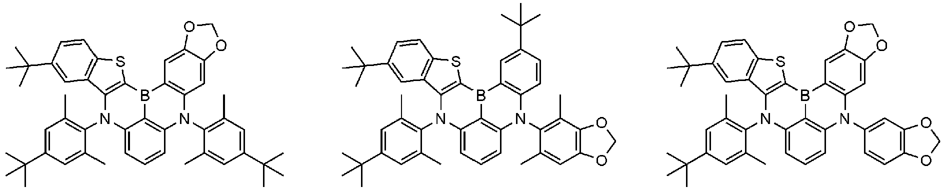

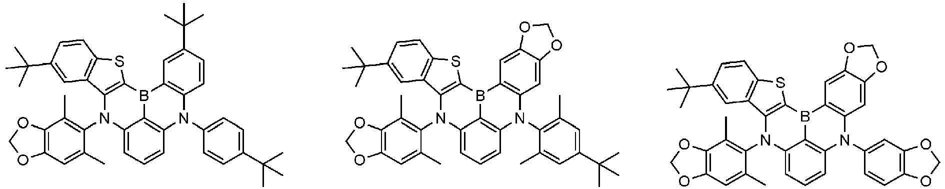

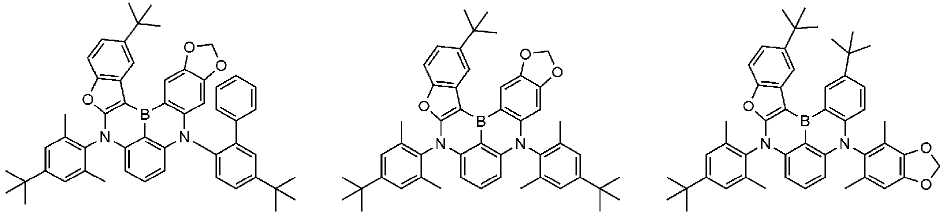

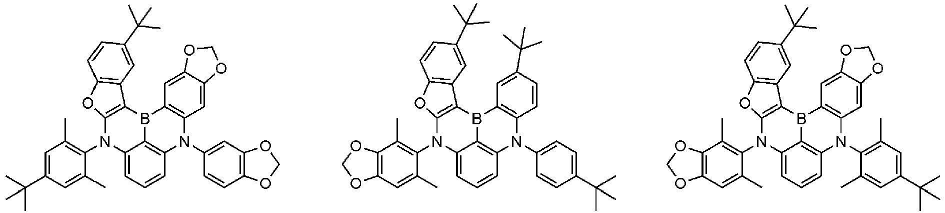

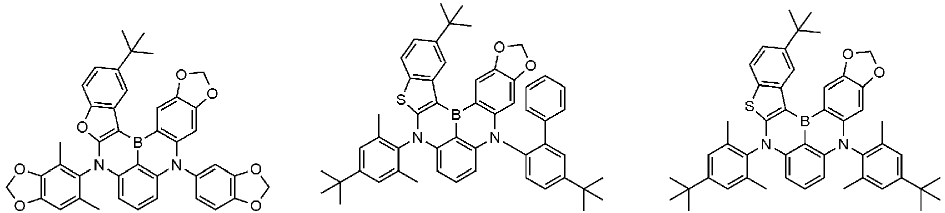

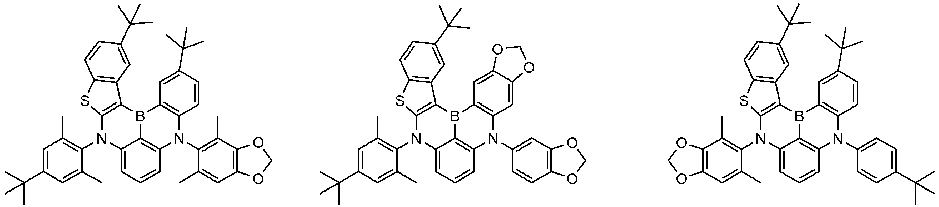

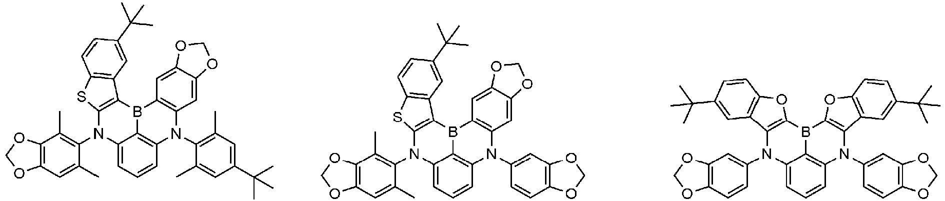

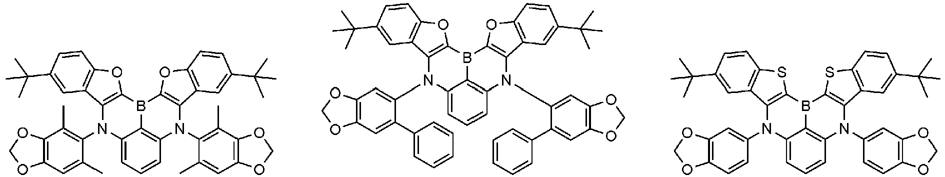

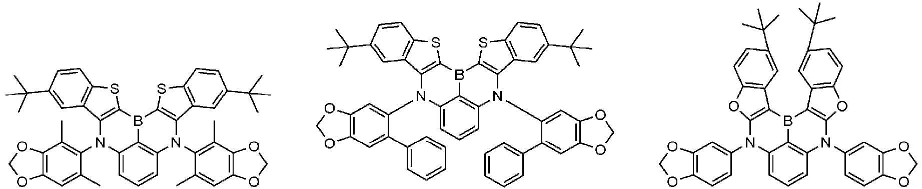

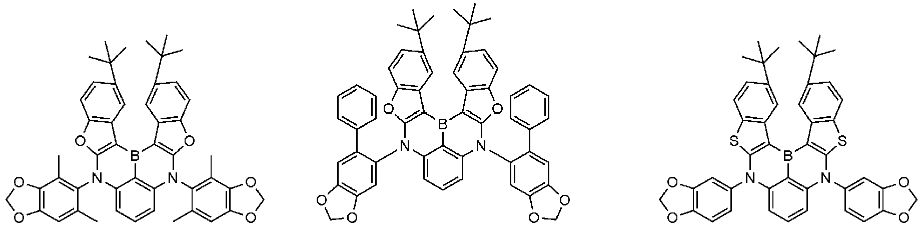

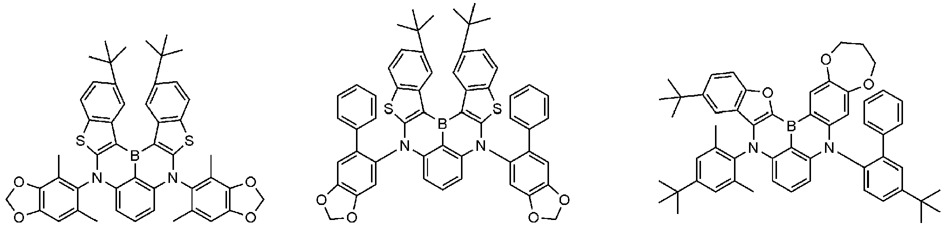

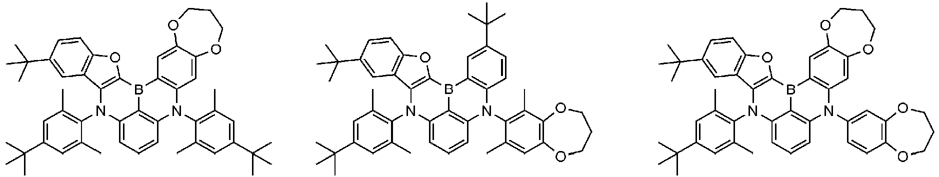

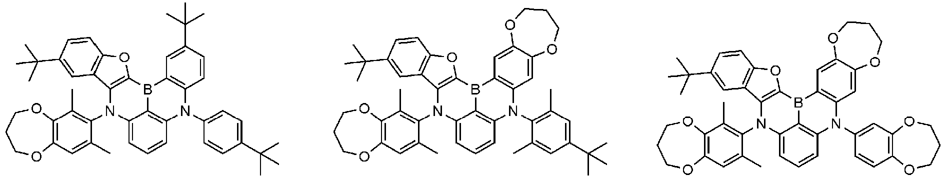

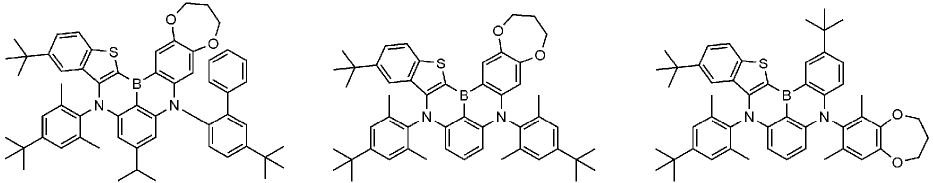

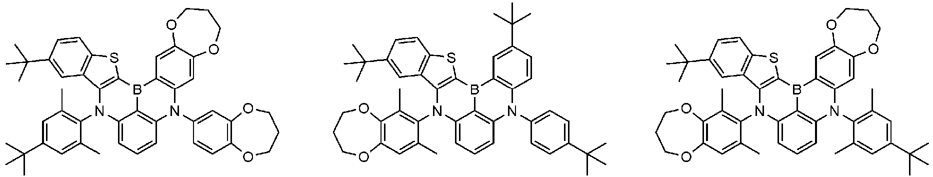

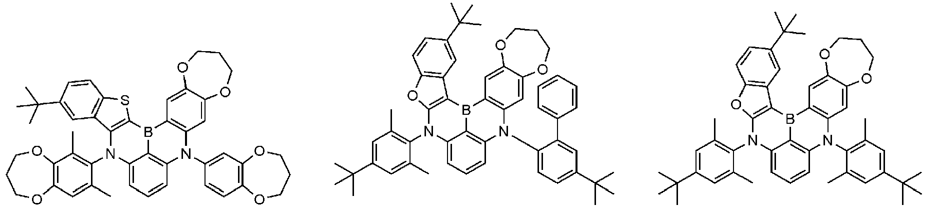

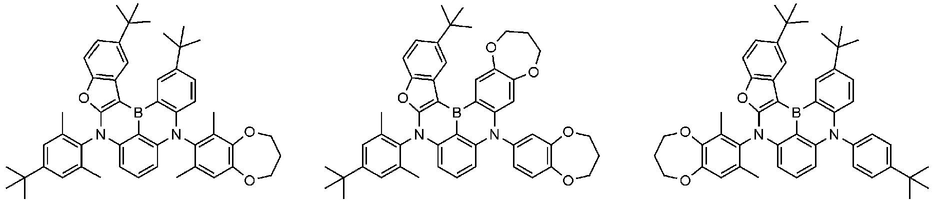

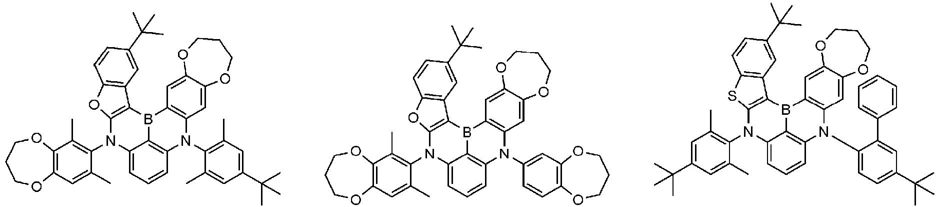

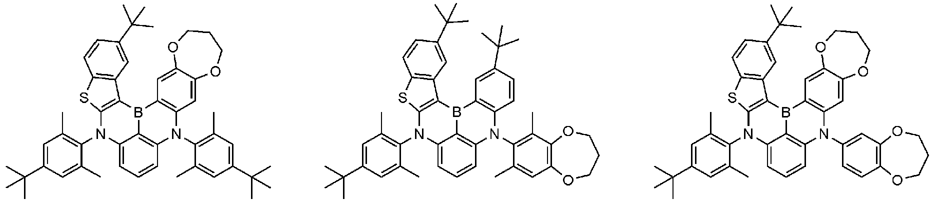

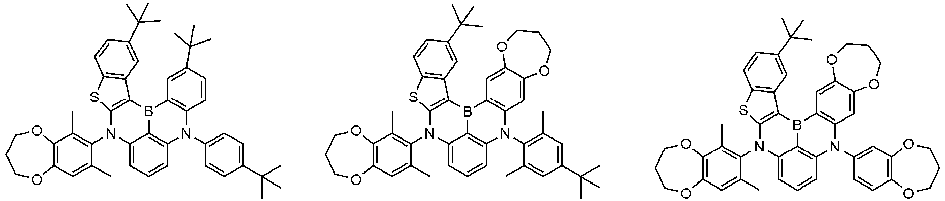

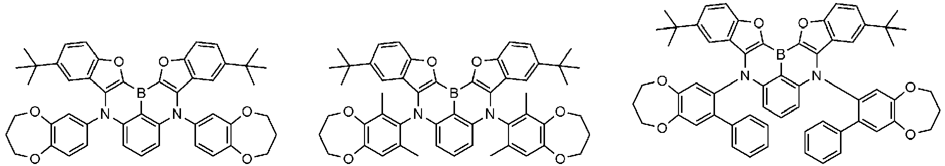

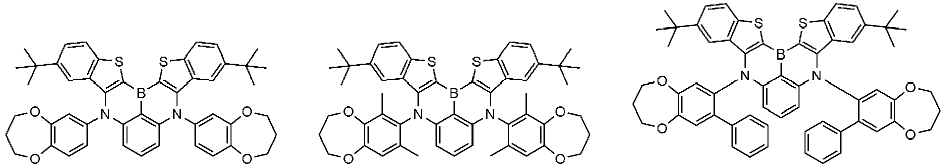

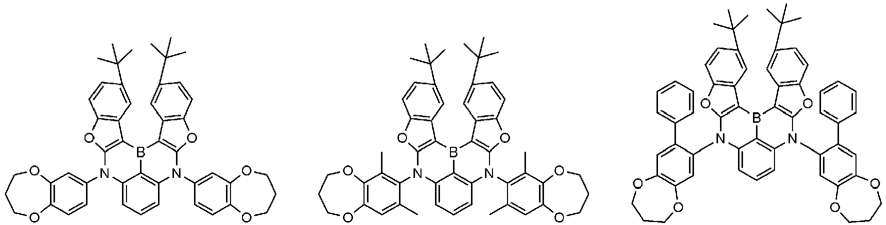

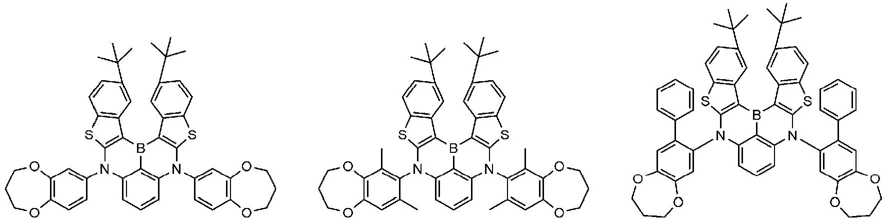

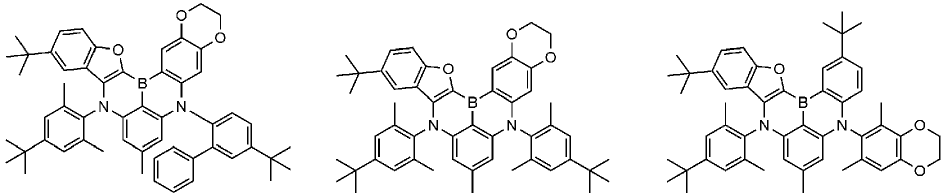

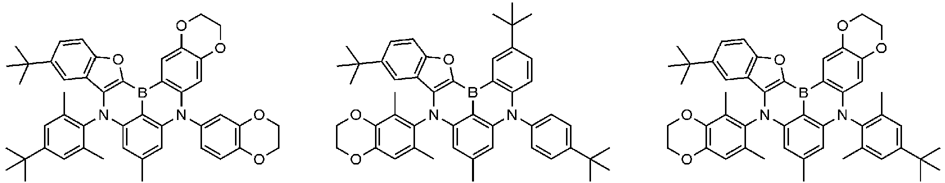

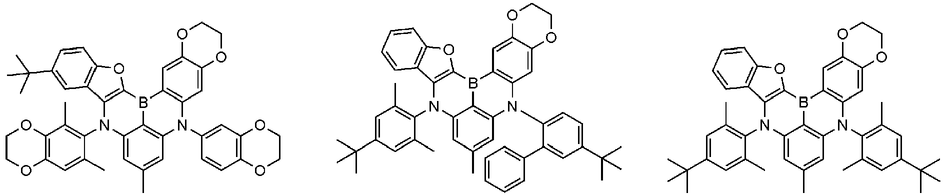

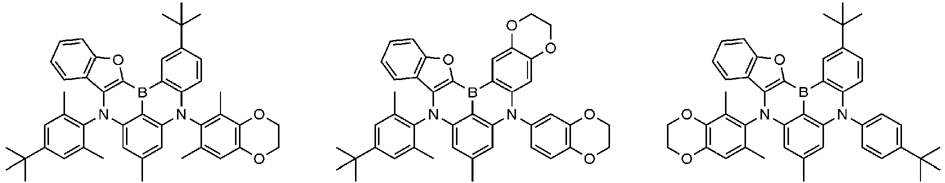

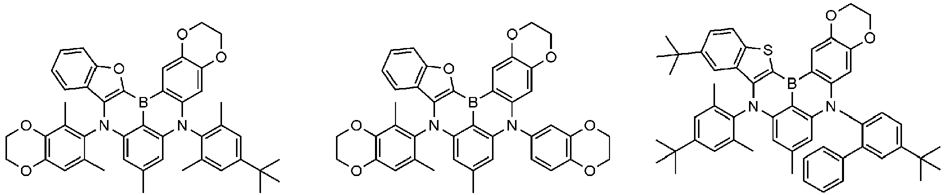

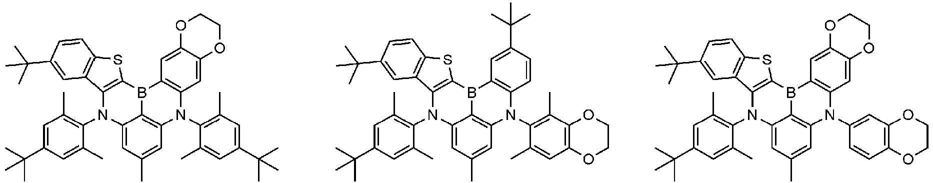

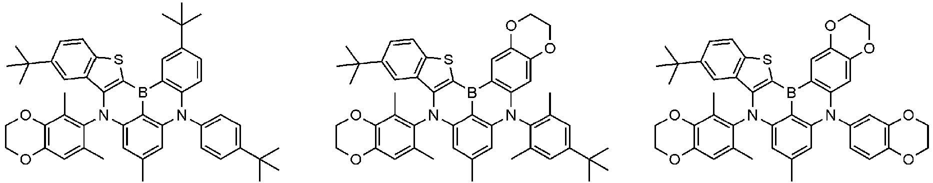

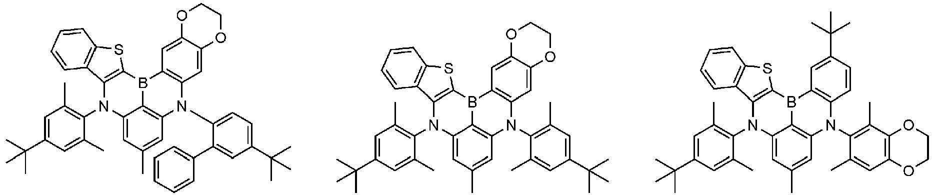

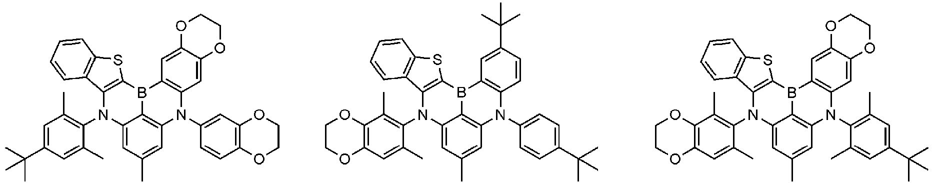

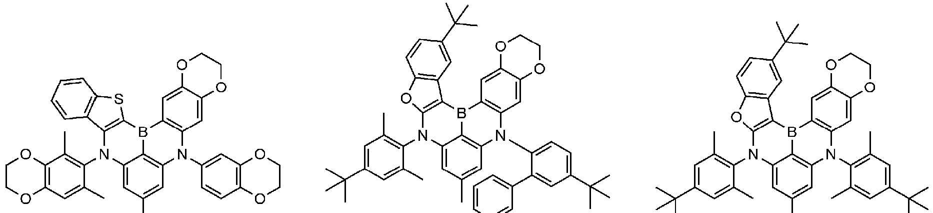

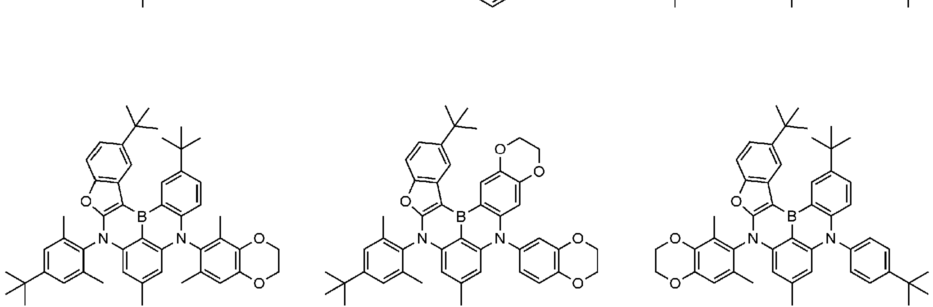

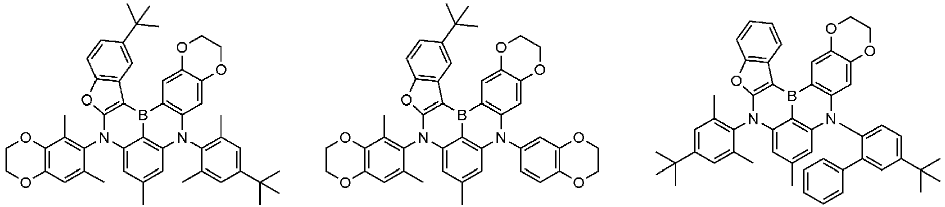

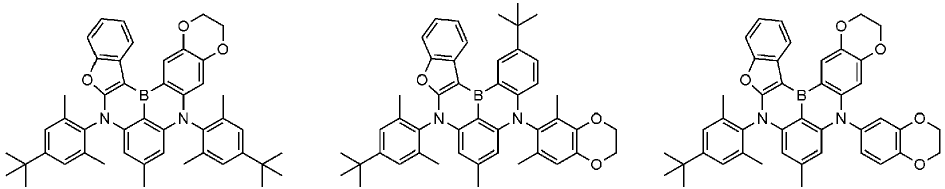

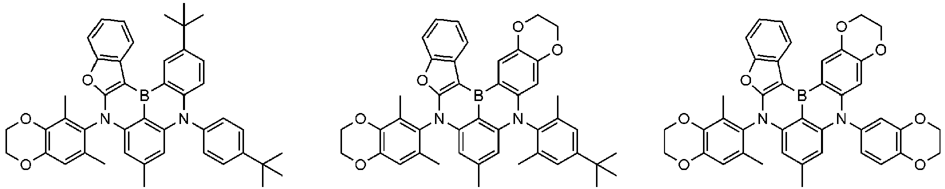

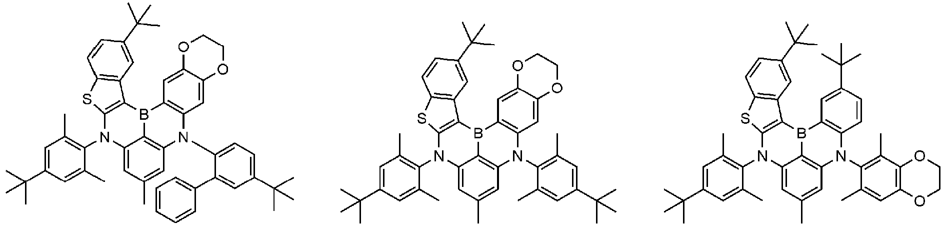

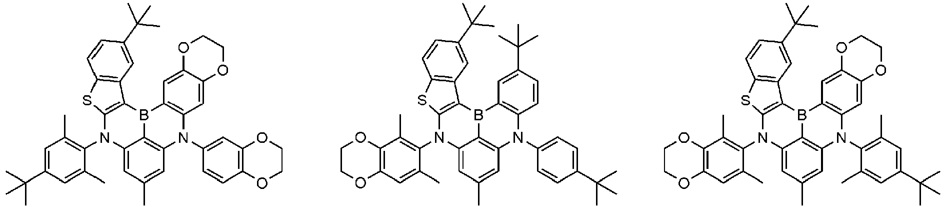

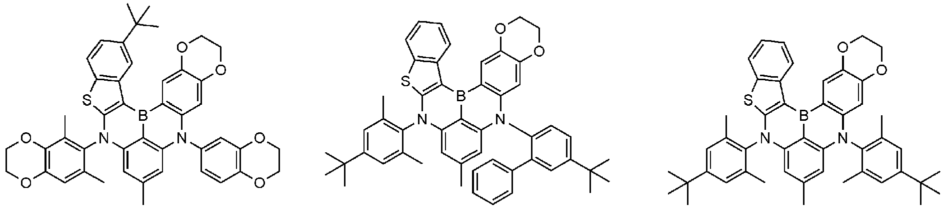

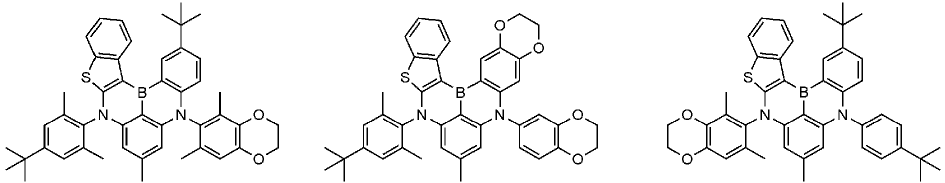

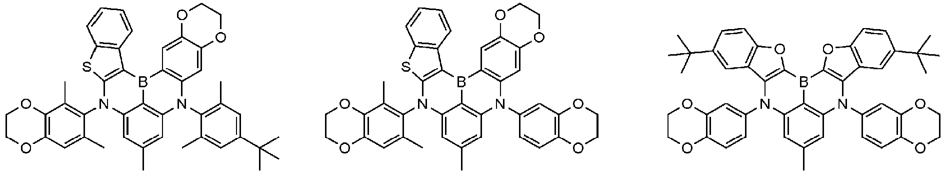

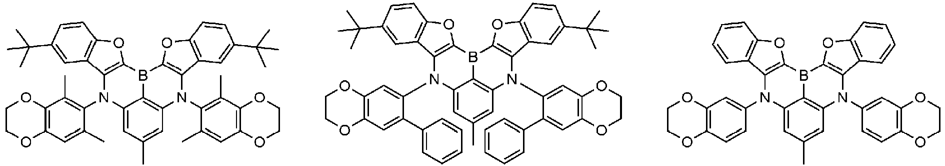

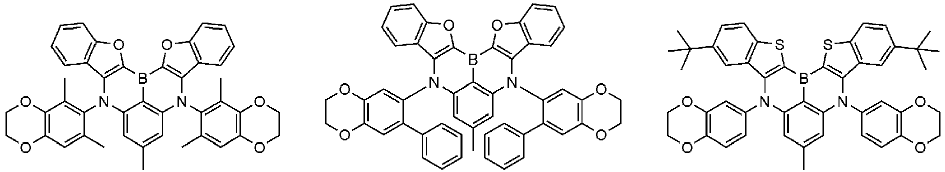

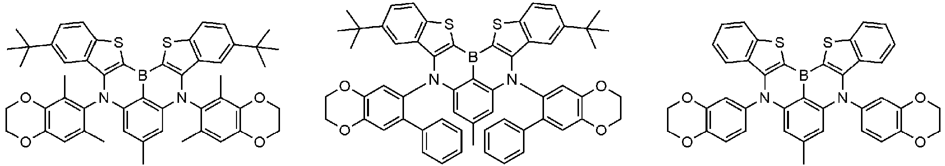

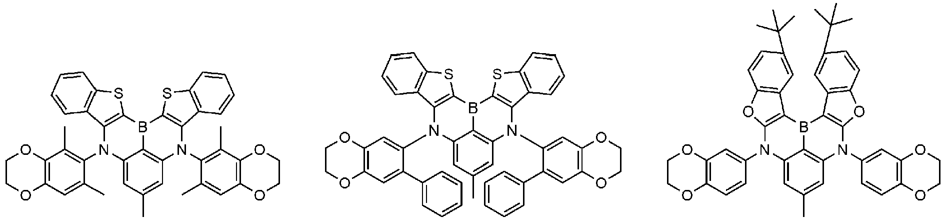

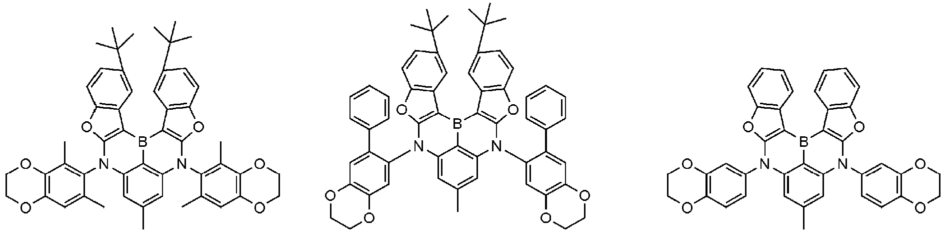

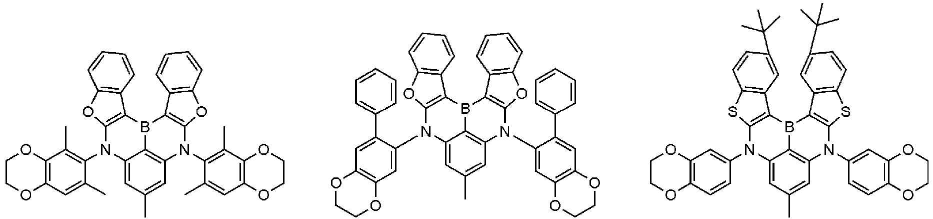

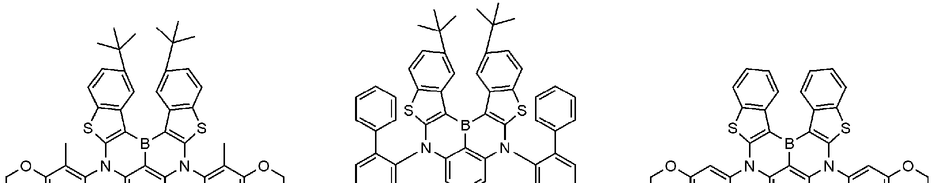

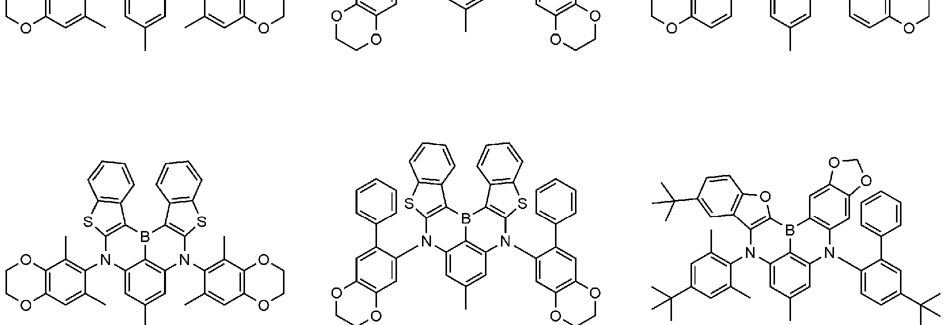

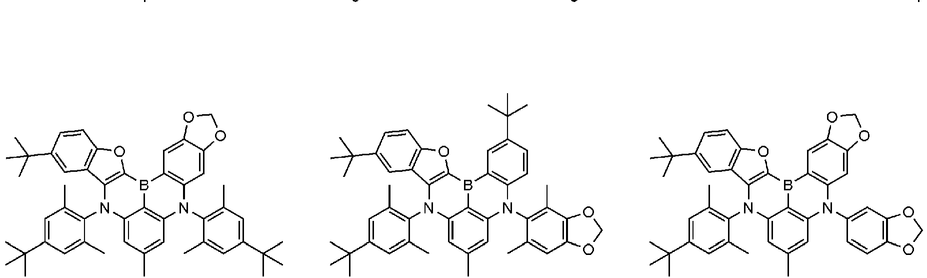

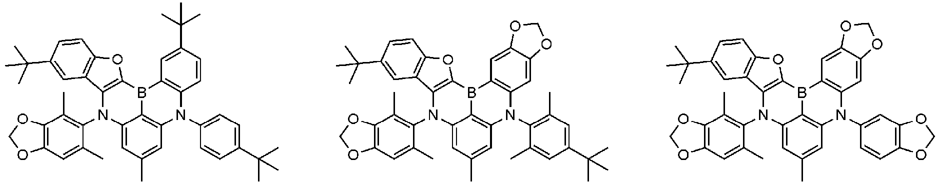

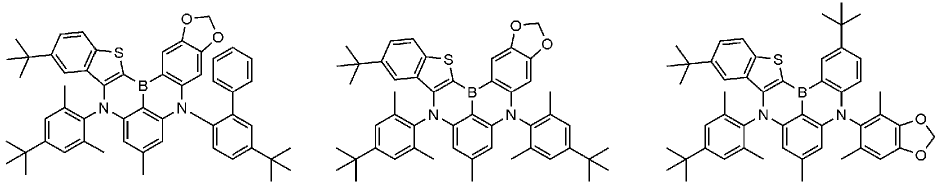

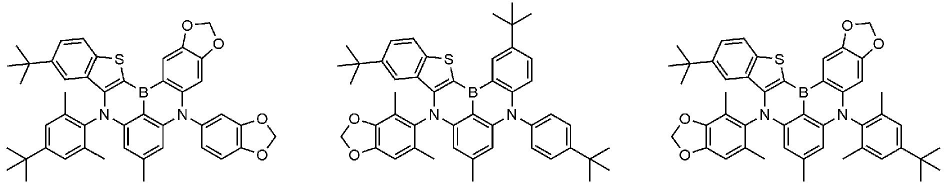

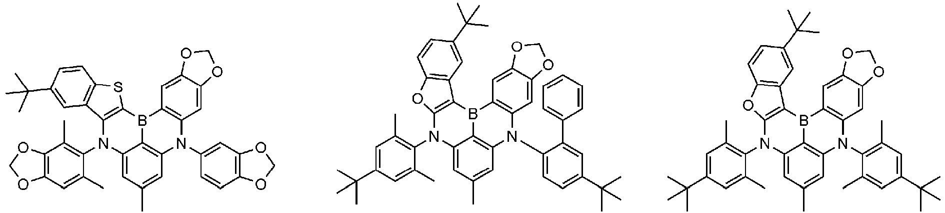

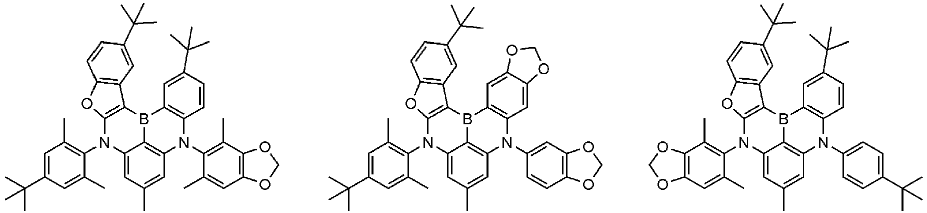

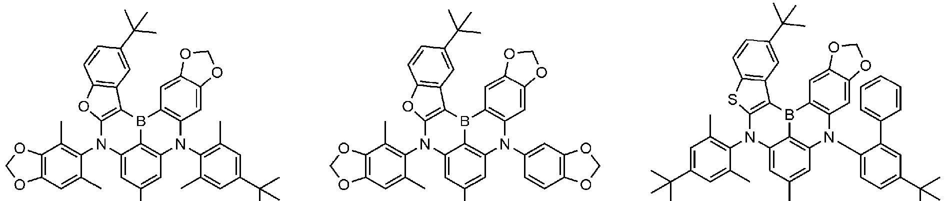

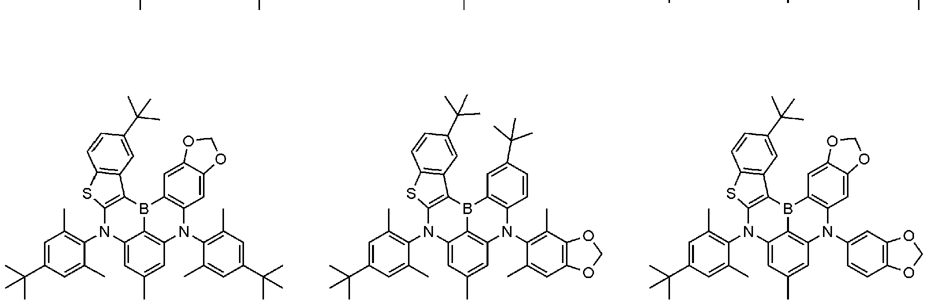

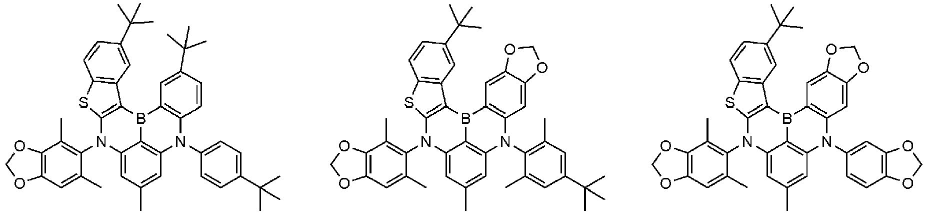

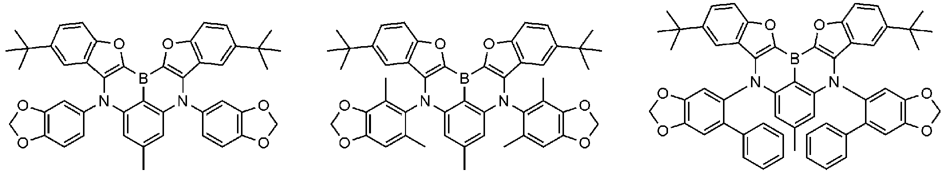

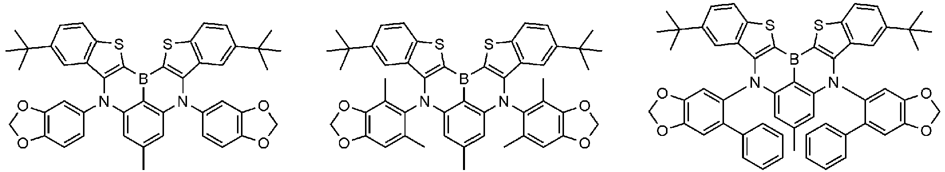

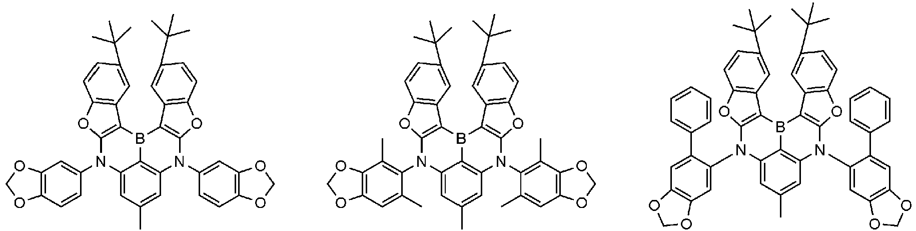

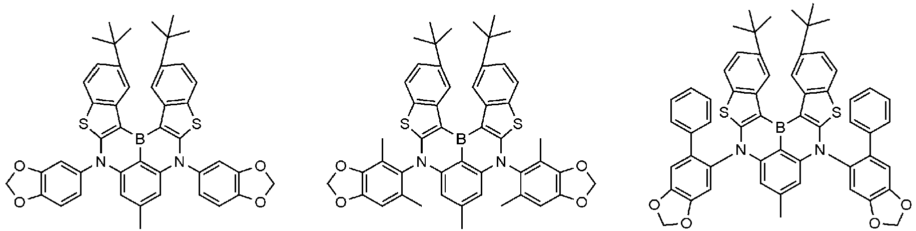

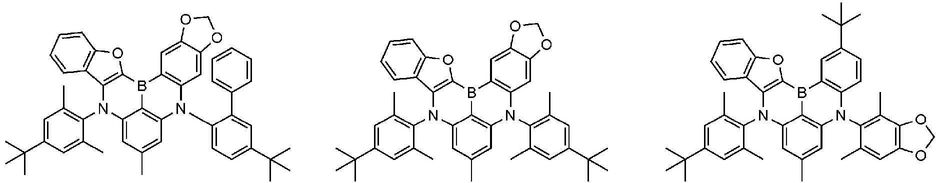

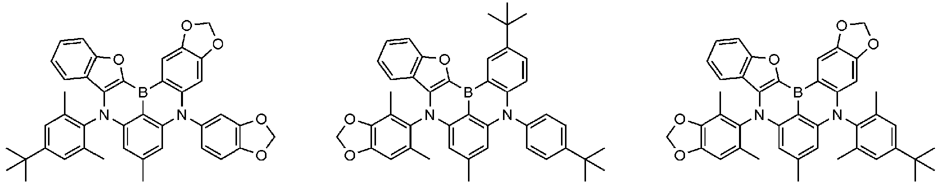

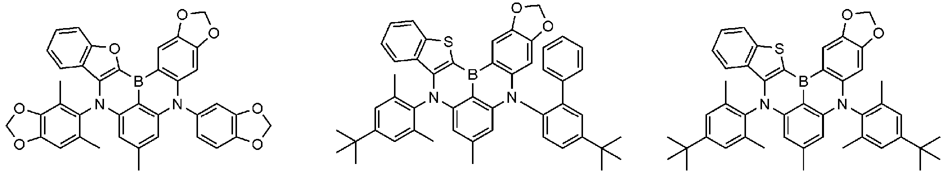

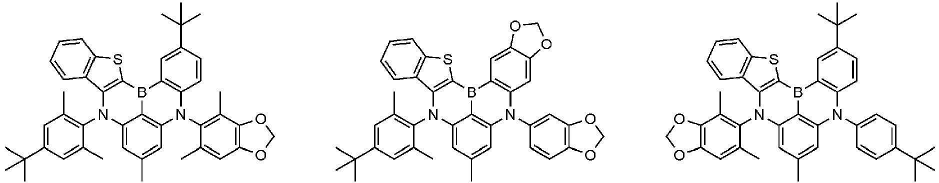

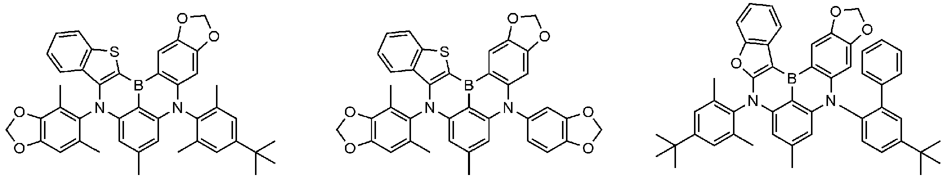

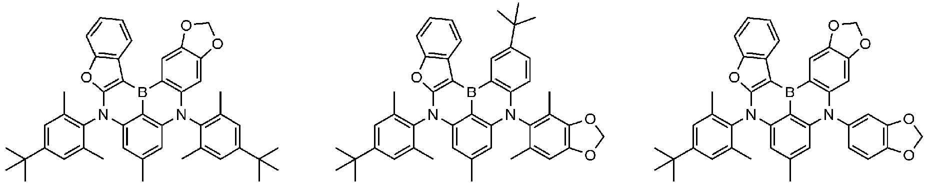

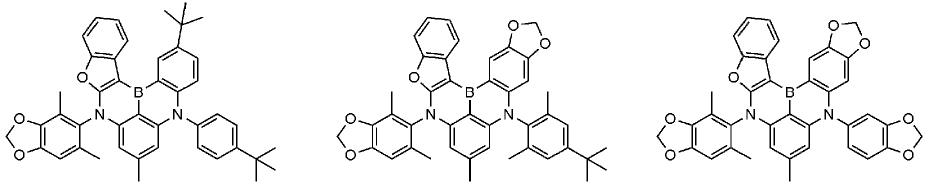

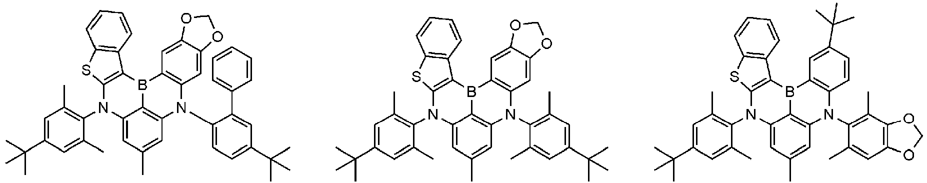

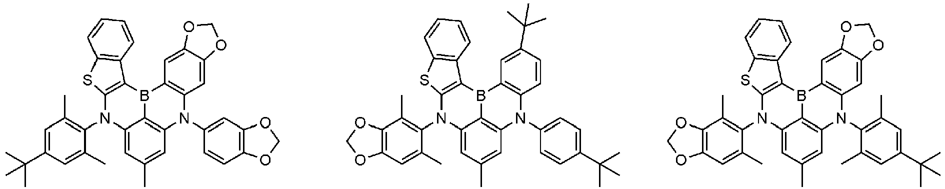

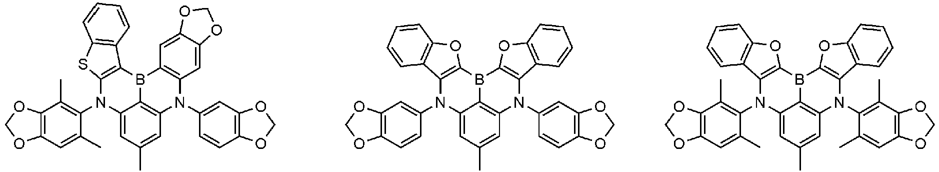

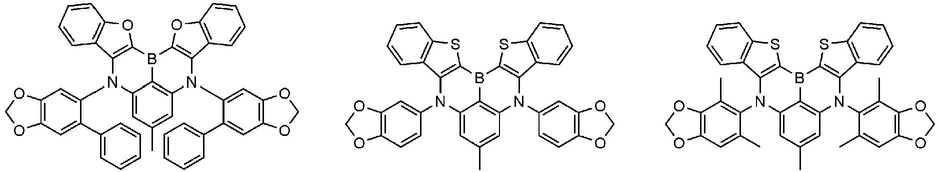

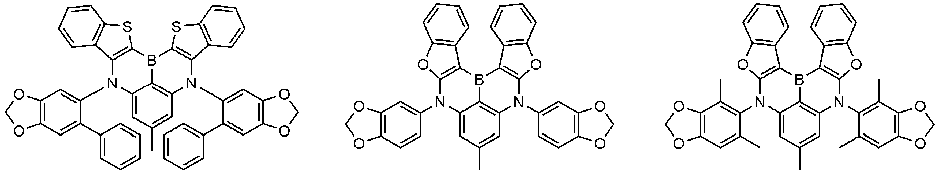

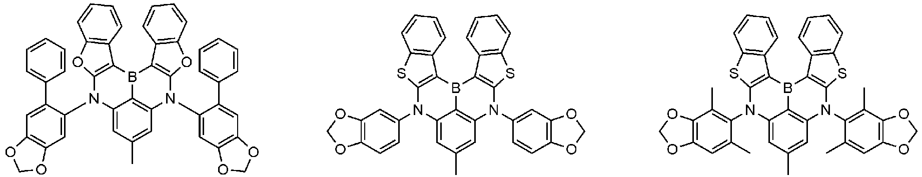

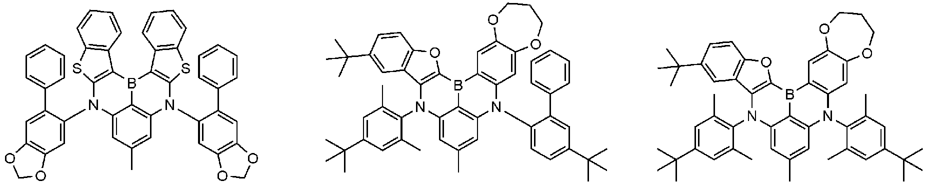

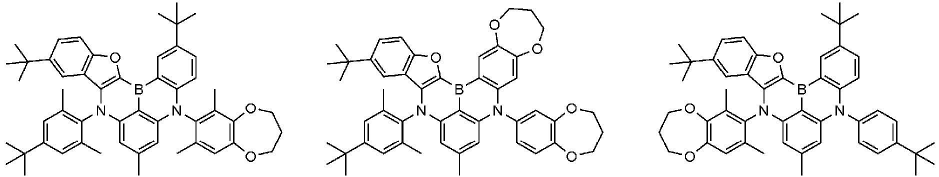

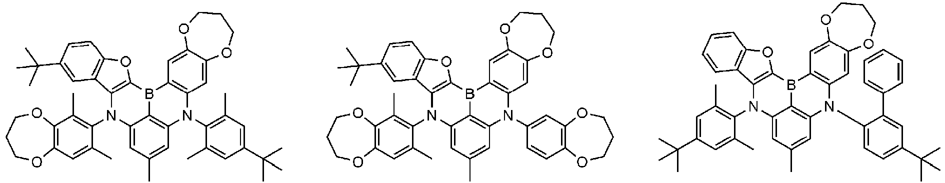

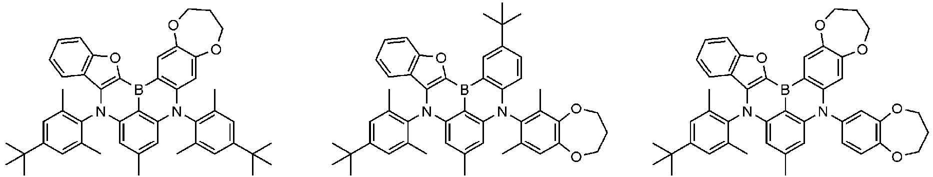

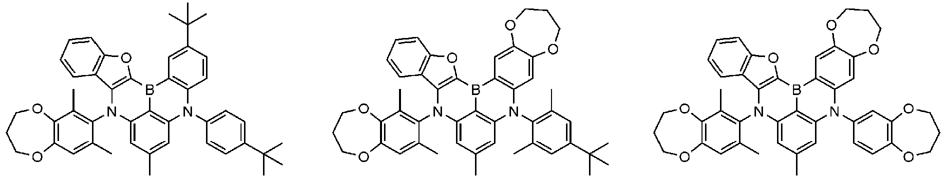

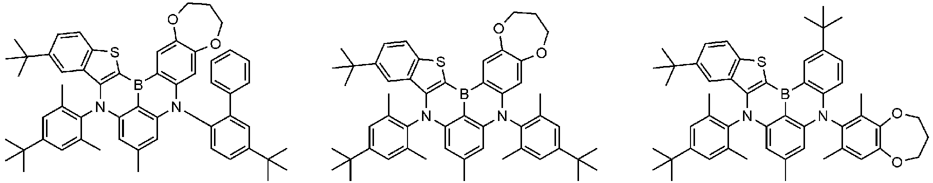

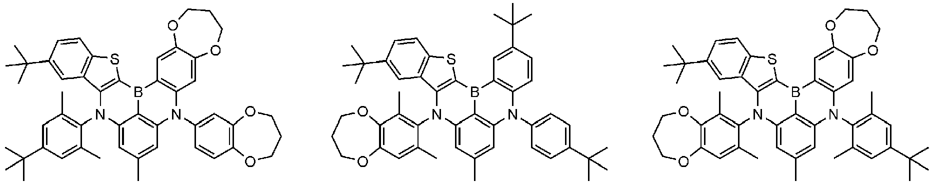

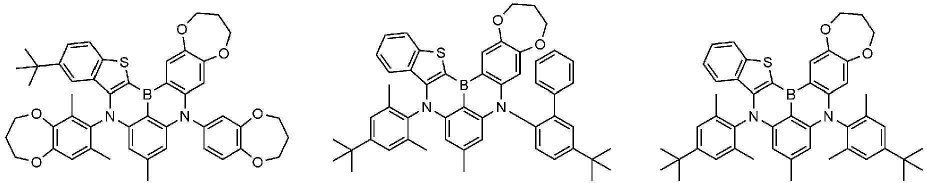

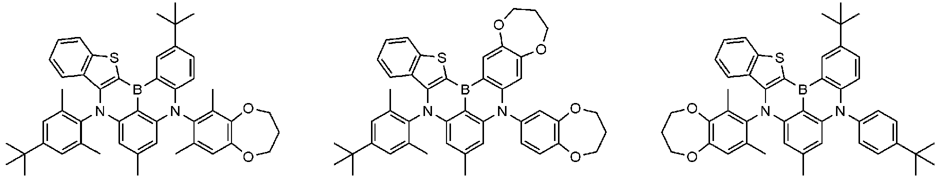

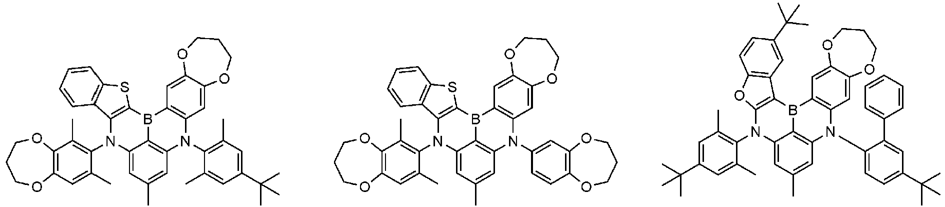

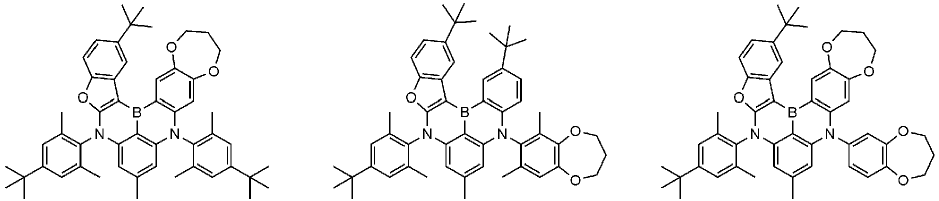

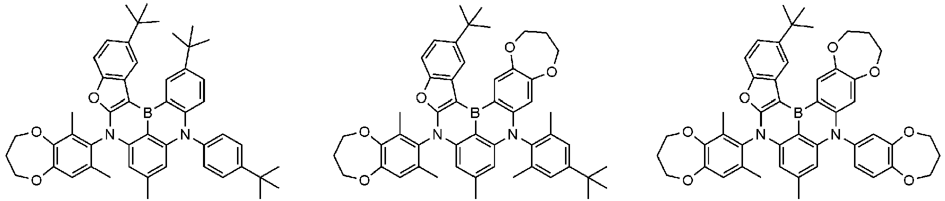

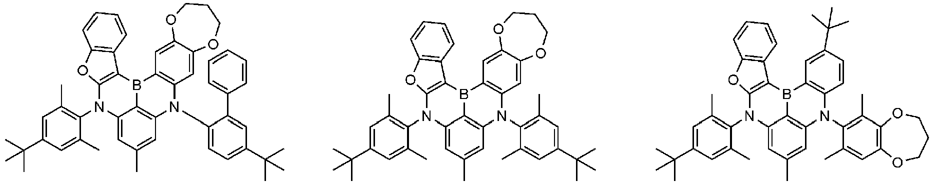

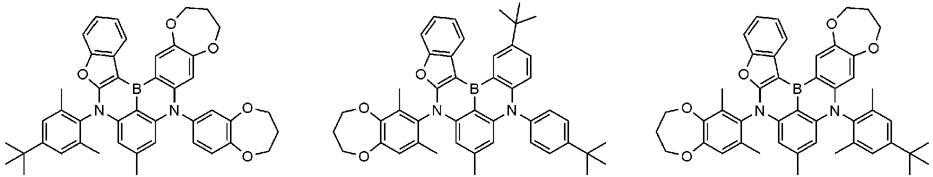

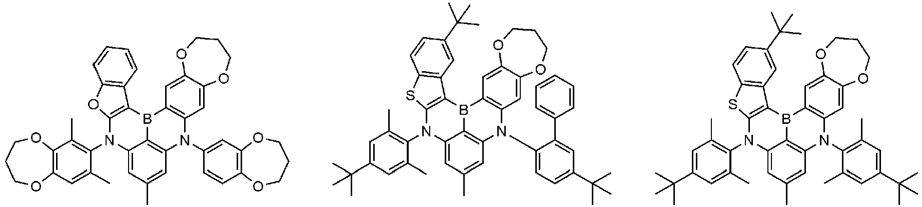

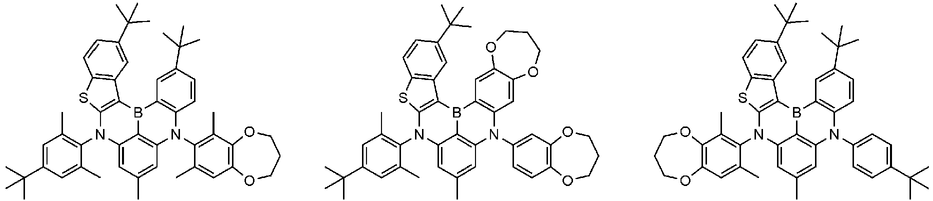

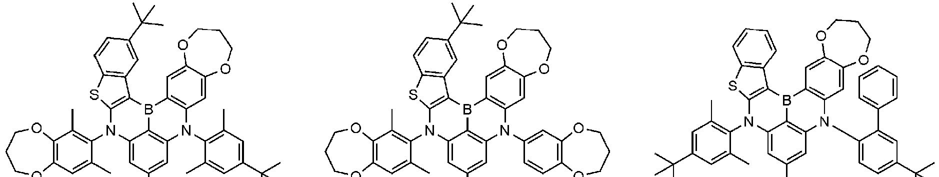

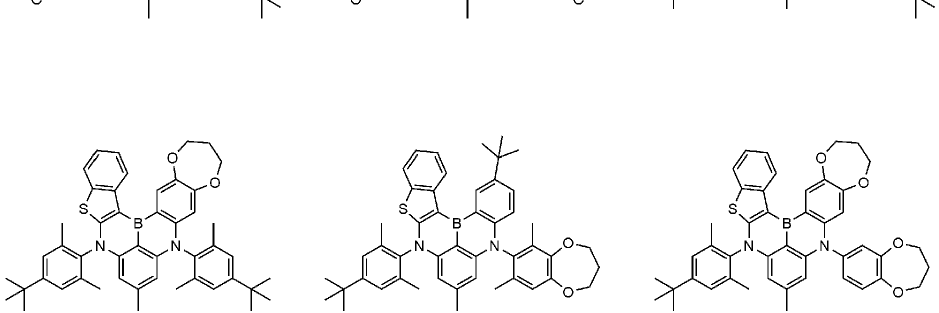

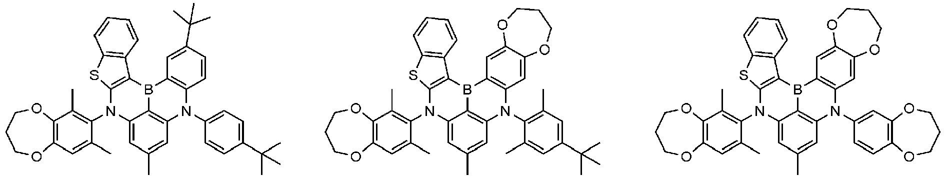

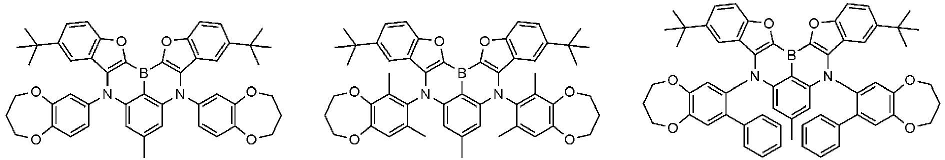

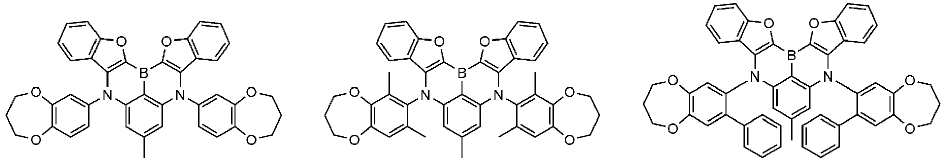

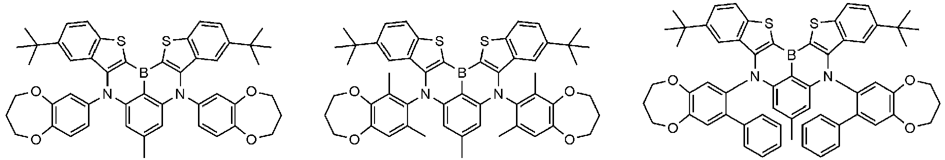

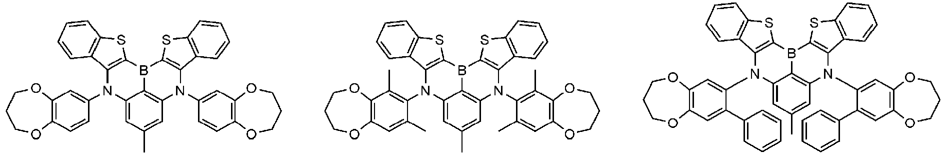

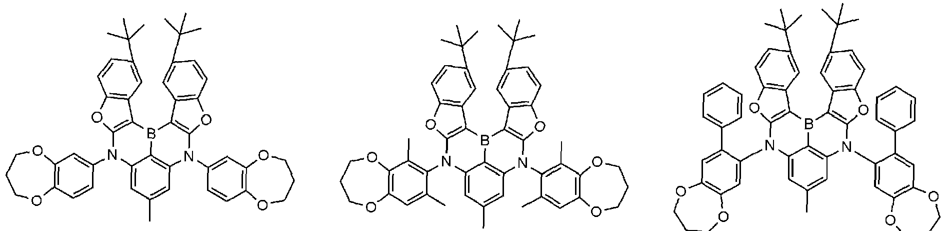

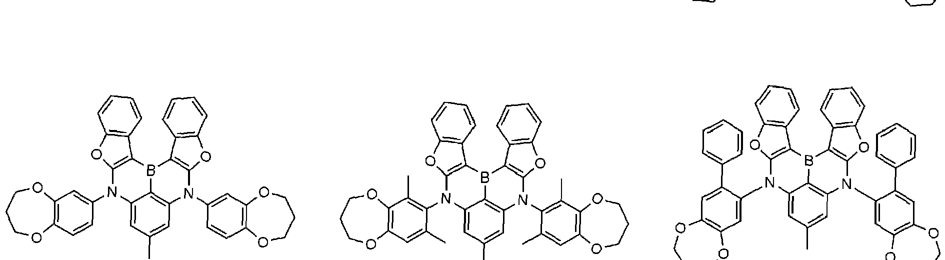

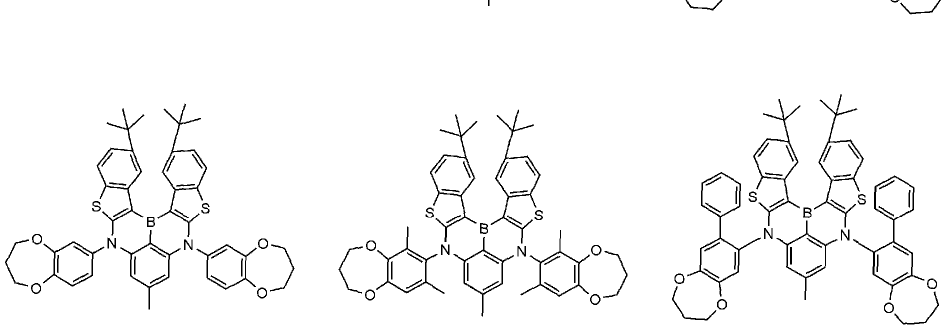

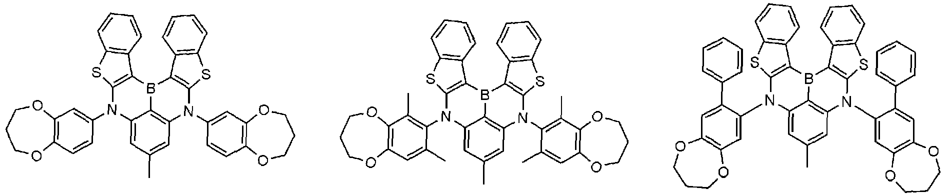

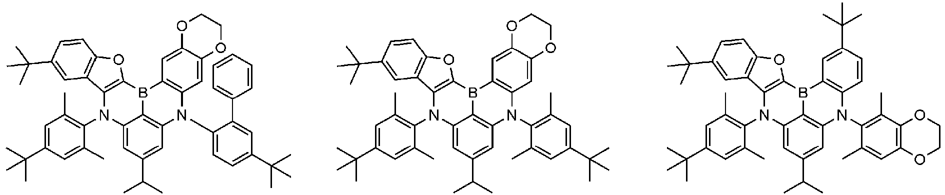

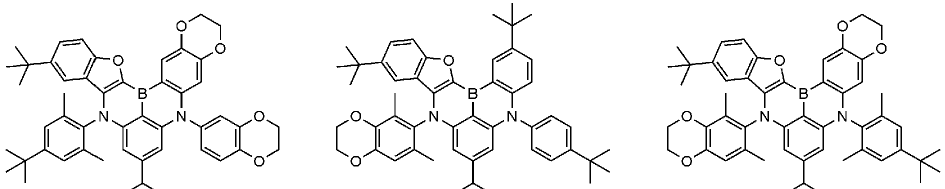

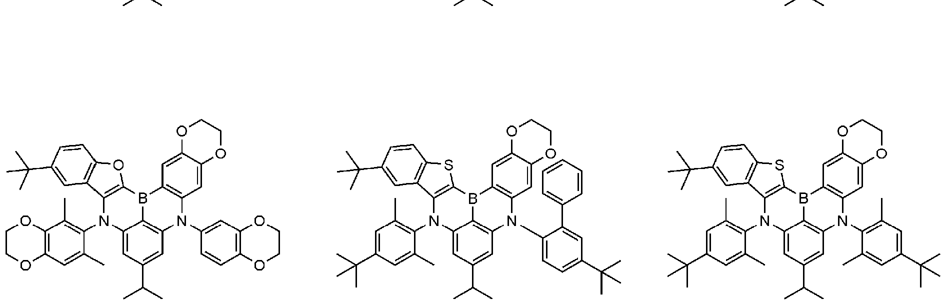

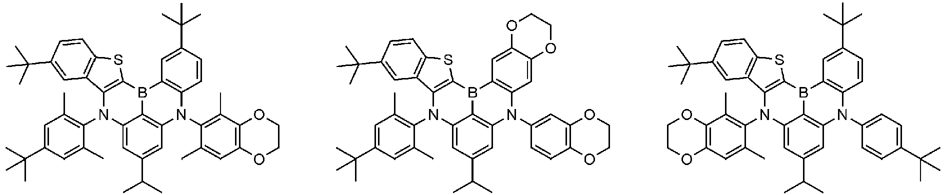

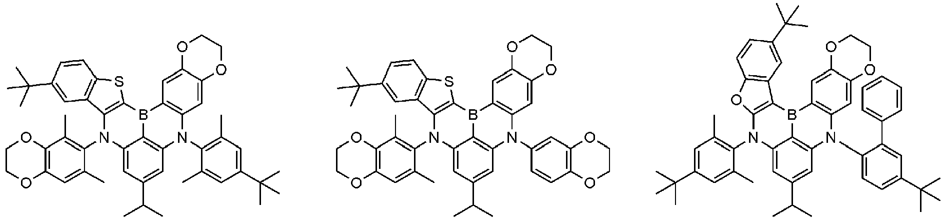

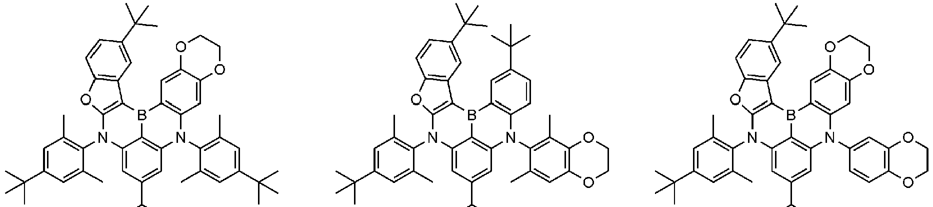

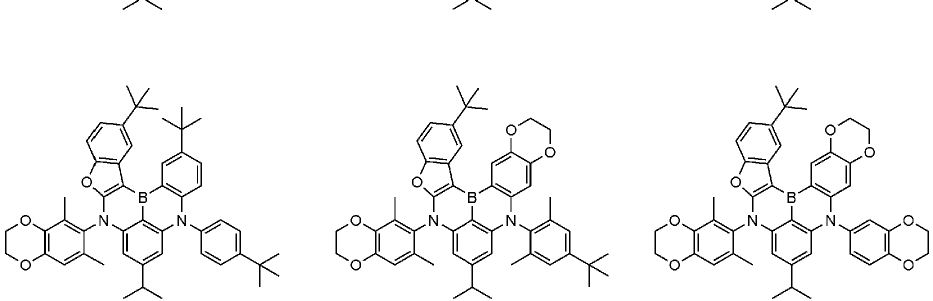

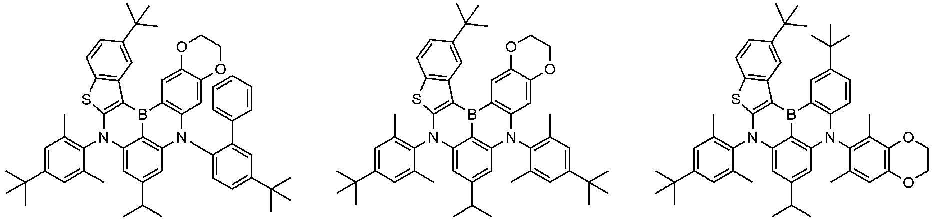

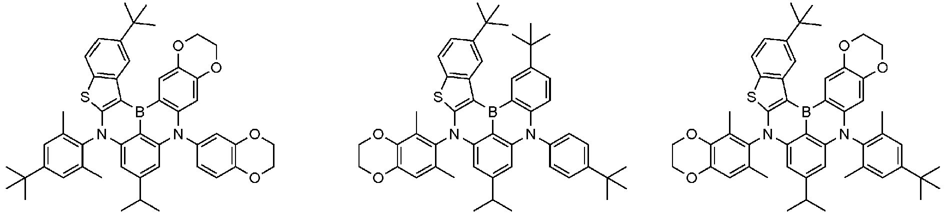

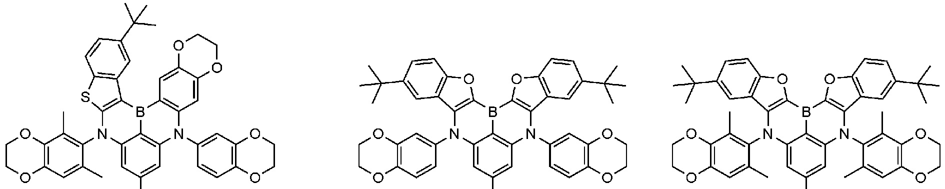

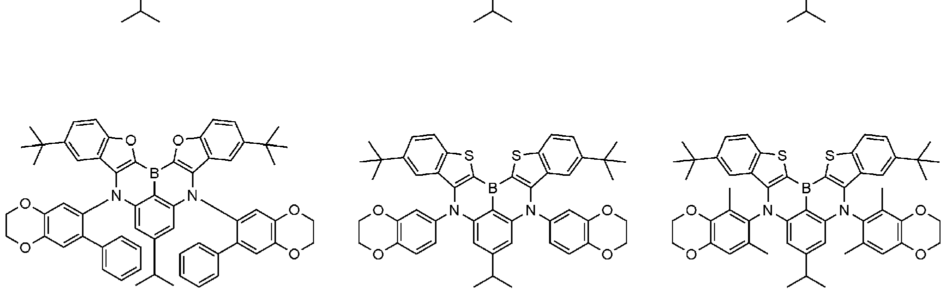

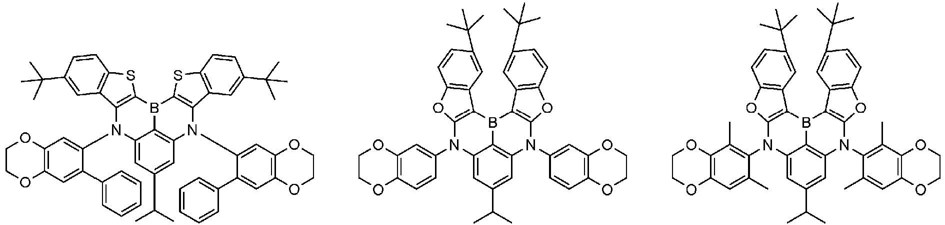

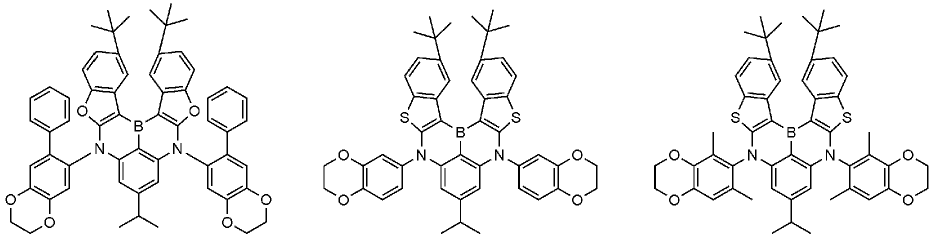

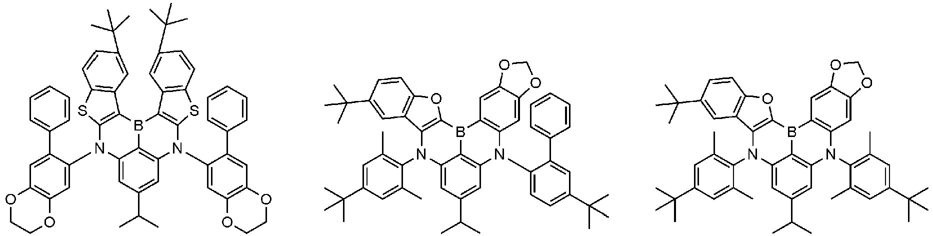

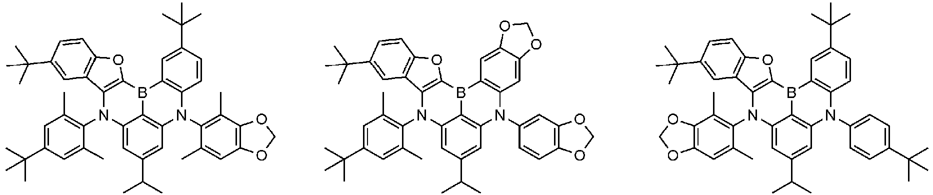

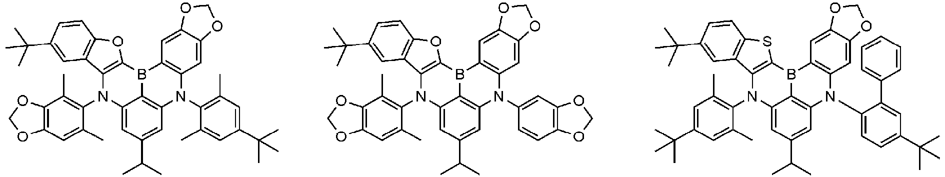

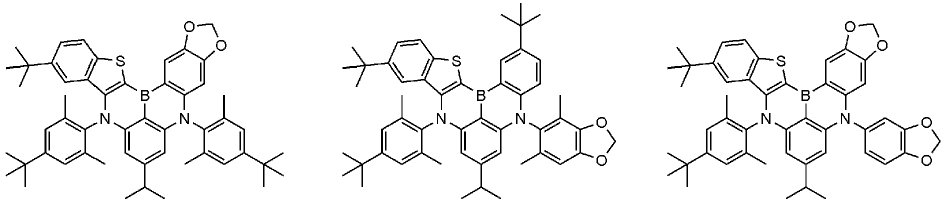

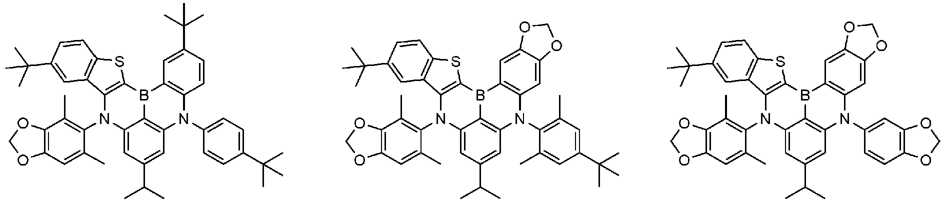

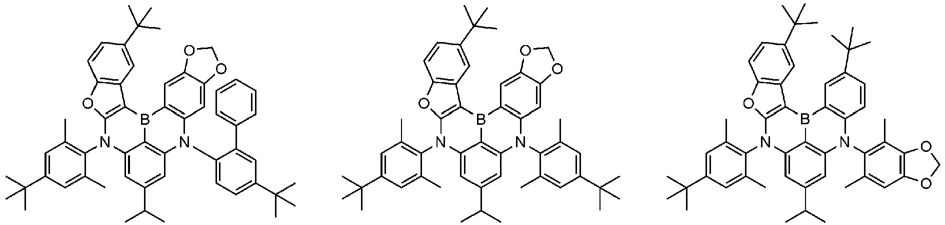

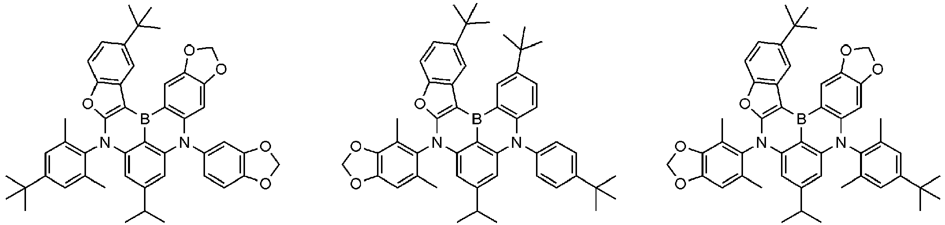

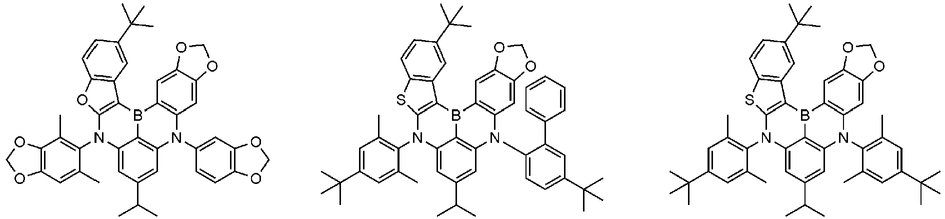

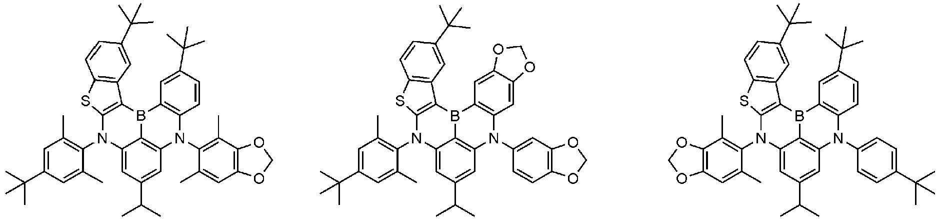

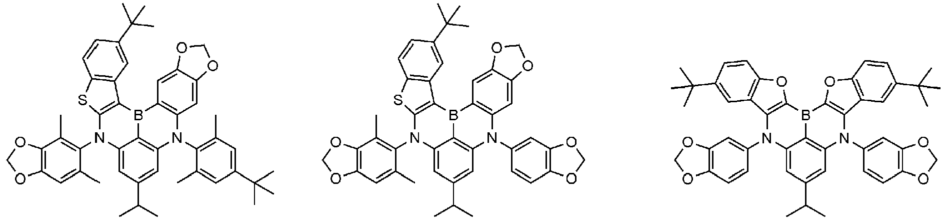

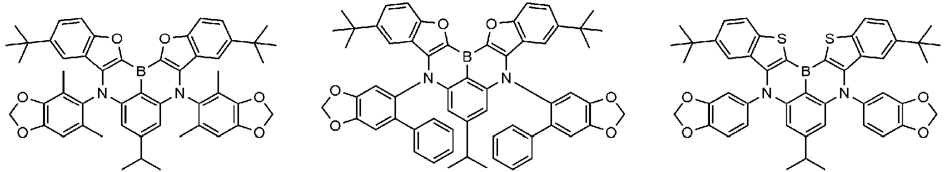

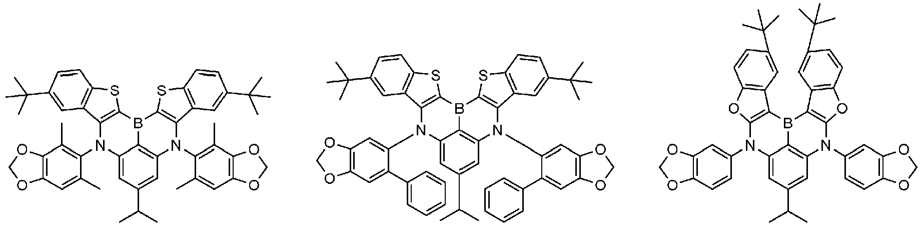

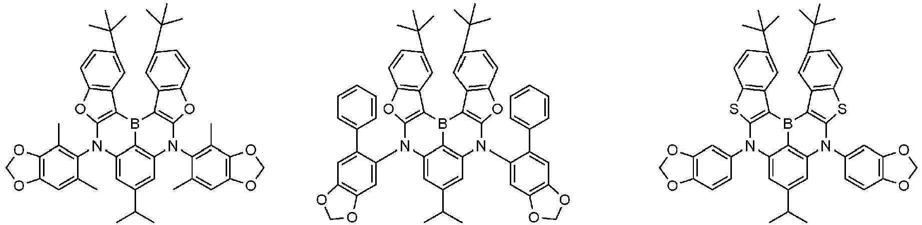

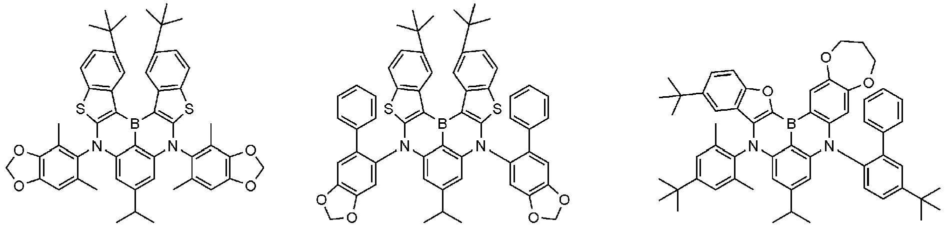

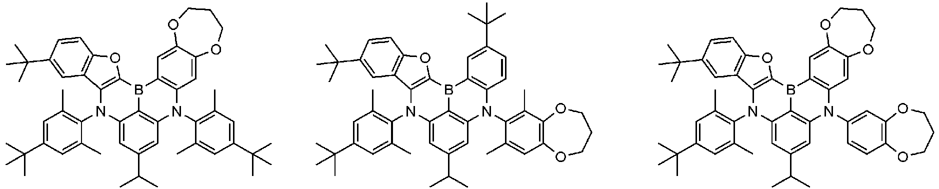

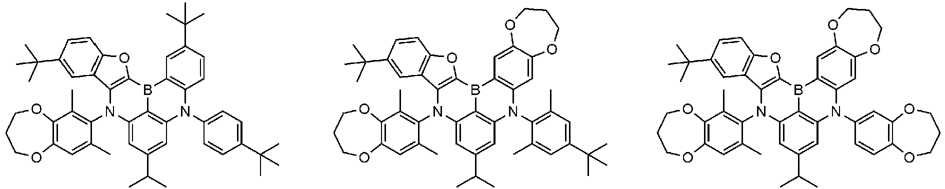

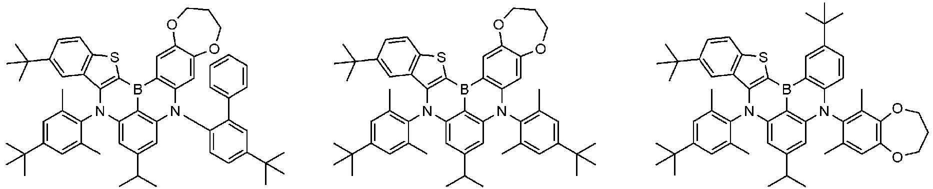

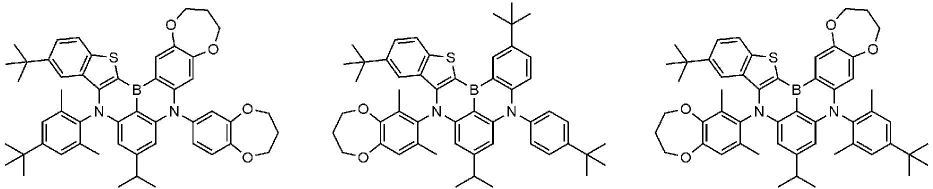

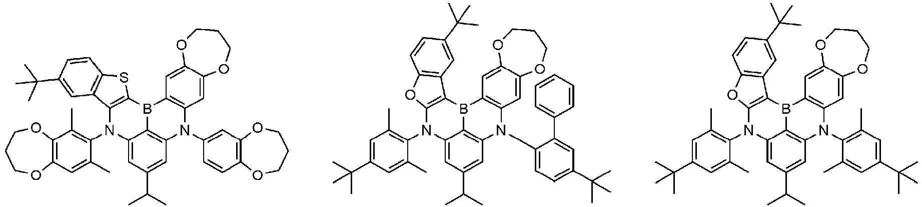

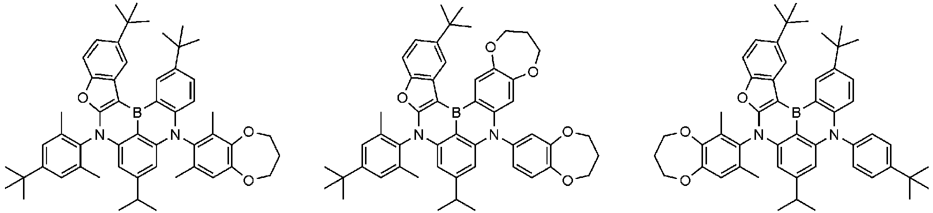

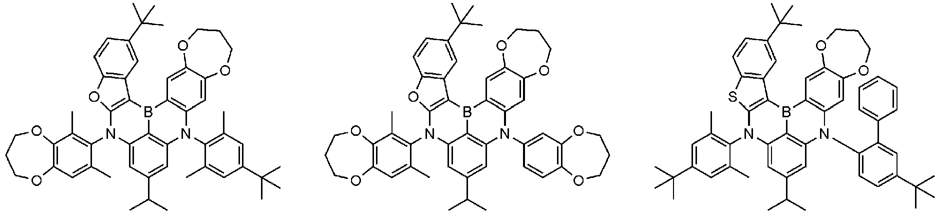

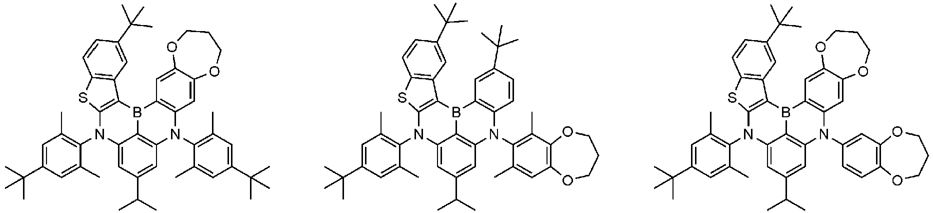

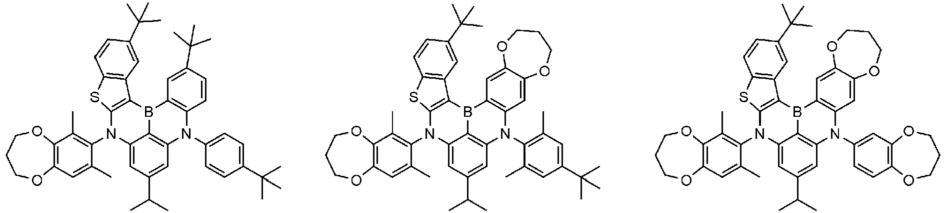

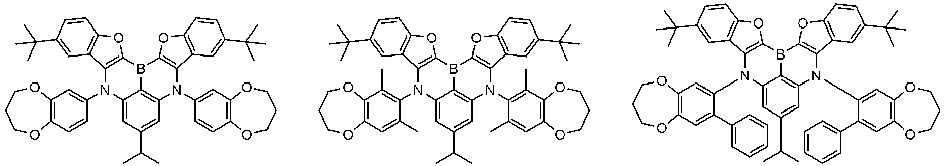

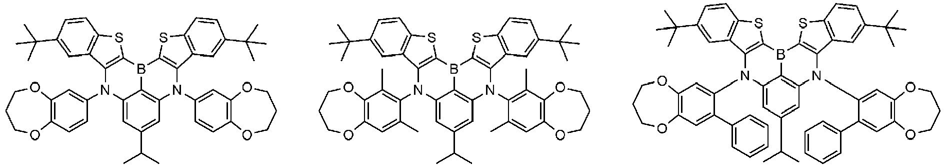

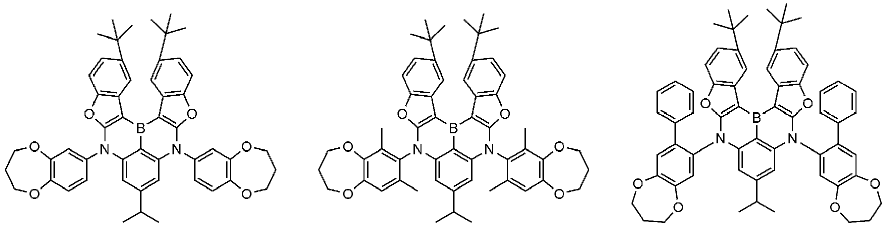

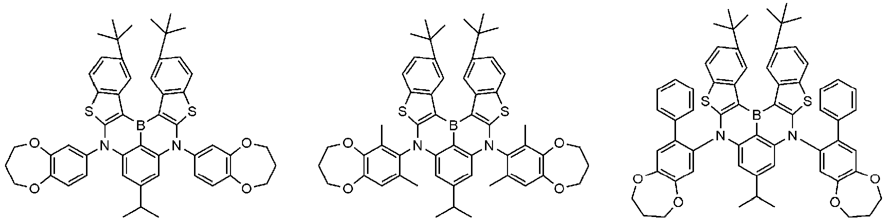

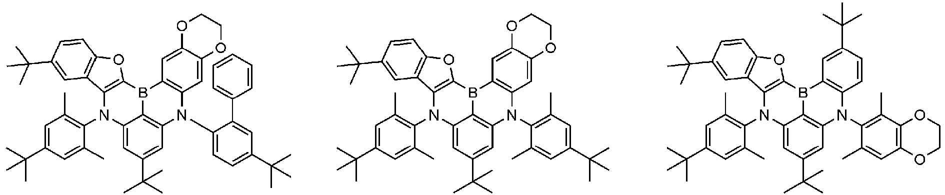

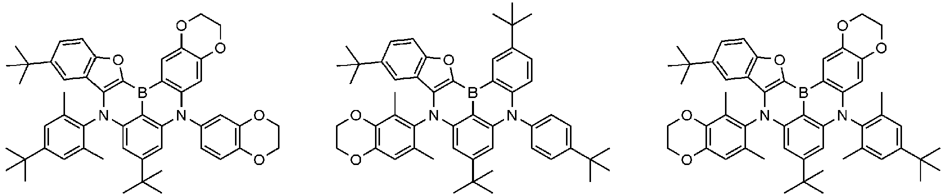

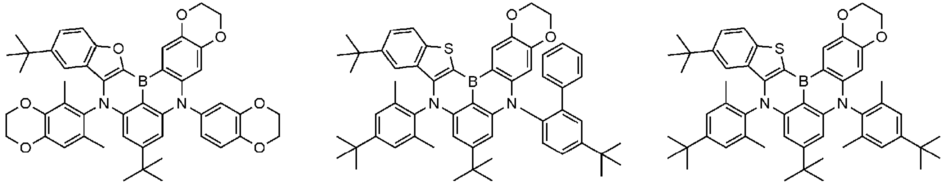

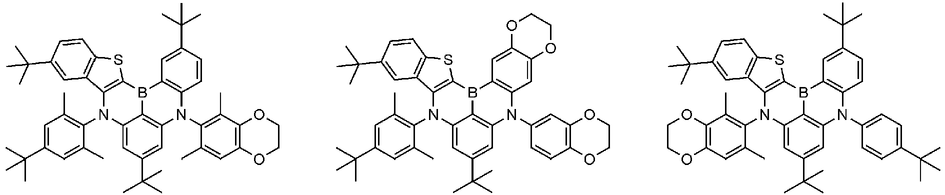

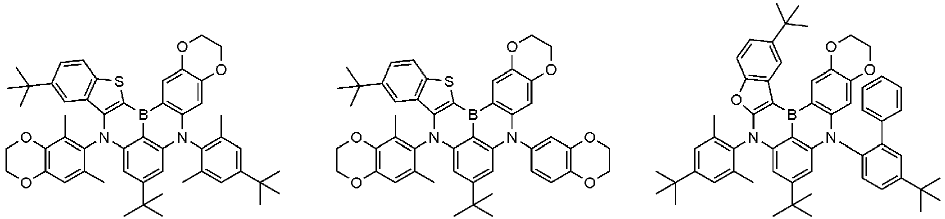

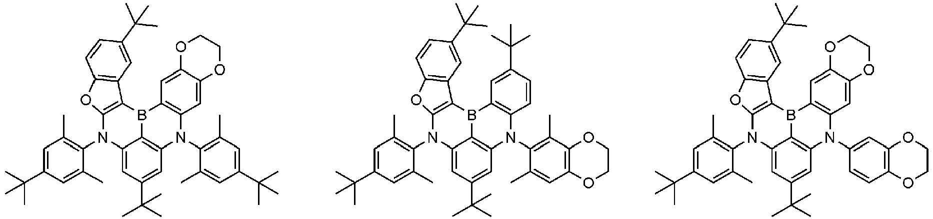

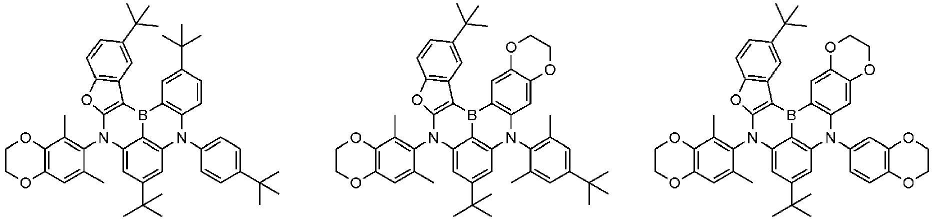

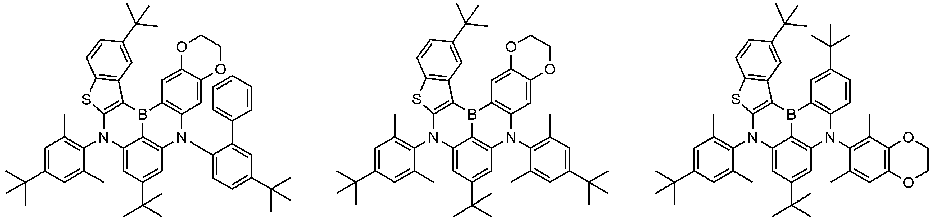

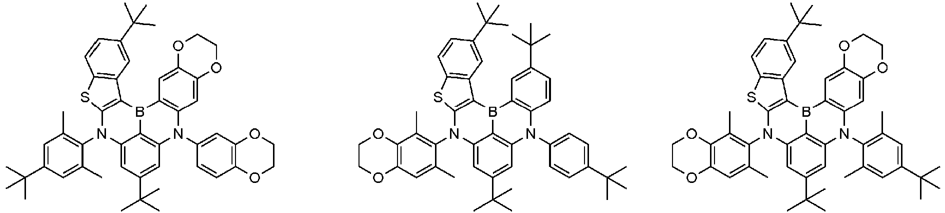

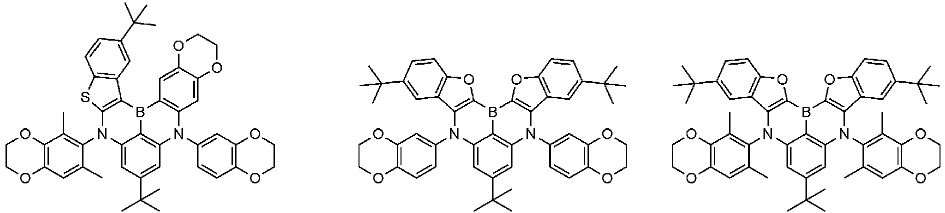

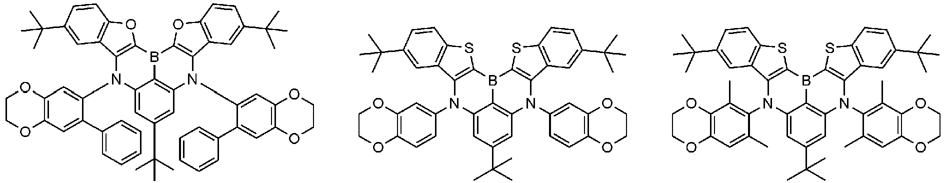

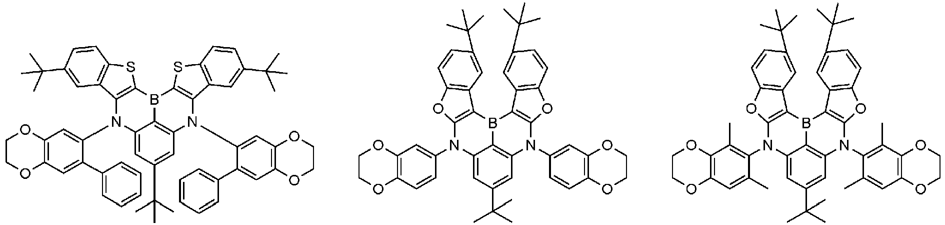

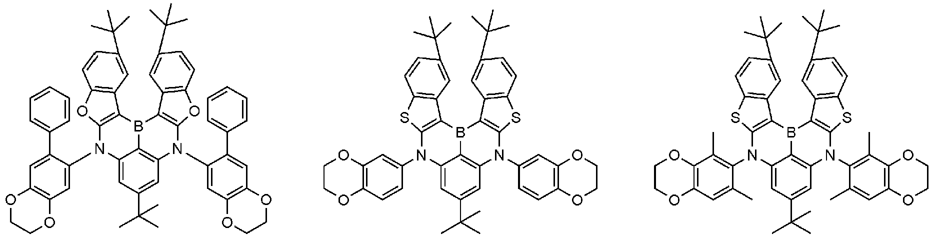

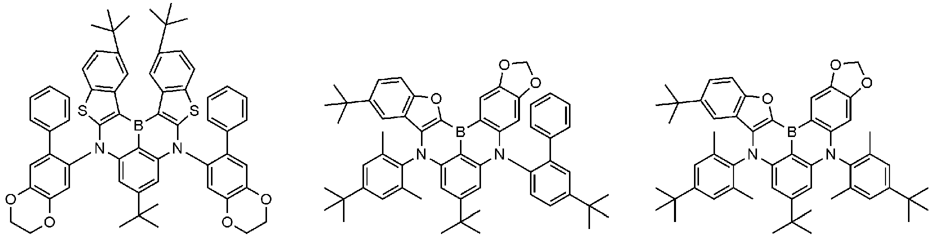

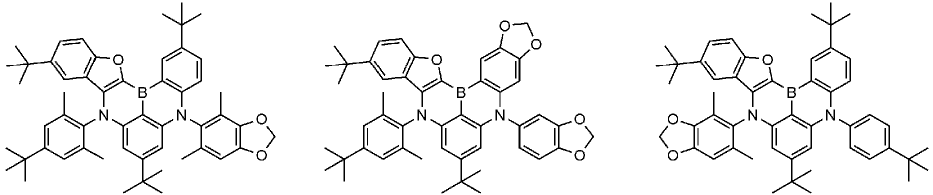

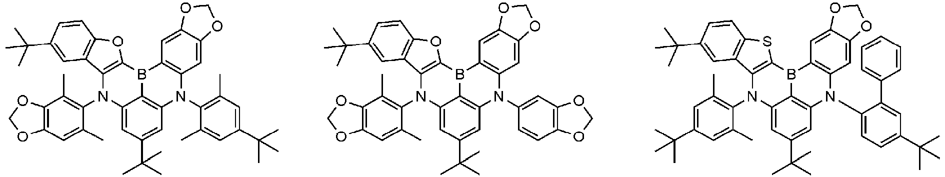

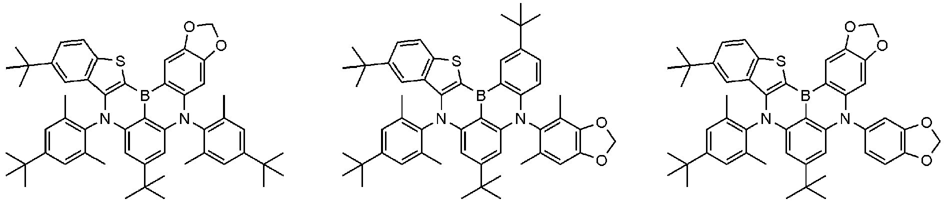

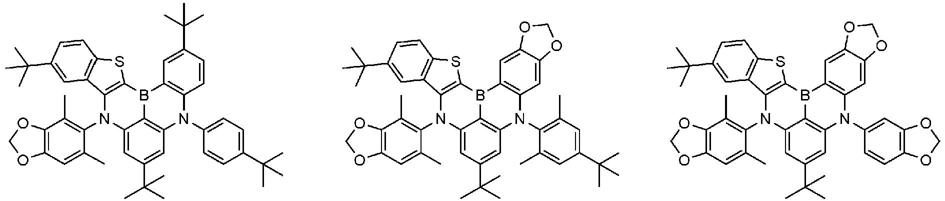

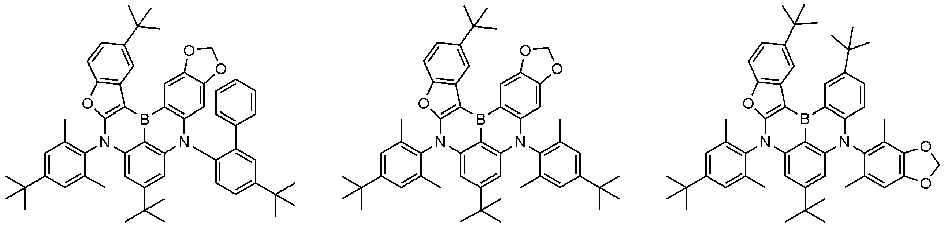

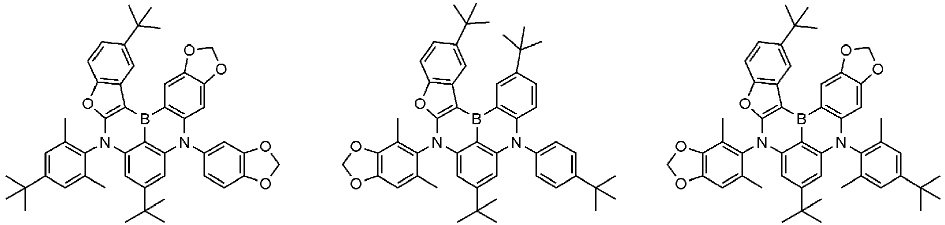

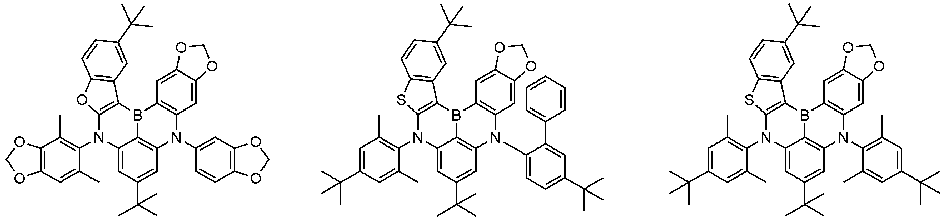

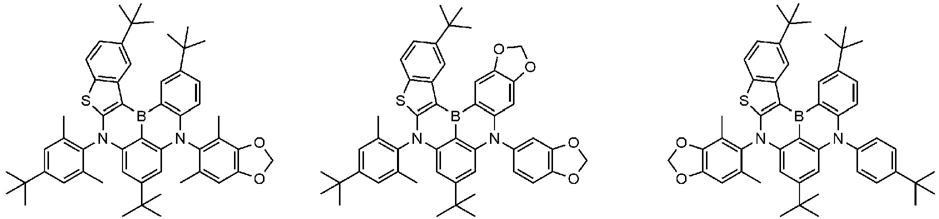

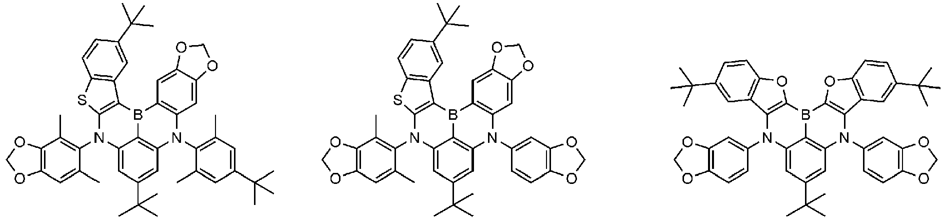

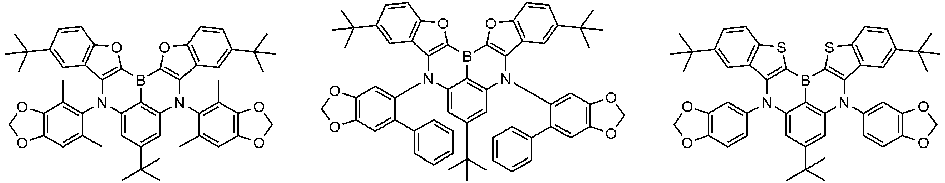

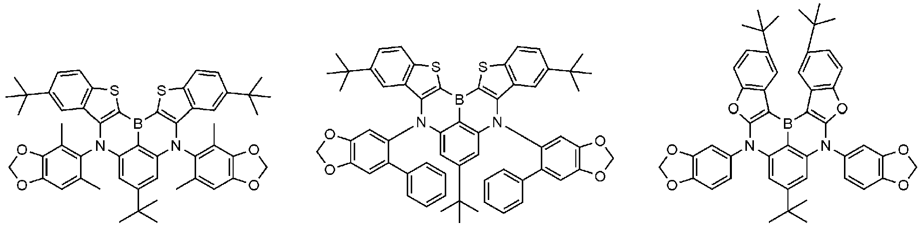

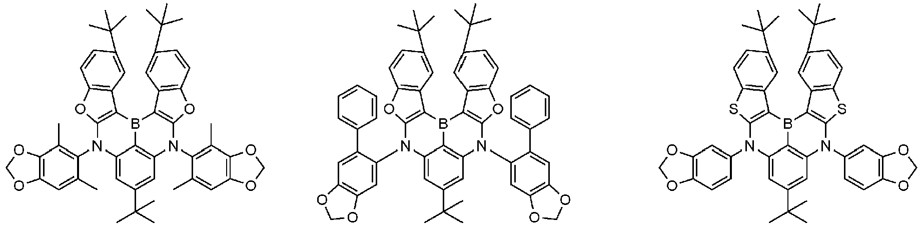

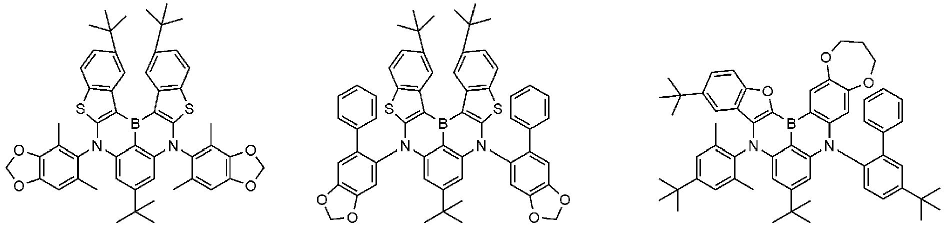

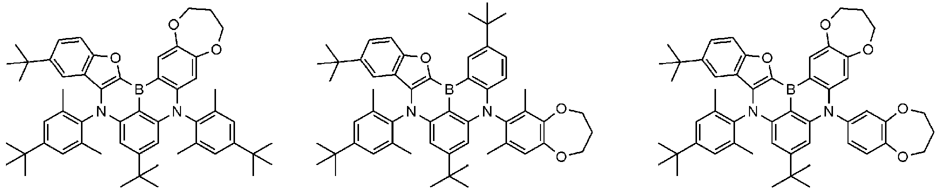

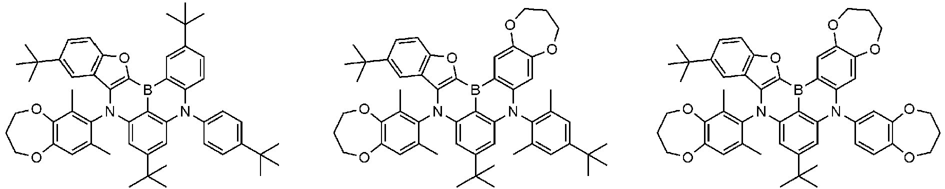

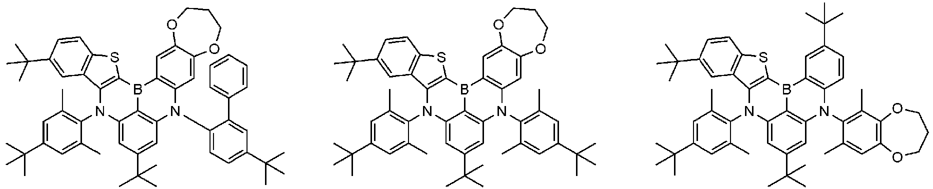

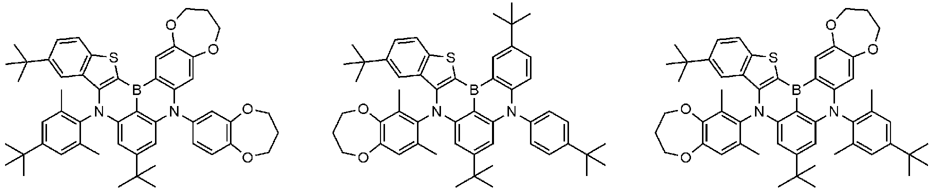

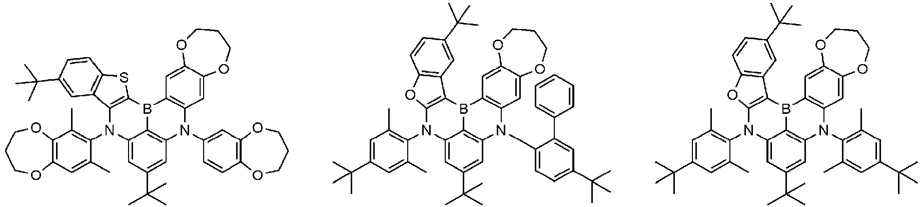

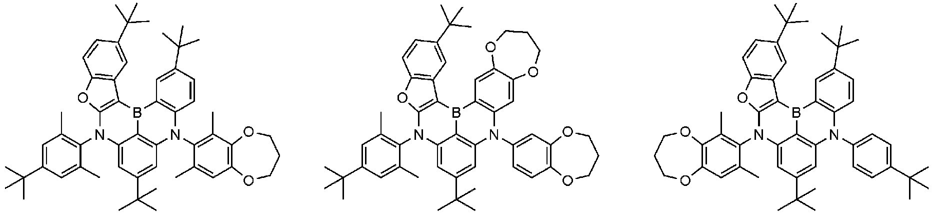

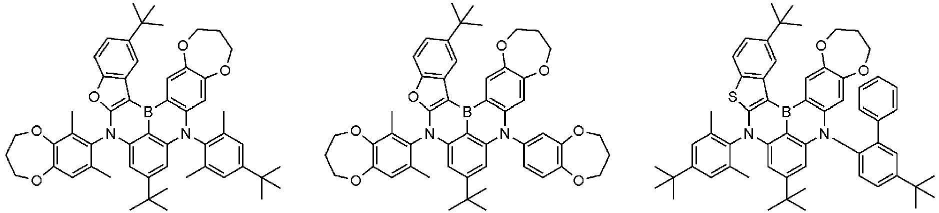

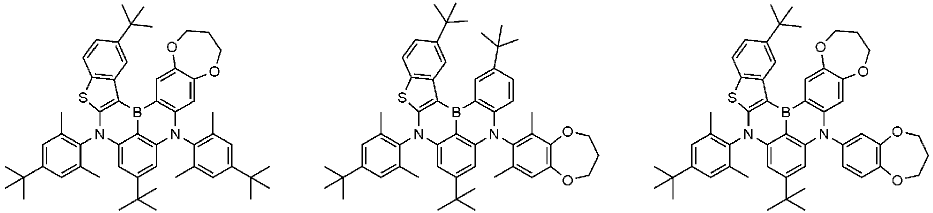

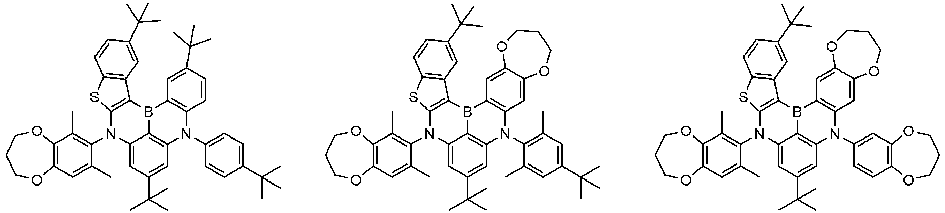

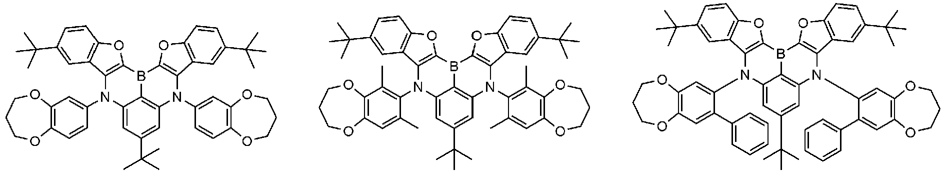

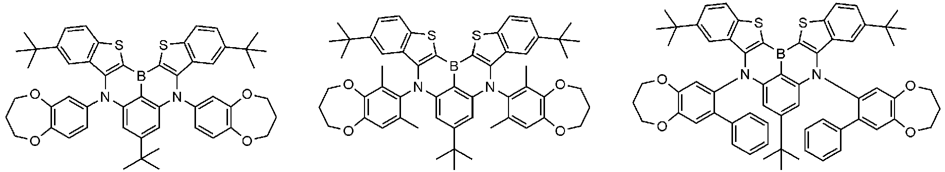

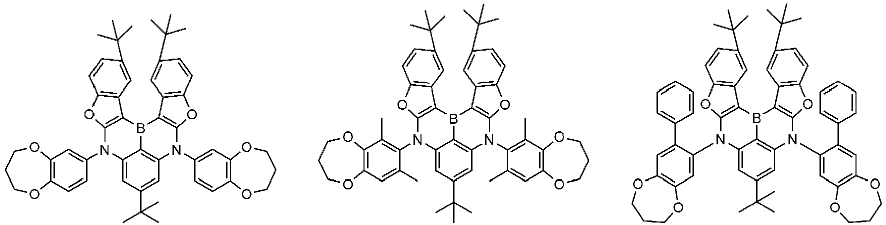

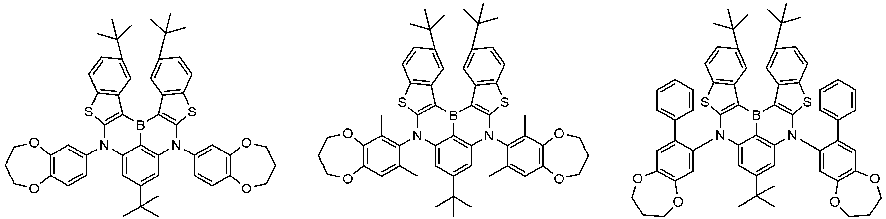

Meanwhile, there is provided a method for preparing a compound represented by the Chemical Formula 1 as shown in Reaction Scheme 1 below: 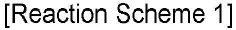 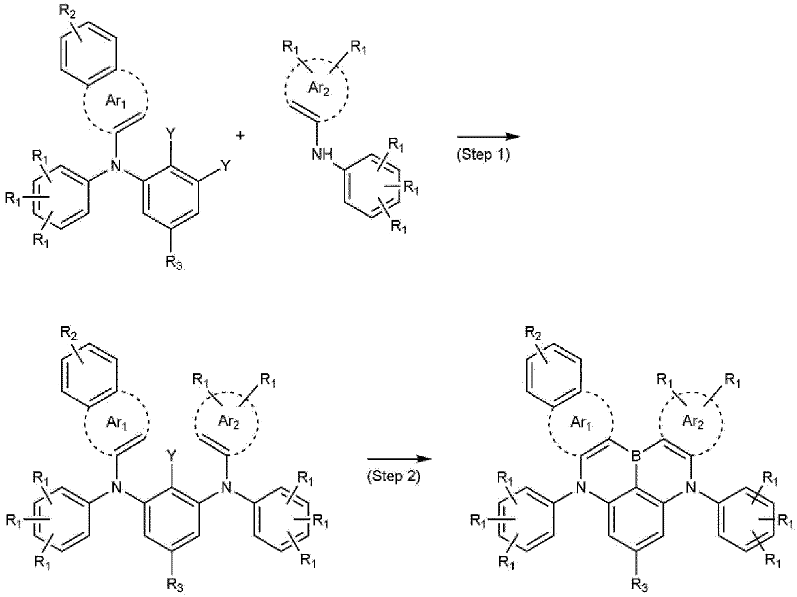 in the Reaction Scheme 1, definitions of other substituents except for Y are the same as defined above, and Y is halogen, preferably bromo, or chloro.

The step 1 is an amine substitution reaction, and preferably performed in the presence of a palladium catalyst and a base. In addition, the reactive group for the amine substitution reaction may be appropriately changed. The step 2 is a reaction with Bl₃, and preferably performed in the presence of a base. The preparation method may be more specifically described in Preparation Examples described below.

Meanwhile, the organic material layer including the compound according to the present disclosure can be prepared using various methods such as a vacuum deposition method and a solution process, and the solution process will be described in more detail below.

### (Coating composition)

Meanwhile, the compound according to the present disclosure can form an organic material layer of an organic light emitting device, particularly, a light emitting layer by a solution process. Specifically, the compound may be used as a dopant material of the light emitting layer. To this end, there is provided a coating composition including the above-described compound according to the present disclosure and a solvent.

The solvent is not particularly limited as long as it is a solvent capable of dissolving or dispersing the compound according to the present disclosure. For example, the solvent may include a chlorine-based solvent such as chloroform, methylene chloride, 1,2-dichloroethane, 1,1,2-trichloroethane, chlorobenzene, o-dichlorobenzene; an ether-based solvent such as tetrahydrofuran and dioxane; an aromatic hydrocarbon-based solvent such as toluene, xylene, trimethylbenzene, and mesitylene; an aliphatic hydrocarbon-based solvent such as cyclohexane, methylcyclohexane, n-pentane, n-hexane, n-heptane, n-octane, n-nonane, and n-decane; a ketone-based solvent such as acetone, methyl ethyl ketone, and cyclohexanone; an ester-based solvent such as ethyl acetate, butyl acetate, and ethyl cellosolve acetate; a polyhydric alcohol and derivatives thereof such as ethylene glycol, ethylene glycol monobutyl ether, ethylene glycol monoethyl ether, ethylene glycol monomethyl ether, dimethoxyethane, propylene glycol, diethoxymethane, triethylene glycol monoethyl ether, glycerin, and 1,2-hexane diol; an alcohol-based solvent such as methanol, ethanol, propanol, isopropanol, and cyclohexanol; a sulfoxide-based solvent such as dimethyl sulfoxide; an amide-based solvent such as N-methyl-2-pyrrolidone and N,N-dimethylformamide; a benzoate-based solvent such as butyl benzoate and methyl-2-methoxy benzoate; tetralin; and 3-phenoxytoluene. In addition, the above-mentioned solvents may be used alone or in combination of two or more thereof. Preferably, toluene may be used as the solvent.

In addition, the coating composition may further include a compound used as a host material, and the compound used for the host material will be described later. In addition, the coating composition may include a compound used as a dopant material, and the compound used for the dopant material will be described later.

In addition, a viscosity of the coating composition is preferably 1 cP or more. In order to facilitate the coating of the coating composition, the viscosity of the coating composition is preferably 10 cP or less. In addition, a concentration of the compound according to the present disclosure in the coating composition is preferably 0.1 wt/v% or more. In order for the coating composition to be optimally coated, the concentration of the compound according to the present disclosure in the coating composition is preferably 20 wt/v% or less.

In the present disclosure, there is also provided a method of forming a light emitting layer using the above-described coating composition. Specifically, the method includes the steps of: coating the coating composition according to the present disclosure on the anode or on the hole transport layer formed on the anode in a solution process; and heat-treating the coated coating composition.

The solution process uses the coating composition according to the present disclosure as described above, and refers to spin coating, dip coating, doctor blading, inkjet printing, screen printing, spraying, roll coating, etc., but is not limited thereto.

A temperature in the heat-treatment step is preferably 150 to 230 °C. In addition, the heat-treatment is performed for 1 minute to 3 hours, more preferably for 10 minutes to 1 hour. In addition, the heat-treatment is preferably performed under an inert gas atmosphere such as argon or nitrogen.

### (Organic light emitting device)

In addition, according to another aspect of the present disclosure, there is provided an organic light emitting device including the compound represented by the Chemical Formula 1. As an example, there is provided an organic light emitting device including: a first electrode; a second electrode that is provided opposite to the first electrode; and one or more organic material layers that are provided between the first electrode and the second electrode, wherein at least one layer of the organic material layers includes the compound represented by the Chemical Formula 1.

The organic material layer of the organic light emitting device of the present disclosure may have a single-layer structure, or it may have a multilayered structure in which two or more organic material layers are stacked. For example, the organic light emitting device of the present disclosure may have a structure including a hole injection layer, a hole transport layer, a light emitting layer, an electron transport layer, or an electron injection layer as the organic material layer. However, the structure of the organic light emitting device is not limited thereto, and it may include a smaller number of organic layers.

In addition, the organic material layer may include a light emitting layer, and the light emitting layer may include the compound represented by the Chemical Formula 1. In particular, the compound according to the present disclosure can be used as a dopant in the light emitting layer.

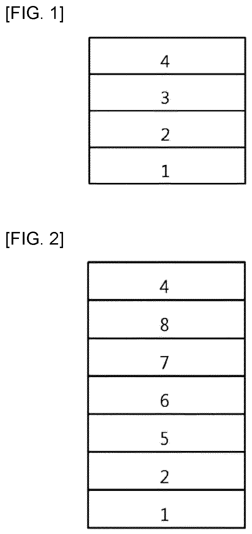

Further, the organic light emitting device according to the present disclosure may be a normal type organic light emitting device in which an anode, one or more organic material layers and a cathode are sequentially stacked on a substrate. Further, the organic light emitting device according to the present disclosure may be an inverted type organic light emitting device in which a cathode, one or more organic material layers and an anode are sequentially stacked on a substrate. For example, the structure of an organic light emitting device according to an embodiment of the present disclosure is illustrated in FIGS. 1 and 2.

FIG. 1 shows an example of an organic light emitting device including a substrate 1, an anode 2, a light emitting layer 3, and a cathode 4. In such a structure, the compound represented by the Chemical Formula 1 may be included in the light emitting layer.

FIG. 2 shows an example of an organic light emitting device including a substrate 1, an anode 2, a hole injection layer 5, a hole transport layer 6, a light emitting layer 7, an electron injection and transport layer 8, and a cathode 4. In such a structure, the compound represented by the Chemical Formula 1 may be included in the light emitting layer.

The organic light emitting device according to the present disclosure may be manufactured using materials and methods known in the art, except that at least one layer of the organic material layers includes the compound represented by the Chemical Formula 1. Moreover, when the organic light emitting device includes a plurality of organic material layers, the organic material layers may be formed of the same material or different materials.

For example, the organic light emitting device according to the present disclosure can be manufactured by sequentially stacking an anode, an organic material layer and a cathode on a substrate. In this case, the organic light emitting device may be manufactured by depositing a metal, metal oxides having conductivity, or an alloy thereof on the substrate using a PVD (physical vapor deposition) method such as a sputtering method or an e-beam evaporation method to form an anode, forming organic material layers including the hole injection layer, the hole transport layer, the light emitting layer and the electron transport layer thereon, and then depositing a material that can be used as the cathode thereon.

In addition to such a method, the organic light emitting device may be manufactured by sequentially depositing a cathode material, an organic material layer and an anode material on a substrate (International Publication WO2003/012890). However, the manufacturing method is not limited thereto.

For example, the first electrode is an anode, and the second electrode is a cathode, or alternatively, the first electrode is a cathode and the second electrode is an anode.

As the anode material, generally, a material having a large work function is preferably used so that holes can be smoothly injected into the organic material layer. Specific examples of the anode material include metals such as vanadium, chrome, copper, zinc, and gold, or an alloy thereof; metal oxides such as zinc oxides, indium oxides, indium tin oxides (ITO), and indium zinc oxides (IZO); a combination of metals and oxides, such as ZnO:Al or SnO₂:Sb; conductive compounds such as poly(3-methylthiophene), poly[3,4-(ethylene-1,2-dioxy)thiophene](PEDOT), polypyrrole, and polyaniline.

As the cathode material, generally, a material having a small work function is preferably used so that electrons can be easily injected into the organic material layer. Specific examples of the cathode material include metals such as magnesium, calcium, sodium, potassium, titanium, indium, yttrium, lithium, gadolinium, aluminum, silver, tin, and lead, or an alloy thereof; a multilayered structure material such as LiF/Al or LiO₂/Al.

The hole injection layer is a layer for injecting holes from the electrode, and the hole injection material is preferably a compound which has a capability of transporting the holes, thus has a hole injecting effect in the anode and an excellent hole-injecting effect to the light emitting layer or the light emitting material, prevents excitons produced in the light emitting layer from moving to an electron injection layer or the electron injection material, and is excellent in the ability to form a thin film. It is preferable that a HOMO (highest occupied molecular orbital) of the hole injection material is between the work function of the anode material and a HOMO of a peripheral organic material layer. Specific examples of the hole injection material include metal porphyrine, oligothiophene, an arylamine-based organic material, a hexanitrilehexaazatriphenylene-based organic material, a quinacridone-based organic material, a perylene-based organic material, anthraquinone, polyaniline and polythiophene-based conductive compound.

In addition, the hole transport layer is a layer that receives holes from a hole injection layer and transports the holes to the light emitting layer. The hole transport material is suitably a material having large mobility to the holes, which may receive holes from the anode or the hole injection layer and transfer the holes to the light emitting layer. Specific examples thereof include an arylamine-based organic material, a conductive compound, a block copolymer in which a conjugate portion and a non-conjugate portion are present together.

In addition, the light emitting layer may include a host material and a dopant material. The host material may be a fused aromatic ring derivative or a heterocycle-containing compound. Specific examples of the fused aromatic ring derivatives include anthracene derivatives, pyrene derivatives, naphthalene derivatives, pentacene derivatives, phenanthrene compounds, fluoranthene compounds. Examples of the heterocyclic-containing compounds include carbazole derivatives, dibenzofuran derivatives, ladder-type furan compounds, pyrimidine derivatives.

The dopant material includes an aromatic amine derivative, a styrylamine compound, a boron complex, a fluoranthene compound, a metal complex. Specifically, the aromatic amine derivative is a substituted or unsubstituted fused aromatic ring derivative having an arylamino group, and examples thereof include pyrene, anthracene, chrysene, and periflanthene, which have an arylamino group. The styrylamine compound is a compound where at least one arylvinyl group is substituted in substituted or unsubstituted arylamine, in which one or two or more substituent groups selected from the group consisting of an aryl group, a silyl group, an alkyl group, a cycloalkyl group, and an arylamino group are substituted or unsubstituted. Specific examples thereof include styrylamine, styryldiamine, styryltriamine, styryltetramine. Further, the metal complex includes, e.g., an iridium complex, a platinum complex.

The electron injection and transport layer is a layer that simultaneously serves as an electron transport layer and an electron injection layer by injecting electrons from an electrode and transferring the received electrons to a light emitting layer, and is formed on the light emitting layer or the electron control layer. An electron injection and transport material is suitably a material which can receive electrons well from a cathode and transfer the electrons to a light emitting layer and has large mobility for electrons. Specifically, examples thereof may include an Al complex of 8-hydroxyquinoline; a complex including Alq₃; an organic radical compound; a hydroxyflavone-metal complex; triazine derivatives. Alternatively, examples thereof may include LiF, NaF, NaCl, CsF, Li₂O, BaO, fluorenone, anthraquinodimethane, diphenoquinone, thiopyran dioxide, oxazole, oxadiazole, triazole, imidazole, perylenetetracarboxylic acid, fluorenylidene methane, and anthrone, and derivatives thereof, a metal complex compound, a nitrogen-containing 5-membered ring derivative.

Examples of the metal complex compound include 8-hydroxyquinolinato lithium, bis(8-hydroxyquinolinato)zinc, bis(8-hydroxyquinolinato)copper, bis(8-hydroxyquinolinato)manganese, tris(8-hydroxyquinolinato)aluminum, tris(2-methyl-8-hydroxyquinolinato)aluminum, tris(8-hydroxyquinolinato)gallium, bis(10-hydroxybenzo[h]quinolinato)beryllium, bis(10-hydroxybenzo[h]quinolinato)zinc, bis(2-methyl-8-quinolinato)chlorogallium, bis(2-methyl-8-quinolinato)(o-cresolato)gallium, bis(2-methyl-8-quinolinato)(1-naphtholato)aluminum, bis(2-methyl-8-quinolinato)(2-naphtholato)gallium.

In addition to the above-described materials, the light emitting layer, the hole injection layer, the hole transport layer, the electron transport layer, and the electron injection layer may further include an inorganic compound such as quantum dots or a polymer compound.

The quantum dots may be, for example, colloidal quantum dots, alloy quantum dots, core-shell quantum dots, or core quantum dots. They may be quantum dots including elements belonging to Groups 2 and 16, elements belonging to Groups 13 and 15, elements belonging to Groups 13 and 17, elements belonging to Groups 11 and 17, or elements belonging to Groups 14 and 15. Quantum dots including elements such as cadmium (Cd), selenium (Se), zinc (Zn), sulfur (S), phosphorus (P), indium (In), tellurium (Te), lead (Pb), gallium (Ga), and arsenic (As) may be used.

The organic light emitting device according to the present disclosure may be a bottom emission device, a top emission device, or a double-sided light emitting device, and in particular, may be a bottom emission device requiring relatively high luminous efficiency.

In addition, the compound according to the present disclosure may be included in an organic solar cell or an organic transistor in addition to an organic light emitting device.

The preparation of the compound represented by the Chemical Formula 1 and the organic light emitting device including the same will be described in detail in the following examples. However, these examples are presented for illustrative purposes only, and are not intended to limit the scope of the present disclosure. The scope of the present invention is defined by the appended claims.

### [Examples]

### Example 1: Preparation of Compound 1

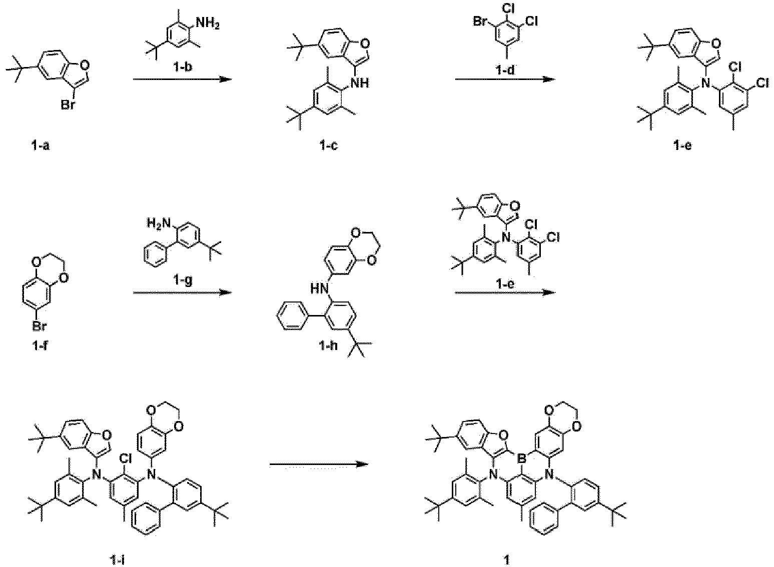

Compound 1-a (1.0 eq.), NaOt-Bu (4 eq.), and Compound 1-b (1.05 eq.) were placed in a round-bottom flask and dissolved in anhydrous toluene (0.1 M). Pd(*t*-Bu₃P)₂(5 mol%) was added dropwise at a bath temperature of 100 °C and stirred for 2 hours. After the reaction, the reactant was cooled at room temperature, diluted sufficiently in CH₂Cl₂, and washed with CH₂Cl₂/brine to separate the organic layer. Water was removed with MgSO₄, and the resultant was passed through a Celite-Florisil-Silica pad. The passed solution was concentrated under reduced pressure and purified by column chromatography to prepare Compound 1-c (76% yield).

Compound 1-d (1.0 eq.), NaOt-Bu (4 eq.), and Compound 1-c (1.05 eq.) were placed in a round-bottom flask and dissolved in anhydrous toluene (0.1 M). Pd(*t*-Bu₃P)₂(5 mol%) was added dropwise at a bath temperature of 120 °C and stirred for 4 hours. After the reaction, the reactant was cooled at room temperature, diluted sufficiently in CH₂Cl₂, and washed with CH₂Cl₂/brine to separate the organic layer. Water was removed with MgSO₄, and the resultant was passed through a Celite-Florisil-Silica pad. The passed solution was concentrated under reduced pressure and purified by column chromatography to prepare Compound 1-e (81% yield).

Compound 1-f (1.0 eq.), NaOt-Bu (4 eq.), and Compound 1-g (1.05 eq.) were placed in a round-bottom flask and dissolved in anhydrous toluene (0.1 M). Pd(*t*-Bu₃P)₂(5 mol%) was added dropwise at a bath temperature of 100 °C and stirred for 2 hours. After the reaction, the reactant was cooled at room temperature, diluted sufficiently in CH₂Cl₂, and washed with CH₂Cl₂/brine to separate the organic layer. Water was removed with MgSO₄, and the resultant was passed through a Celite-Florisil-Silica pad. The passed solution was concentrated under reduced pressure and purified by column chromatography to prepare Compound 1-h (82% yield).

Compound 1-h (1.0 eq.), NaOt-Bu (4 eq.), and Compound 1-e (1.05 eq.) were placed in a round-bottom flask and dissolved in anhydrous toluene (0.1 M). Pd(*t*-Bu₃P)₂(5 mol%) was added dropwise at a bath temperature of 120 °C and stirred overnight. After the reaction, the reactant was cooled at room temperature, diluted sufficiently in CH₂Cl₂, and washed with CH₂Cl₂/brine to separate the organic layer. Water was removed with MgSO₄, and the resultant was passed through a Celite-Florisil-Silica pad. The passed solution was concentrated under reduced pressure and purified by column chromatography to prepare Compound 1-i (73% yield).

Compound 1-i (1.0 eq.) was placed in a round-bottom flask and dissolved in anhydrous toluene (0.03 M). BI₃(2.0 eq.) was slowly added dropwise to the reactant and stirred overnight at a bath temperature of 80 °C. After the reaction, the reactant was sufficiently cooled at room temperature, and diluted in CH₂Cl₂. EtN*i*-Pr₂ (15.0 eq.) and sat.Na₂S₂O₃ (aq.) were sequentially added dropwise to the reactant, washed with CH₂Cl₂/H₂O, and the organic layer was separated. Water was removed with MgSO₄, and the resultant was passed through a Celite-Florisil-Silica pad. The passed solution was concentrated under reduced pressure and purified by column chromatography to prepare Compound 1 (78% yield).

m/z [M+H]⁺ 805.6

### Example 2: Preparation of compound 2

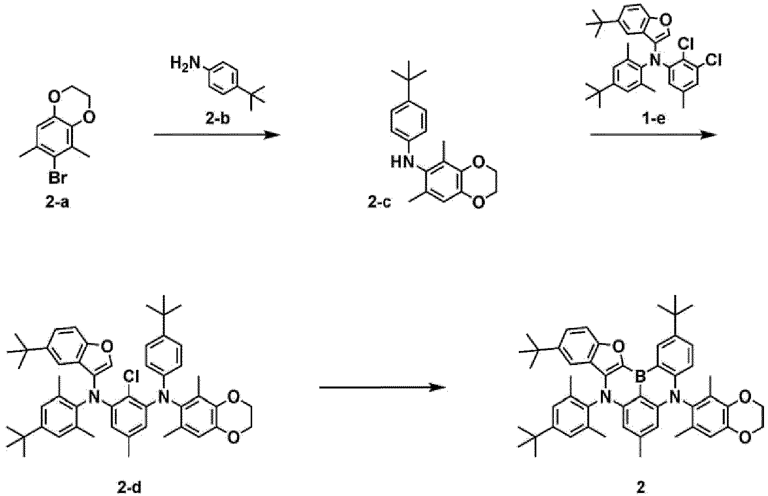

Compound 2 was prepared in the same manner as in the preparation of Compound 1, except that Compound 2-a was used instead of Compound 1-f.

m/z [M+H]⁺ 757.5

### Example 3: Preparation of compound 3

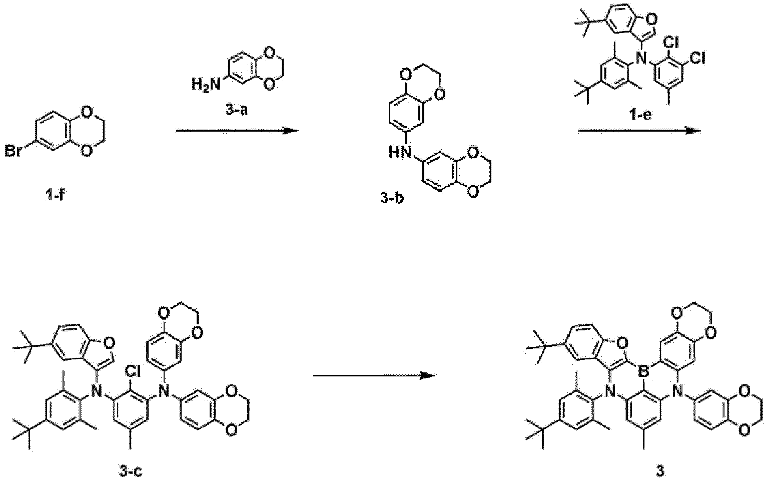

Compound 3 was prepared in the same manner as in the preparation of Compound 1, except that Compound 3-a was used instead of Compound 1-g.

m/z [M+H]⁺ 731.4

### Example 4: Preparation of compound 4

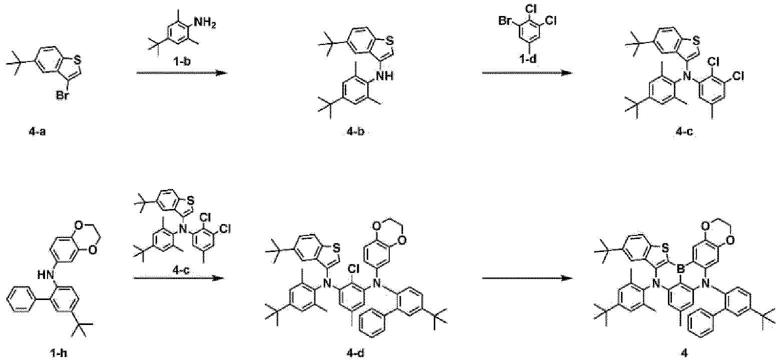

Compound 4 was prepared in the same manner as in the preparation of Compound 1, except that Compound 4-a was used instead of Compound 1-a.

m/z [M+H]⁺ 821.3

### Example 5: Preparation of compound 5

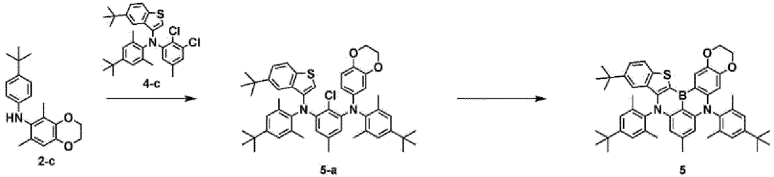

Compound 5 was prepared in the same manner as in the preparation of Compound 4, except that Compound 2-c was used instead of Compound 1-h.

m/z [M+H]⁺ 773.5

### Example 6: Preparation of compound 6

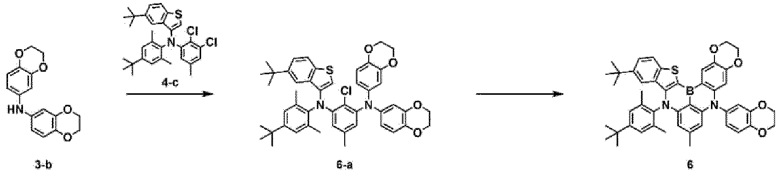

Compound 6 was prepared in the same manner as in the preparation of Compound 4, except that Compound 3-b was used instead of Compound 1-h.

m/z [M+H]⁺ 747.4

### Example 7: Preparation of compound 7

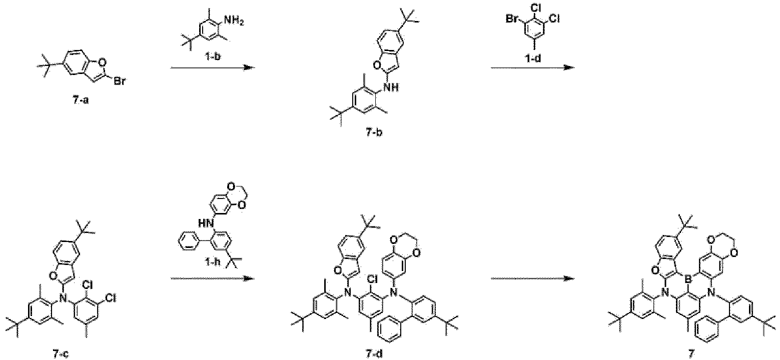

Compound 7 was prepared in the same manner as in the preparation of Compound 1, except that Compound 7-a was used instead of Compound 1-a.

m/z [M+H]⁺ 805.6

### Example 8: Preparation of compound 8

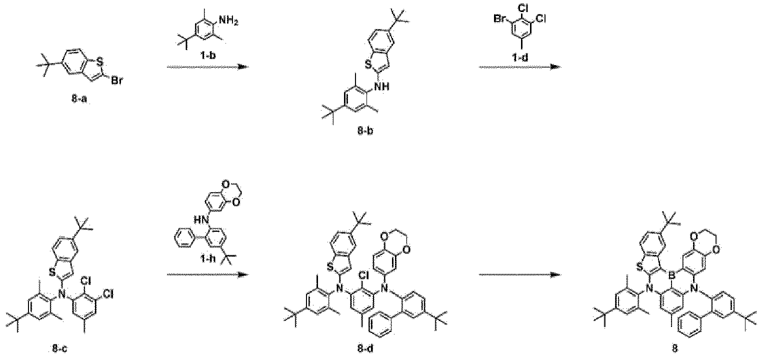

Compound 8 was prepared in the same manner as in the preparation of Compound 1, except that Compound 8-a was used instead of Compound 1-a.

m/z [M+H]⁺ 821.7

### Example 9: Preparation of compound 9

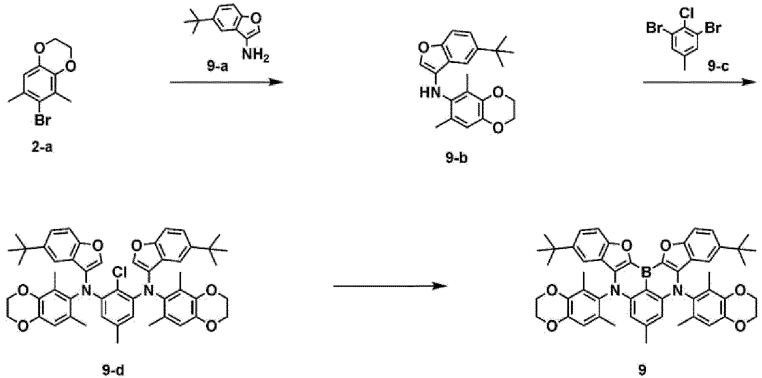

Compound 2-a (1.0 eq.), NaOt-Bu (4 eq.), and Compound 9-a (1.05 eq.) were placed in a round-bottom flask and dissolved in anhydrous toluene (0.1 M). Pd(*t*-Bu₃P)₂(5 mol%) was added dropwise at a bath temperature of 100 °C and stirred for 2 hours. After the reaction, the reactant was cooled at room temperature, diluted sufficiently in CH₂Cl₂, and washed with CH₂Cl₂/brine to separate the organic layer. Water was removed with MgSO₄, and the resultant was passed through a Celite-Florisil-Silica pad. The passed solution was concentrated under reduced pressure and purified by column chromatography to prepare Compound 9-b (87% yield).

Compound 9-c (1.0 eq.), NaOt-Bu (4 eq.), and Compound 9-b (1.05 eq.) were placed in a round-bottom flask and dissolved in anhydrous toluene (0.1 M). Pd(*t*-Bu₃P)₂(5 mol%) was added dropwise at a bath temperature of 100 °C and stirred for 2 hours. After the reaction, the reactant was cooled at room temperature, diluted sufficiently in CH₂Cl₂, and washed with CH₂Cl₂/brine to separate the organic layer. Water was removed with MgSO₄, and the resultant was passed through a Celite-Florisil-Silica pad. The passed solution was concentrated under reduced pressure and purified by column chromatography to prepare Compound 9-d (73% yield).

Compound 9-d (1.0 eq.) was placed in a round-bottom flask and dissolved in anhydrous toluene (0.03 M). BI₃ (2.0 eq.) was slowly added dropwise to the reactant and stirred overnight at a bath temperature of 80 °C. After the reaction, the reactant was sufficiently cooled at room temperature, and diluted in CH₂Cl₂. EtN*i*-Pr₂ (15.0 eq.) and sat.Na₂S₂O₃ (aq.) were sequentially added dropwise to the reactant, washed with CH₂Cl₂/H₂O, and the organic layer was separated. Water was removed with MgSO₄, and the resultant was passed through a Celite-Florisil-Silica pad. The passed solution was concentrated under reduced pressure and purified by column chromatography to prepare Compound 9 (76% yield).

m/z [M+H]⁺ 799.5

### Example 10: Preparation of compound 10

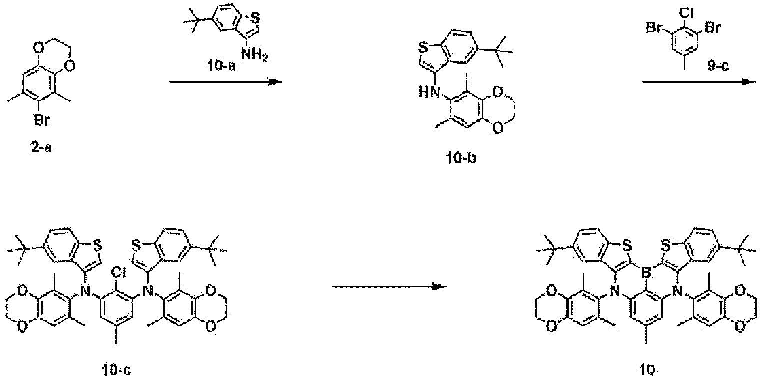

Compound 10 was prepared in the same manner as in the preparation of Compound 9, except that Compound 10-a was used instead of Compound 9-a.

m/z [M+H]⁺ 831.5

### Example 11: Preparation of compound 11

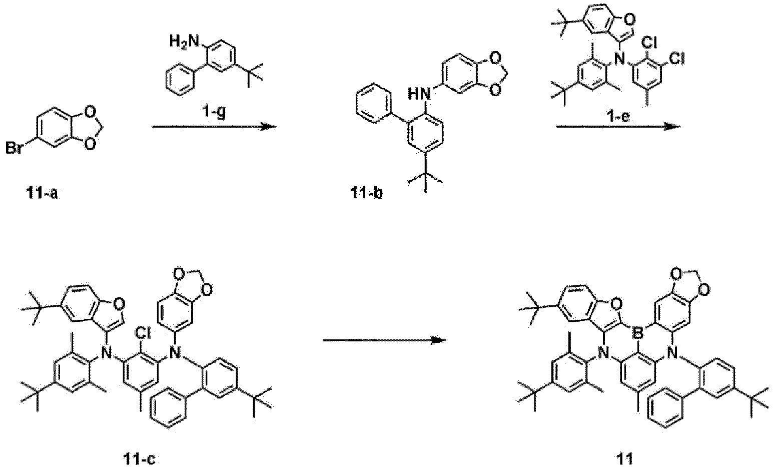

Compound 11 was prepared in the same manner as in the preparation of Compound 1, except that Compound 11-a was used instead of Compound 1-f.

m/z [M+H]⁺ 791.5

### Example 12: Preparation of compound 12

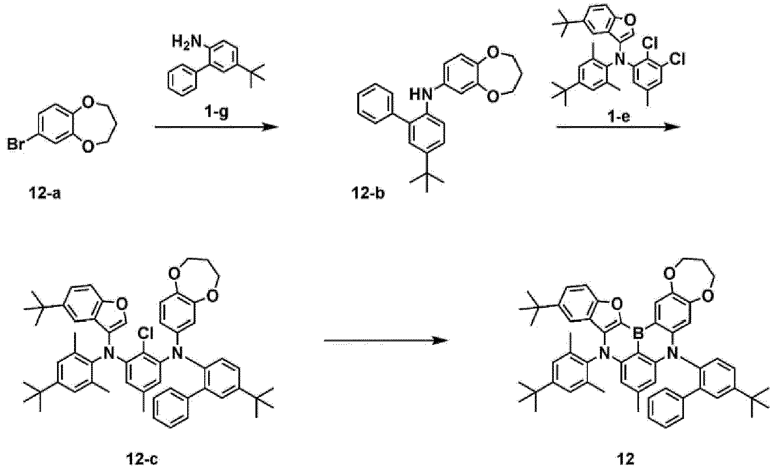

Compound 12 was prepared in the same manner as in the preparation of Compound 1, except that Compound 12-a was used instead of Compound 1-f.

m/z [M+H]⁺ 819.6

### Example 13: Preparation of compound 13

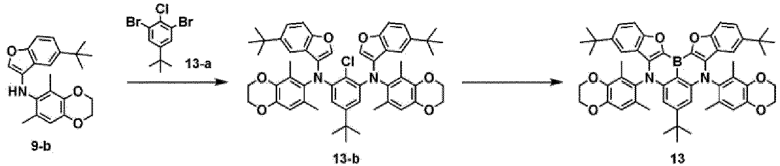

Compound 13 was prepared in the same manner as in the preparation of Compound 9, except that Compound 13-a was used instead of Compound 9-c.

m/z [M+H]⁺ 841.5

### [Comparative Examples]

### Comparative Example 1: Preparation of comparative compound F

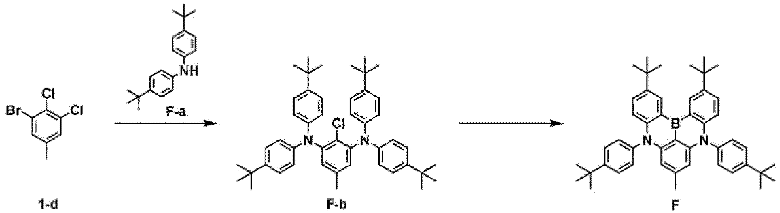

Compound 1-d (1.0 eq.), NaOt-Bu (4 eq.), and Compound F-a (2.05 eq.) were placed in a round-bottom flask and dissolved in anhydrous toluene (0.1 M). Pd(*t*-Bu₃P)₂(5 mol%) was added dropwise at a bath temperature of 120 °C and stirred overnight. After the reaction, the reactant was cooled at room temperature, diluted sufficiently in CH₂Cl₂, and washed with CH₂Cl₂/brine to separate the organic layer. Water was removed with MgSO₄, and the resultant was passed through a Celite-Florisil-Silica pad. The passed solution was concentrated under reduced pressure and purified by column chromatography to prepare Compound F-b (75% yield).

Compound F-b (1.0 eq.) was placed in a round-bottom flask and dissolved in anhydrous toluene (0.03 M). BI₃ (2.0 eq.) was slowly added dropwise to the reactant and stirred overnight at a bath temperature of 80 °C. After the reaction, the reactant was sufficiently cooled at room temperature, and diluted in CH₂Cl₂. EtN*i*-Pr₂ (15.0 eq.) and sat.Na₂S₂O₃ (aq.) were sequentially added dropwise to the reactant, washed with CH₂Cl₂/H₂O, and the organic layer was separated. Water was removed with MgSO₄, and the resultant was passed through a Celite-Florisil-Silica pad. The passed solution was concentrated under reduced pressure and purified by column chromatography to prepare Compound F (87% yield).

m/z [M+H]⁺= 659.6

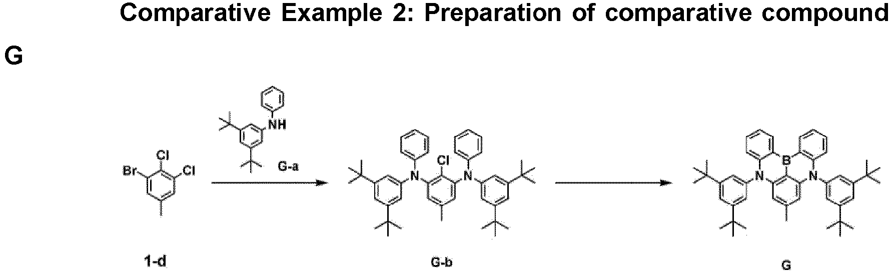

Compound G was prepared in the same manner as in the preparation of Comparative Example 1, except that Compound G-a was used instead of Compound F-a.

m/z [M+H]⁺= 659.5

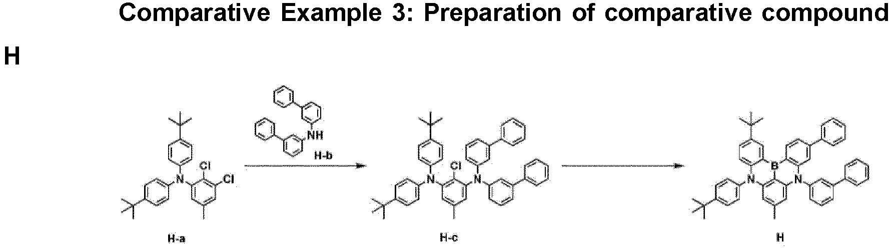

Compound H-a (1.0 eq.), NaOt-Bu (4.0 eq.), and Compound H-b (1.05 eq.) were placed in a round-bottom flask and dissolved in anhydrous toluene (0.1 M). Pd(*t*-Bu₃P)₂(5 mol%) was added dropwise at a bath temperature of 120 °C and stirred overnight. After the reaction, the reactant was cooled at room temperature, diluted sufficiently in CH₂Cl₂, and washed with CH₂Cl₂/brine to separate the organic layer. Water was removed with MgSO₄, and the resultant was passed through a Celite-Florisil-Silica pad. The passed solution was concentrated under reduced pressure and purified by column chromatography to prepare Compound H-c (79% yield).

Compound H-c (1.0 eq.) was placed in a round-bottom flask and dissolved in anhydrous toluene (0.03 M). BI₃ (2.0 eq.) was slowly added dropwise to the reactant and stirred overnight at a bath temperature of 80 °C. After the reaction, the reactant was sufficiently cooled at room temperature, and diluted in CH₂Cl₂. EtN*i*-Pr₂ (15.0 eq.) and sat.Na₂S₂O₃ (aq.) were sequentially added dropwise to the reactant, washed with CH₂Cl₂/H₂O, and the organic layer was separated. Water was removed with MgSO₄, and the resultant was passed through a Celite-Florisil-Silica pad. The passed solution was concentrated under reduced pressure and purified by column chromatography to prepare Compound H (73% yield).

m/z [M+H]⁺= 725.5

### [Experimental Examples]

### Experimental Example 1

A glass substrate on which ITO (Indium Tin Oxide) was coated as a thin film to a thickness of 500 Å was put into distilled water in which a detergent was dissolved, and ultrasonically cleaned. At this time, a product manufactured by Fischer Co. was used as the detergent, and distilled water filtered twice using a filter manufactured by Millipore Co. was used as the distilled water. After the ITO was cleaned for 30 minutes, ultrasonic cleaning was repeated twice using distilled water for 10 minutes. After the cleaning with distilled water was completed, the substrate was ultrasonically cleaned with solvents of isopropyl and acetone, and dried. Thereafter, the substrate was cleaned for 5 minutes, and transferred to a glove box.

A coating composition in which the following Compound O and Compound P (weight ratio: 2:8) were dissolved in cyclohexanone at 20 wt/v% was spin-coated (4000 rpm) on the ITO transparent electrode, and heat-treated (cured) at 200 °C for 30 minutes to prepare a hole injection layer having a thickness of 400 Å. A coating composition in which the following Compound Q (Mn: 27,900; Mw: 35,600; measured by GPC with PC Standard using Agilent 1200 series) was dissolved in toluene at 6 wt/v% was spin-coated (4000 rpm) on the hole injection layer, and heat-treated at 200 °C for 30 minutes to form a hole transport layer having a thickness of 200 Å. A coating composition in which the Compound 1 and the following Compound R (weight ratio: 2:98) were dissolved in cyclohexanone at 2 wt/v% was spin-coated (4000 rpm) on the hole transport layer, and heat-treated at 180 °C for 30 minutes to form a light emitting layer having a thickness of 400 Å.

After transferring to a vacuum evaporator, the following Compound S was vacuum-deposited to a thickness of 350 Å on the light emitting layer to form an electron injection and transport layer. On the electron injection and transport layer, LiF and aluminum were sequentially deposited to a thickness of 10 Å and 1,000 Å, respectively to form a cathode.

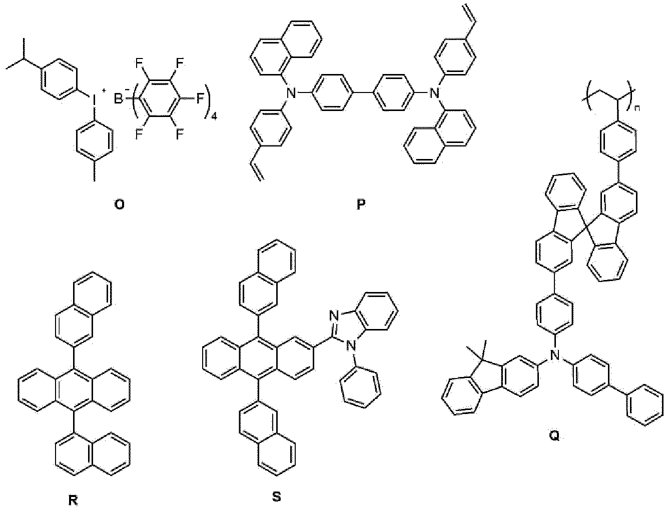

In the above process, the deposition rate of the organic material was maintained at 0.4 to 0.7 Å/sec, the deposition rate of LiF was maintained at 0.3 Å/sec, and the deposition rate of aluminum was maintained at 2 Å /sec. In addition, the degree of vacuum during the deposition was maintained at 0.0000266644 Pa to 0.0000066661 Pa (2*10⁻⁷ to 5*10⁻⁸ torr).

### Experimental Examples 2 to 12

An organic light emitting device was manufactured in the same manner as in Experimental Example 1, except that the compound shown in Table 1 was used instead of Compound 1 as the dopant of the light emitting layer.

### Comparative Experimental Examples 1 to 3

An organic light emitting device was manufactured in the same manner as in Experimental Example 1, except that the compound shown in Table 1 was used instead of Compound 1 as the dopant of the light emitting layer.

For the organic light emitting devices prepared in Experimental Examples and Comparative Experimental Examples, the driving voltage, external quantum efficiency (EQE) and lifespan were measured at a current density of 10 mA/cm², and the results are shown in Table 1 below. At this time, the external quantum efficiency (EQE) was calculated as "(the number of emitted photons)/(the number of injected charge carriers)*100", and T90 means the time taken until the initial luminance (500 cd/m² (500 nit)) decreases to 90%.

**[Table 1]**

| | Dopant in light emitting layer | Driving voltage (V@10mA/cm²) | EQE (%@10mA/cm²) | Lifespan (hr) (T90@500 cd/m² (500 nit)) |
|---|---|---|---|---|
| Experimental Example 1 | Compound 1 | 4.66 | 6.13 | 204 |
| Experimental Example 2 | Compound 2 | 4.81 | 6.17 | 203 |
| Experimental Example 3 | Compound 3 | 4.82 | 6.15 | 213 |
| Experimental Example 4 | Compound 4 | 4.79 | 6.12 | 199 |
| Experimental Example 5 | Compound 5 | 4.70 | 6.02 | 204 |
| Experimental Example 6 | Compound 6 | 4.72 | 6.08 | 203 |
| Experimental Example 7 | Compound 7 | 4.69 | 6.17 | 199 |
| Experimental Example 8 | Compound 8 | 4.66 | 6.21 | 202 |
| Experimental Example 9 | Compound 9 | 4.62 | 5.99 | 208 |
| Experimental Example 10 | Compound 10 | 4.71 | 6.02 | 206 |
| Experimental Example 11 | Compound 11 | 4.69 | 6.05 | 204 |
| Experimental Example 12 | Compound 12 | 4.68 | 6.08 | 187 |
| Experimental Example 13 | Compound 13 | 4.80 | 6.03 | 212 |
| Comparative Experimental Example 1 | Compound F | 4.69 | 4.39 | 105 |
| Comparative Experimental Example 2 | Compound G | 4.68 | 4.23 | 99 |
| Comparative Experimental Example 3 | Compound H | 4.62 | 3.98 | 83 |

As shown in Table 1, the organic light emitting device including the compound of the present disclosure in the light emitting layer exhibited excellent efficiency, driving voltage, and lifespan.

### [DESCRIPTION OF SYMBOLS]

| | | | |
|---|---|---|---|
| 1: | Substrate | 2: | Anode |
| 3: | Light emitting layer | 4: | Cathode |
| 5: | Hole injection layer | 6: | Hole transport layer |
| 7: | Light emitting layer | 8: | Electron injection and transport layer |

## Claims

1. A compound represented by the following Chemical Formula 1: 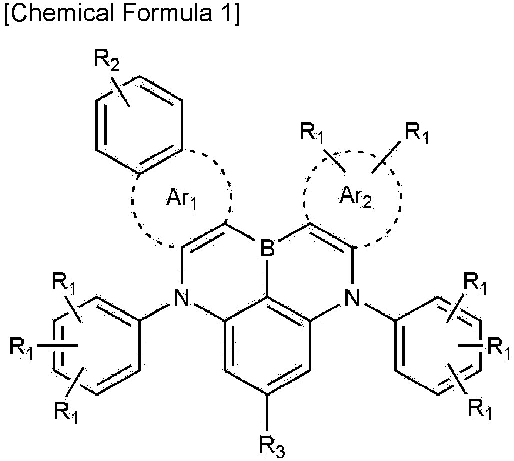 in Chemical Formula 1,
Ar₁ is furan, or thiophene, which is fused with two adjacent rings,
Ar₂ is benzene, benzofuran, or benzothiophene, which is fused with an adjacent ring,
each R₁ is independently hydrogen, deuterium, a substituted or unsubstituted C₁₋₆₀ alkyl, or a substituted or unsubstituted C₆₋₆₀ aryl, or two adjacent R₁s are combined to form -O-(CH₂)ₘ-O-, wherein m is an integer of 1 to 4;
R₂ is hydrogen, deuterium, or a substituted or unsubstituted C₁₋₆₀ alkyl, and
R₃ is hydrogen, deuterium, or a substituted or unsubstituted C₁₋₆₀ alkyl,
provided that the Chemical Formula 1 comprises at least one -O-(CH₂)ₘ-O-formed by combining two adjacent R₁s.

2. The compound of Claim 1,
wherein the Chemical Formula 1 is represented by any one of the following Chemical Formulae 1-1 to 1-4: 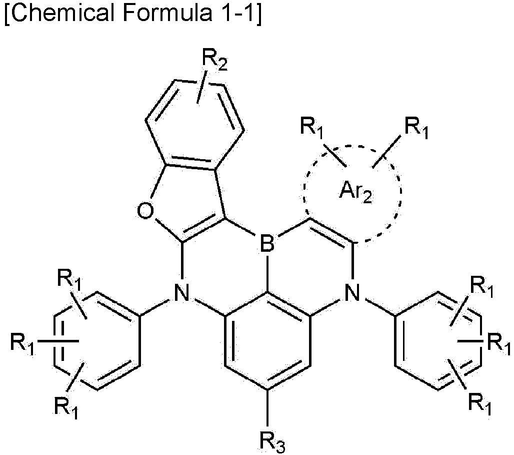 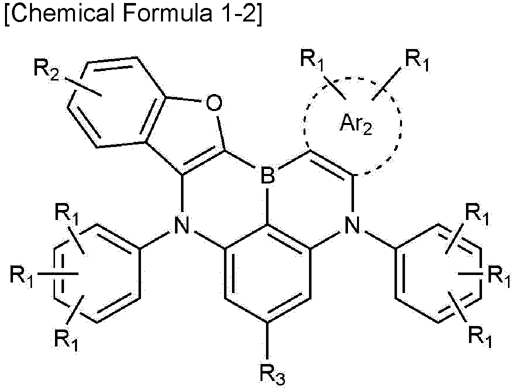 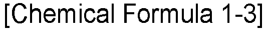 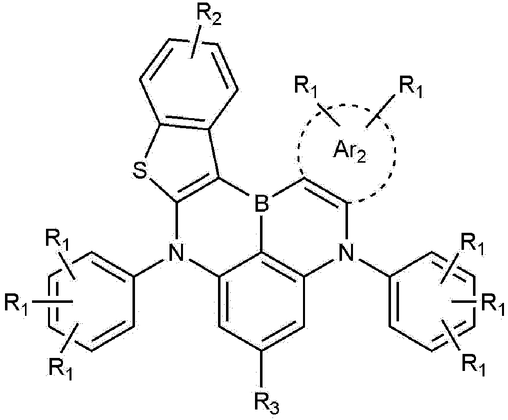 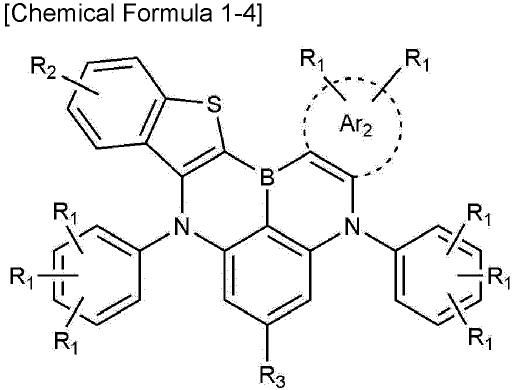
in the Chemical Formulae 1-1 to 1-4,
Ar₂ and R₁ to R₃ are as defined in Claim 1.

3. The compound of Claim 1,
wherein each R₁ is independently hydrogen, deuterium, C₁₋₁₀ alkyl, or C₆₋₂₀ aryl, or two adjacent R₁s are combined to form 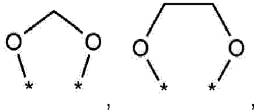 or

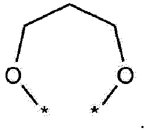

4. The compound of Claim 1,
wherein each R₁ is independently hydrogen, deuterium, methyl, ethyl, propyl, isopropyl, butyl, isobutyl, tertbutyl, or phenyl, or two adjacent R₁s are combined to form

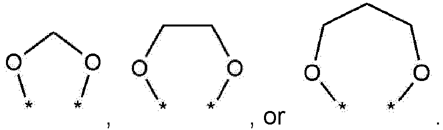

5. The compound of Claim 1,
wherein R₂ is hydrogen, deuterium, or C₁₋₁₀ alkyl.

6. The compound of Claim 1,
wherein R₂ is hydrogen, deuterium, methyl, ethyl, propyl, isopropyl, butyl, isobutyl, or tertbutyl.

7. The compound of Claim 1,
wherein R₃ is hydrogen, deuterium, or C₁₋₁₀ alkyl.

8. The compound of Claim 1,
wherein R₃ is hydrogen, deuterium, methyl, ethyl, propyl, isopropyl, butyl, isobutyl, or tertbutyl.

9. The compound of Claim 1,
wherein the compound represented by the Chemical Formula 1 is any one selected from the group consisting of:

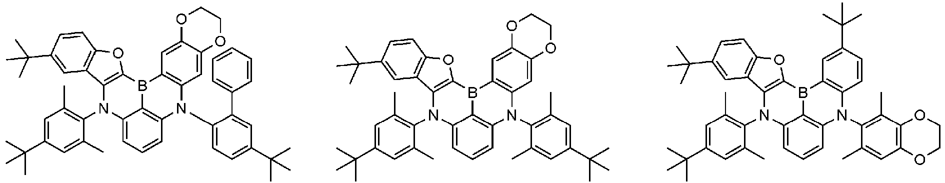

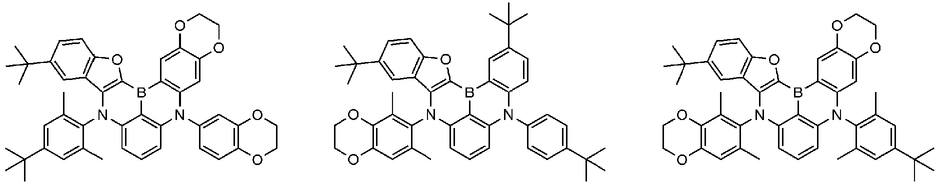

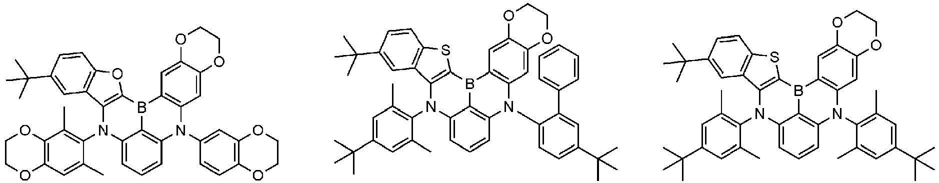

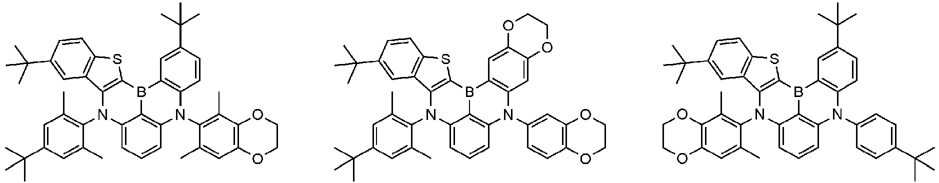

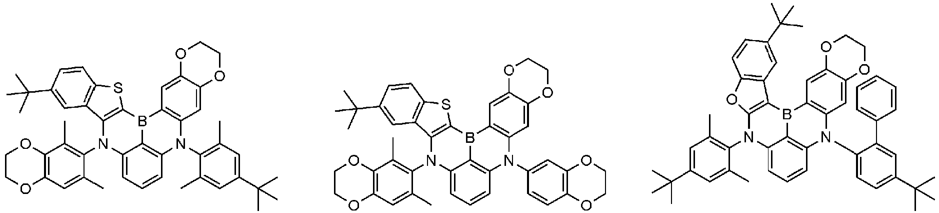

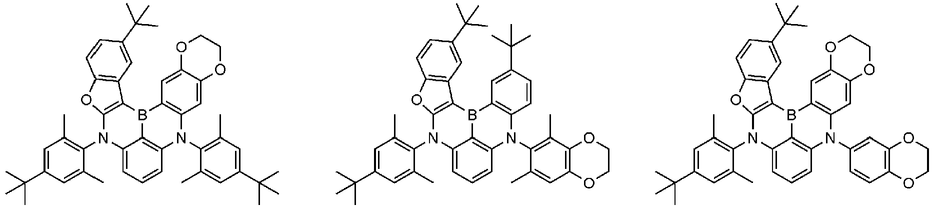

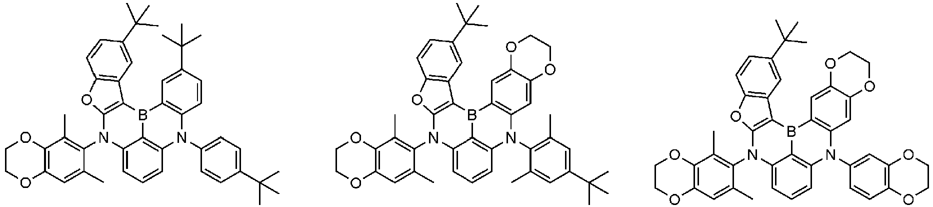

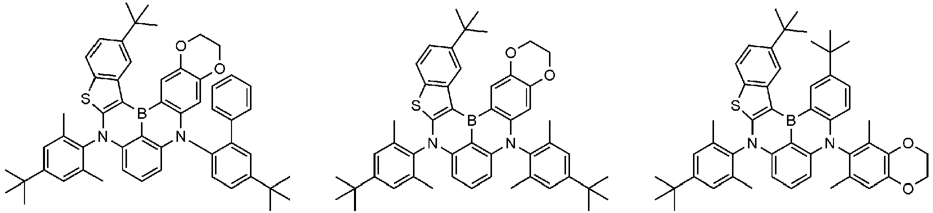

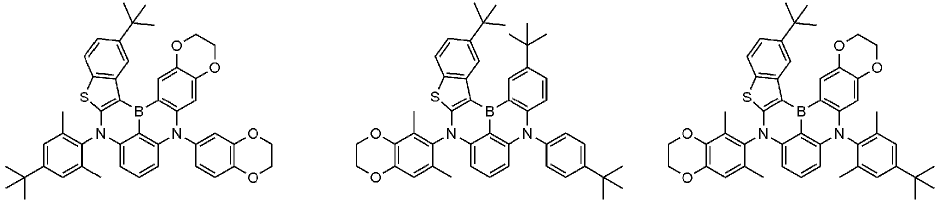

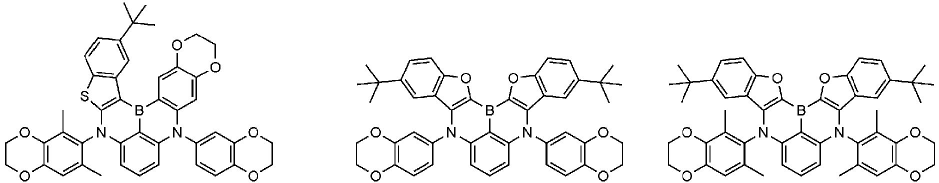

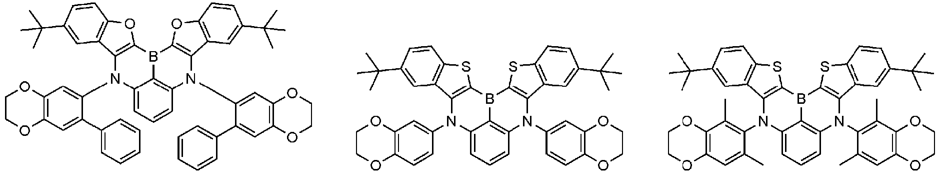

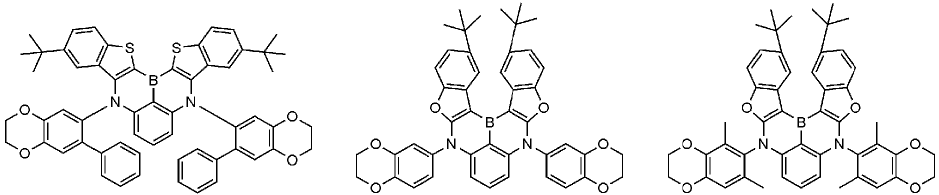

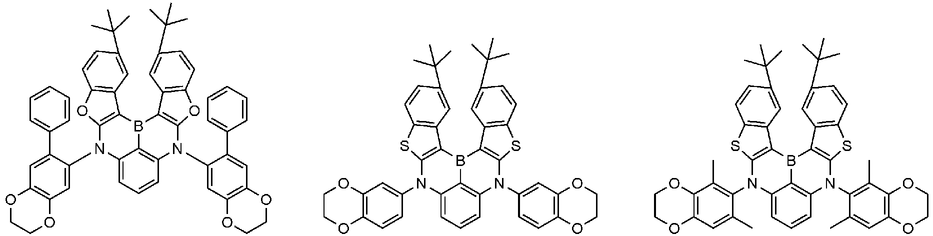

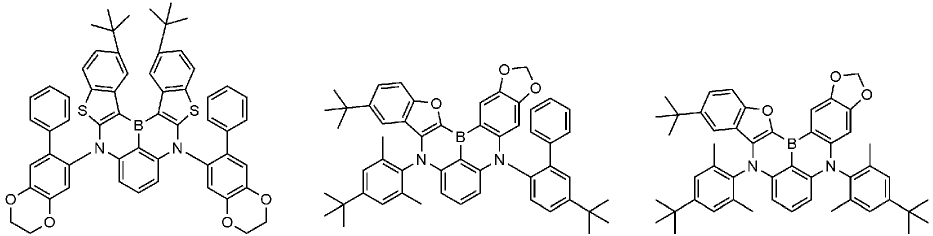

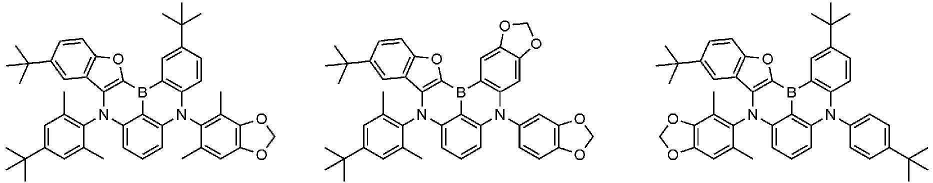

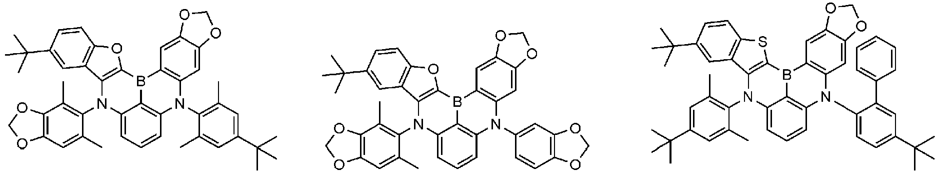

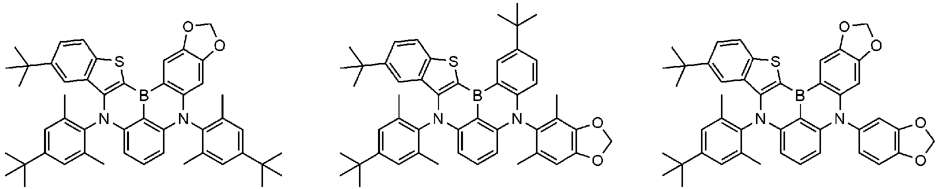

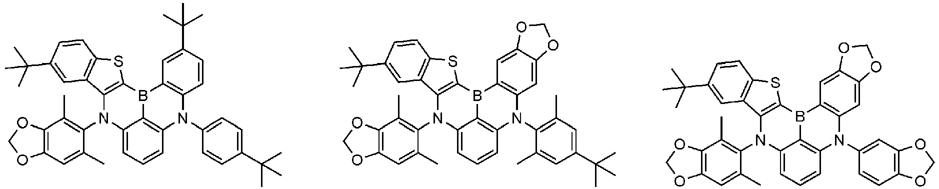

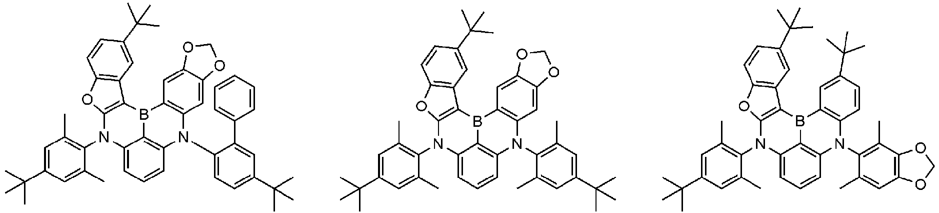

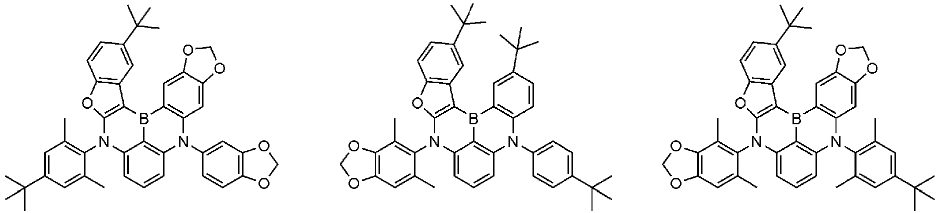

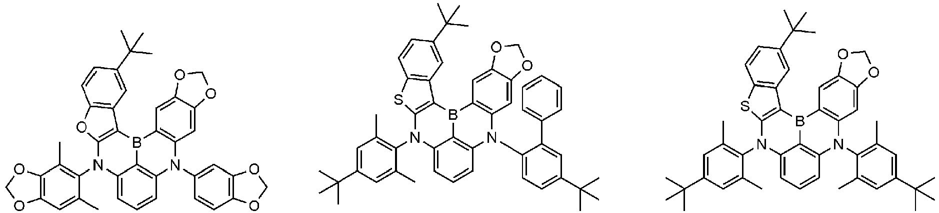

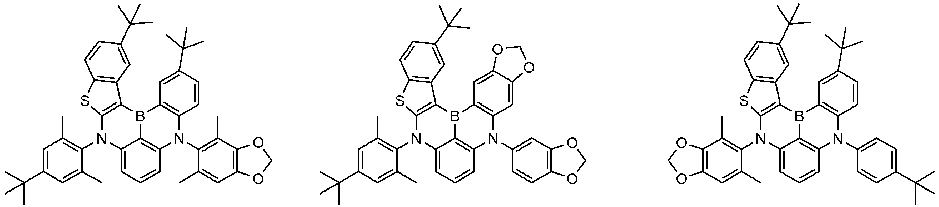

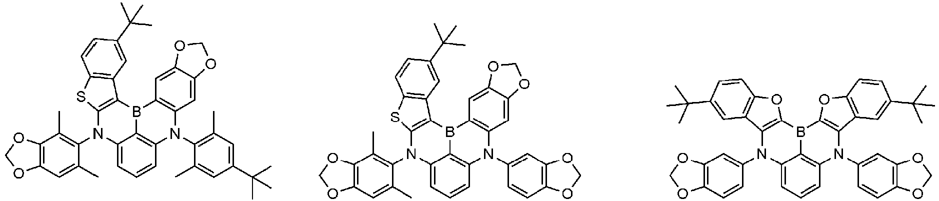

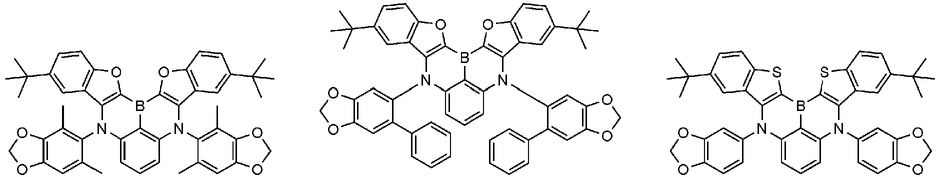

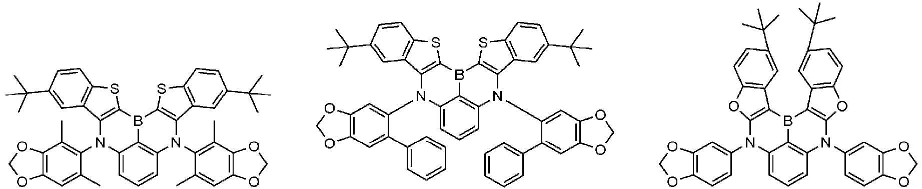

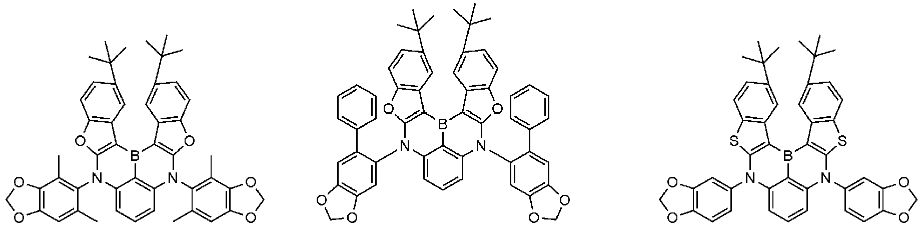

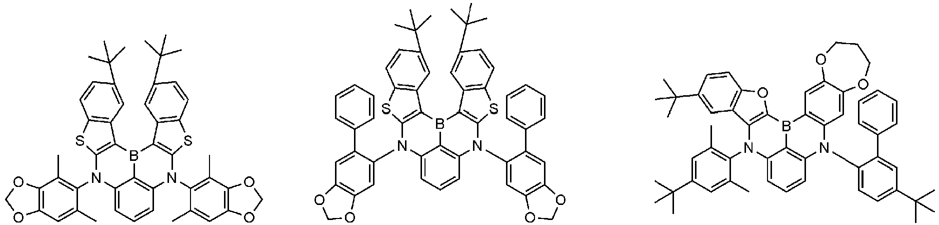

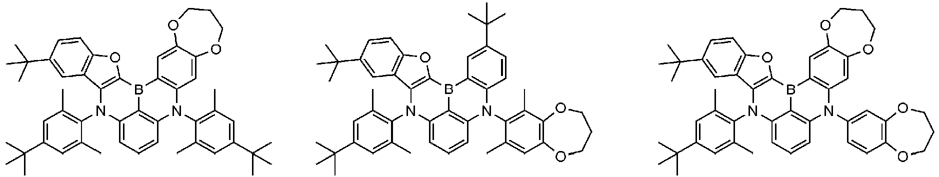

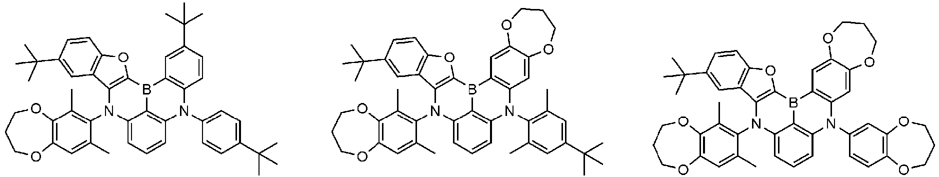

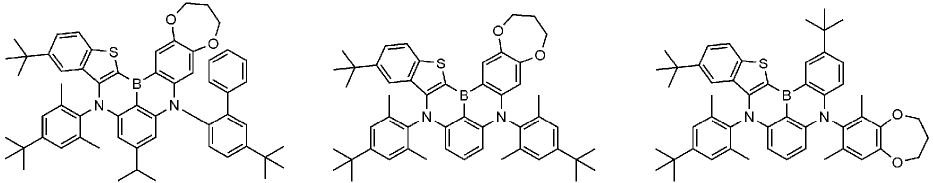

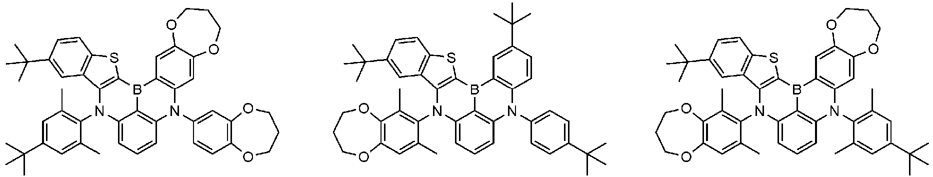

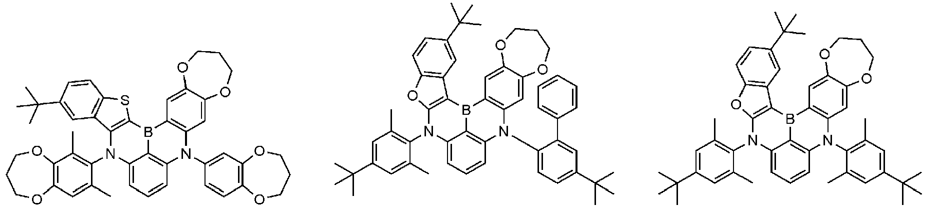

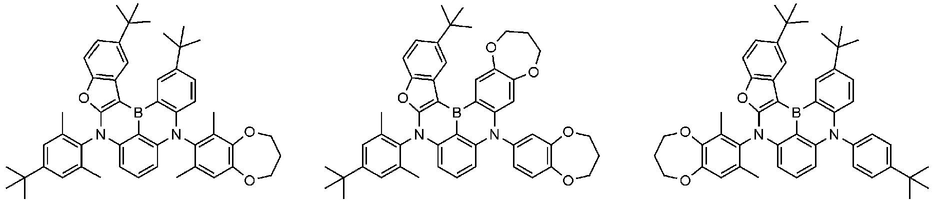

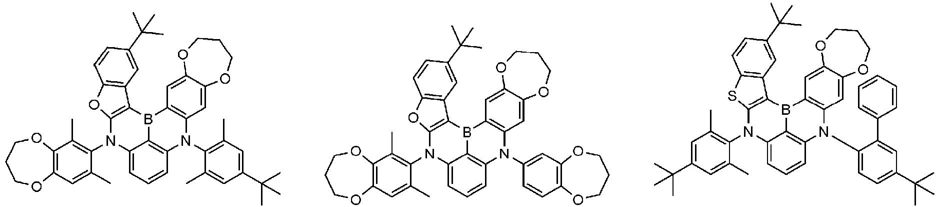

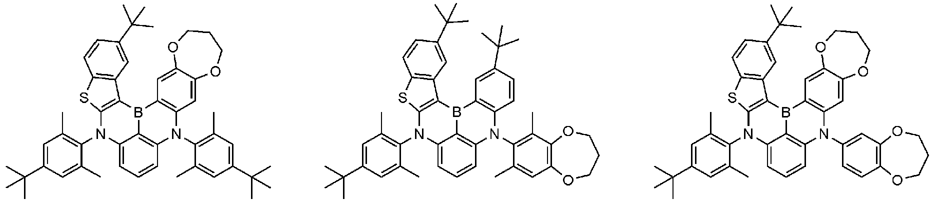

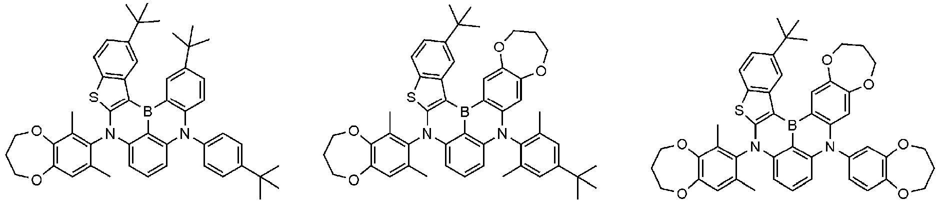

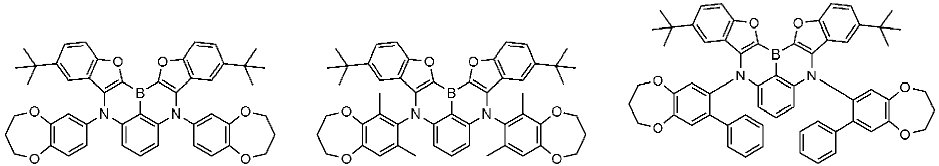

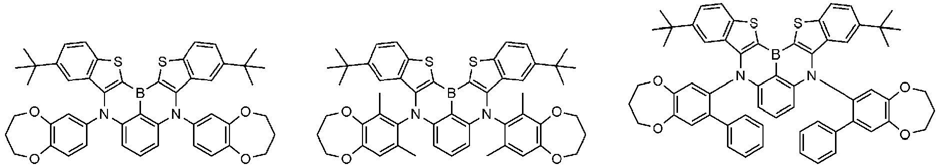

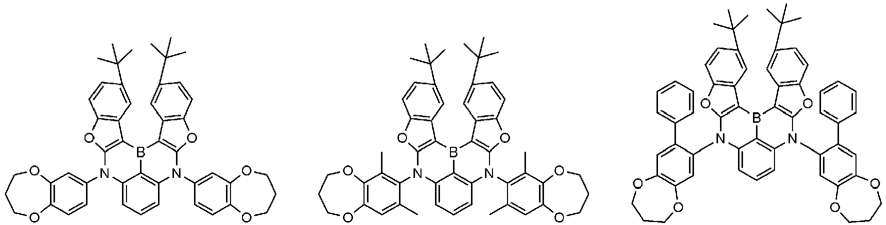

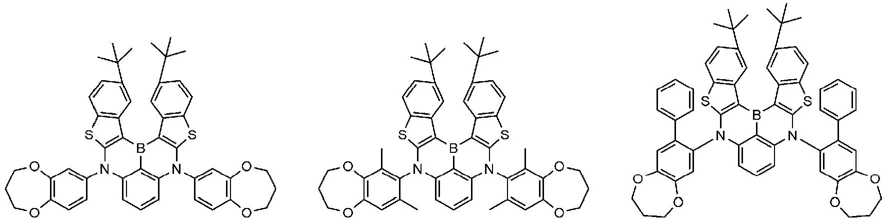

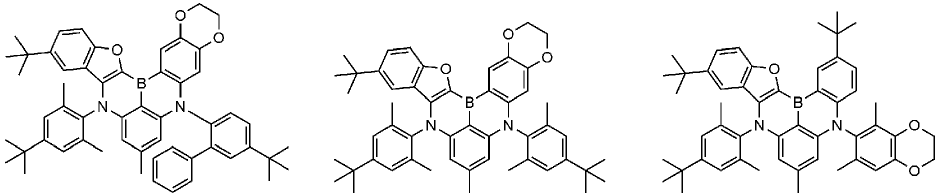

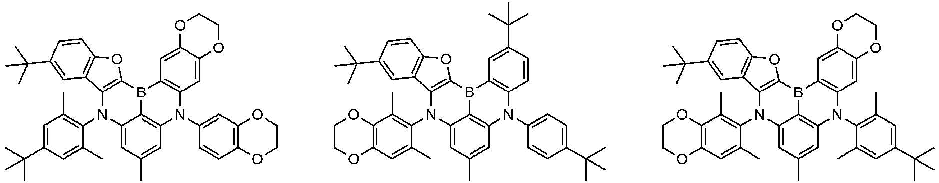

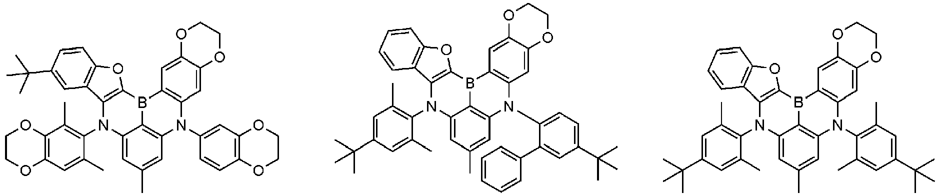

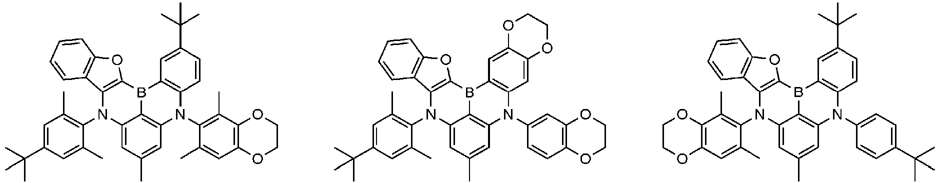

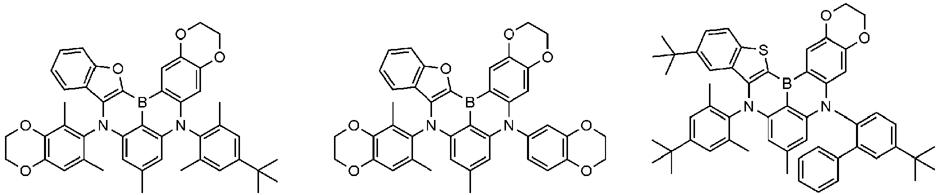

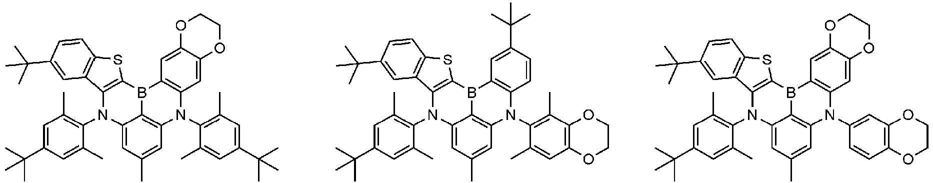

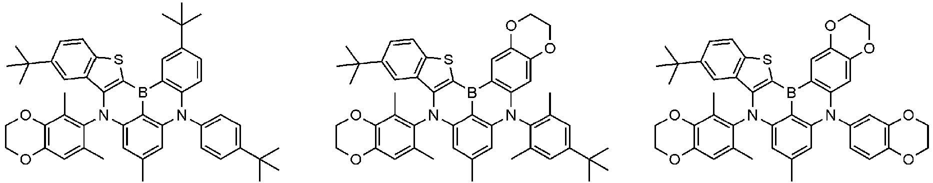

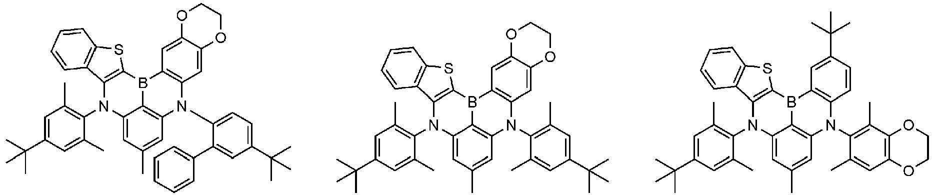

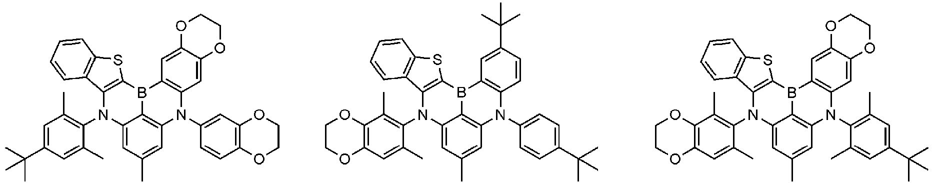

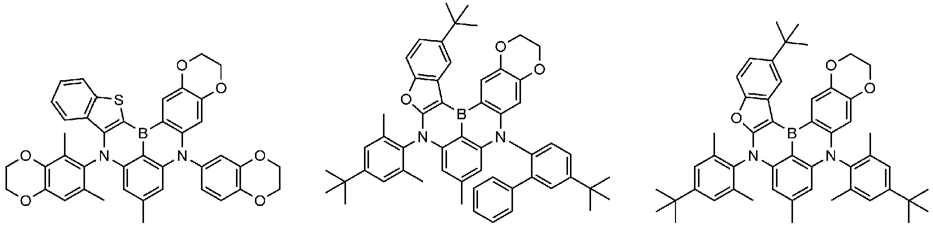

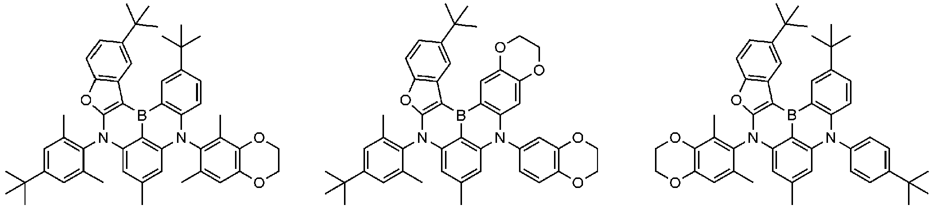

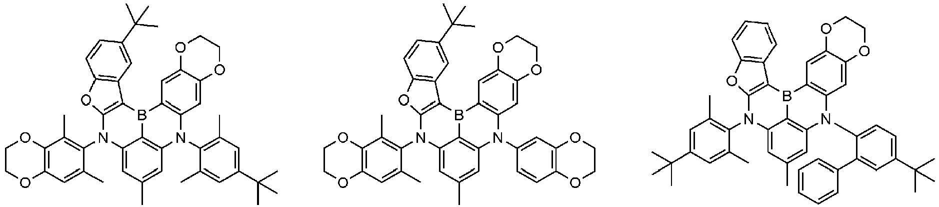

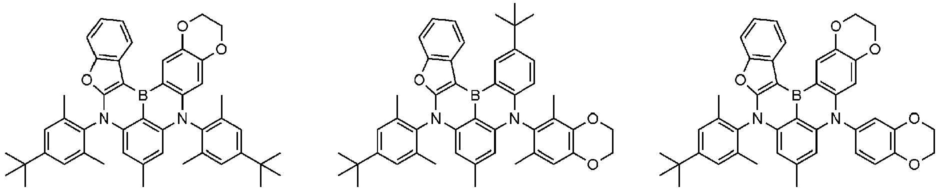

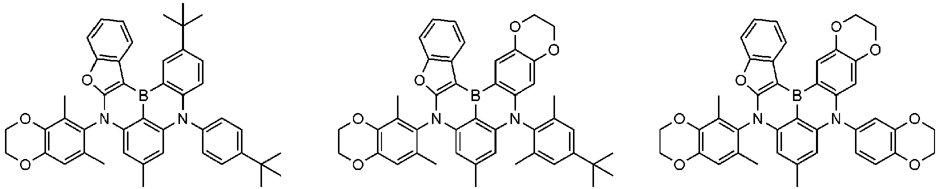

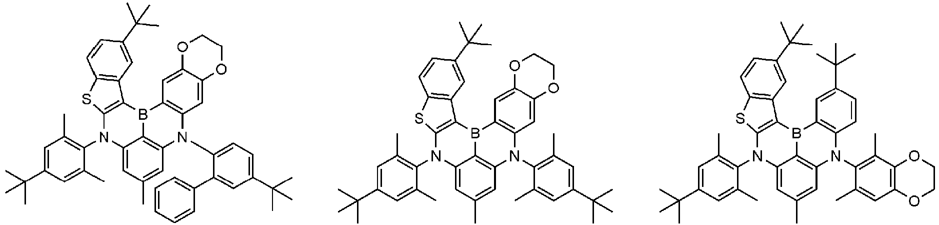

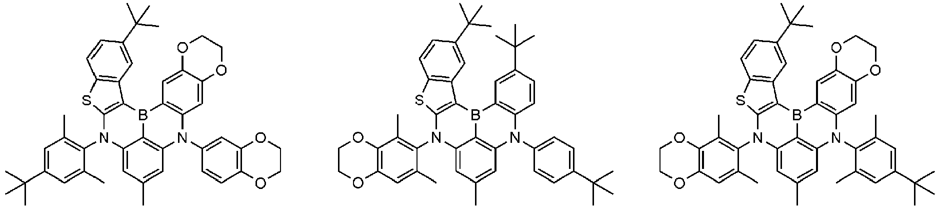

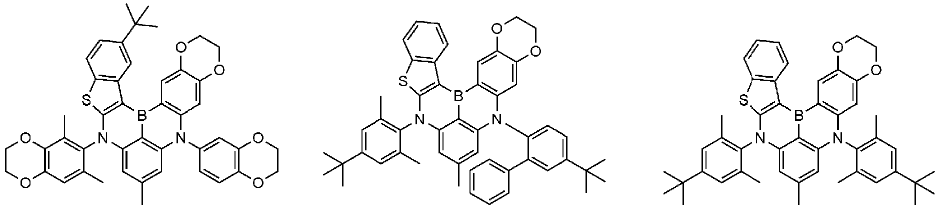

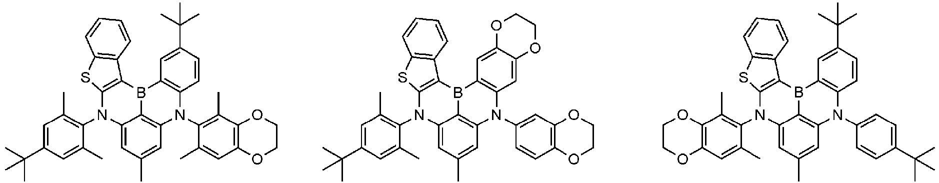

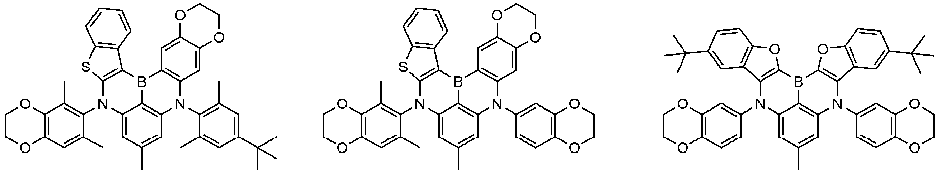

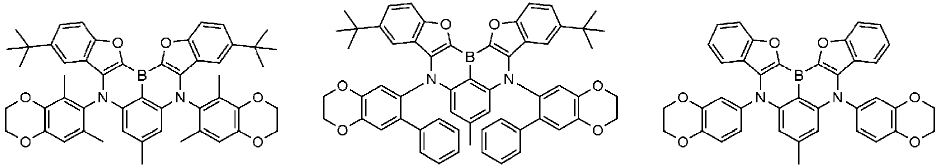

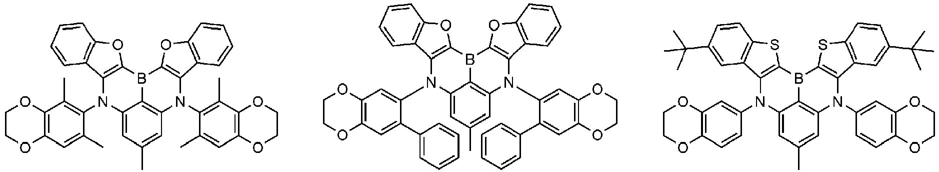

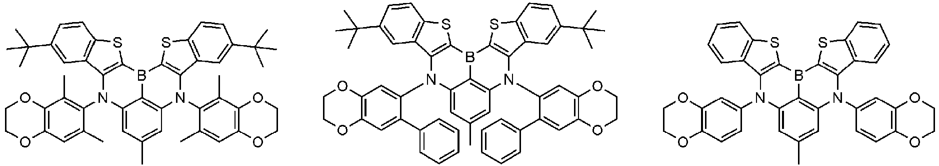

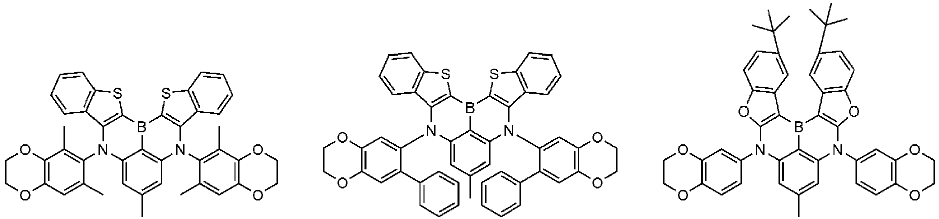

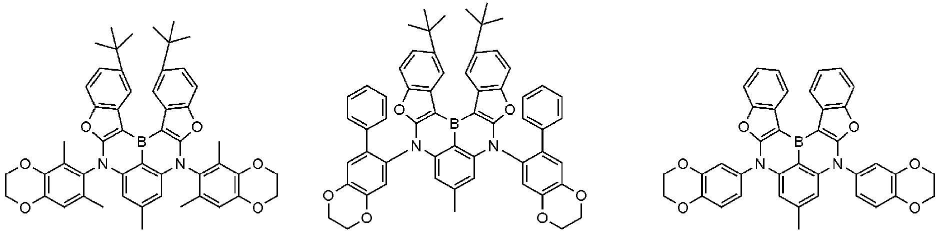

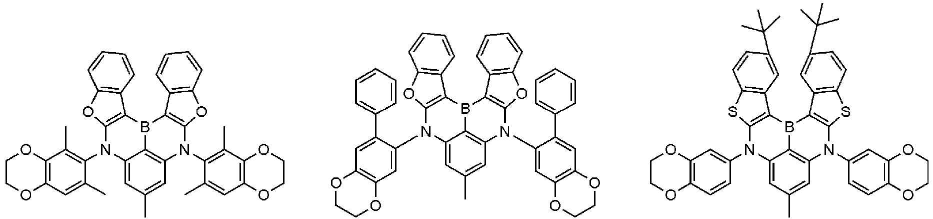

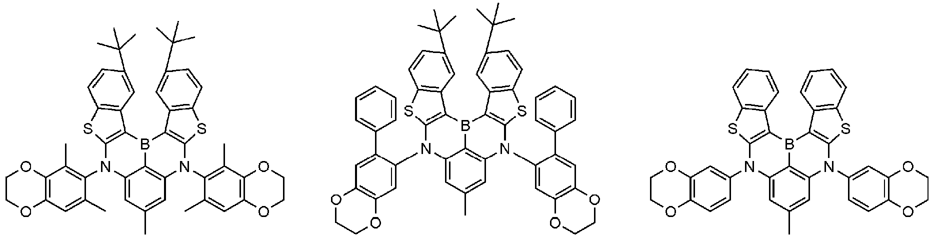

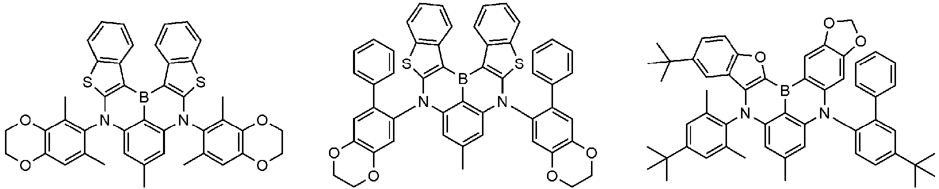

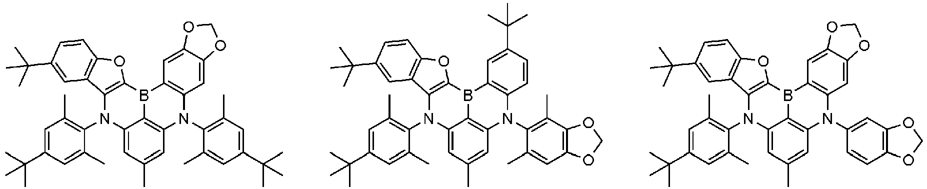

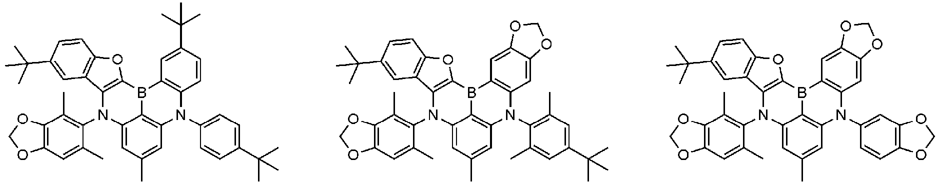

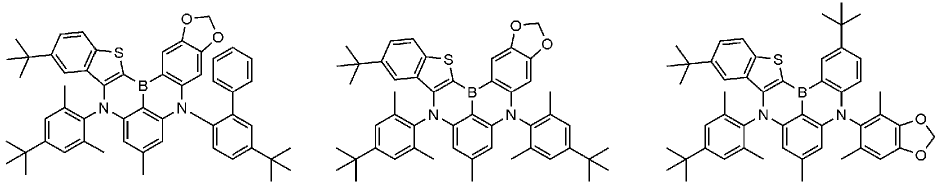

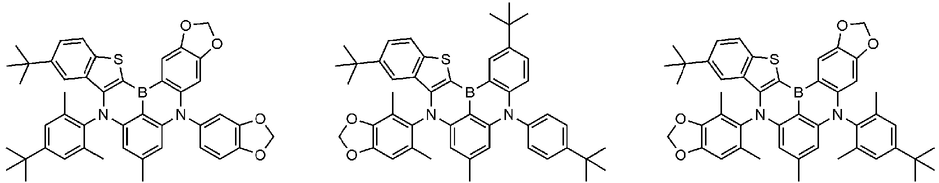

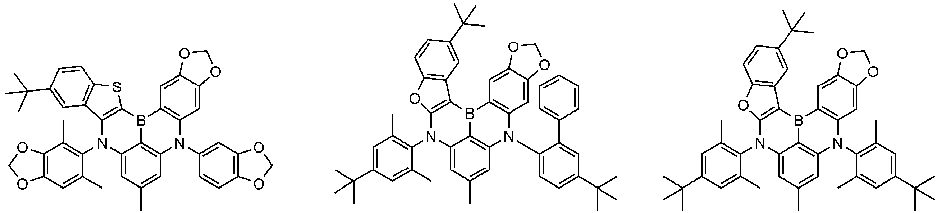

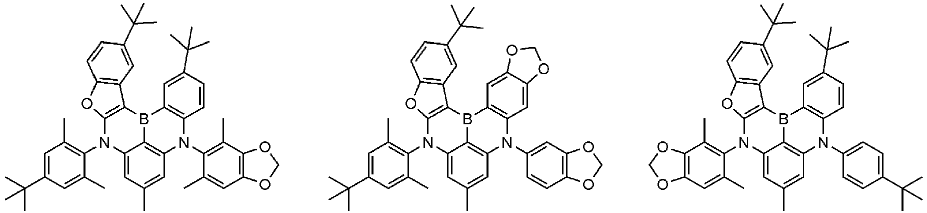

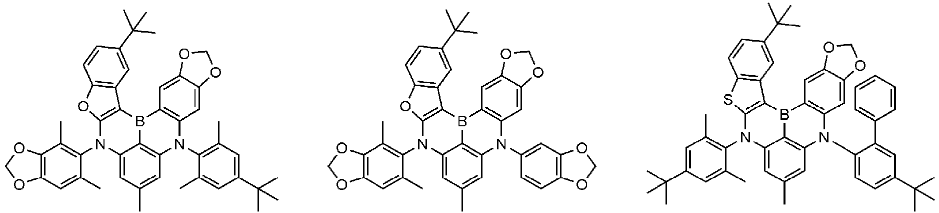

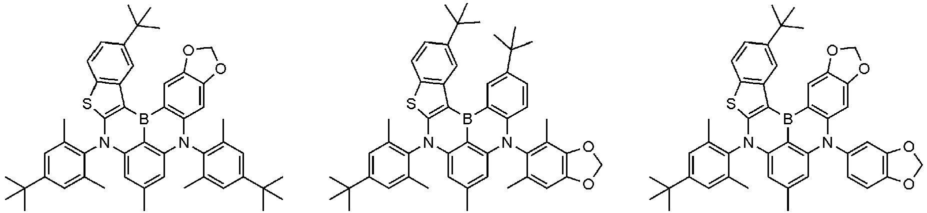

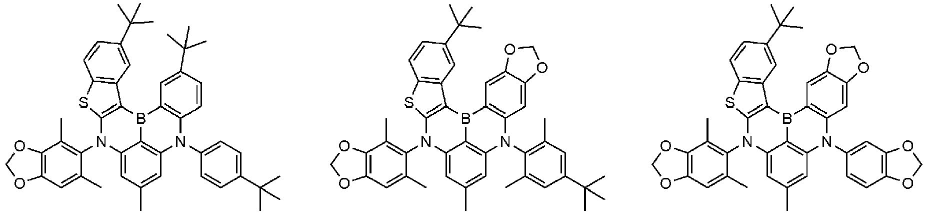

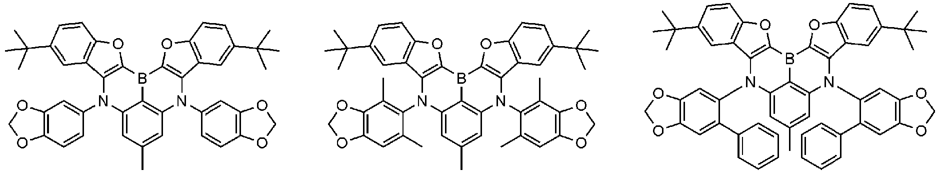

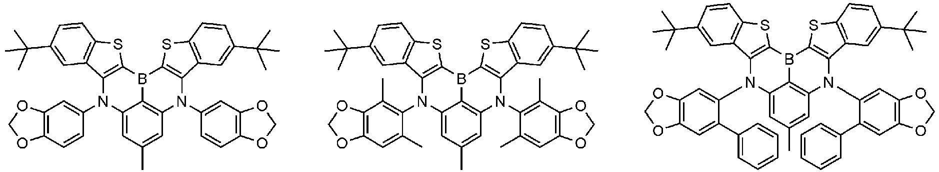

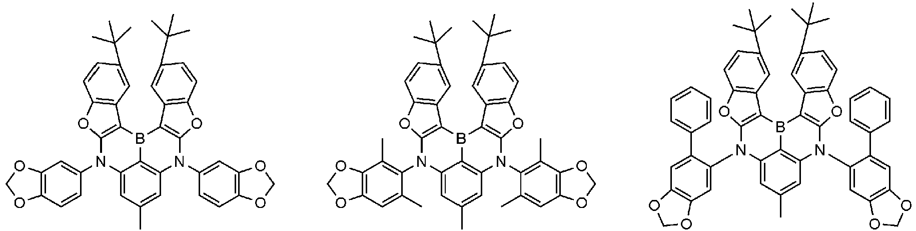

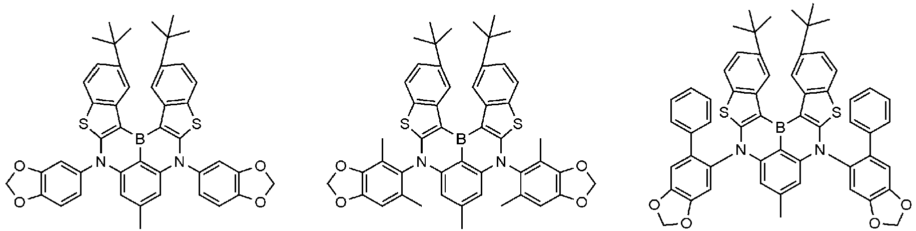

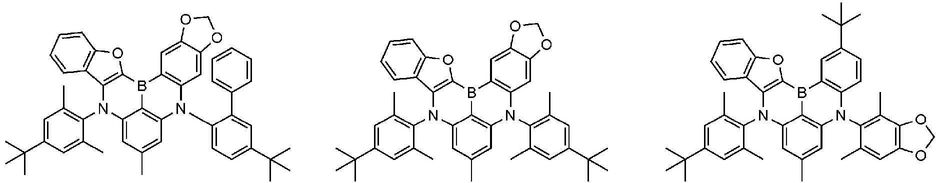

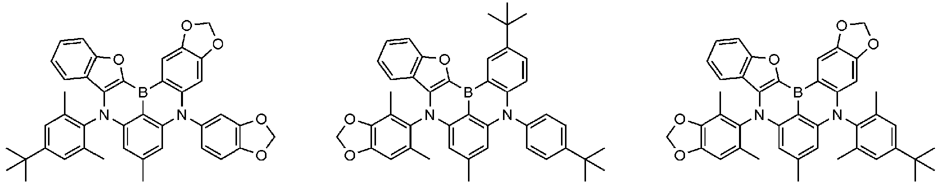

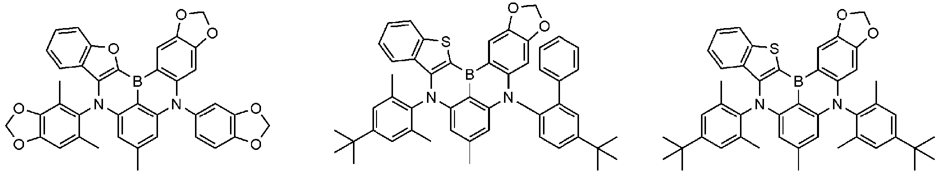

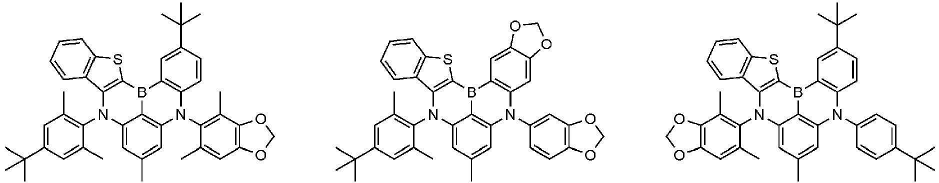

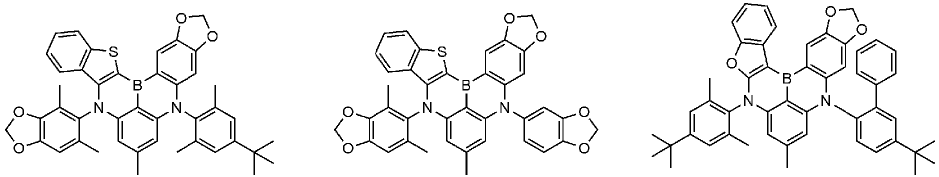

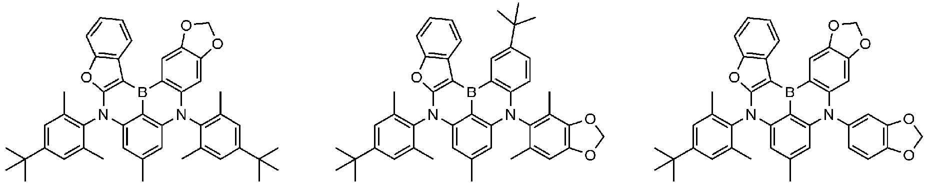

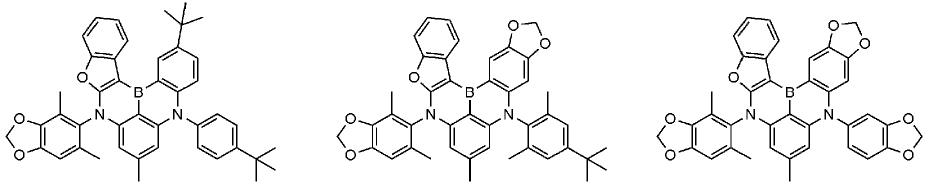

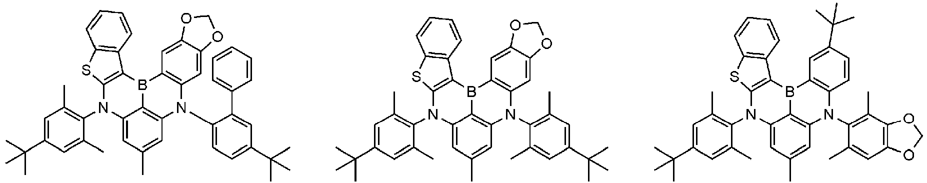

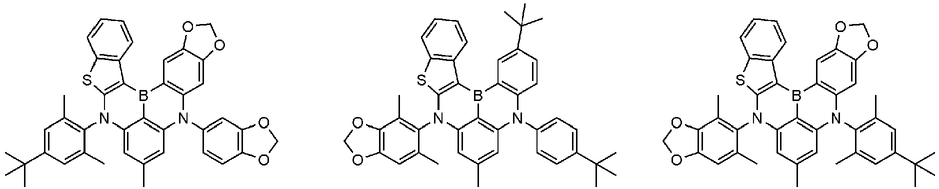

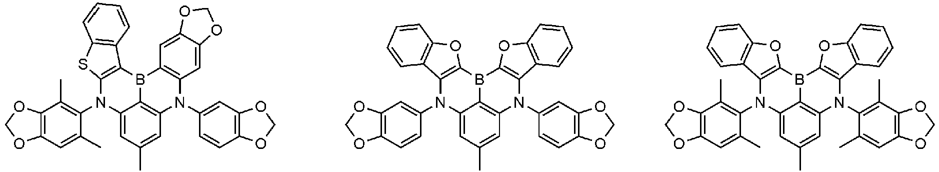

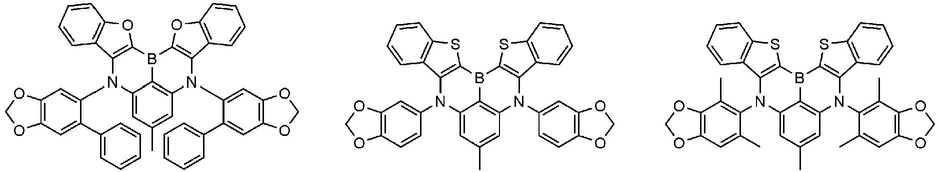

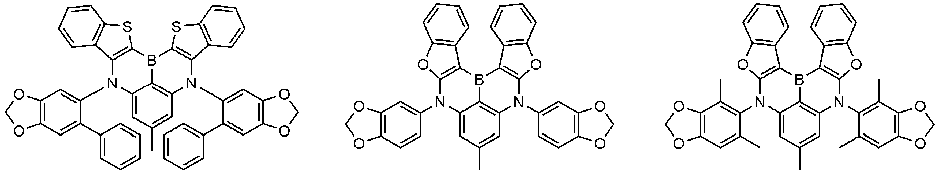

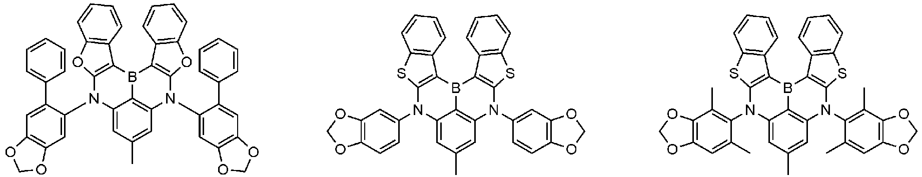

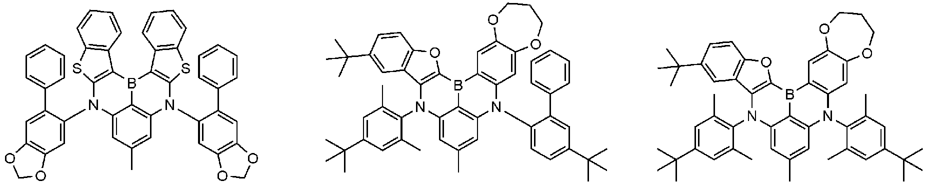

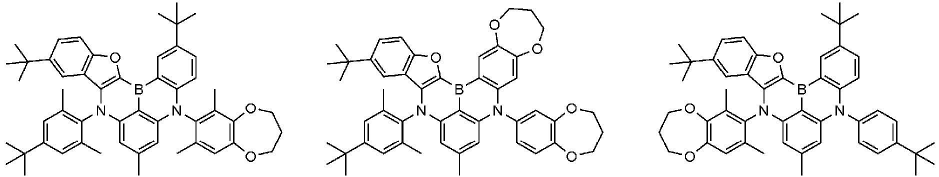

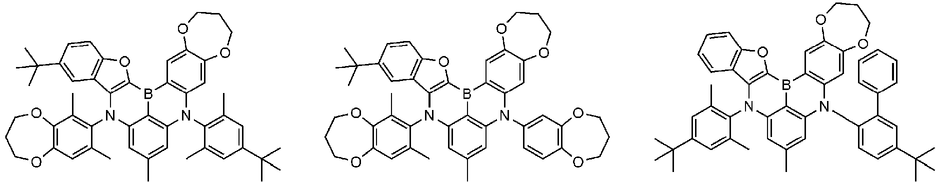

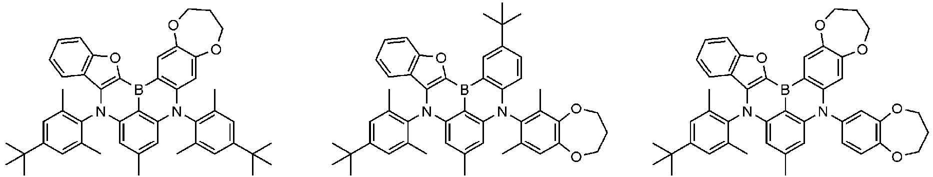

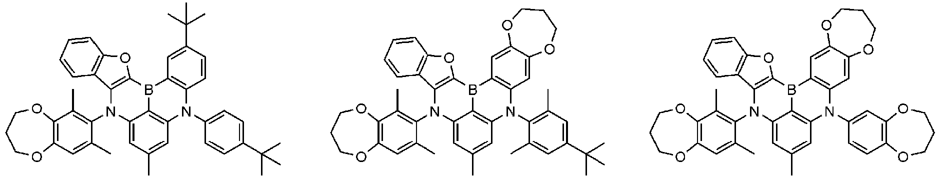

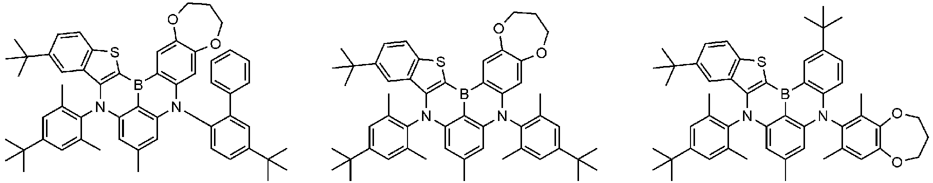

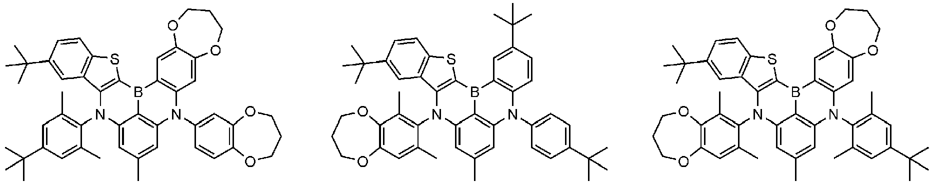

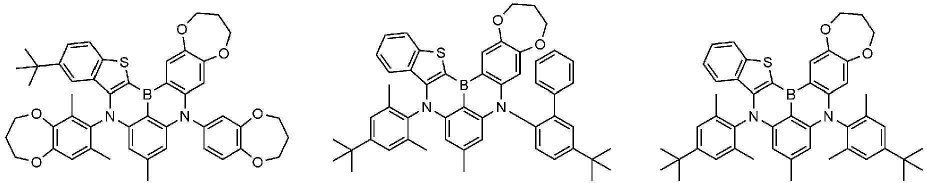

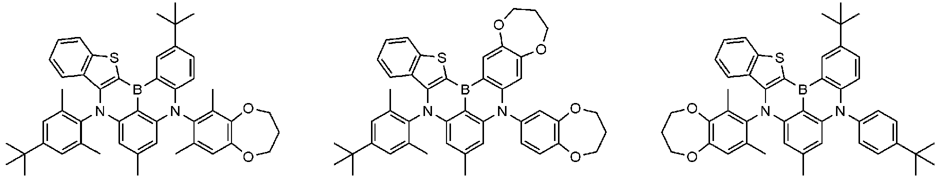

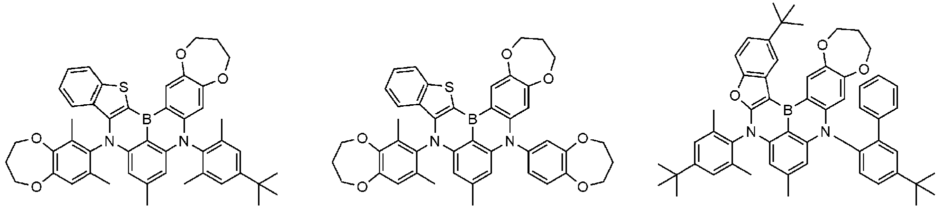

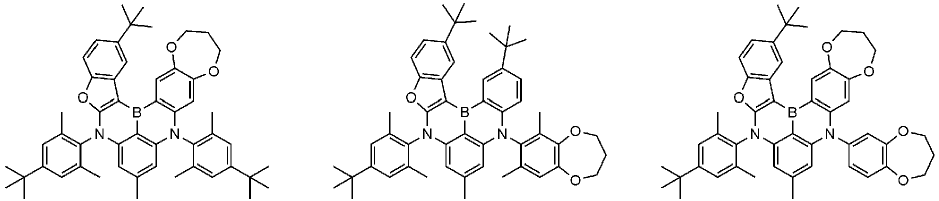

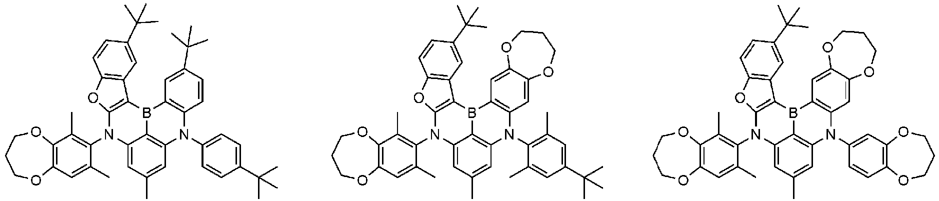

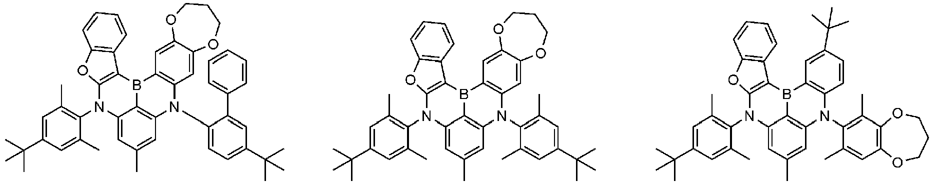

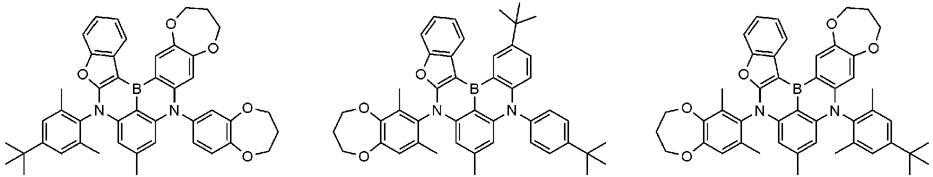

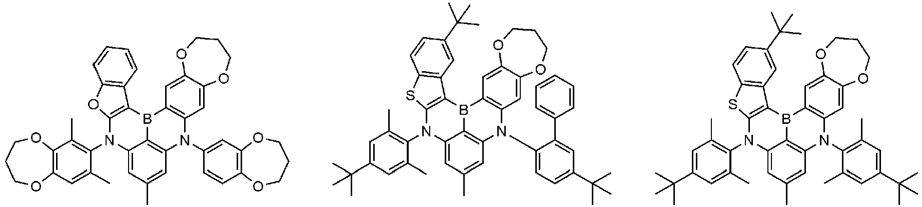

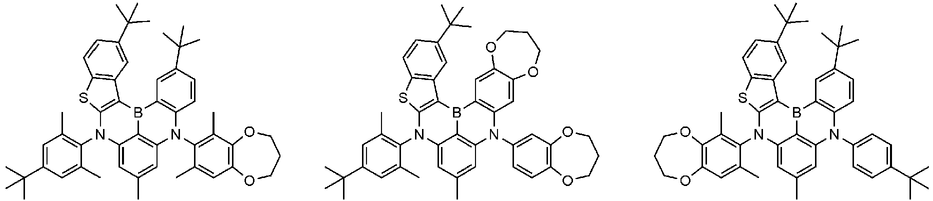

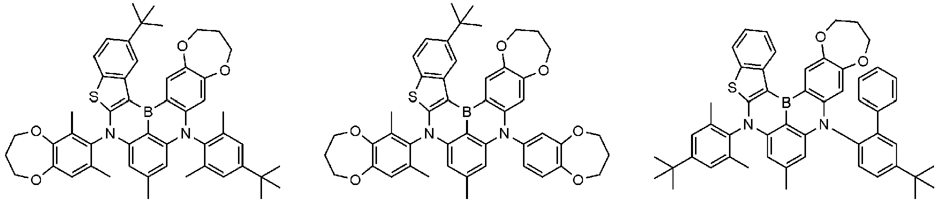

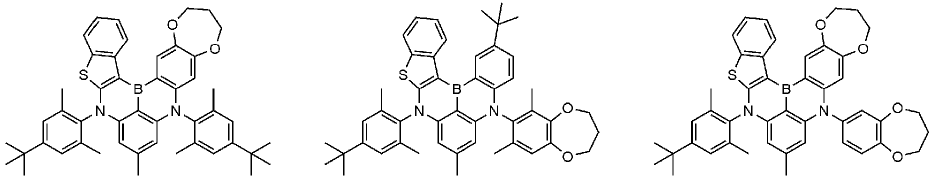

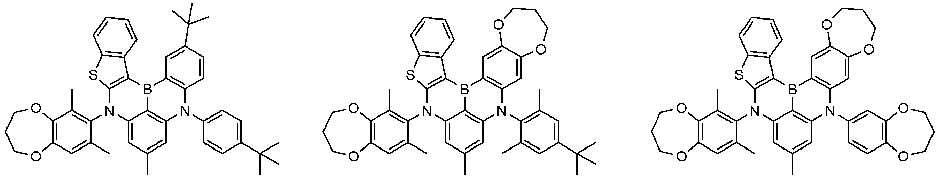

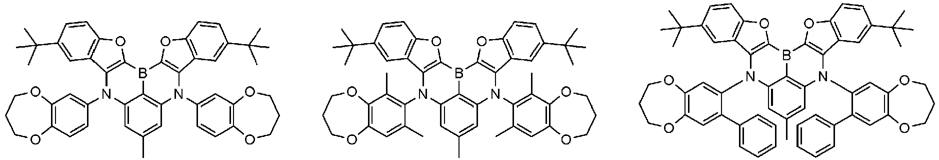

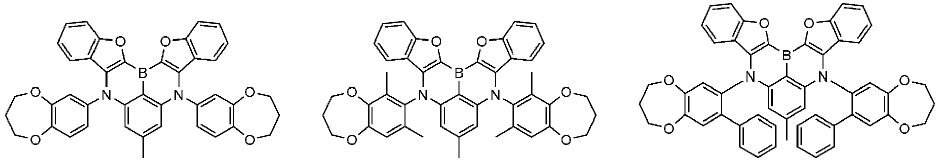

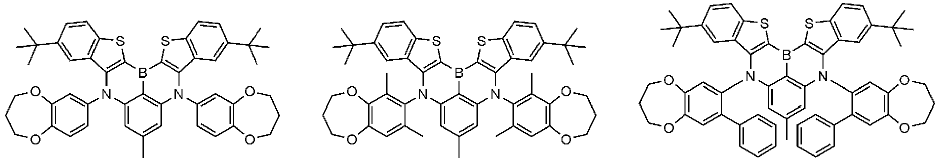

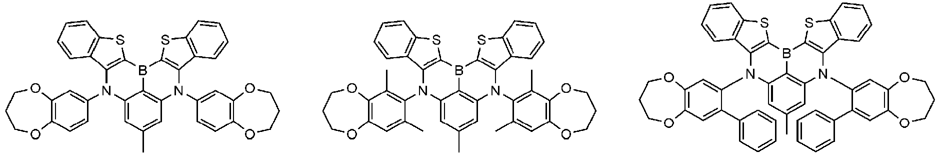

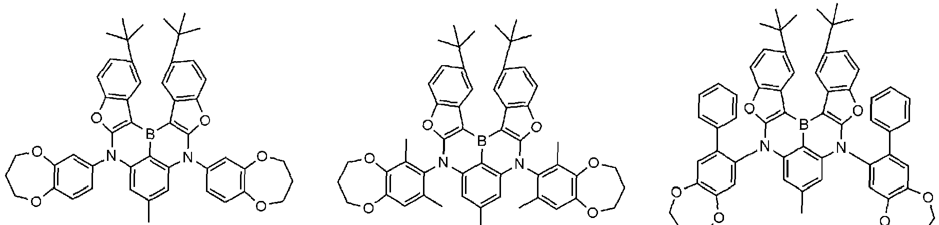

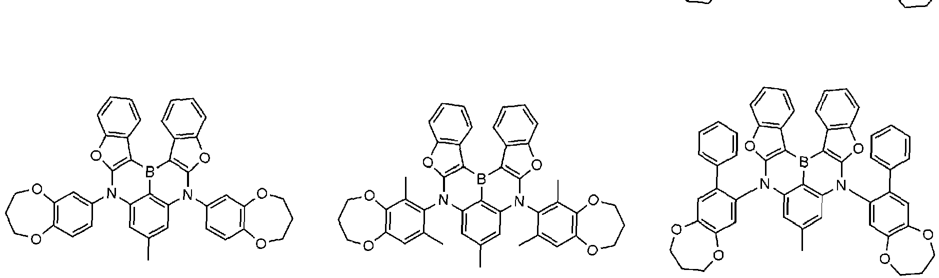

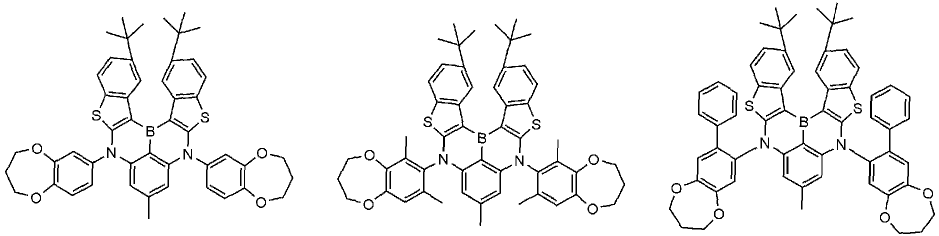

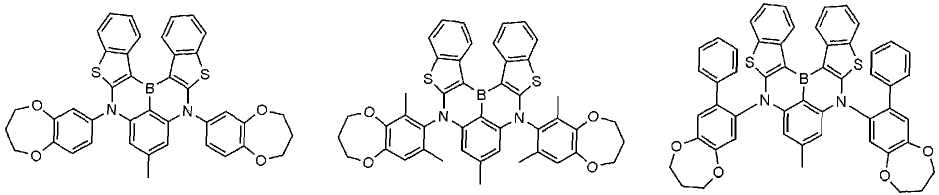

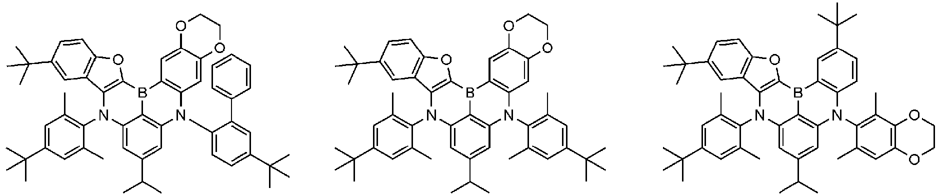

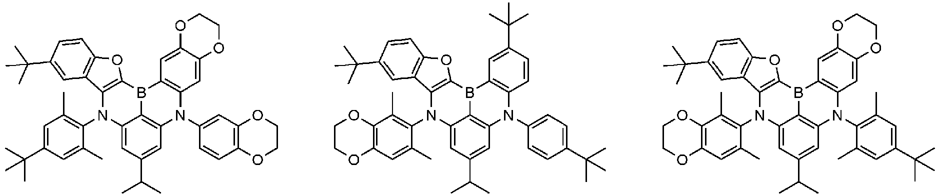

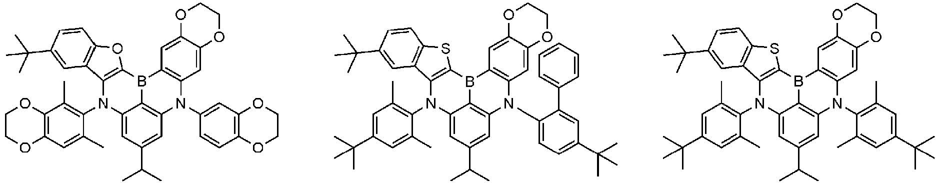

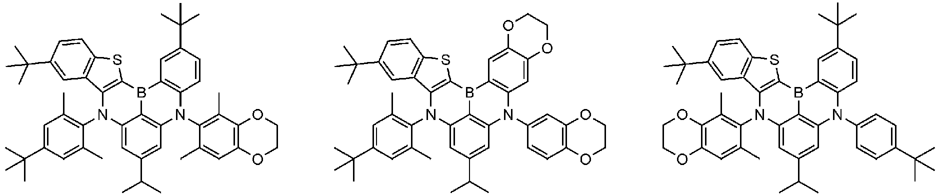

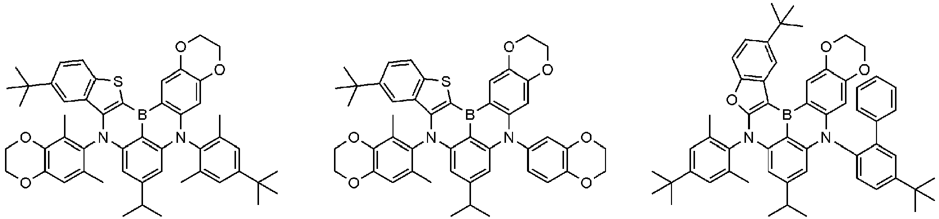

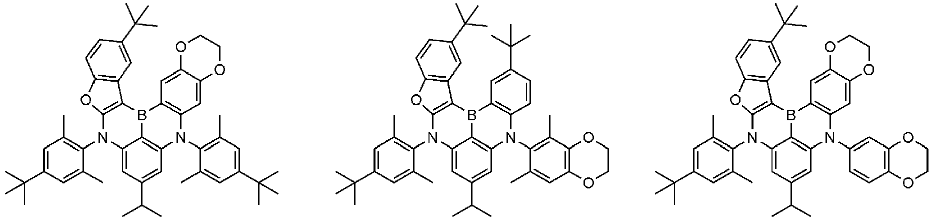

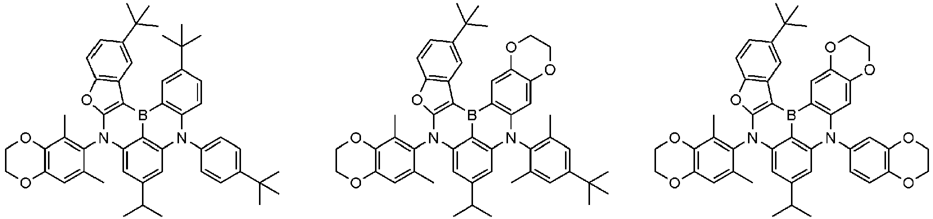

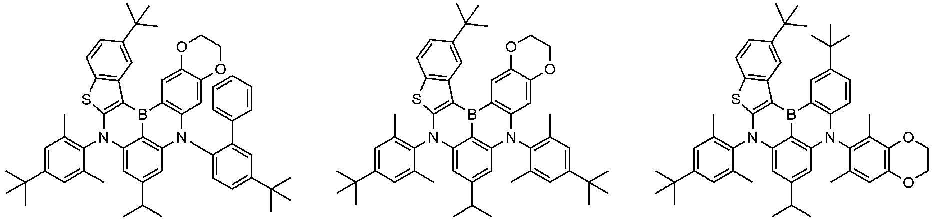

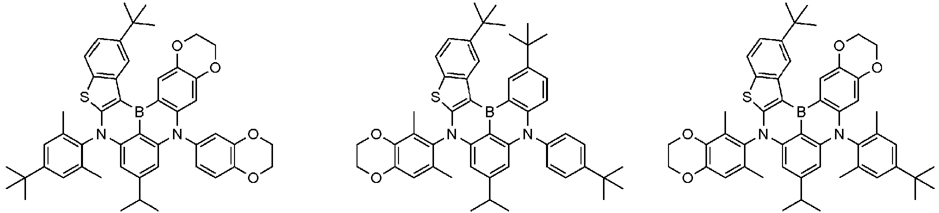

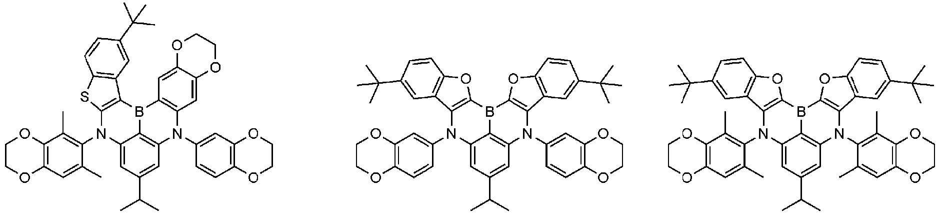

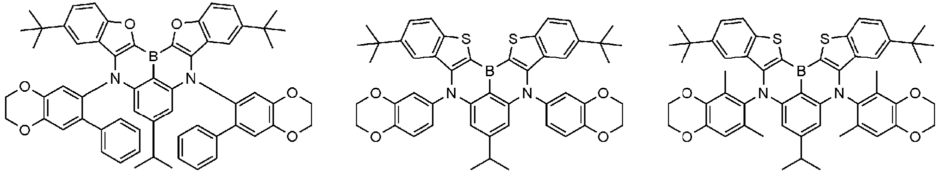

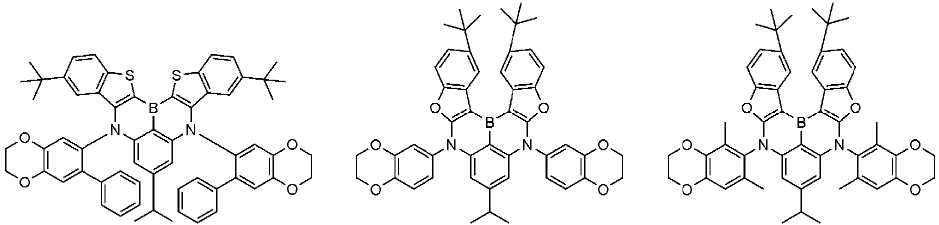

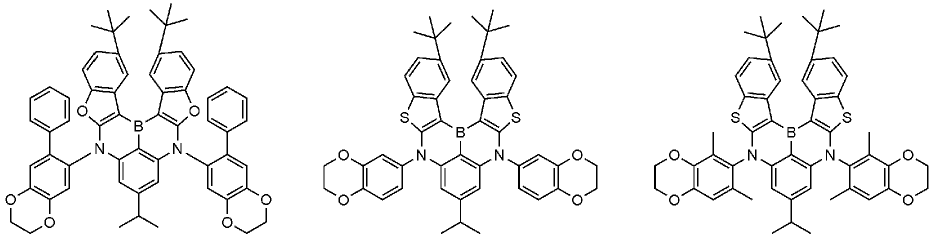

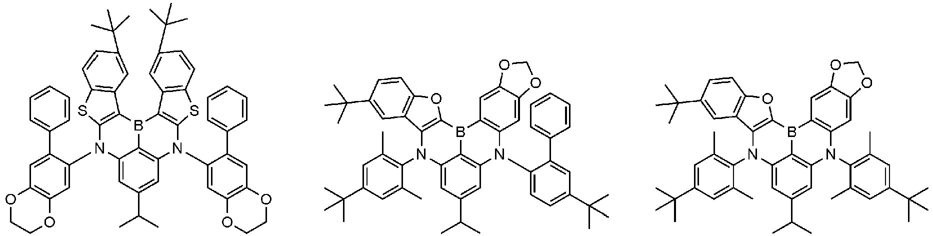

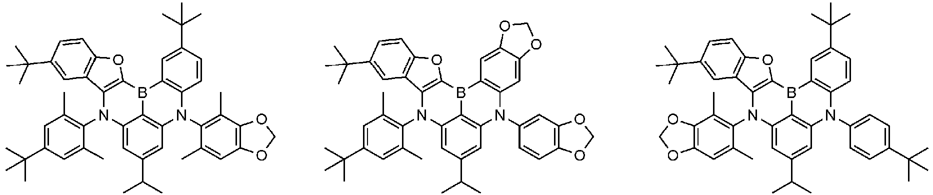

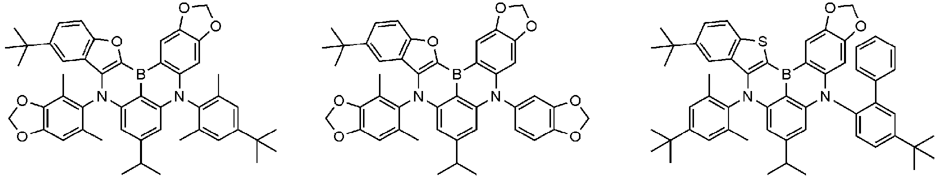

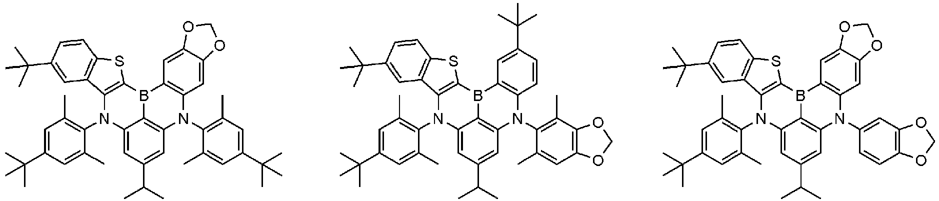

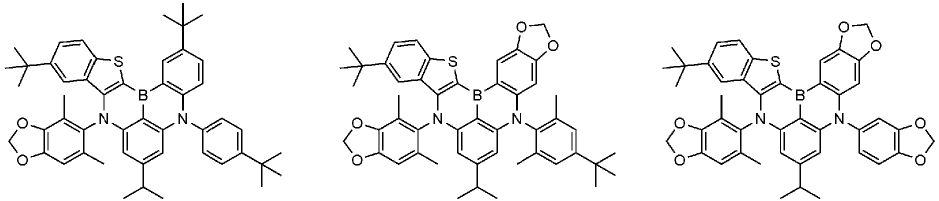

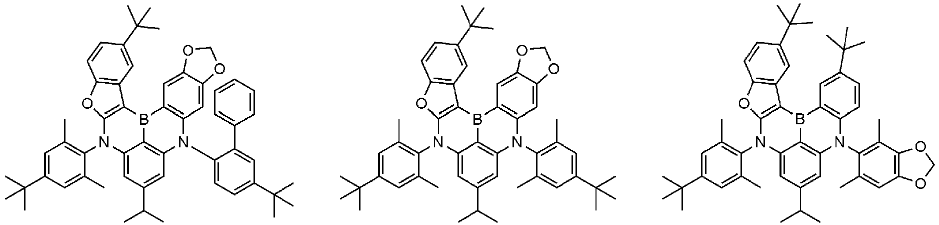

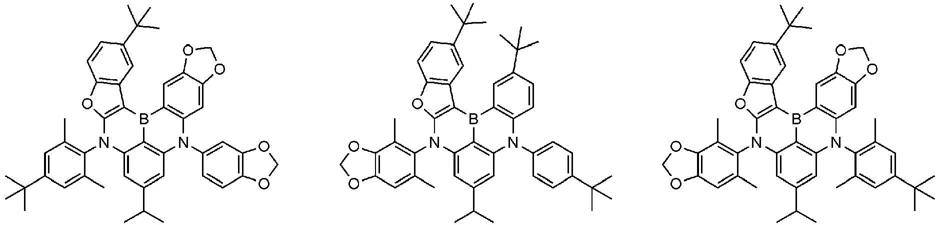

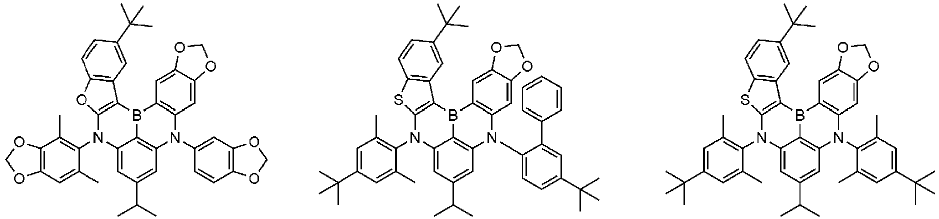

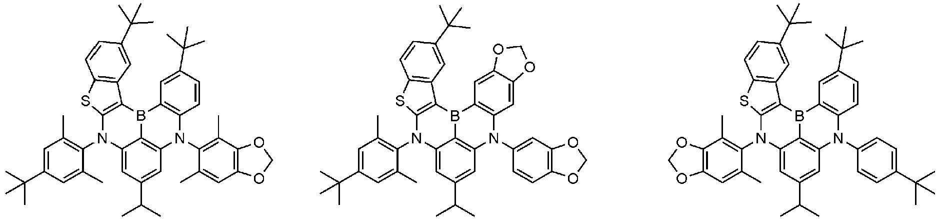

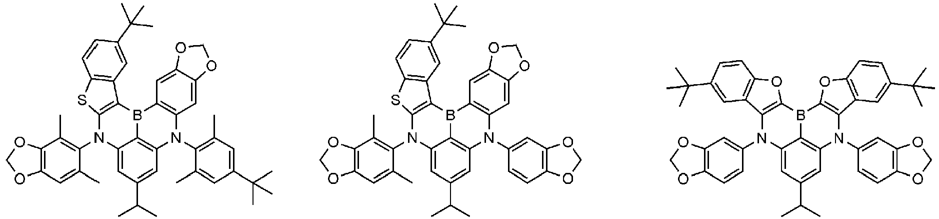

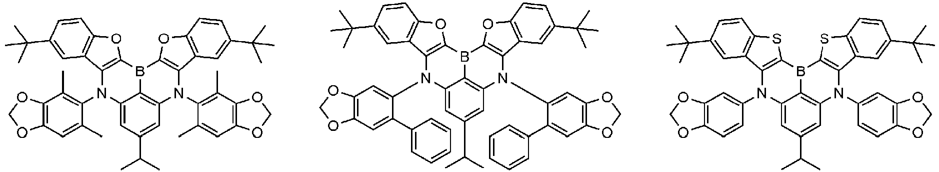

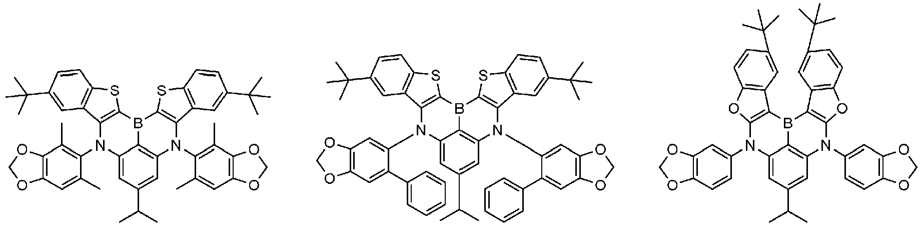

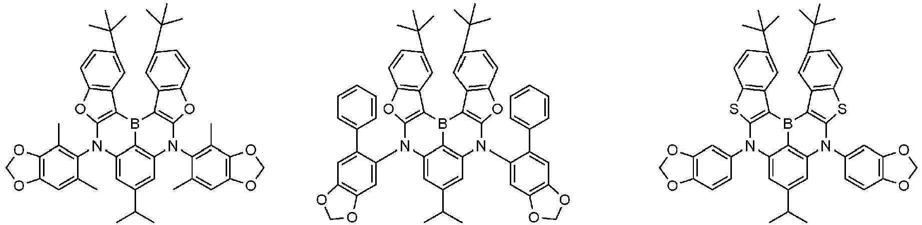

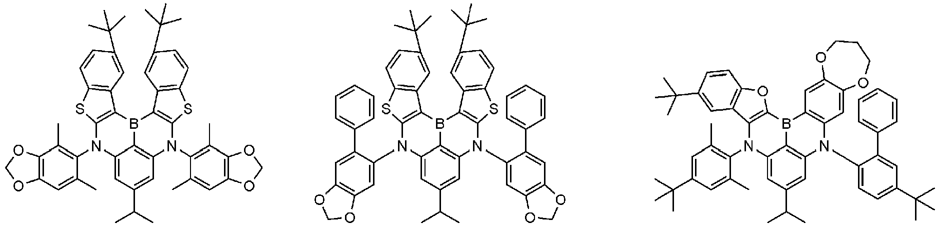

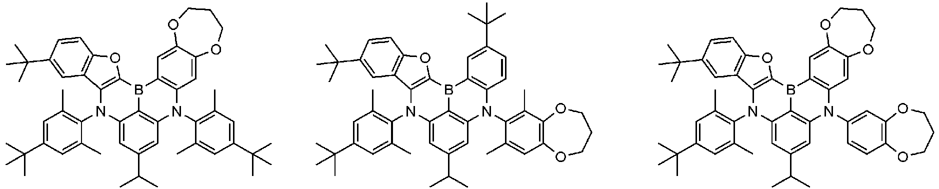

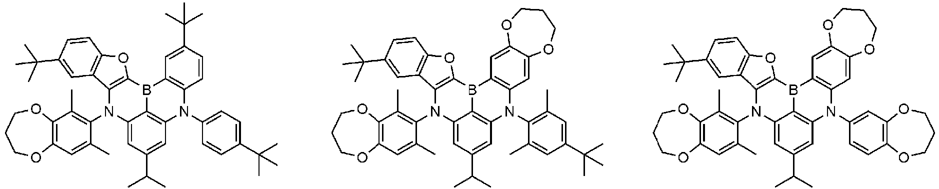

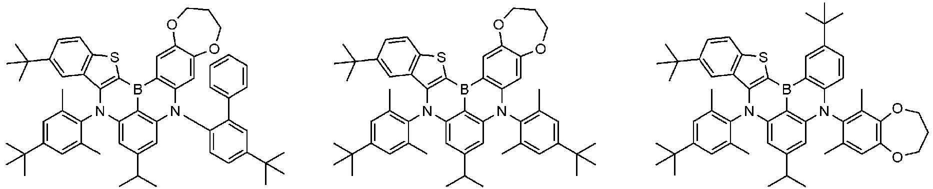

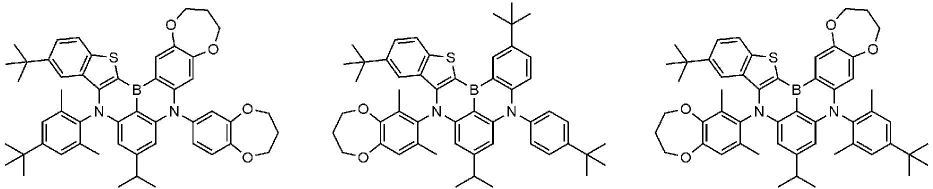

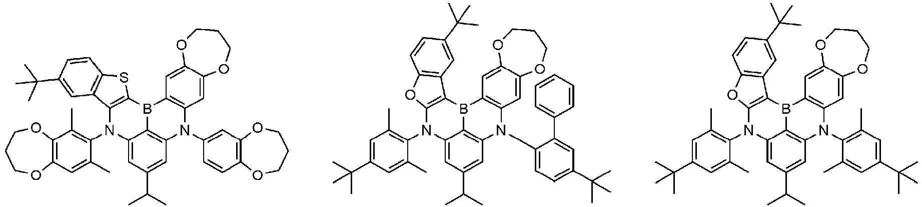

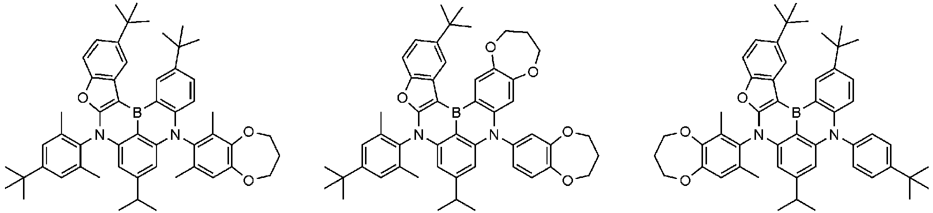

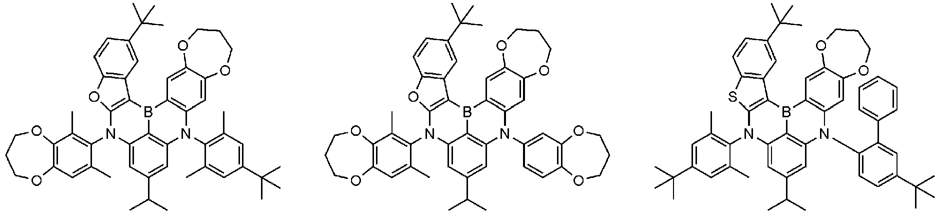

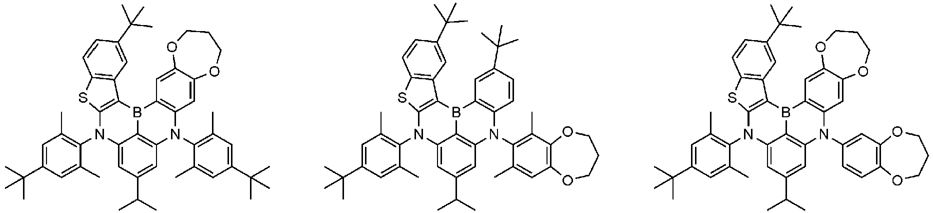

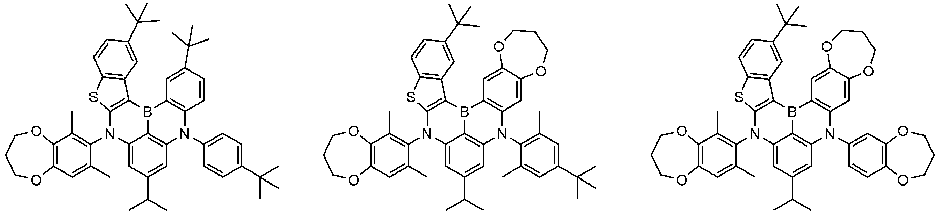

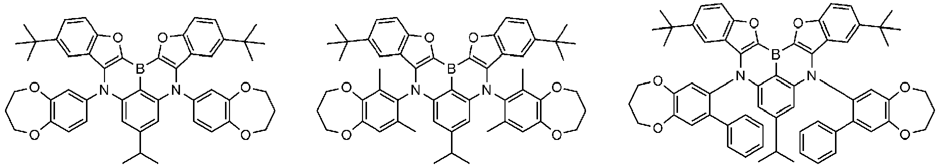

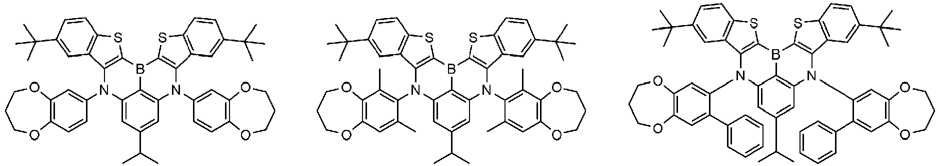

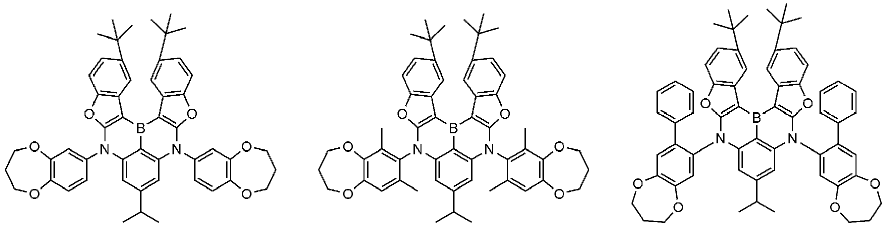

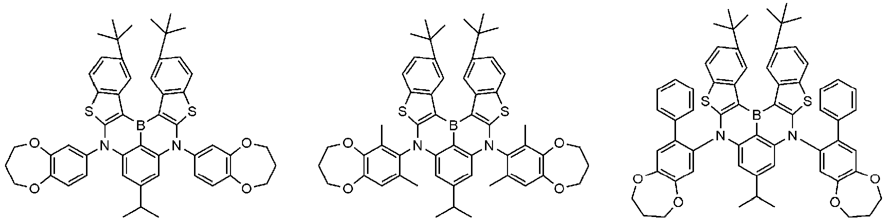

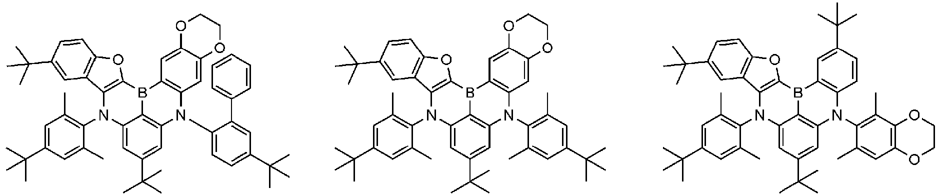

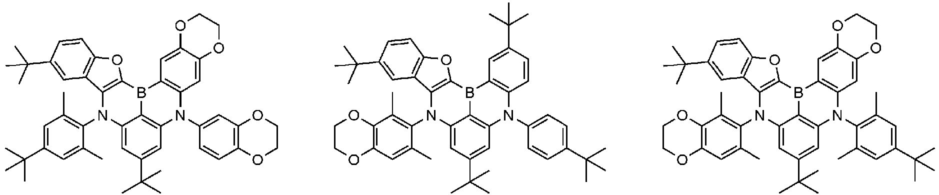

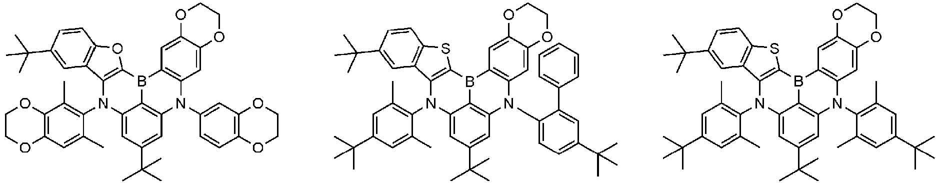

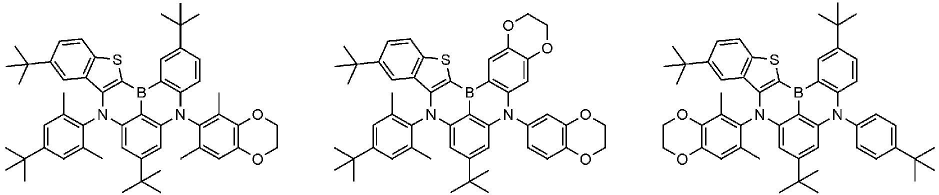

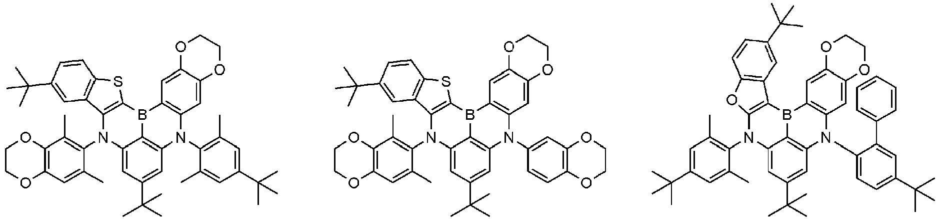

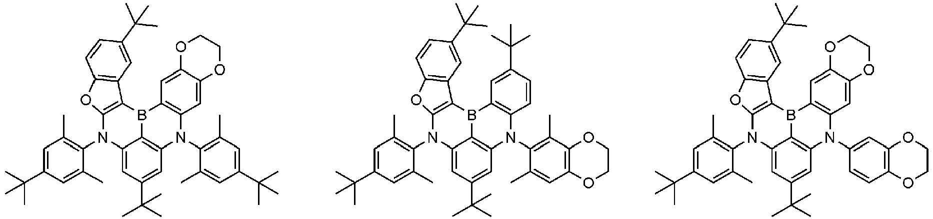

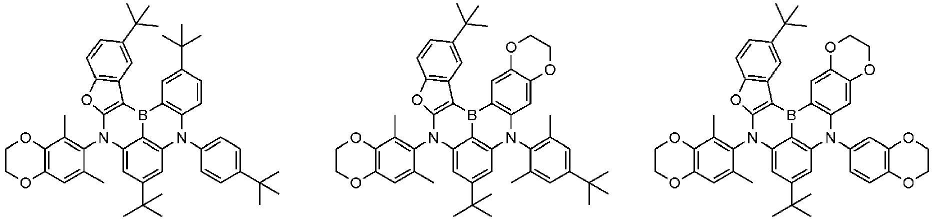

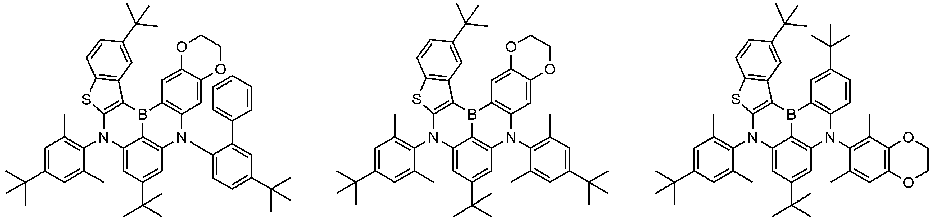

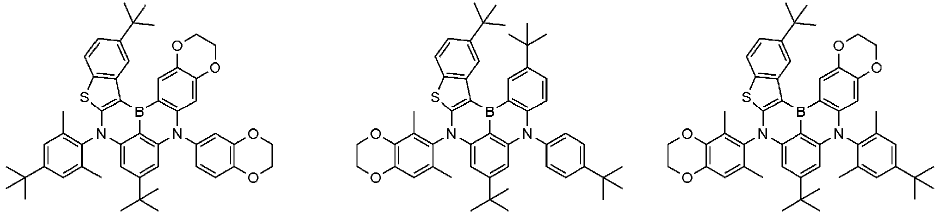

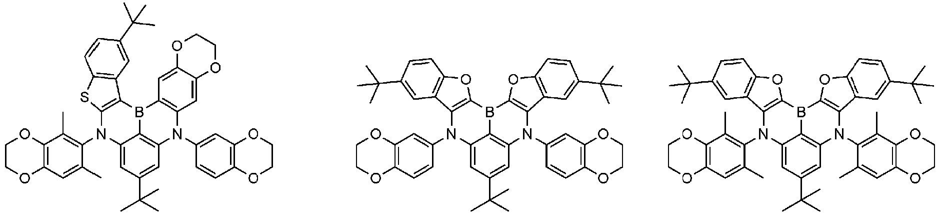

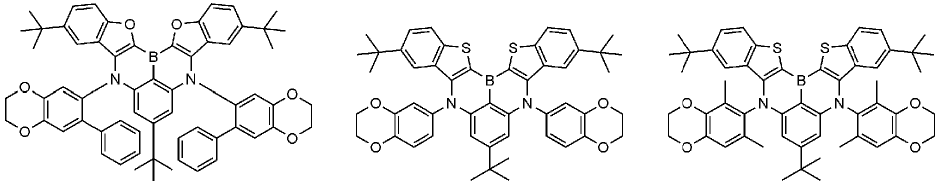

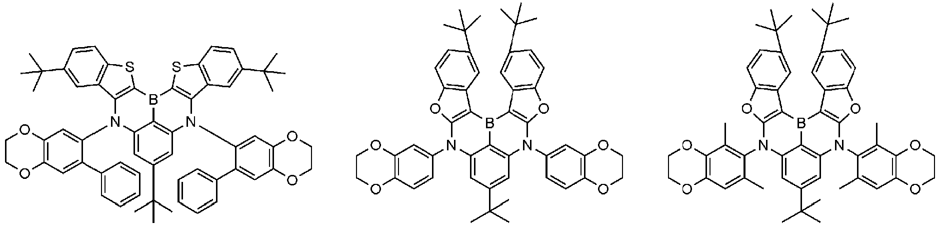

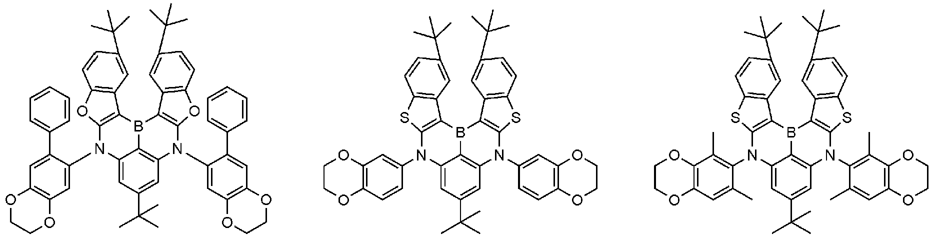

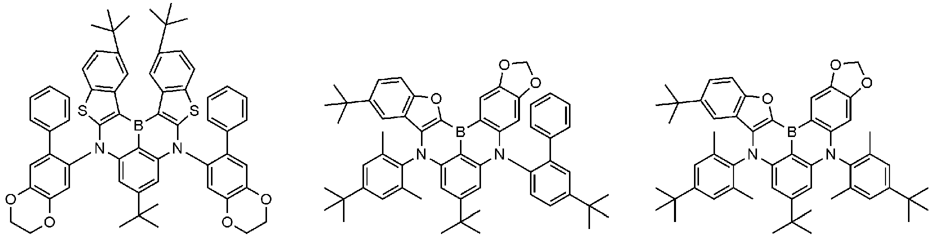

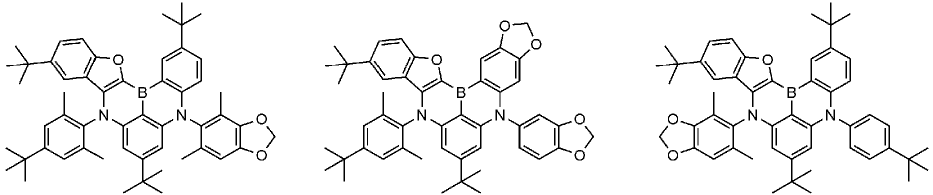

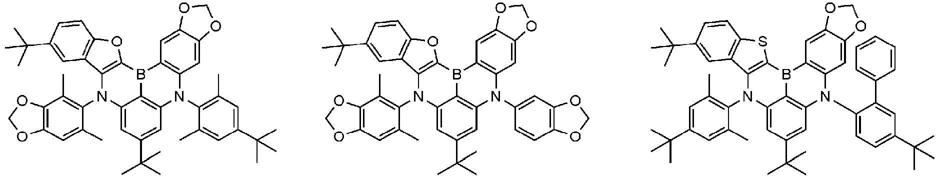

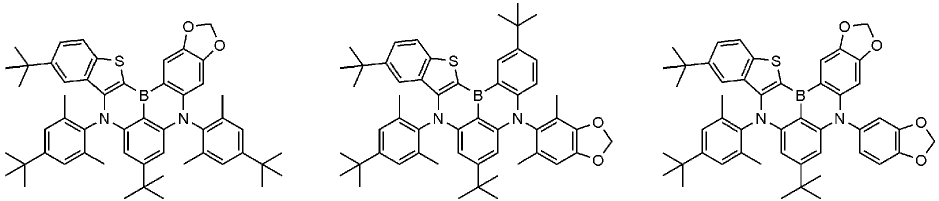

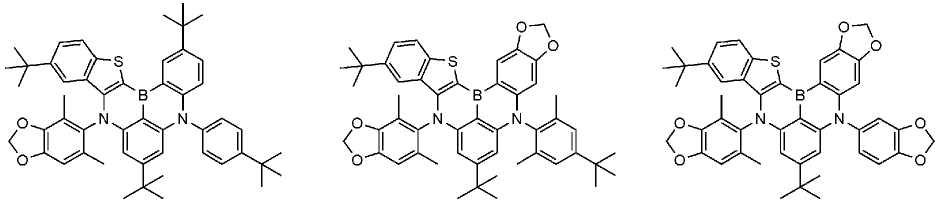

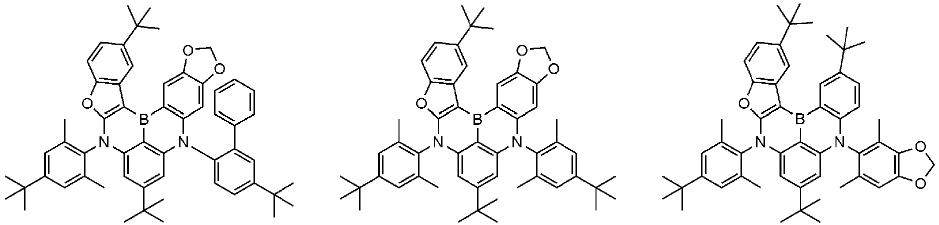

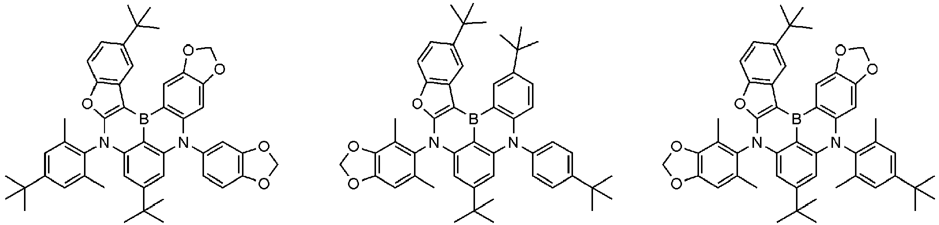

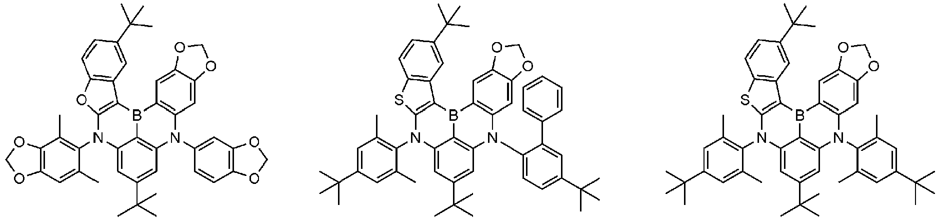

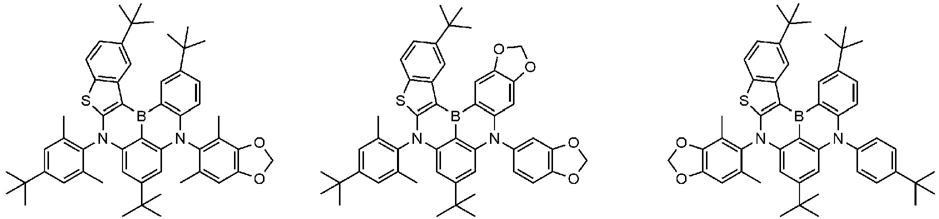

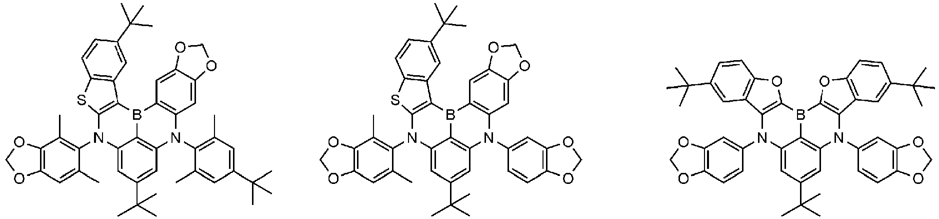

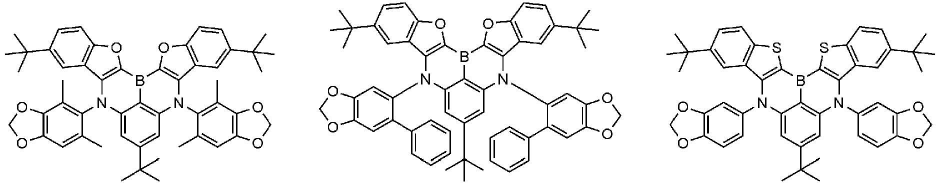

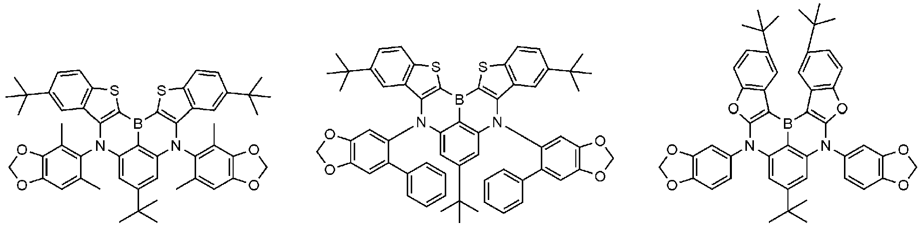

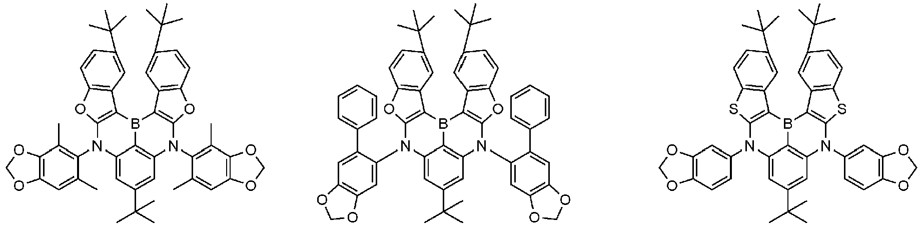

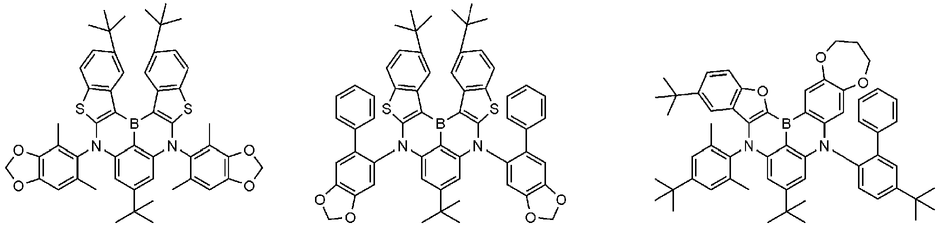

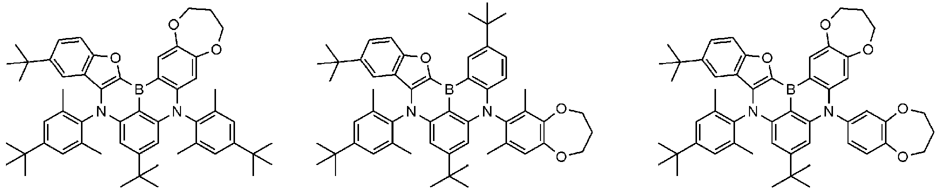

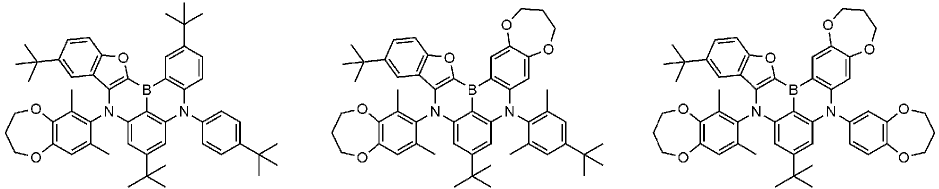

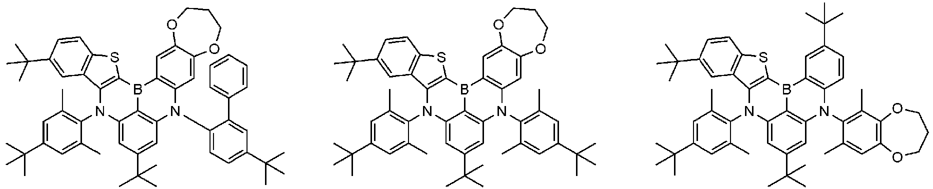

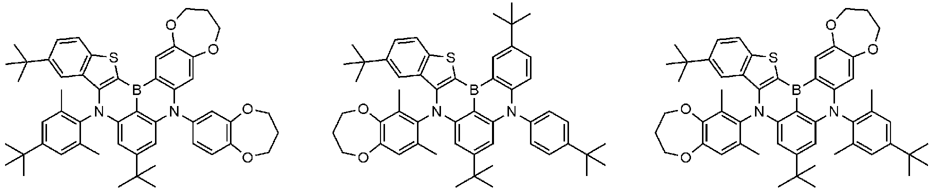

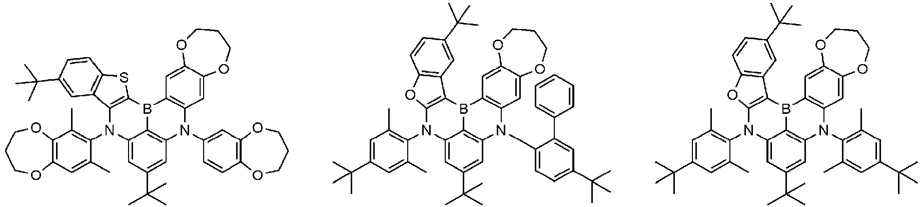

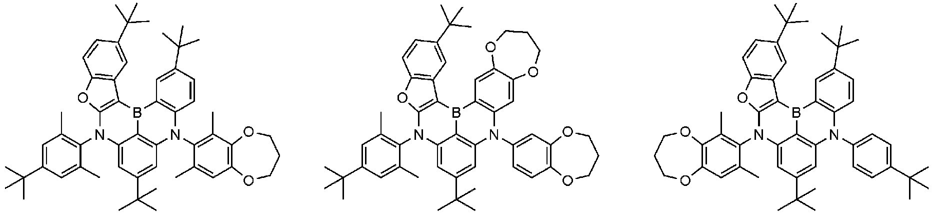

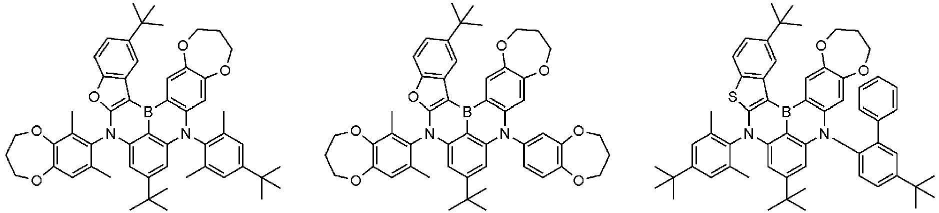

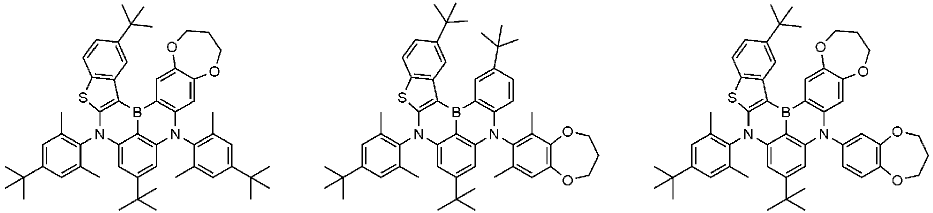

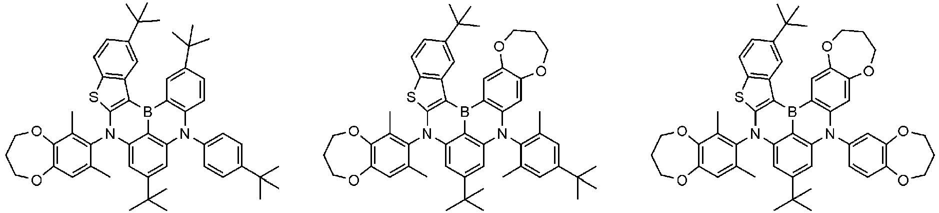

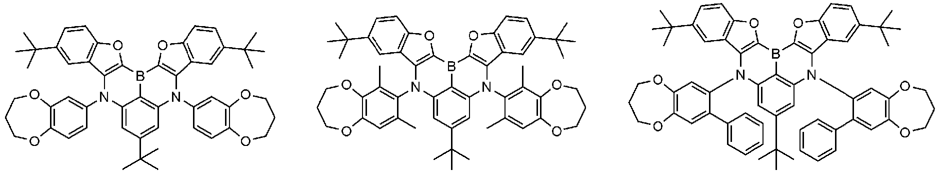

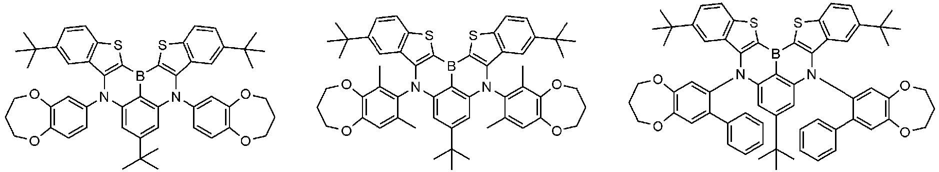

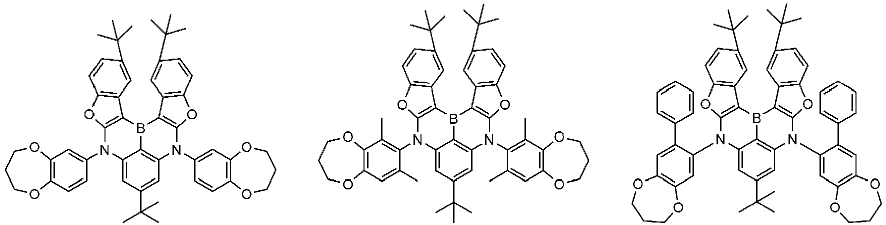

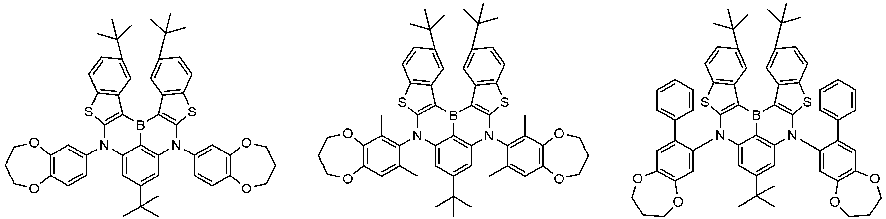

10. An organic light emitting device comprising: a first electrode; a second electrode that is provided opposite to the first electrode; and one or more organic material layers that are provided between the first electrode and the second electrode, wherein at least one layer of the organic material layers comprises the compound according to any one of Claims 1 to 9.

11. The organic light emitting device of Claim 10,
wherein the organic material layer comprising the compound is a light emitting layer.

## Patentansprüche

1. Verbindung, dargestellt durch die folgende chemische Formel 1: 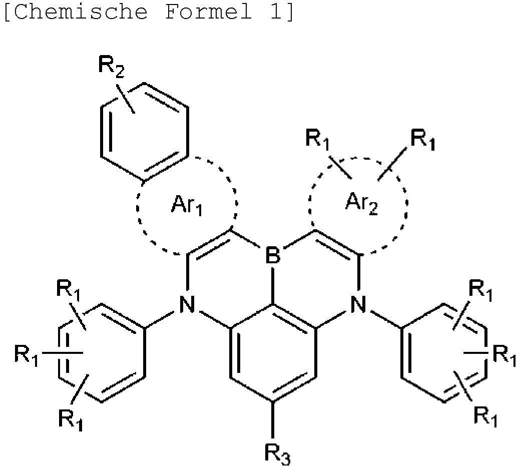 worin in der chemischen Formel 1,
Ar₁ Furan oder Thiophen ist, das mit zwei benachbarten Ringen kondensiert ist,
Ar₂ Benzol, Benzofuran oder Benzothiophen ist, das mit einem benachbarten Ring kondensiert ist,
jedes R₁ unabhängig Wasserstoff, Deuterium, ein substituiertes oder unsubstituiertes C₁₋₆₀-Alkyl oder ein substituiertes oder unsubstituiertes C₆₋₆₀-Aryl ist, oder zwei benachbarte R₁ miteinander verbunden sind, um -O-(CH₂)ₘ-O- zu bilden, worin m eine ganze Zahl von 1 bis 4 ist;
R₂ Wasserstoff, Deuterium oder ein substituiertes oder unsubstituiertes C₁₋₆₀-Alkyl ist, und
R₃ Wasserstoff, Deuterium oder ein substituiertes oder unsubstituiertes C₁₋₆₀-Alkyl ist,
mit der Maßgabe, dass die chemische Formel 1 mindestens ein -O-(CH₂)ₘ-O-, gebildet durch Verbinden zweier benachbarter R₁, umfasst.

2. Verbindung gemäß Anspruch 1,
wobei die chemische Formel 1 durch eine der folgenden chemischen Formeln 1-1 bis 1-4 dargestellt ist: 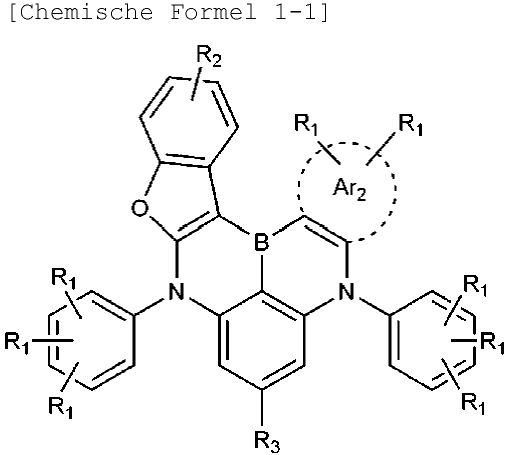 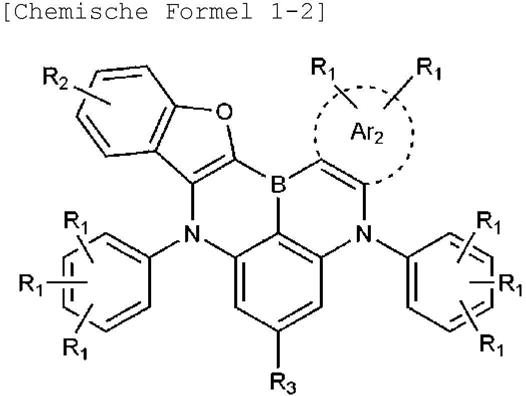 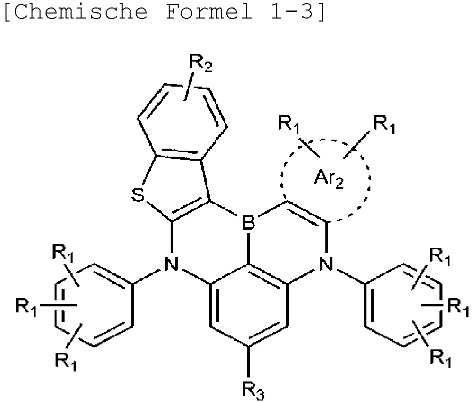 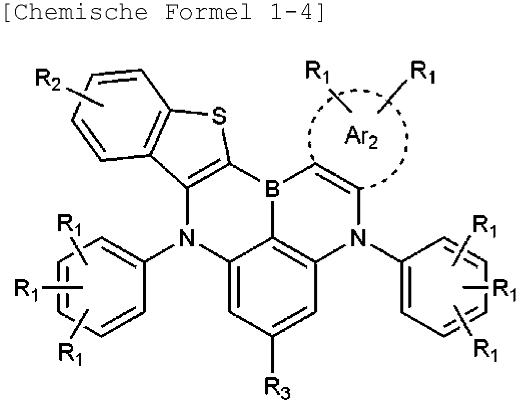 worin in den chemischen Formeln 1-1 bis 1-4,
Ar₂ und R₁ bis R₃ wie in Anspruch 1 definiert sind.

3. Verbindung gemäß Anspruch 1,
worin jedes R₁ unabhängig Wasserstoff, Deuterium, C₁₋₁₀-Alkyl oder C₆₋₂₀-Aryl ist oder zwei benachbarte R₁ miteinander verbunden sind, um 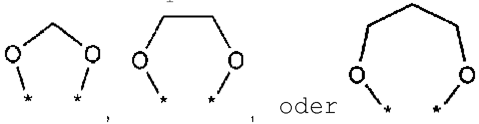 zu bilden.

4. Verbindung gemäß Anspruch 1,
worin jedes R₁ unabhängig Wasserstoff, Deuterium, Methyl, Ethyl, Propyl, Isopropyl, Butyl, Isobutyl, tert-Butyl oder Phenyl ist oder zwei benachbarte R₁ miteinander verbunden sind, um 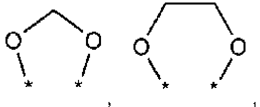 oder 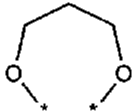 zu bilden.

5. Verbindung gemäß Anspruch 1,
worin R₂ Wasserstoff, Deuterium oder C₁₋₁₀-Alkyl ist.

6. Verbindung gemäß Anspruch 1,
worin R₂ Wasserstoff, Deuterium, Methyl, Ethyl, Propyl, Isopropyl, Butyl, Isobutyl oder tert-Butyl ist.

7. Verbindung gemäß Anspruch 1,
worin R₃ Wasserstoff, Deuterium oder C₁₋₁₀-Alkyl ist.

8. Verbindung gemäß Anspruch 1,
worin R₃ Wasserstoff, Deuterium, Methyl, Ethyl, Propyl, Isopropyl, Butyl, Isobutyl oder tert-Butyl ist.

9. Verbindung gemäß Anspruch 1,
wobei die durch die chemische Formel 1 dargestellte Verbindung eine beliebige ist, die ausgewählt ist aus der Gruppe bestehend aus:

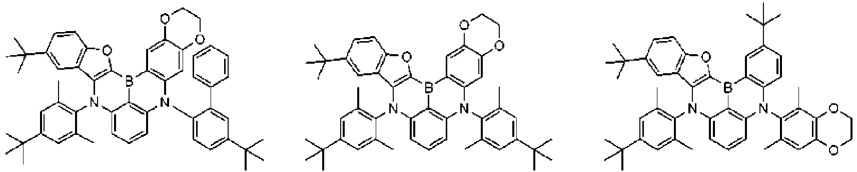

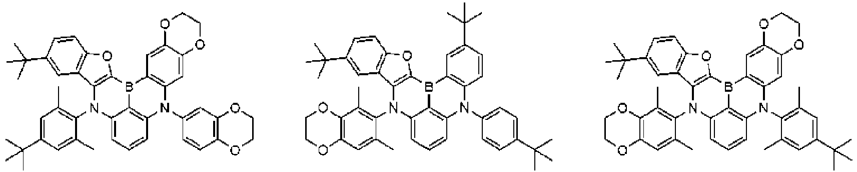

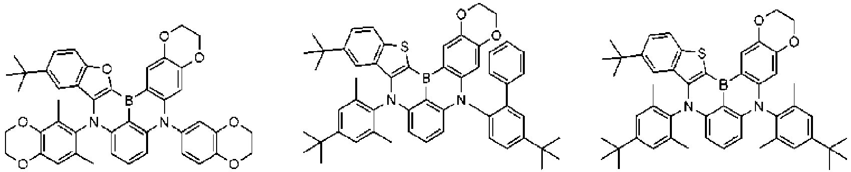

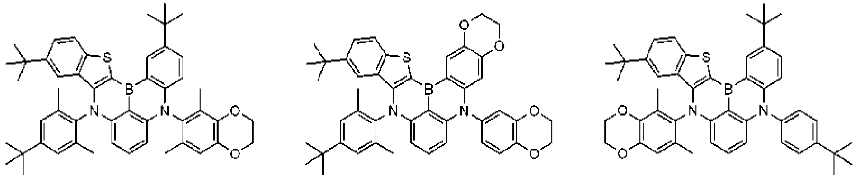

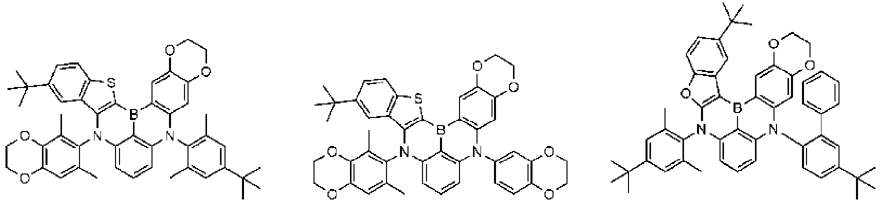

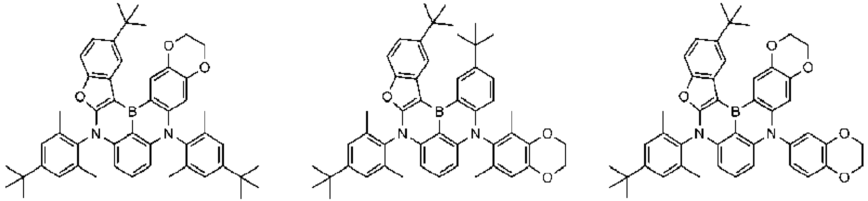

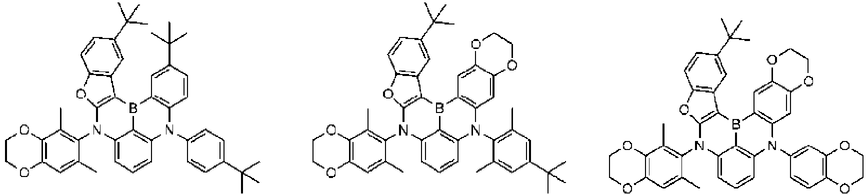

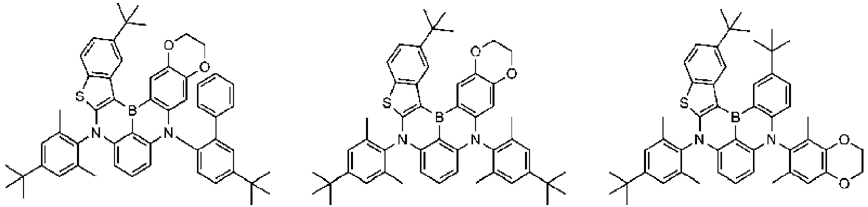

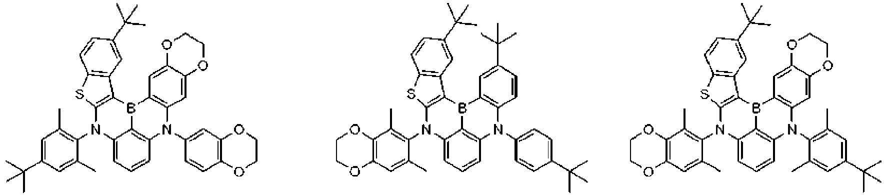

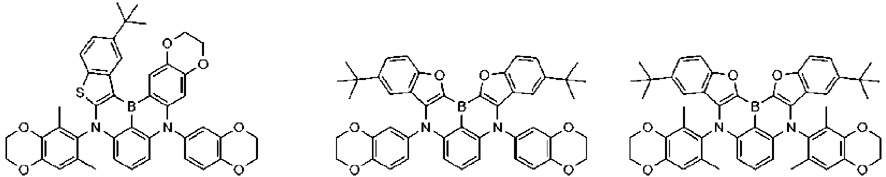

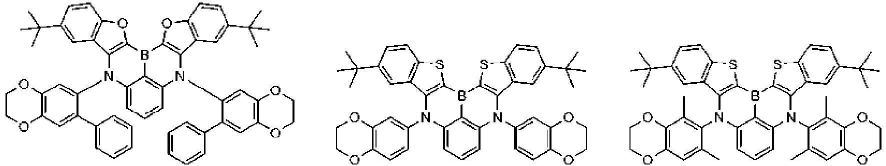

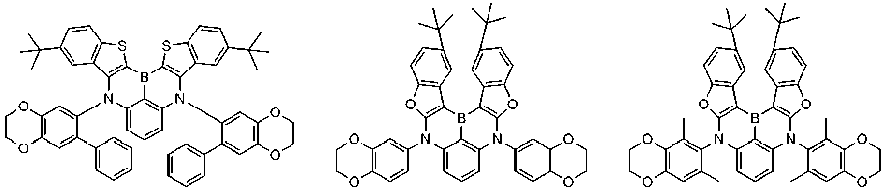

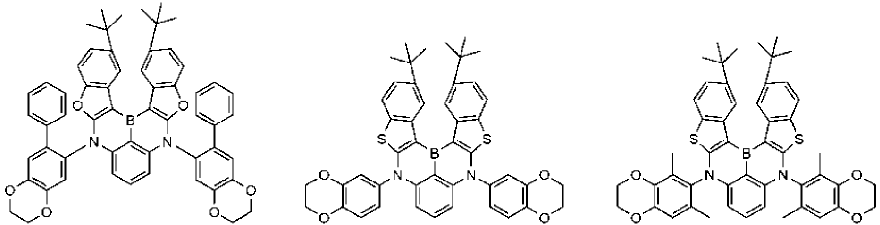

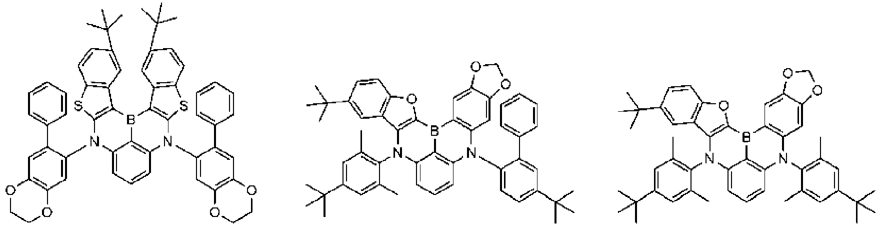

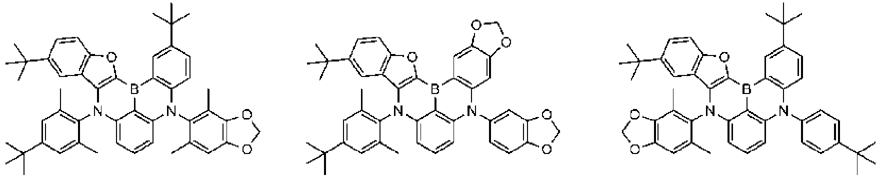

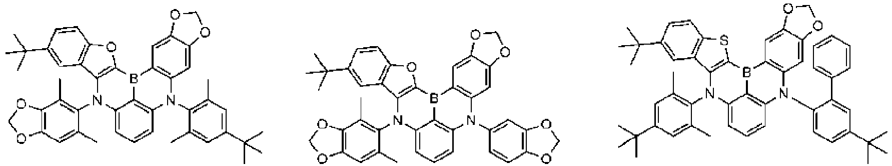

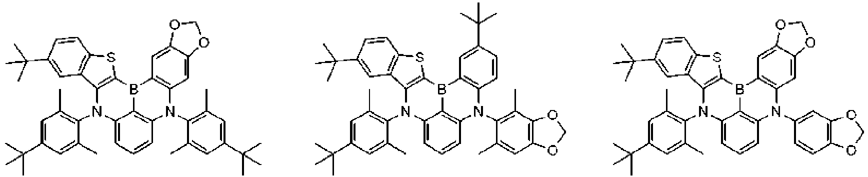

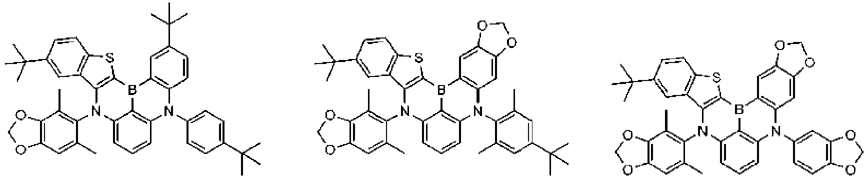

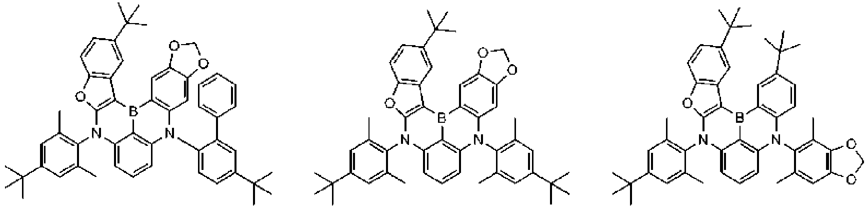

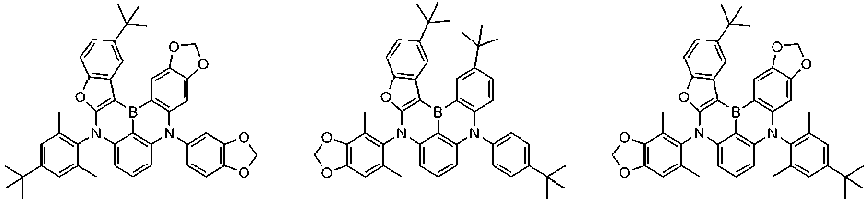

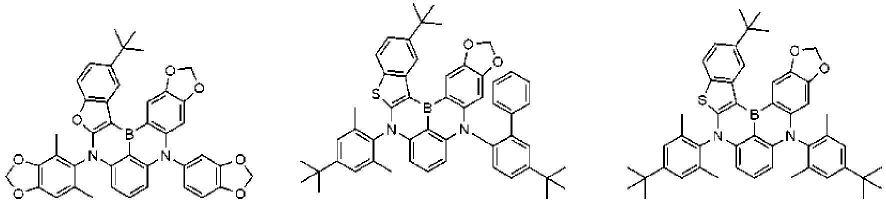

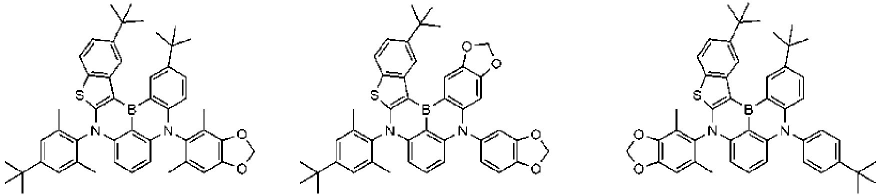

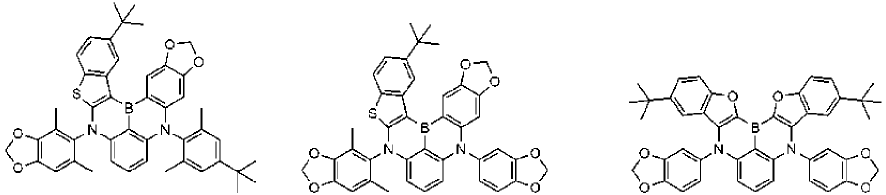

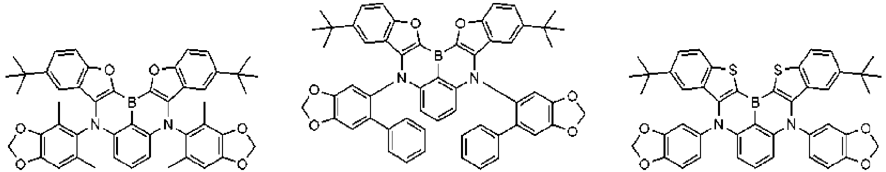

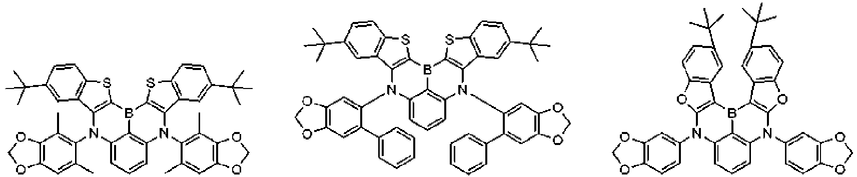

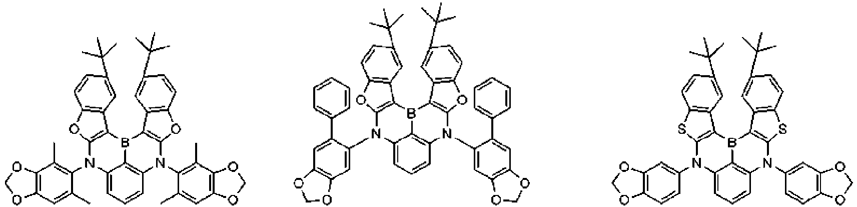

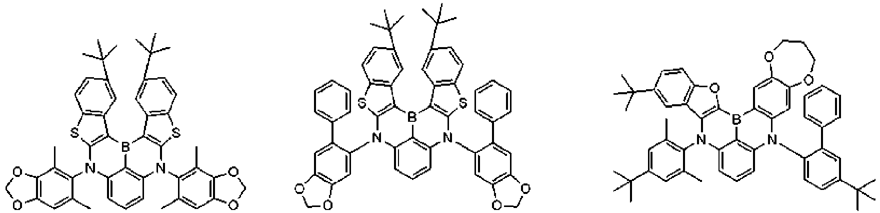

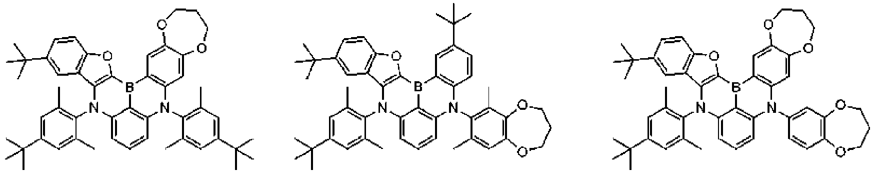

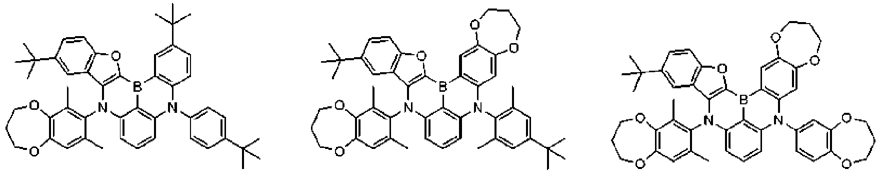

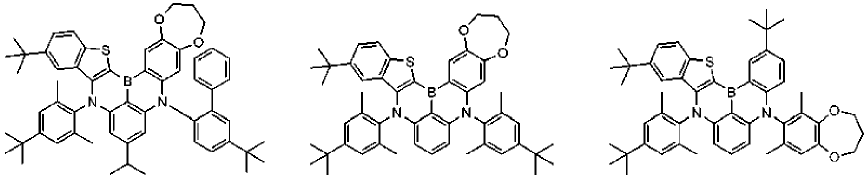

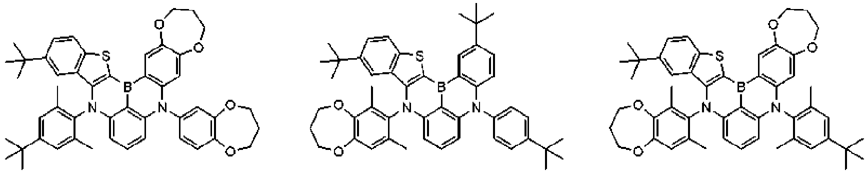

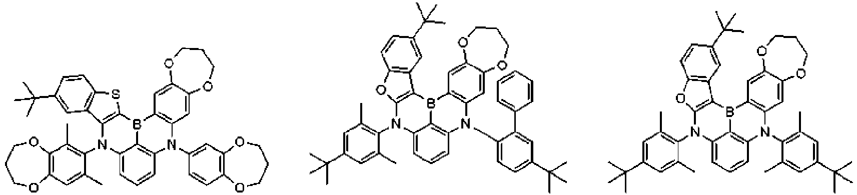

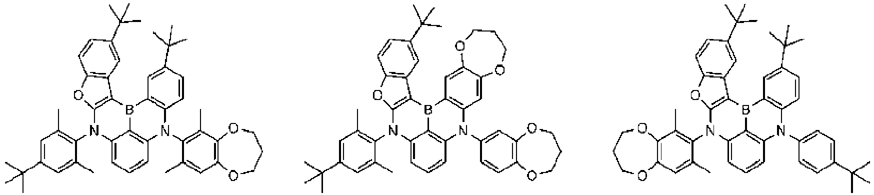

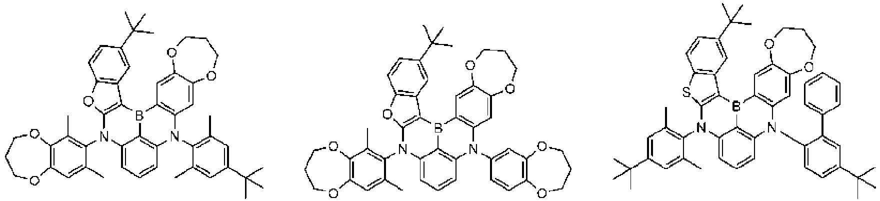

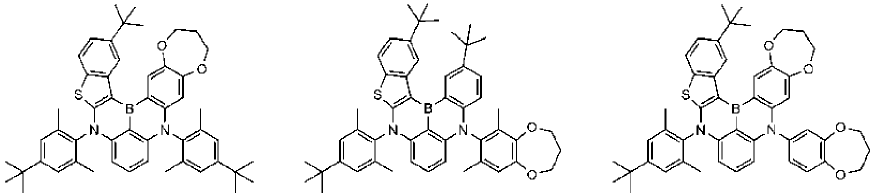

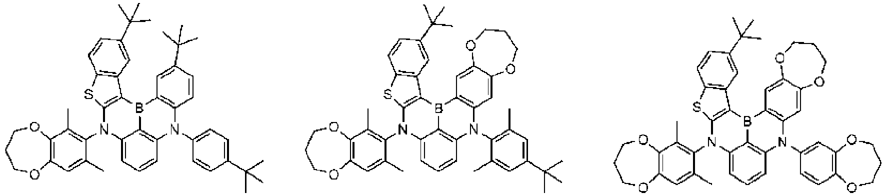

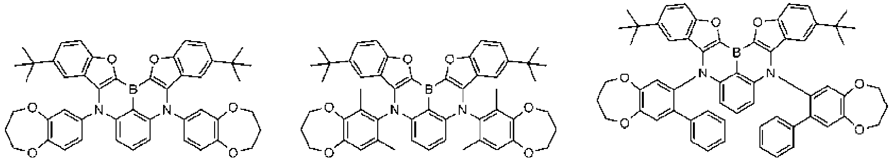

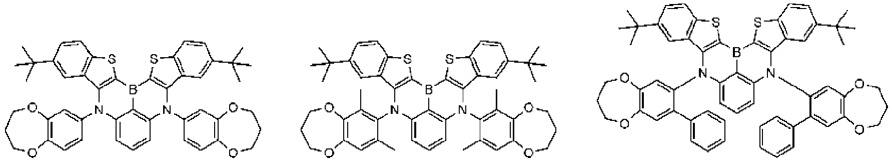

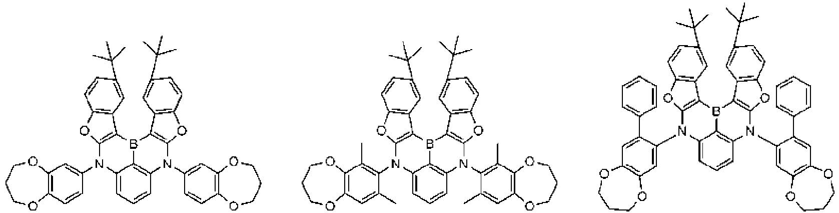

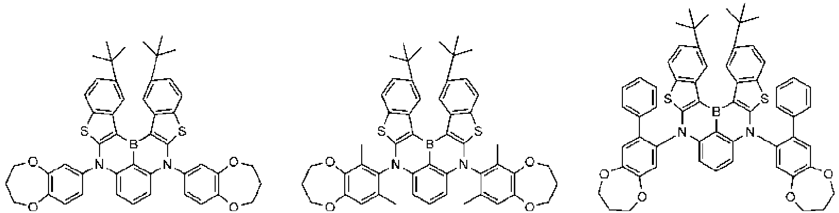

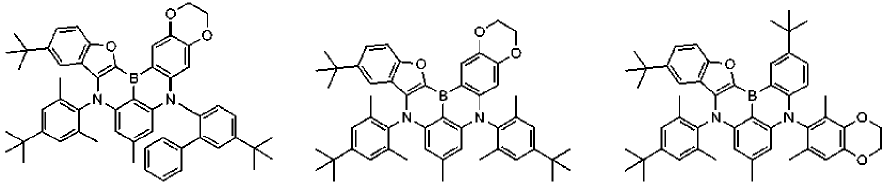

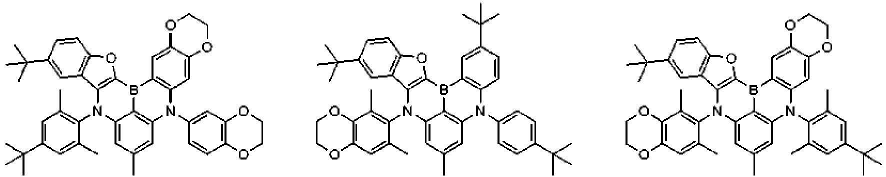

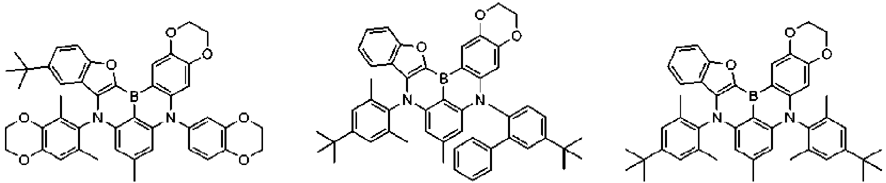

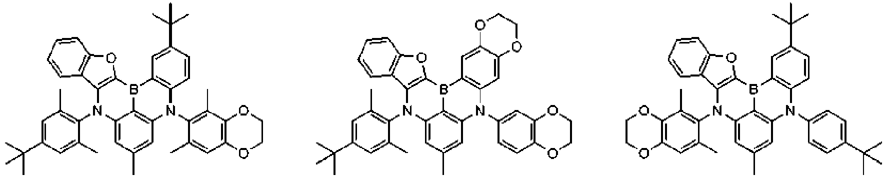

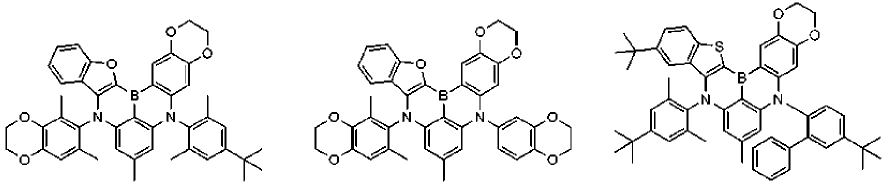

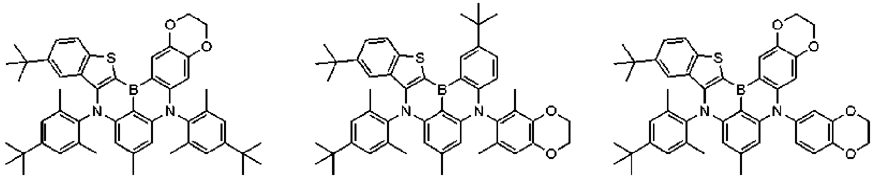

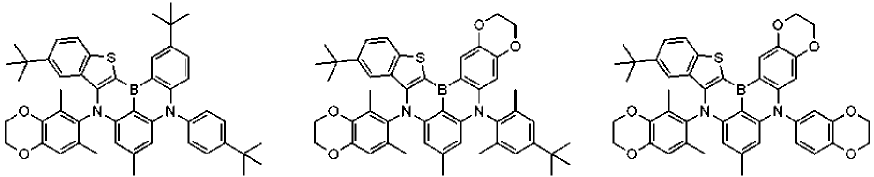

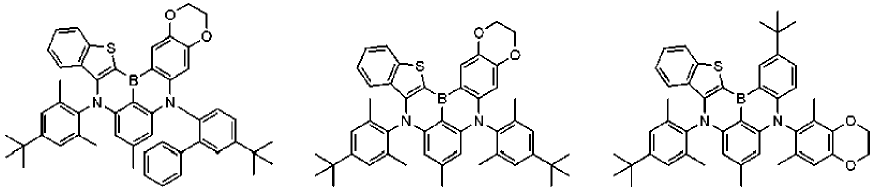

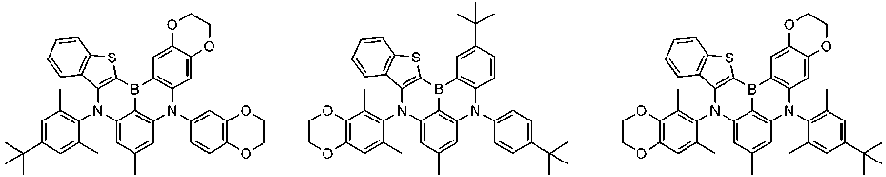

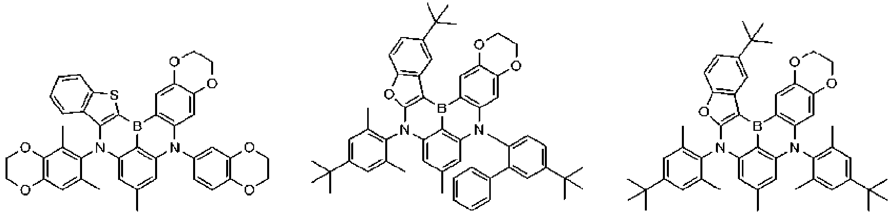

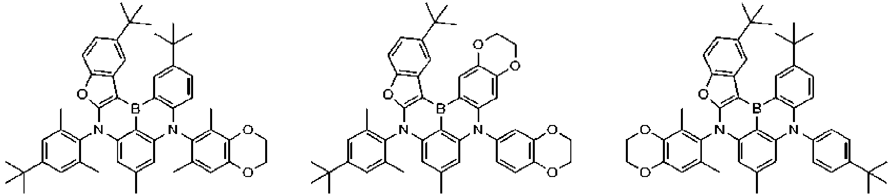

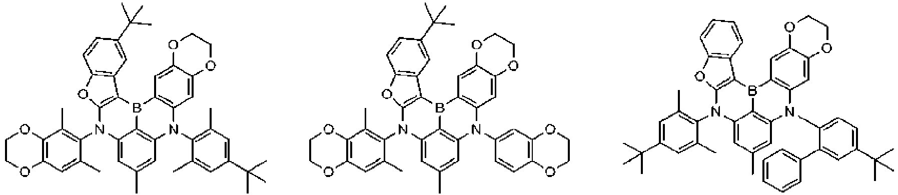

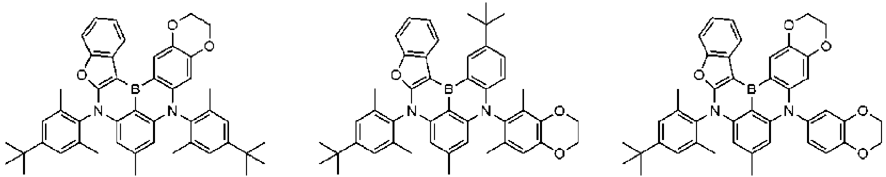

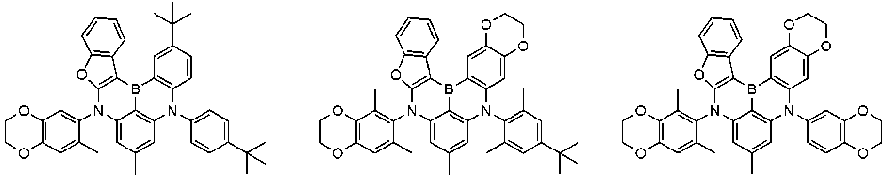

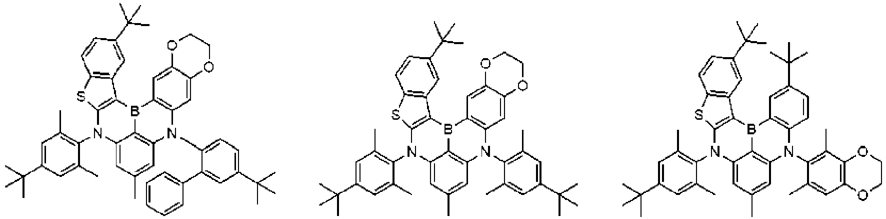

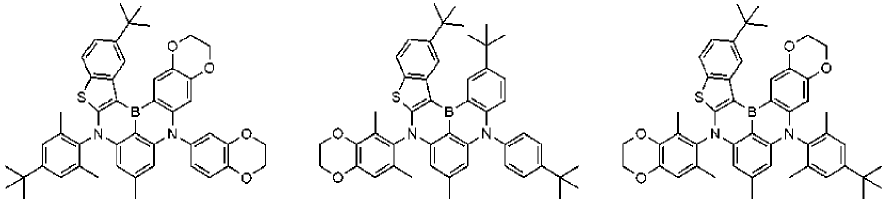

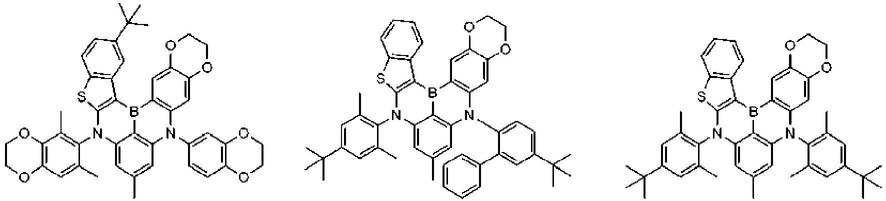

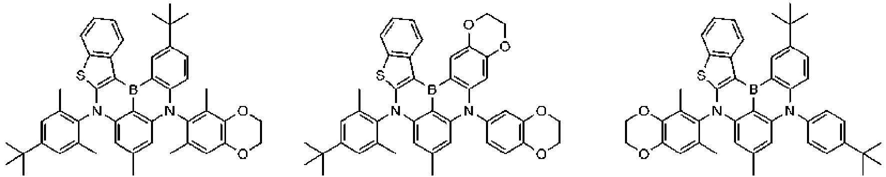

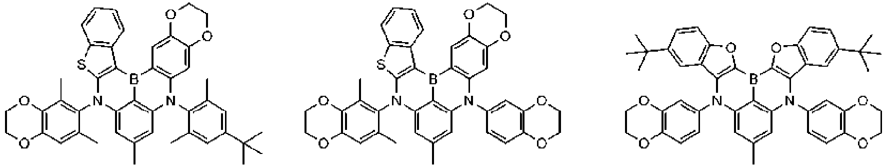

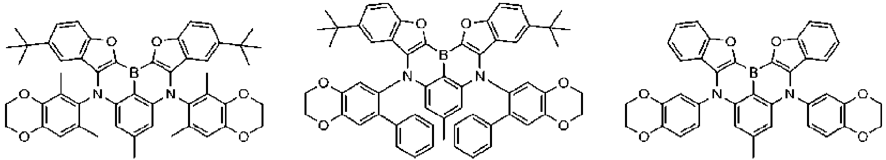

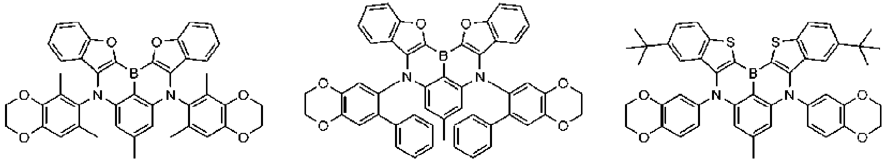

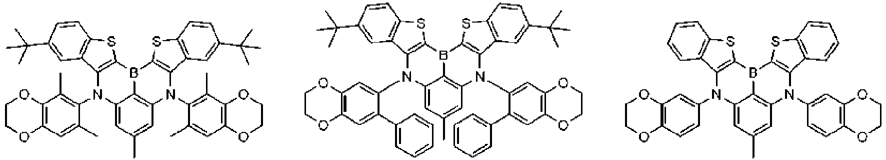

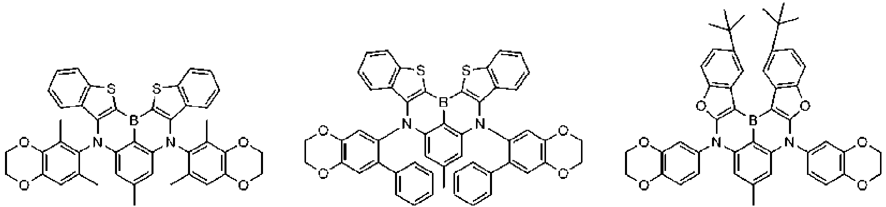

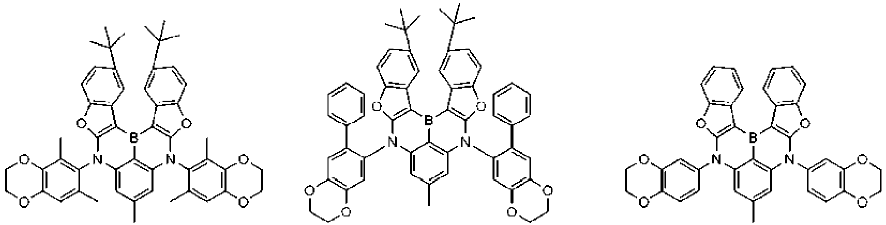

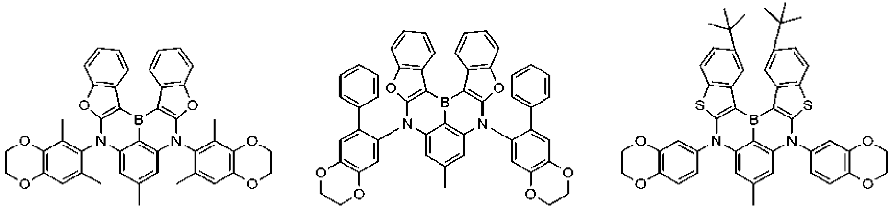

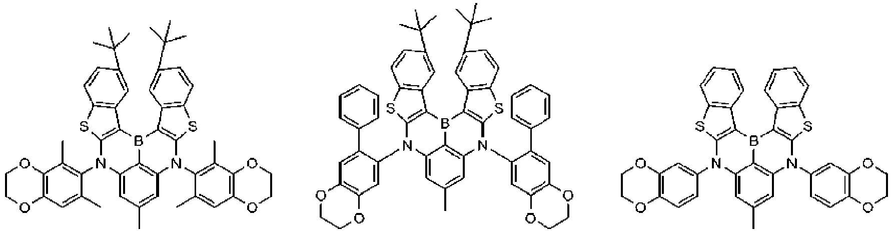

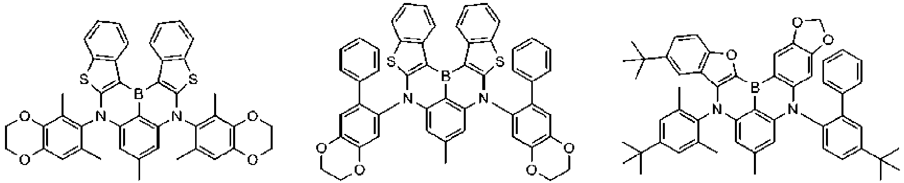

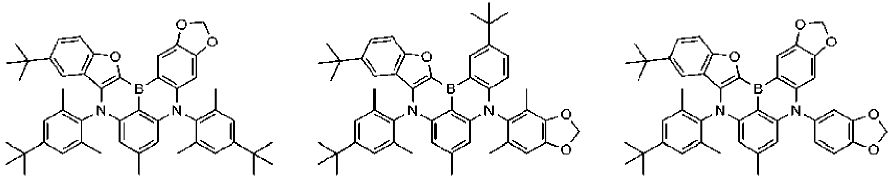

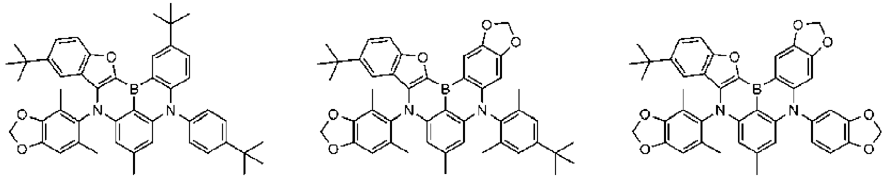

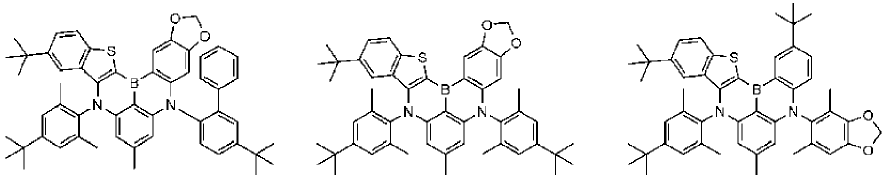

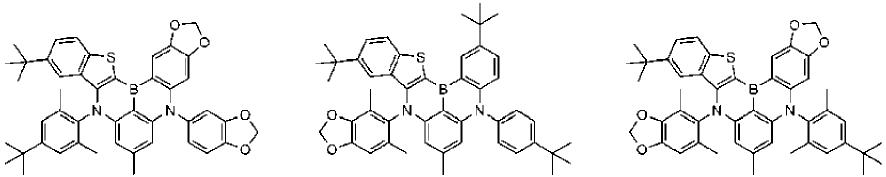

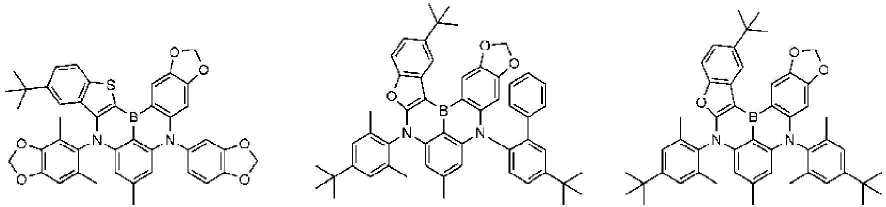

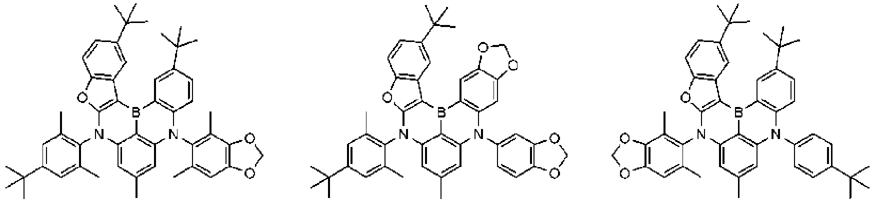

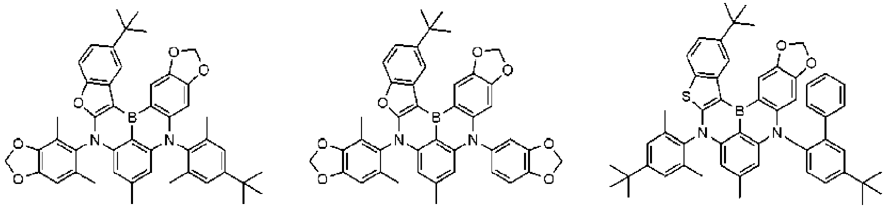

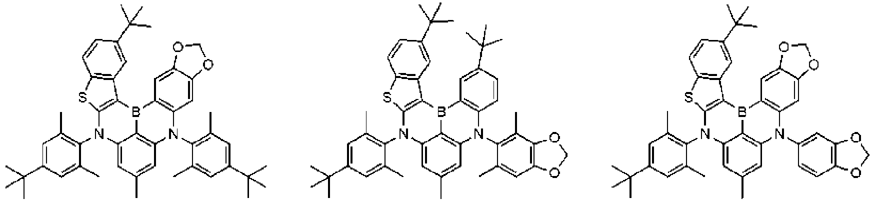

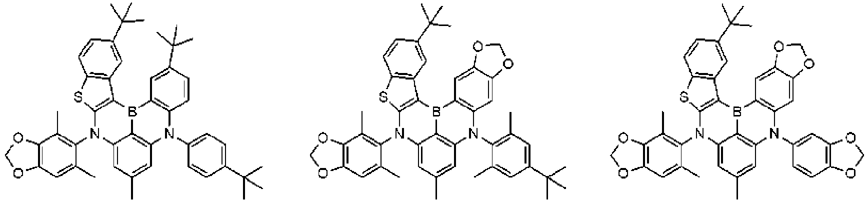

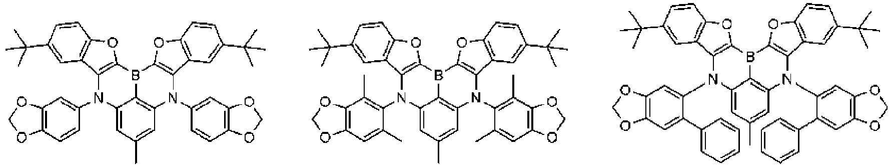

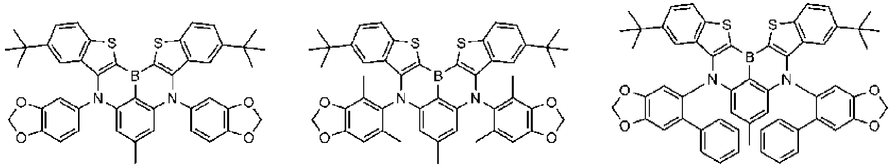

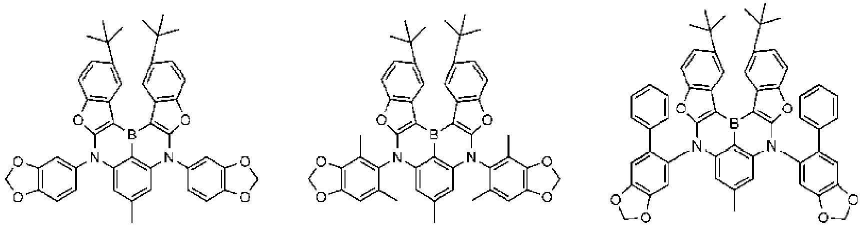

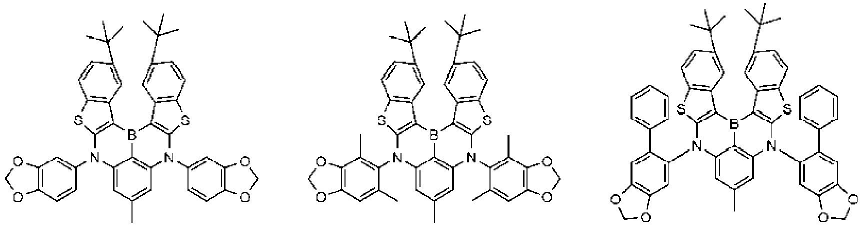

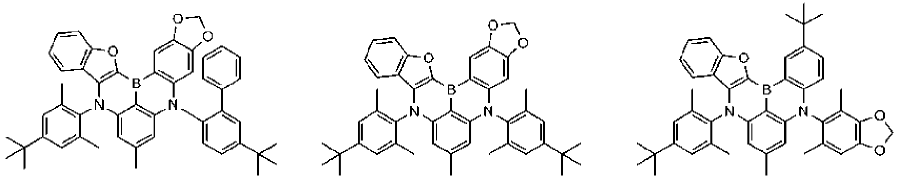

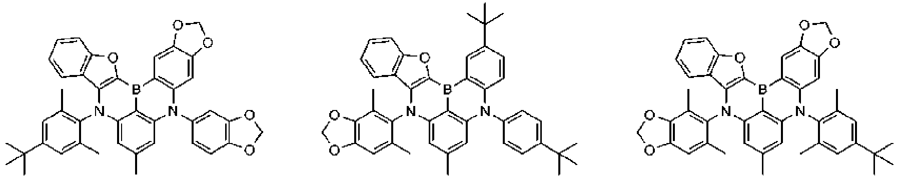

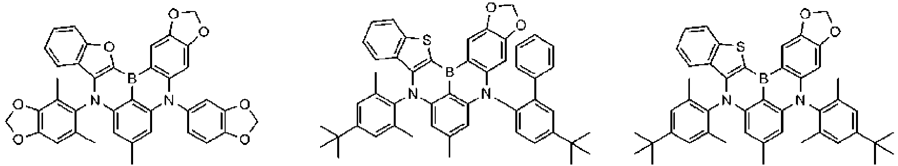

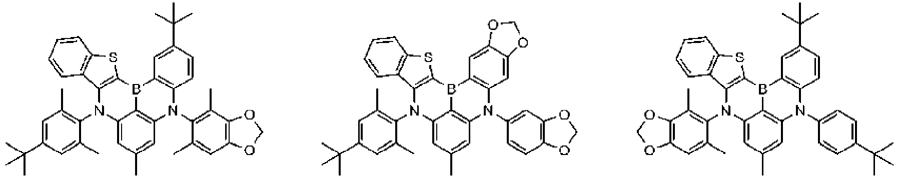

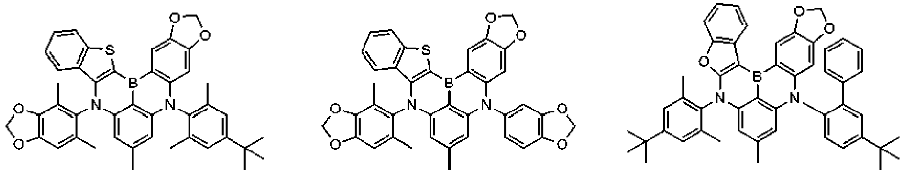

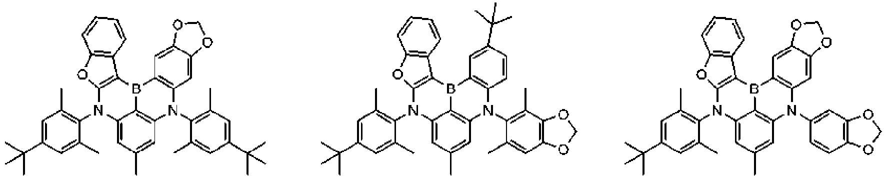

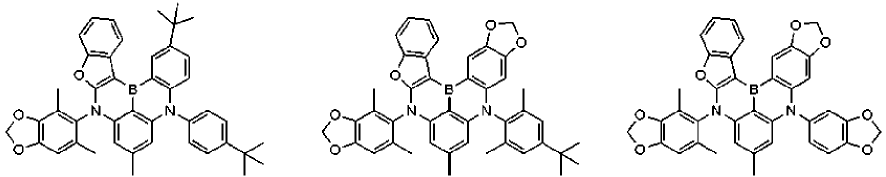

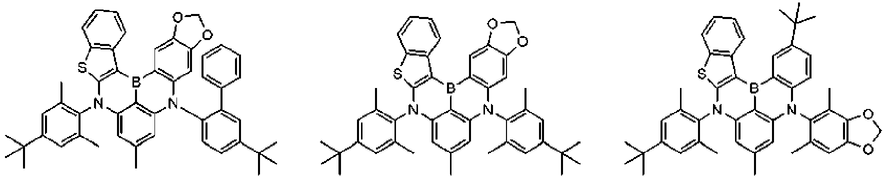

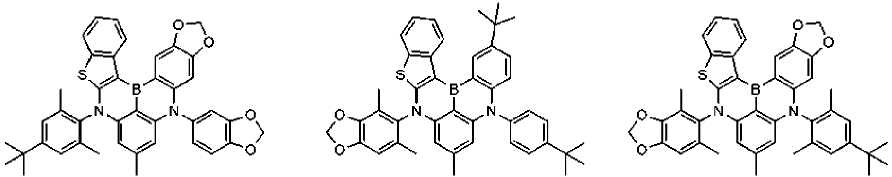

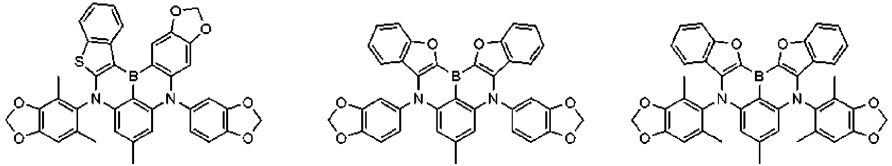

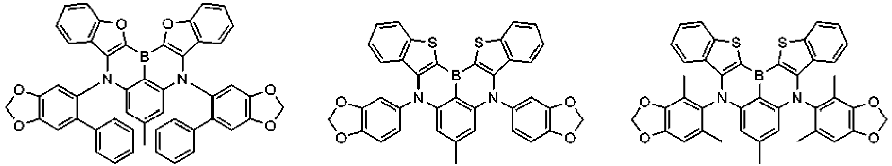

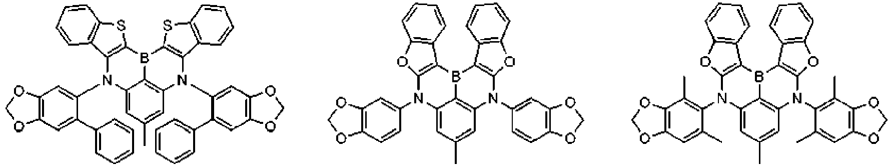

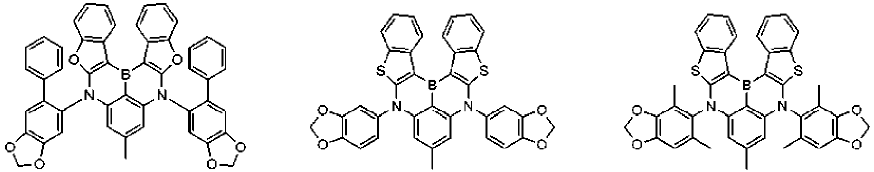

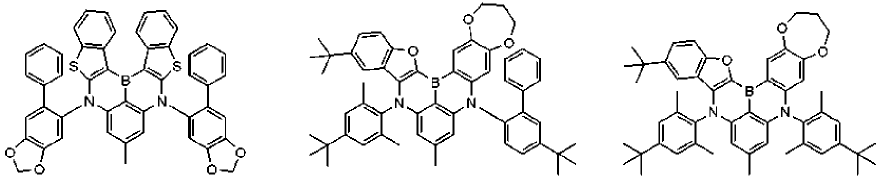

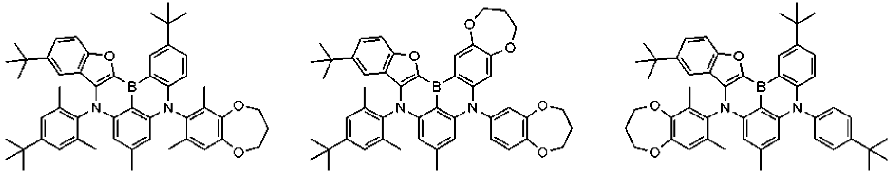

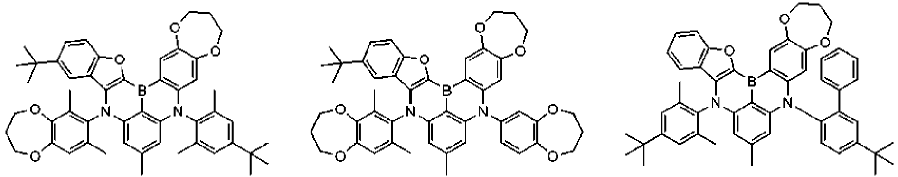

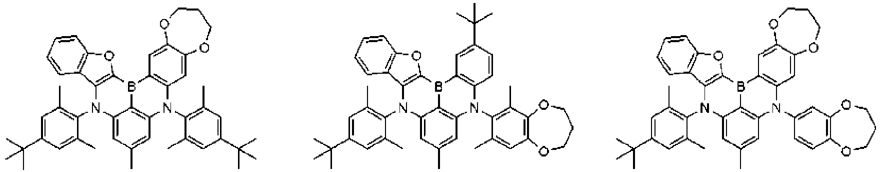

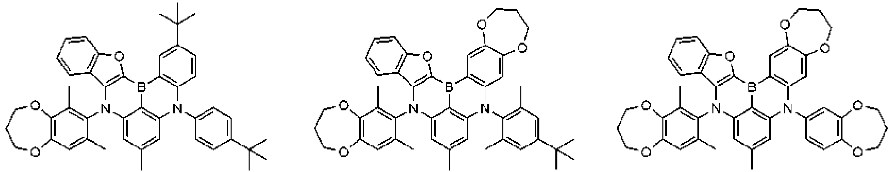

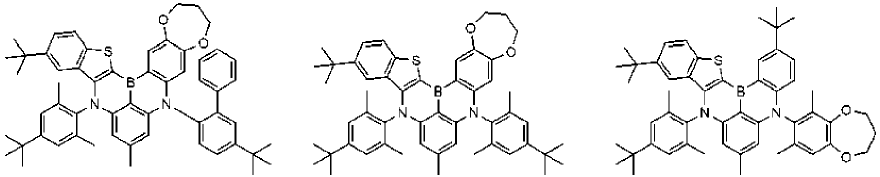

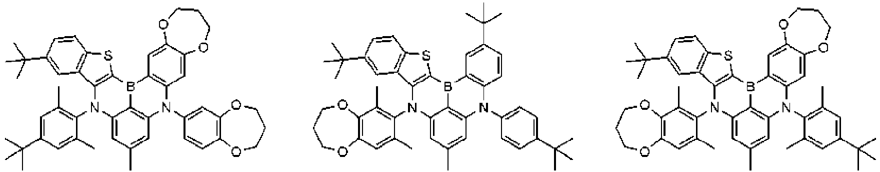

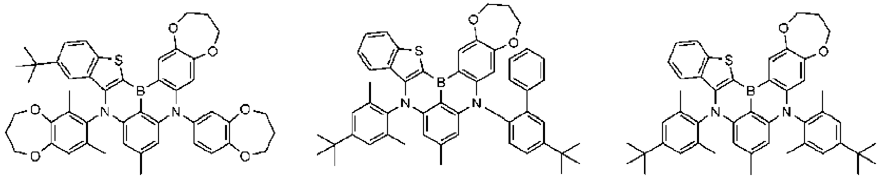

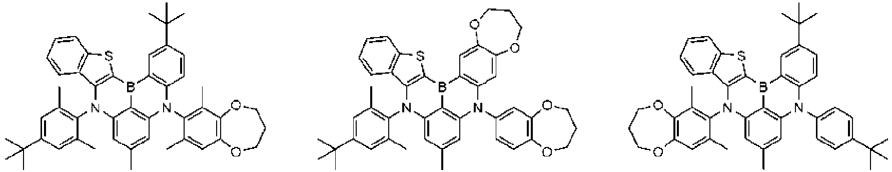

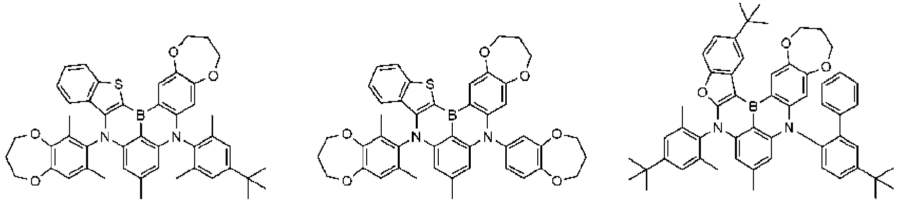

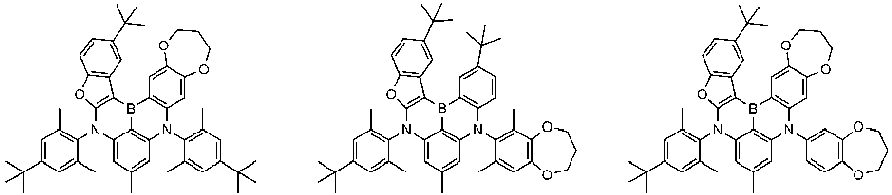

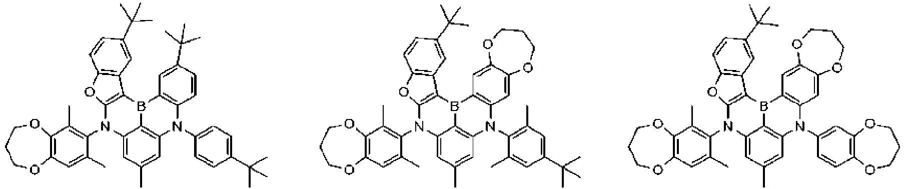

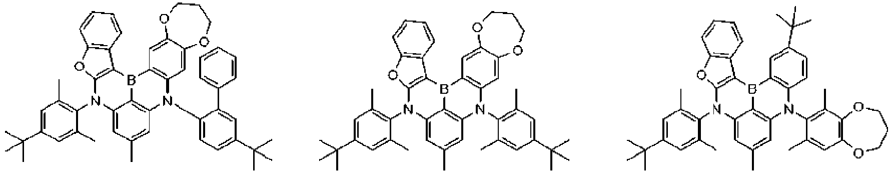

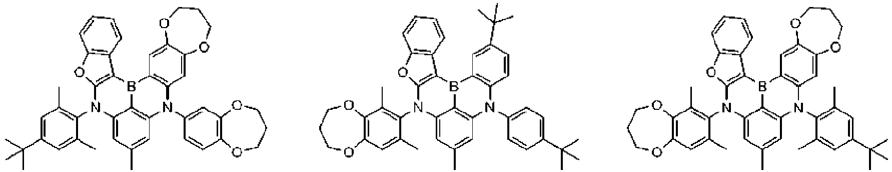

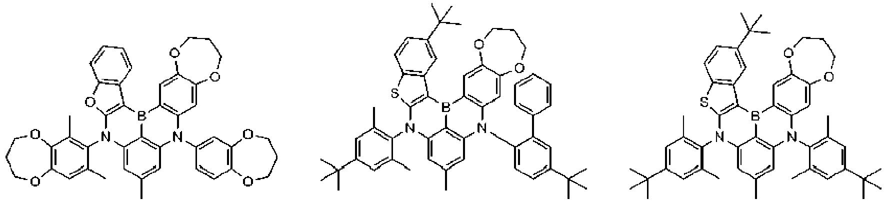

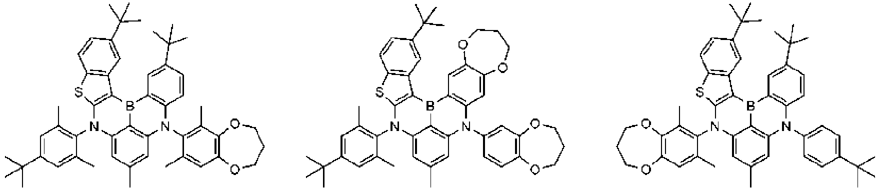

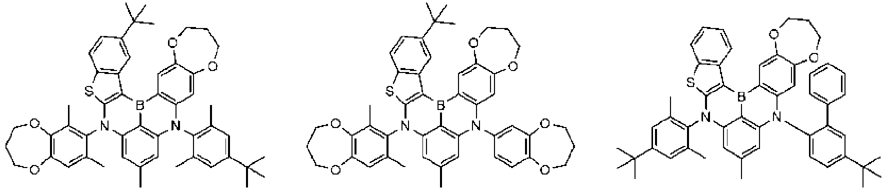

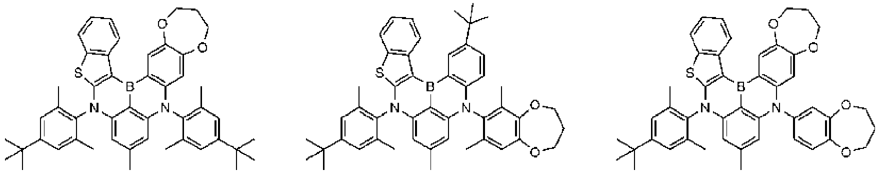

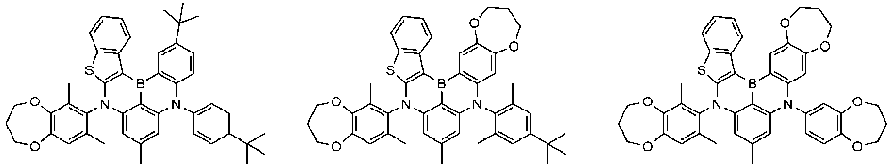

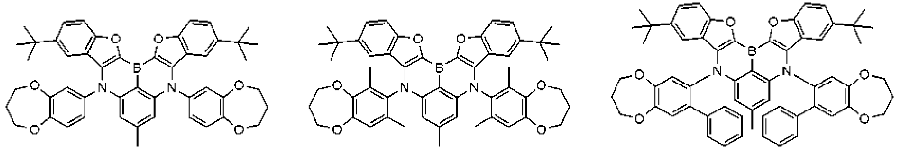

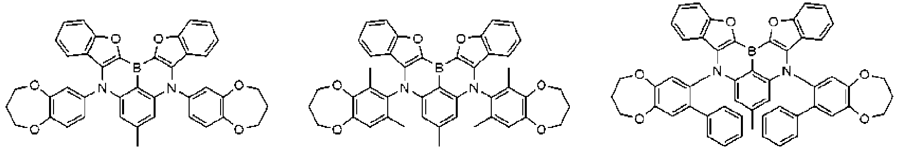

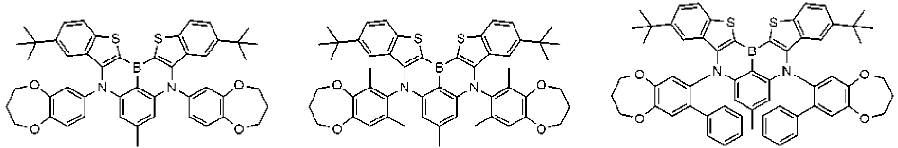

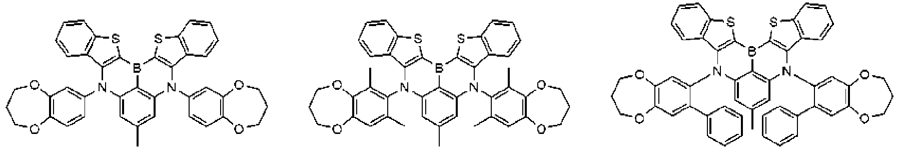

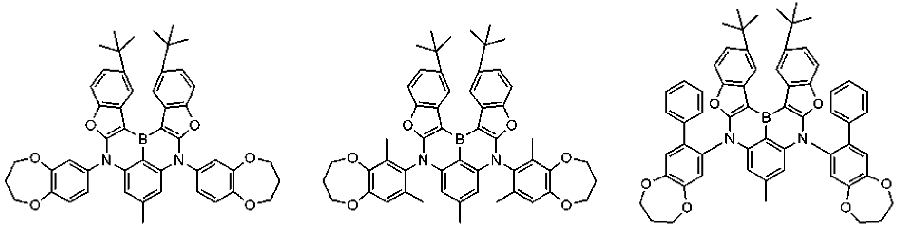

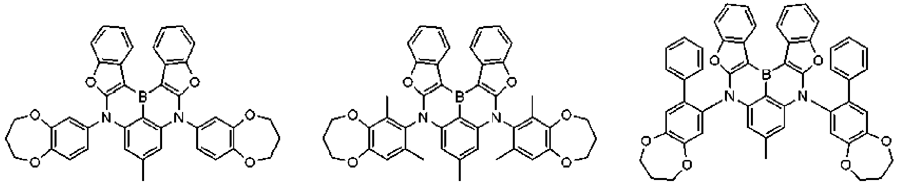

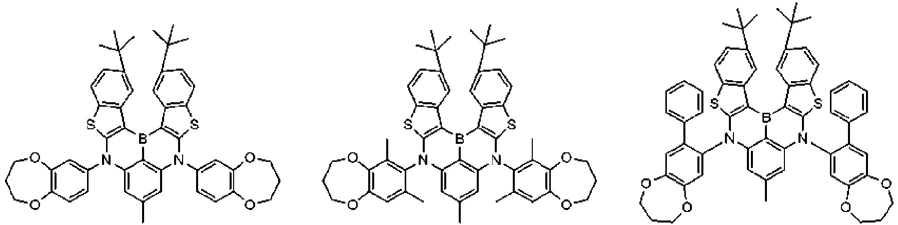

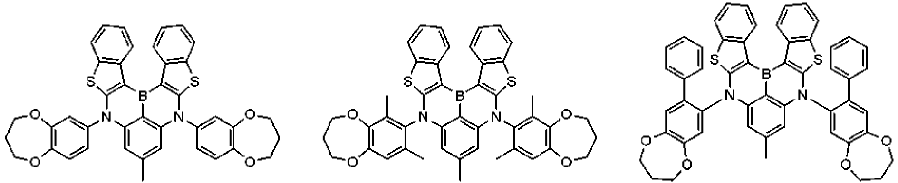

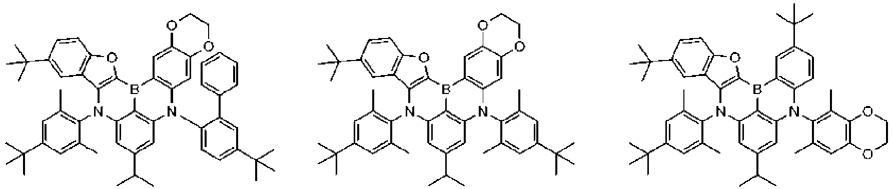

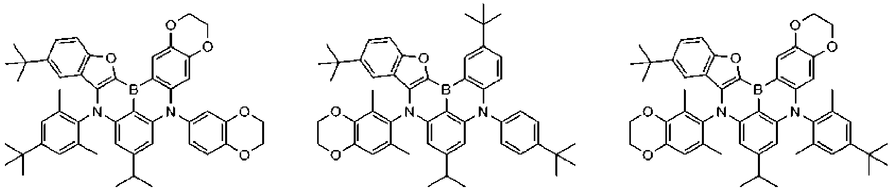

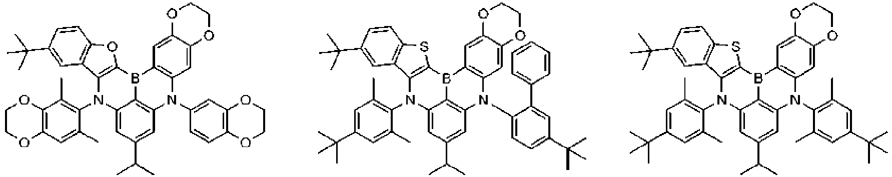

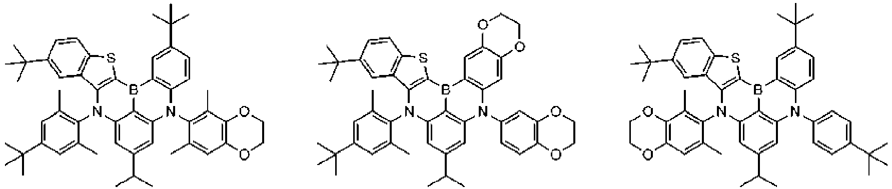

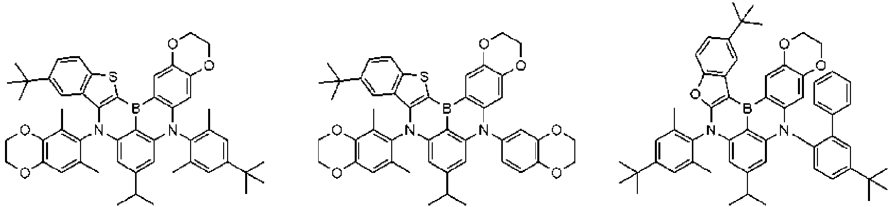

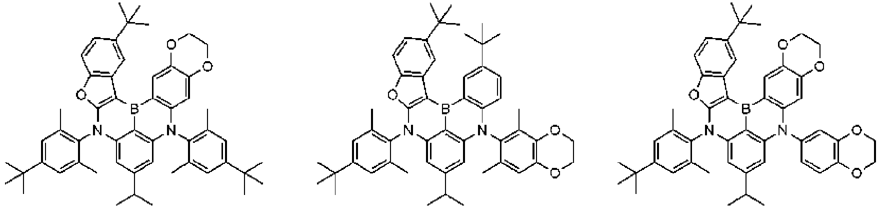

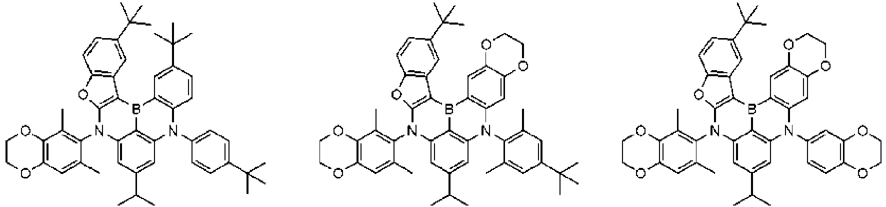

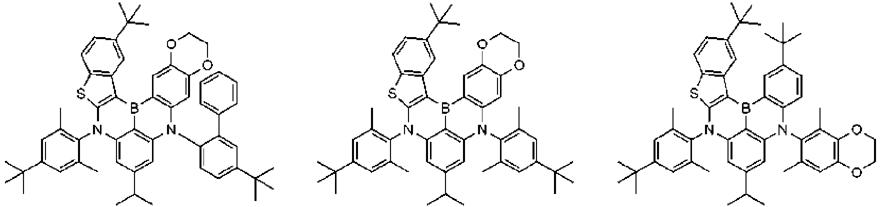

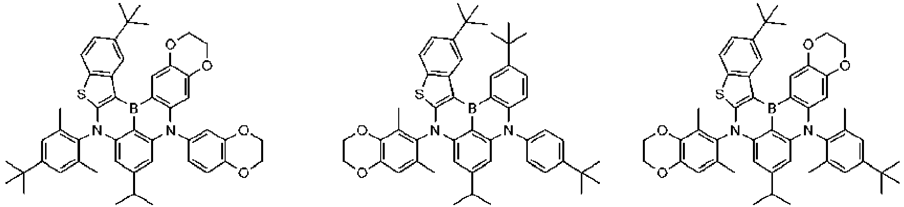

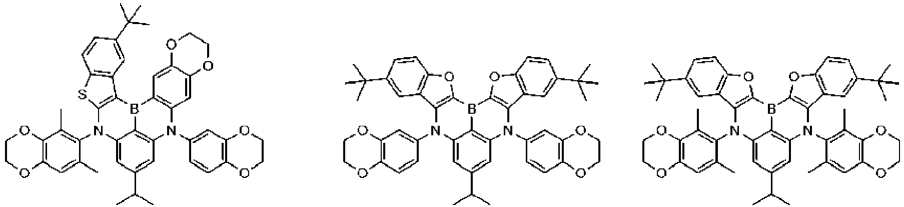

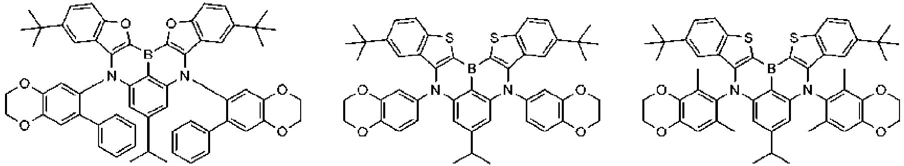

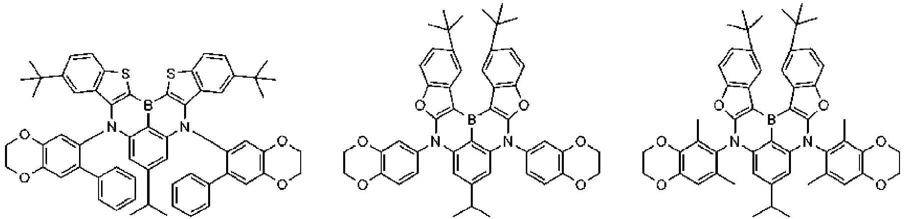

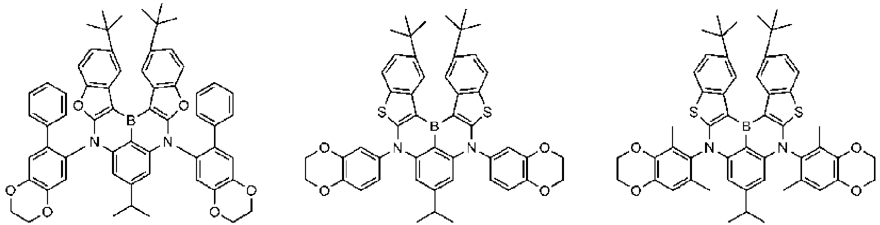

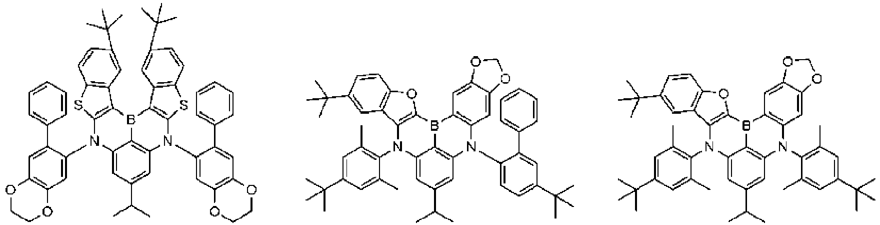

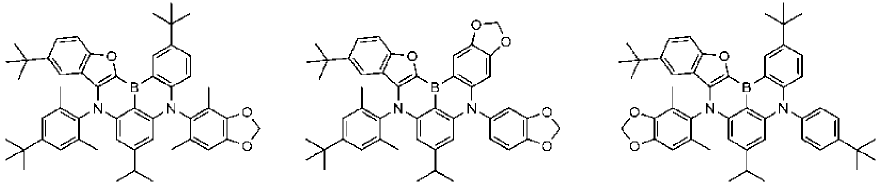

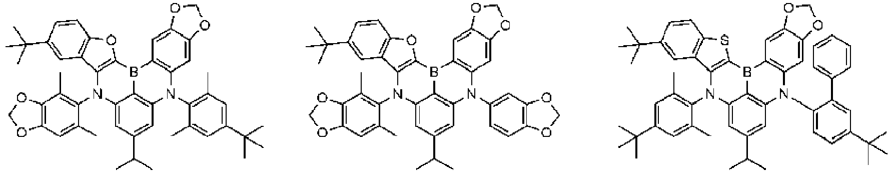

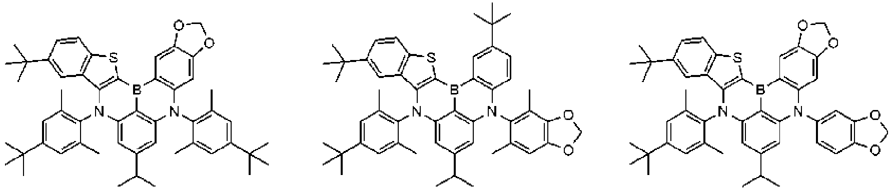

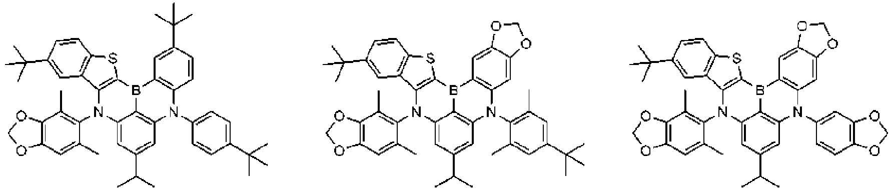

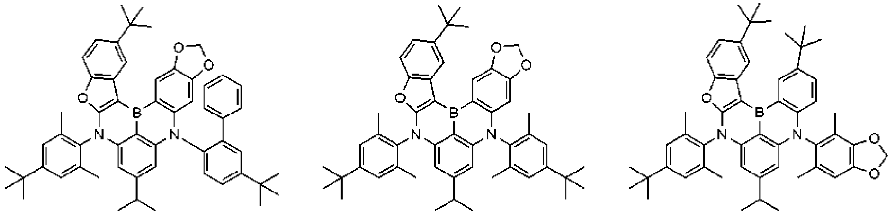

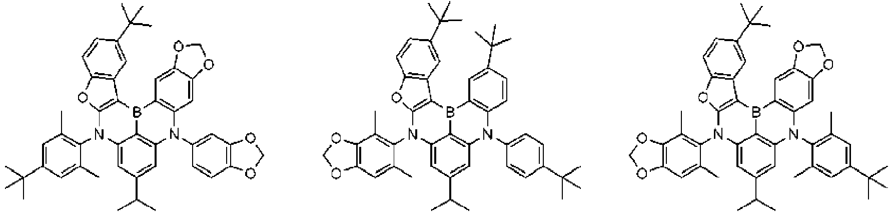

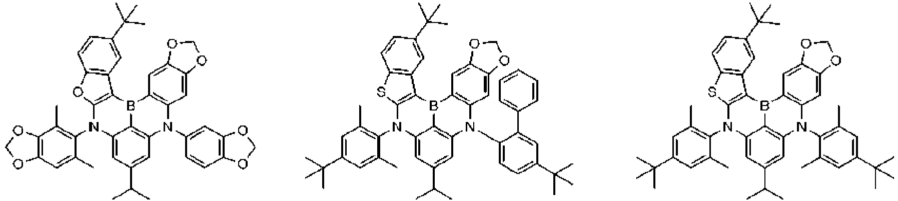

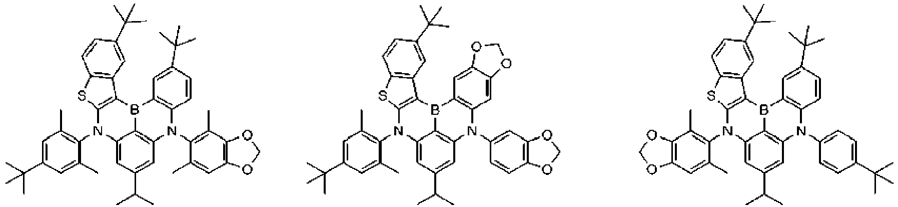

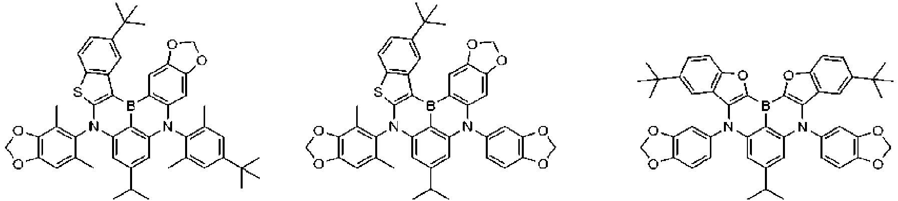

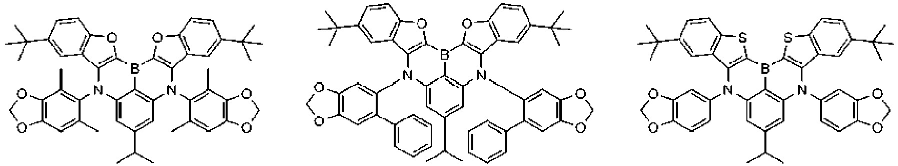

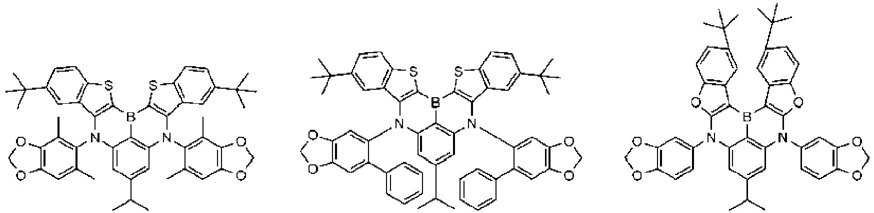

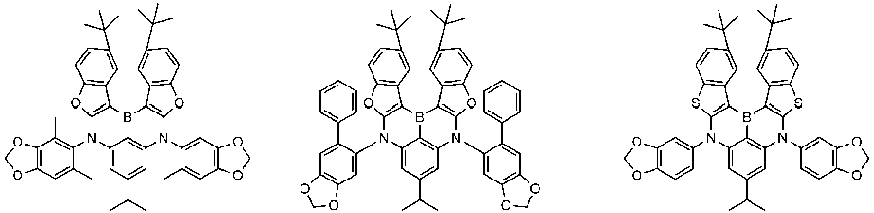

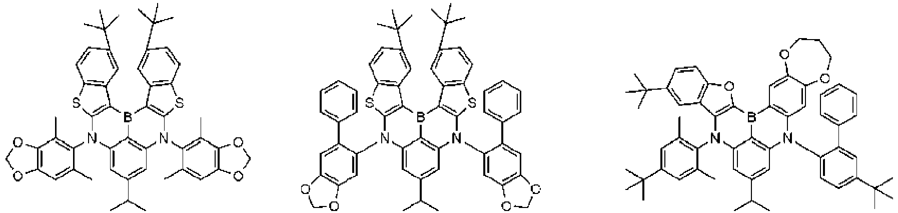

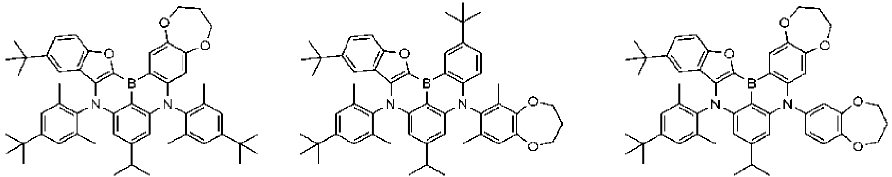

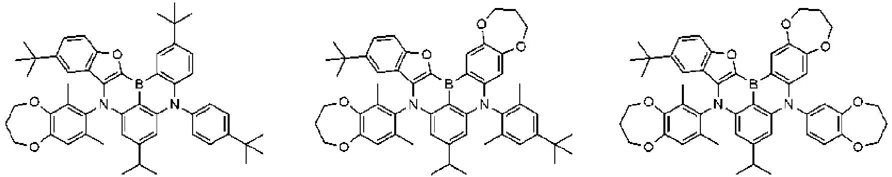

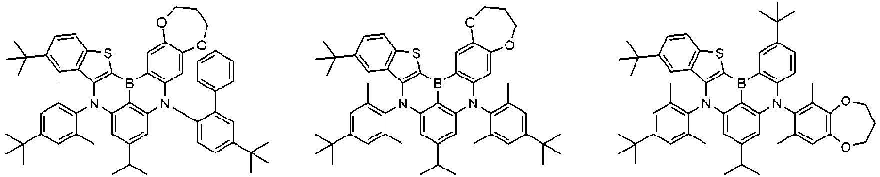

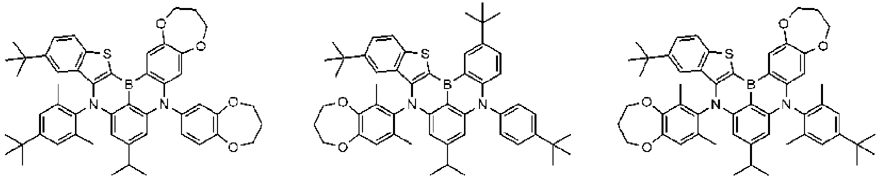

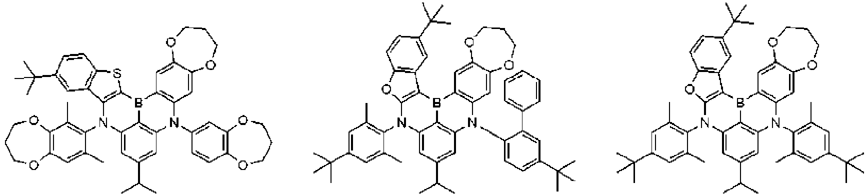

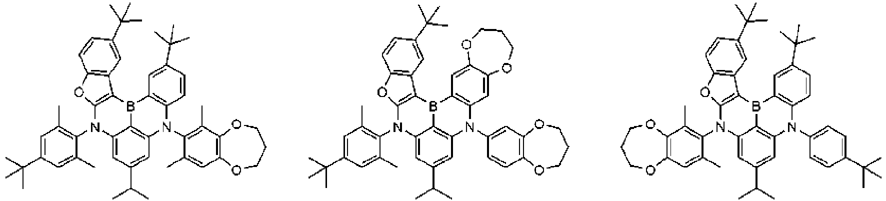

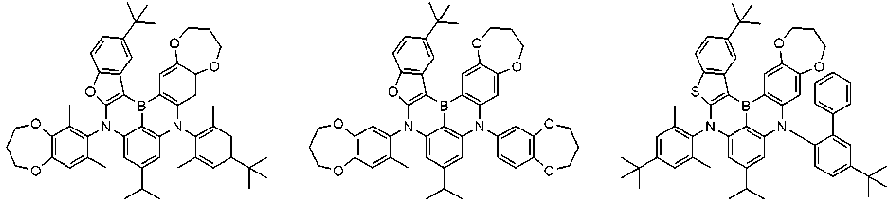

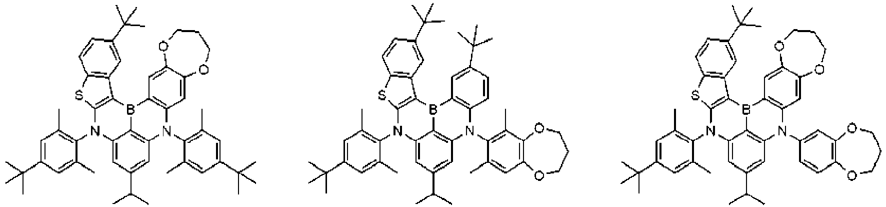

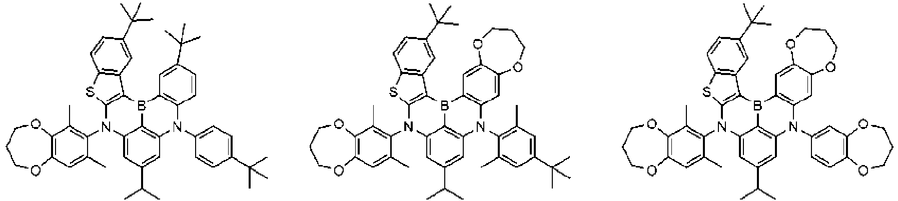

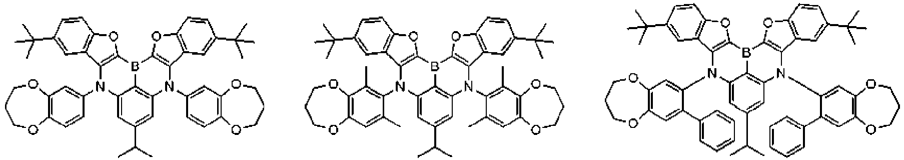

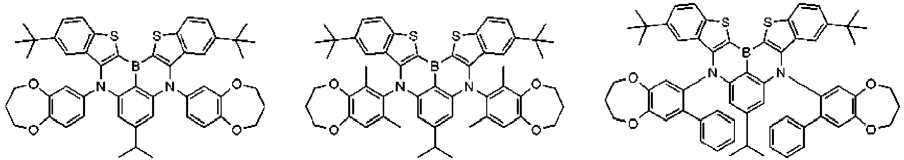

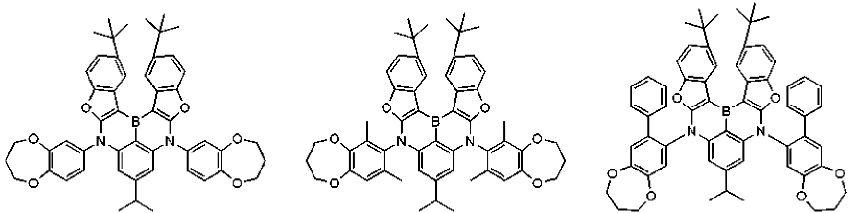

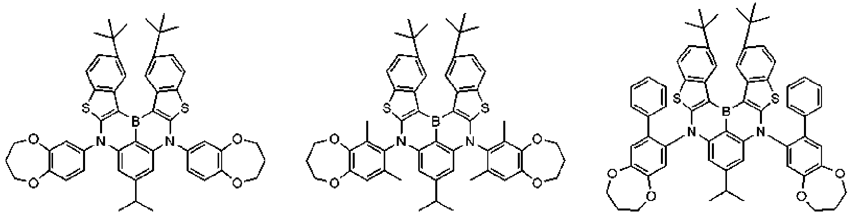

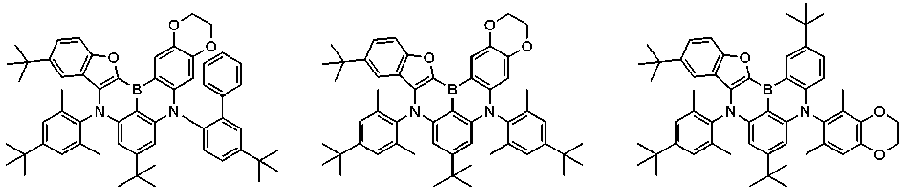

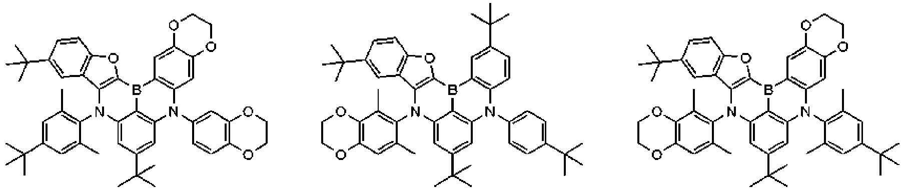

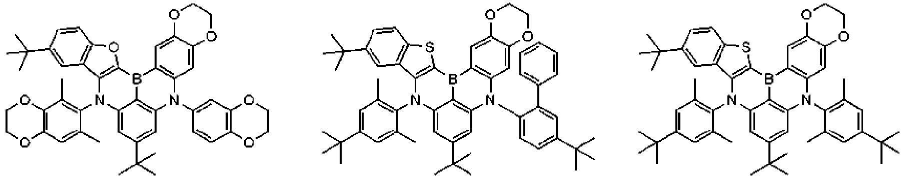

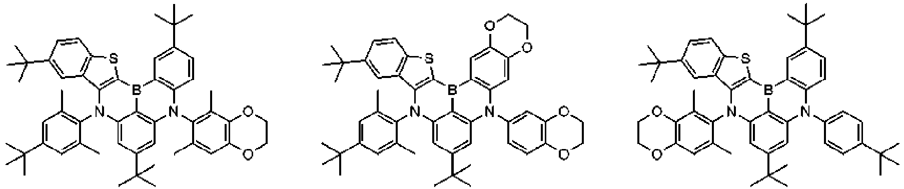

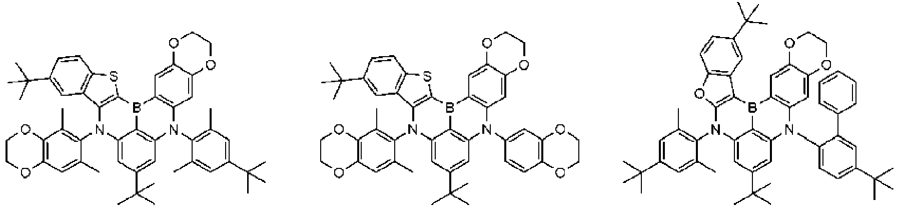

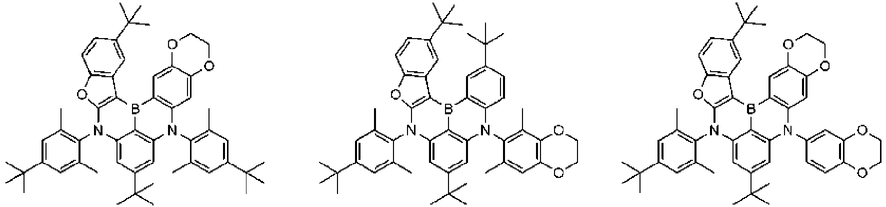

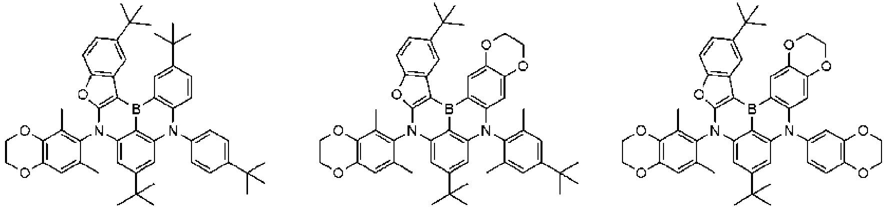

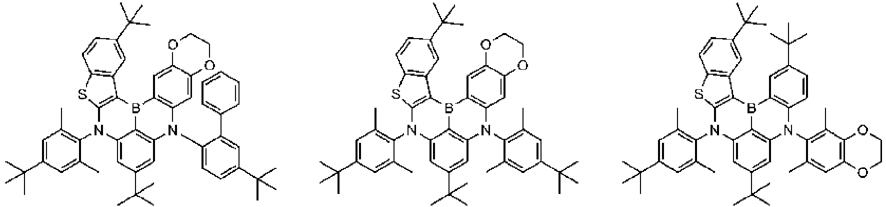

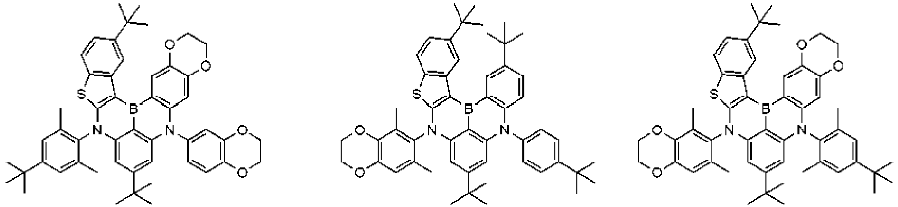

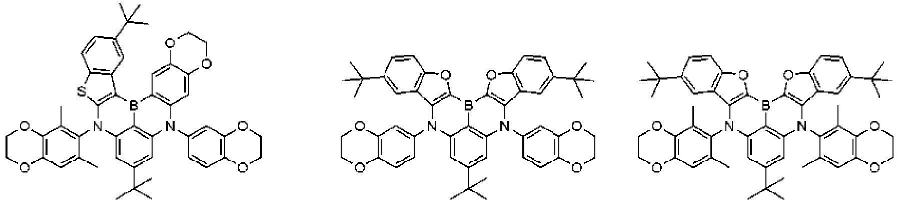

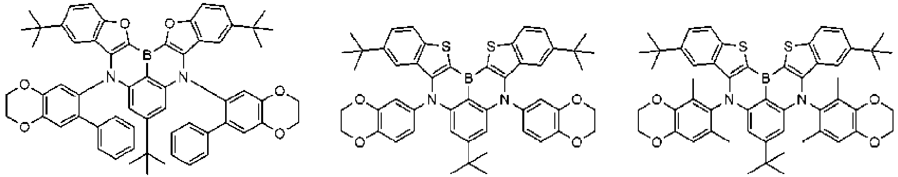

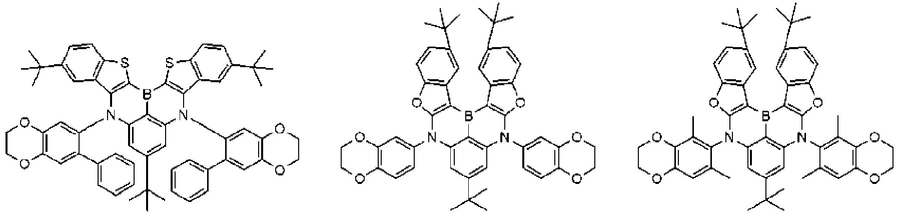

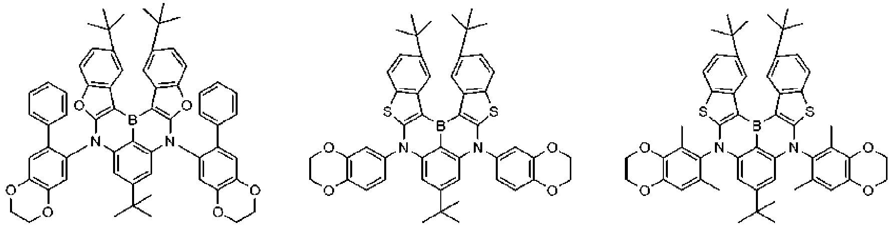

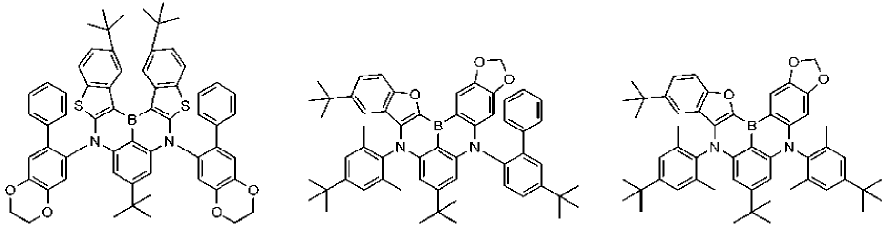

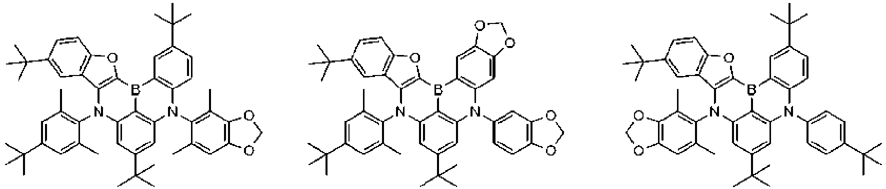

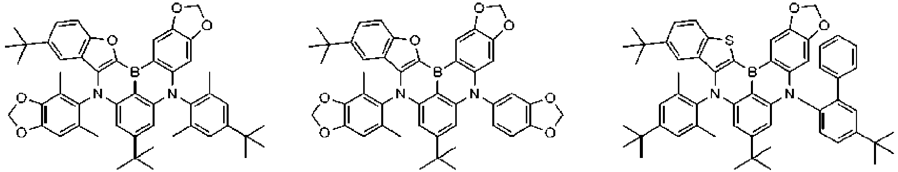

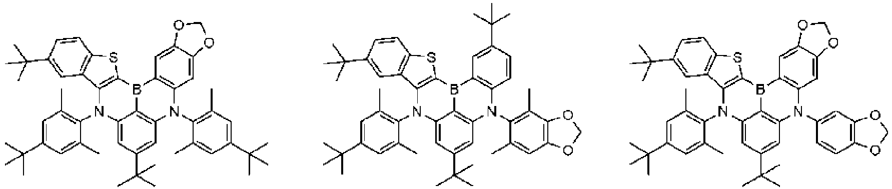

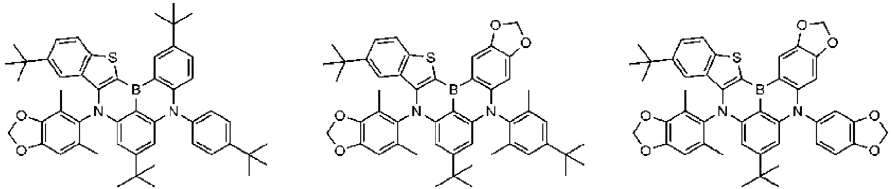

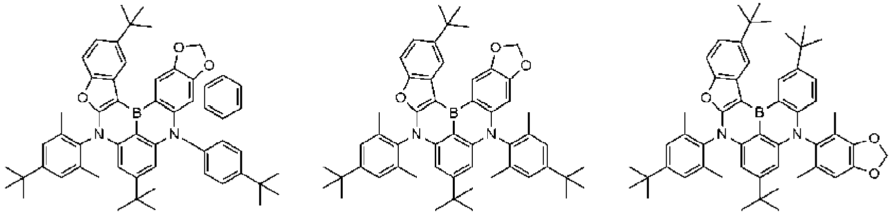

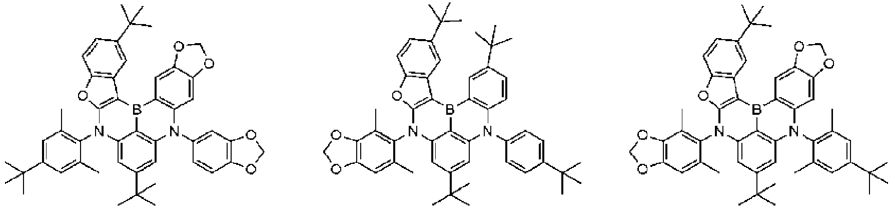

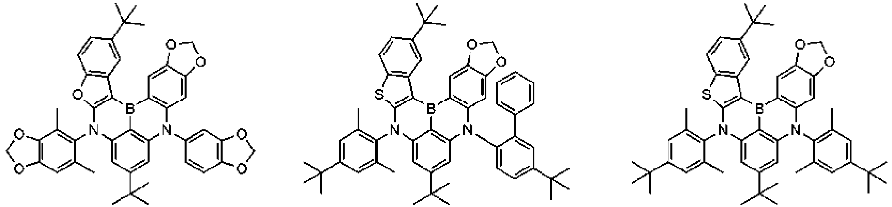

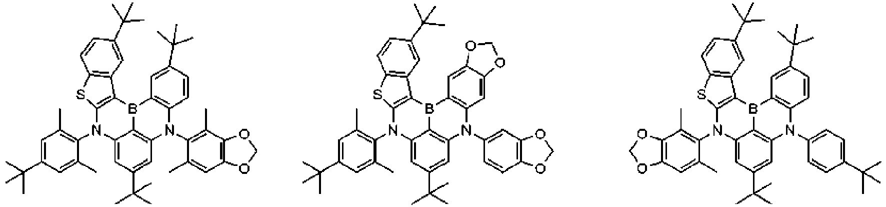

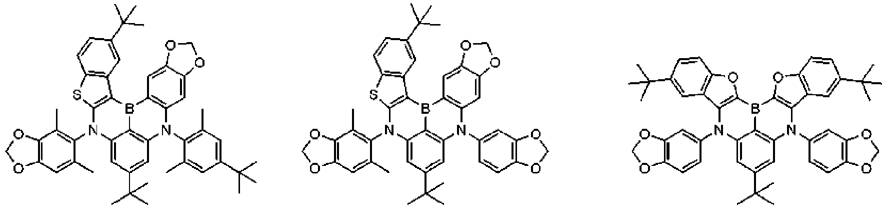

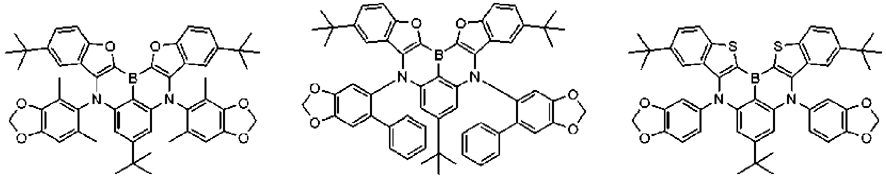

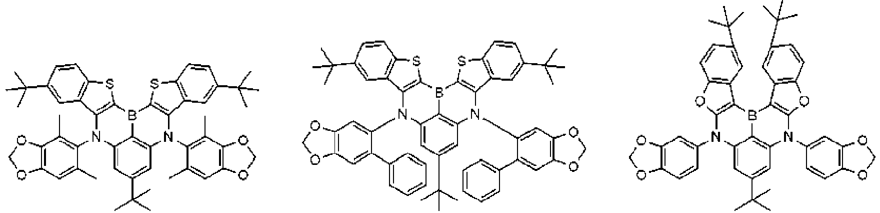

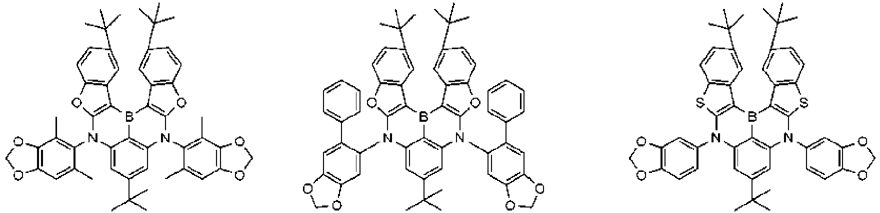

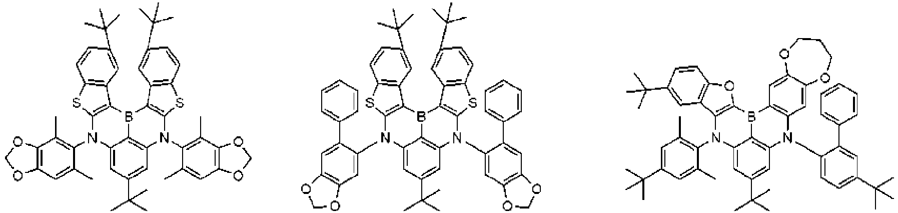

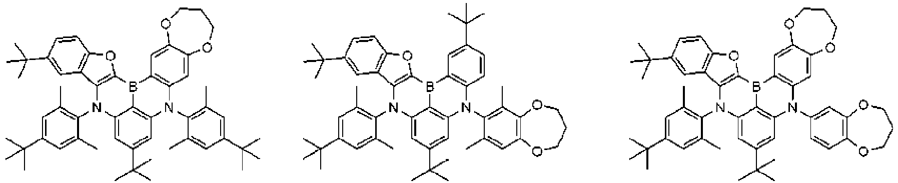

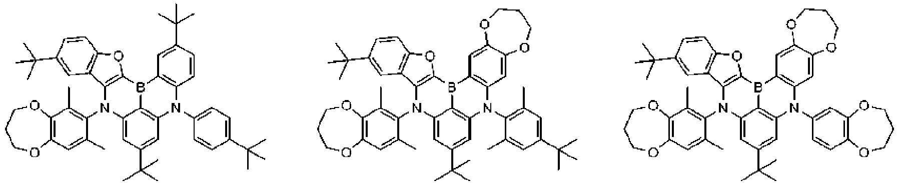

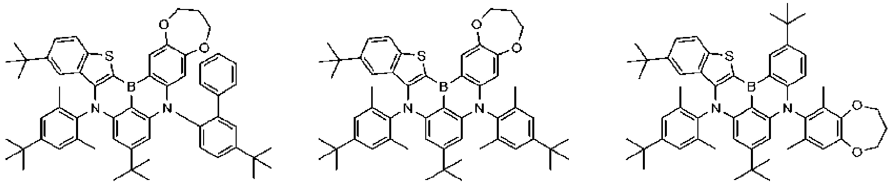

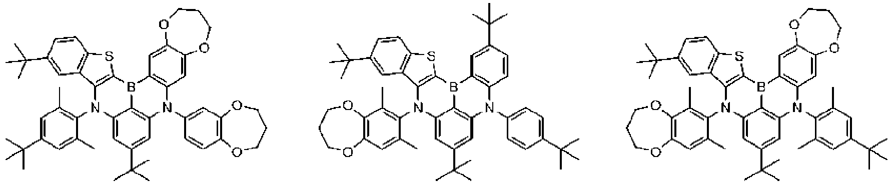

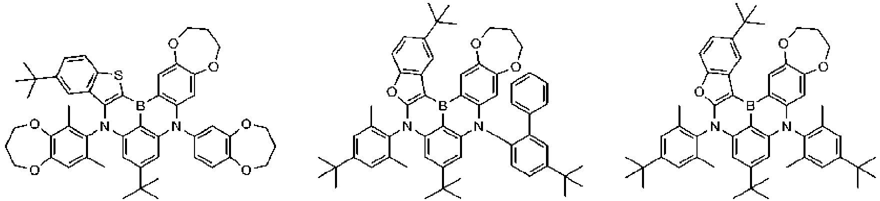

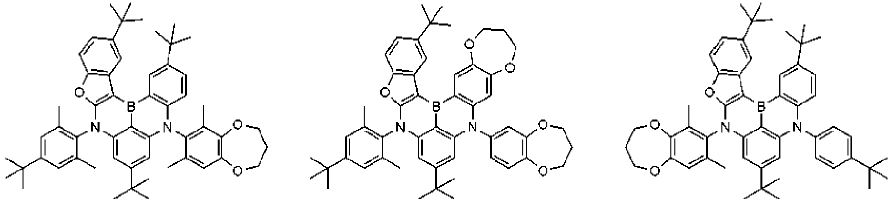

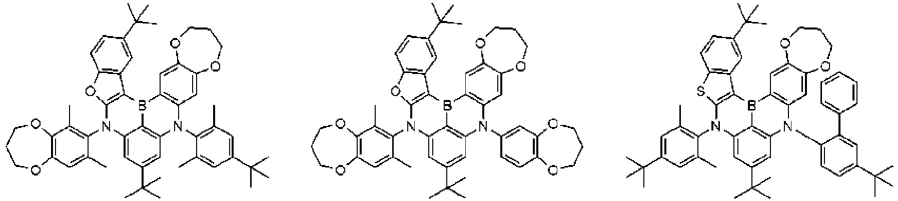

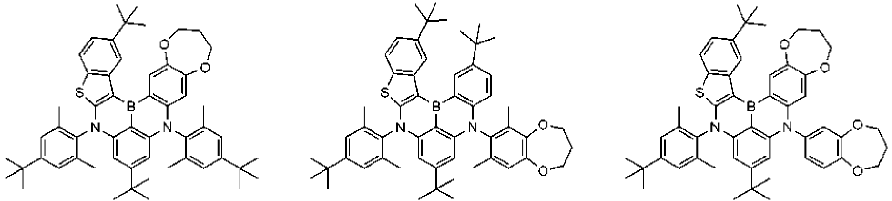

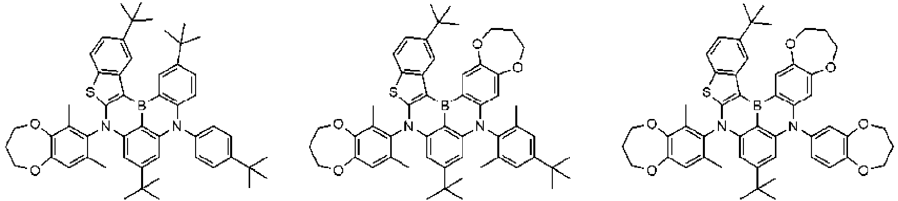

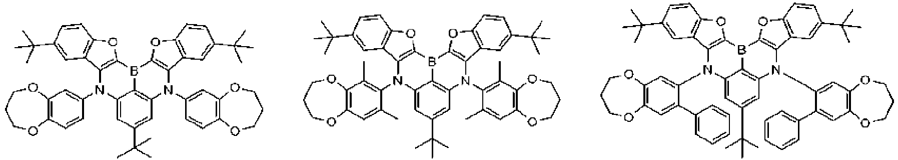

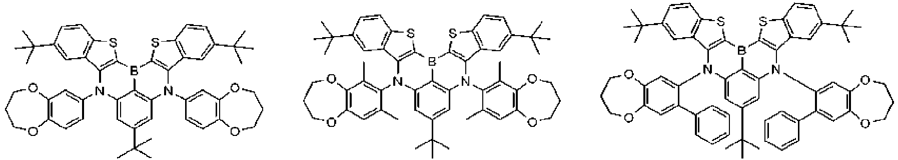

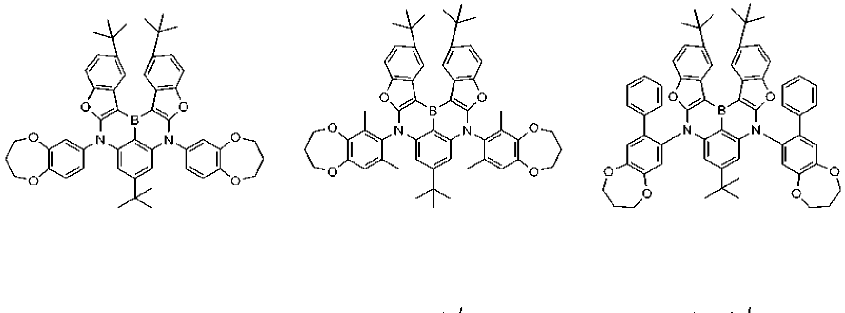

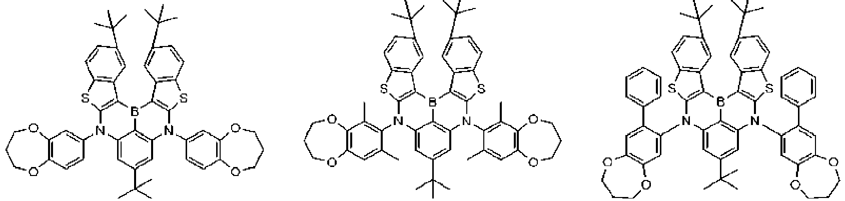

10. Organische lichtemittierende Vorrichtung, umfassend: eine erste Elektrode; eine zweite Elektrode, die gegenüber der ersten Elektrode angeordnet ist; und eine oder mehrere Schichten aus organischem Material, die zwischen der ersten Elektrode und der zweiten Elektrode angeordnet sind, wobei mindestens eine Schicht der Schichten aus organischem Material die Verbindung gemäß mindestens einem der Ansprüche 1 bis 9 umfasst.

11. Organische lichtemittierende Vorrichtung gemäß Anspruch 10,
wobei die Schicht aus organischem Material, die die Verbindung umfasst, eine lichtemittierende Schicht ist.

## Revendications

1. Composé représenté par la formule chimique 1 suivante : 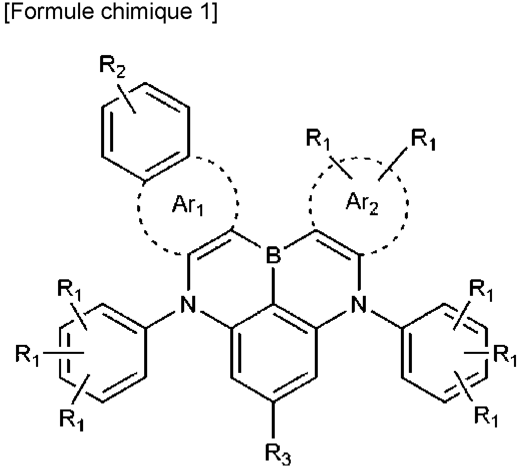 dans la formule chimique 1,
Ar₁ est furane ou thiophène, qui est fusionné avec deux cycles adjacents,
Ar₂ est benzène, benzofurane ou benzothiophène, qui est fusionné avec un cycle adjacent,
chaque R₁ est indépendamment hydrogène, deutérium, un alkyle en C₁₋₆₀ substitué ou non substitué, ou un aryle en C₆₋₆₀ substitué ou non substitué, ou deux R₁ adjacents sont combinés pour former -O-(CH₂)ₘ-O-, dans lequel m est un nombre entier de 1 à 4 ;
R₂ est hydrogène, deutérium, ou un alkyle en C₁₋₆₀ substitué ou non substitué, et
R₃ est hydrogène, deutérium ou un alkyle en C₁₋₆₀ substitué ou non substitué, à condition que la formule chimique 1 comprenne au moins un -Q-(CH₂)m-Q- formé par la combinaison de deux R₁ adjacents.

2. Composé selon la revendication 1,
dans lequel la formule chimique 1 est représentée par l'une quelconque des formules chimiques 1-1 à 1-4 suivantes : 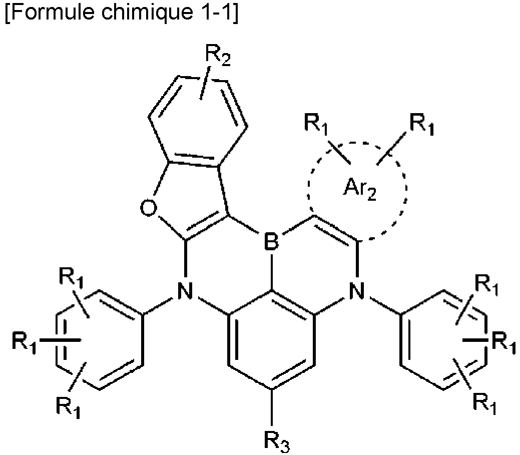 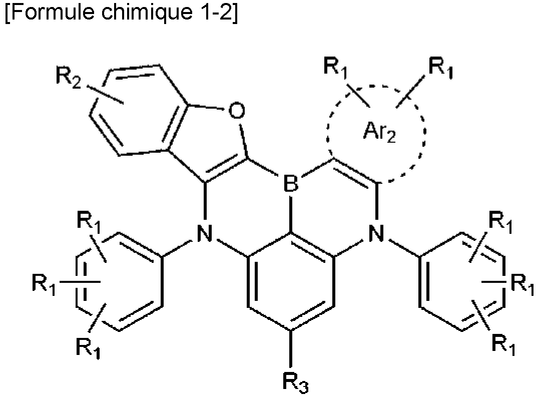 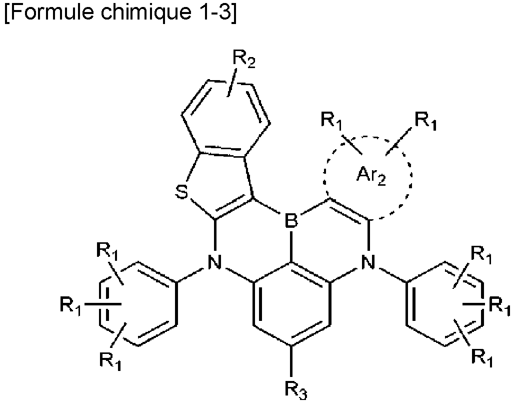 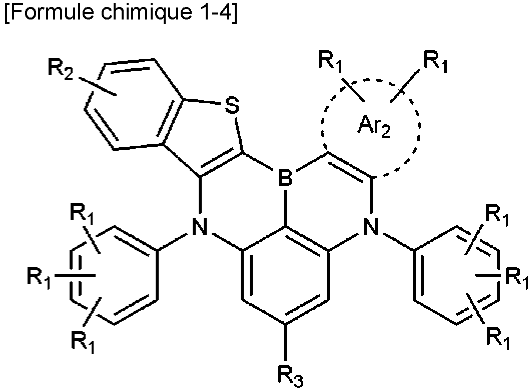
dans les formules chimiques 1-1 à 1-4,
Ar₂ et R₁ à R₃ sont tels que définis dans la revendication 1.

3. Composé selon la revendication 1,
dans lequel chaque R₁ est indépendamment hydrogène, deutérium, alkyle en C₁₋₁₀, ou aryle en C₆₋₂₀, ou deux R₁ adjacents sont combinés pour former

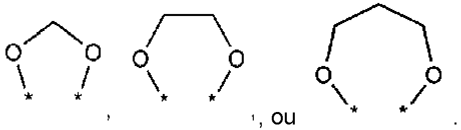

4. Composé selon la revendication 1,
dans lequel chaque R₁ est indépendamment hydrogène, deutérium, méthyle, éthyle, propyle, isopropyle, butyle, isobutyle, tertbutyle, ou phényle, ou deux R₁ adjacents sont combinés pour former

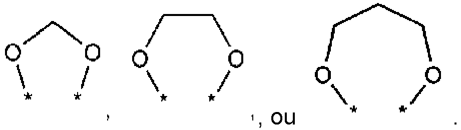

5. Composé selon la revendication 1,
dans lequel R₂ est hydrogène, deutérium ou alkyle en C₁₋₁₀.

6. Composé selon la revendication 1,
dans lequel R₂ est hydrogène, deutérium, méthyle, éthyle, propyle, isopropyle, butyle, isobutyle, ou tertbutyle.

7. Composé selon la revendication 1,
dans lequel R₃ est hydrogène, deutérium, ou alkyle en C₁₋₁₀.

8. Composé selon la revendication 1,
dans lequel R₃ est hydrogène, deutérium, méthyle, éthyle, propyle, isopropyle, butyle, isobutyle, ou tertbutyle.

9. Composé selon la revendication 1,
dans lequel le composé représenté par la formule chimique 1 est l'un quelconque sélectionné parmi le groupe consistant en :

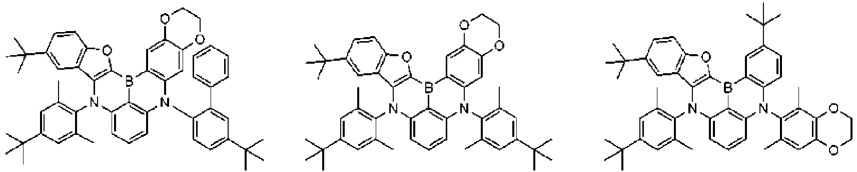

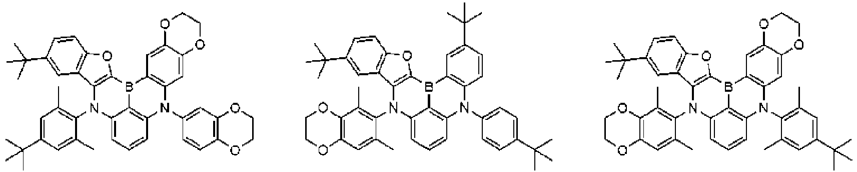

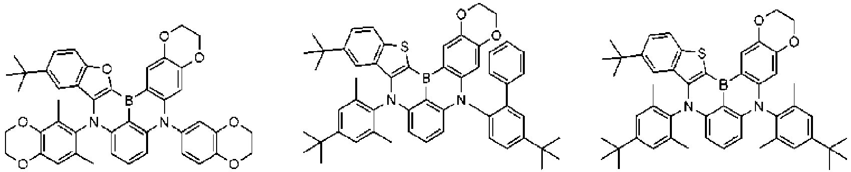

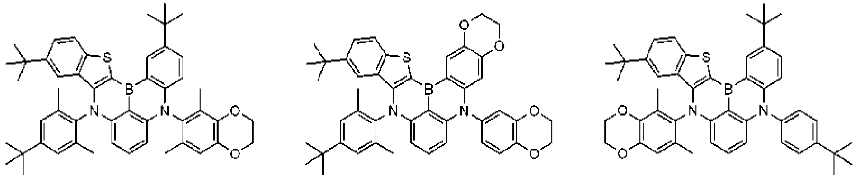

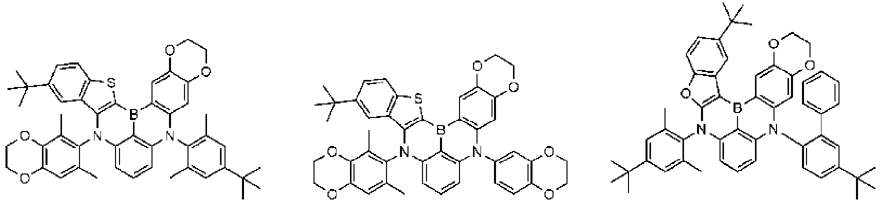

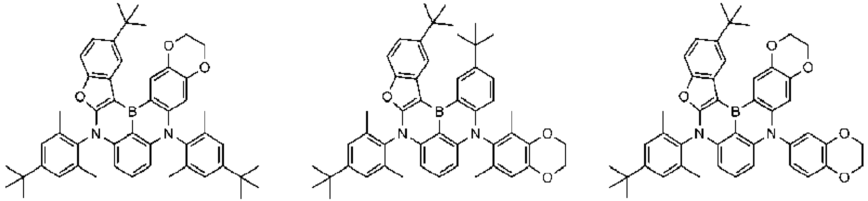

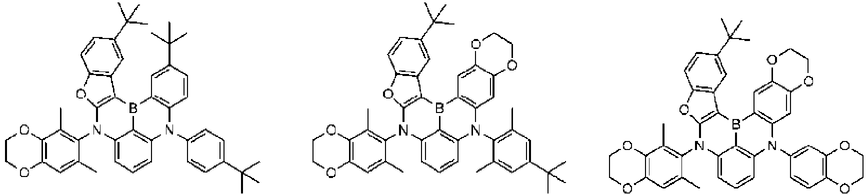

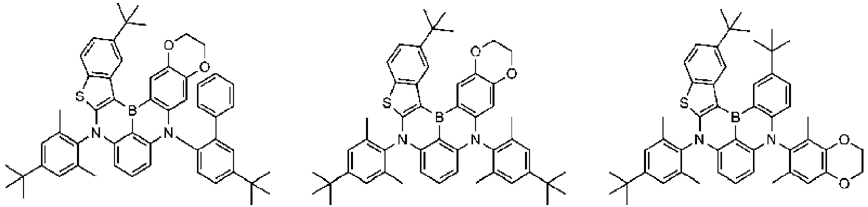

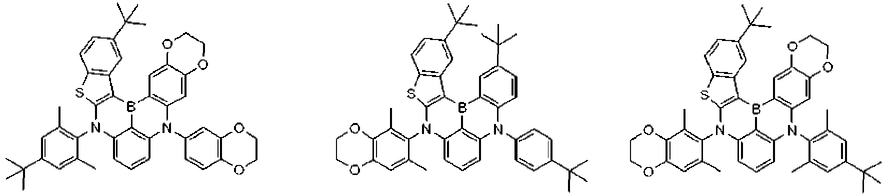

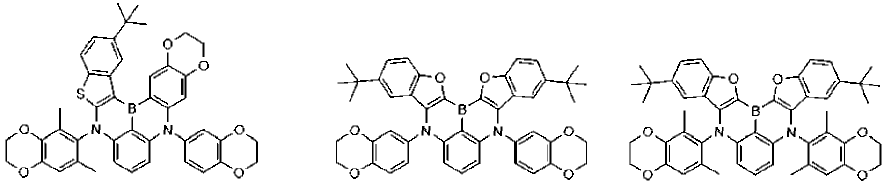

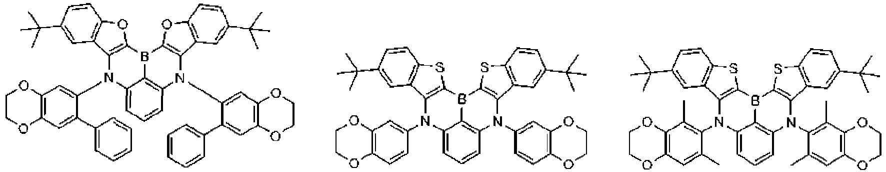

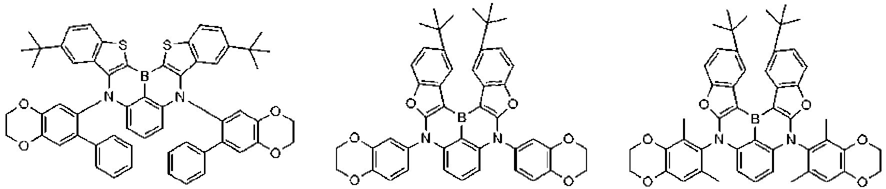

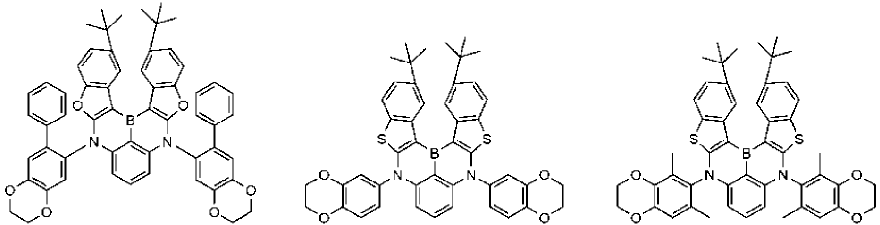

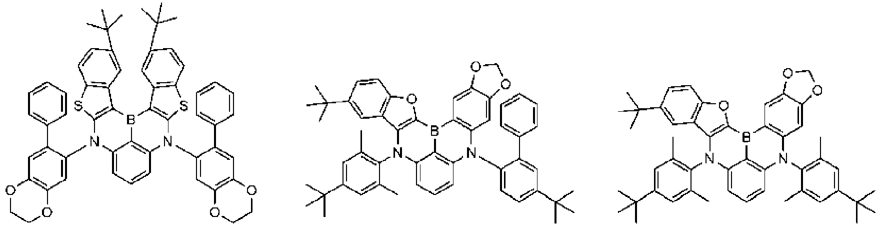

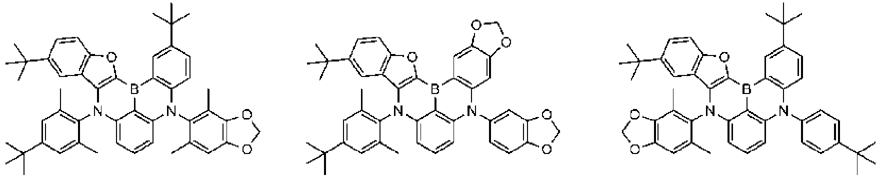

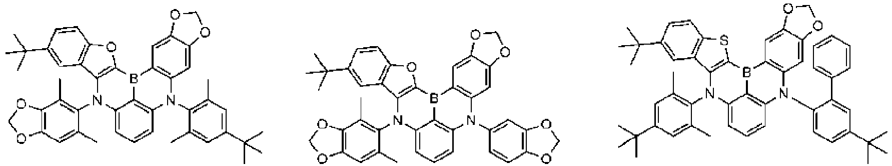

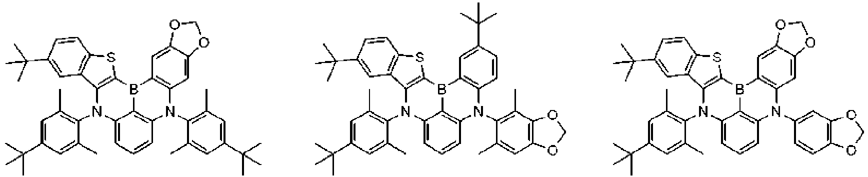

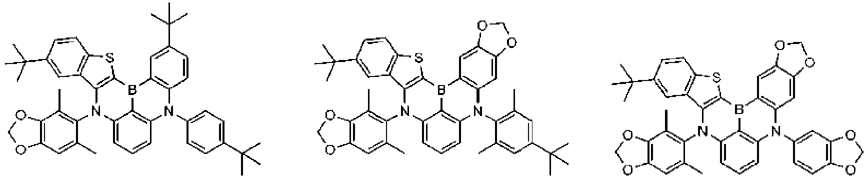

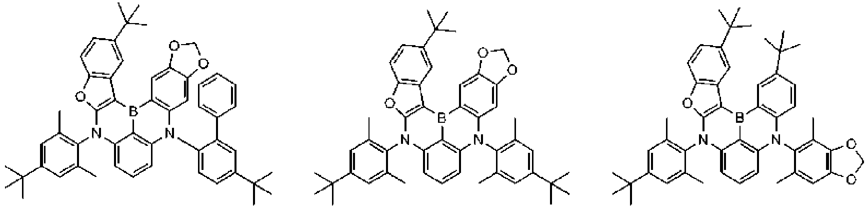

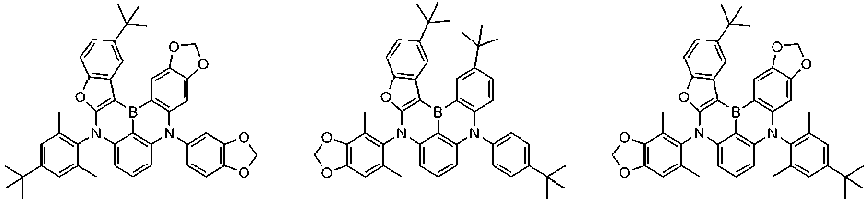

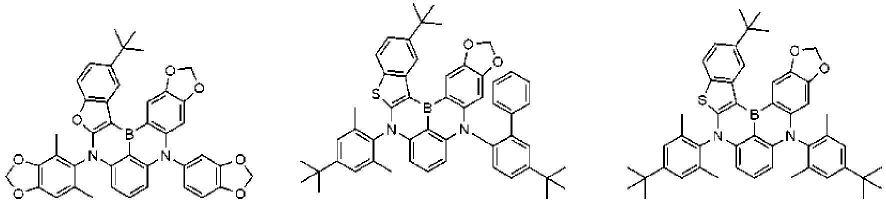

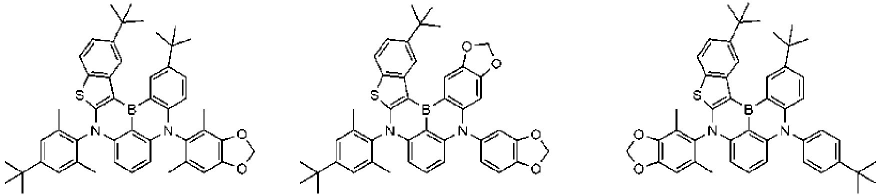

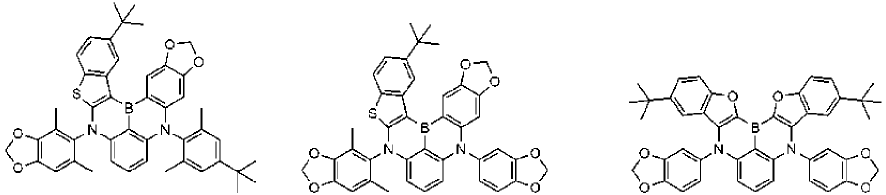

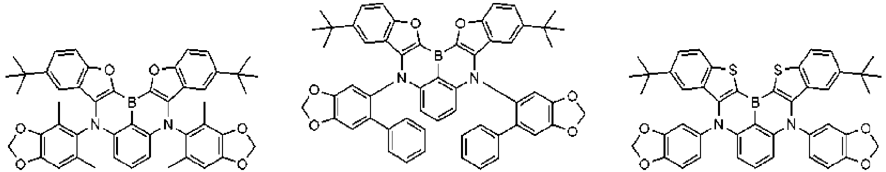

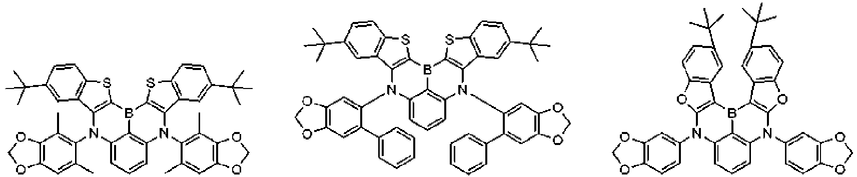

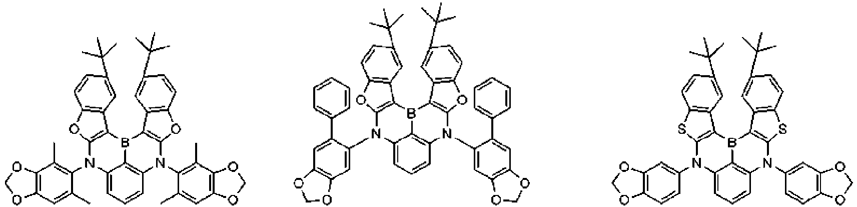

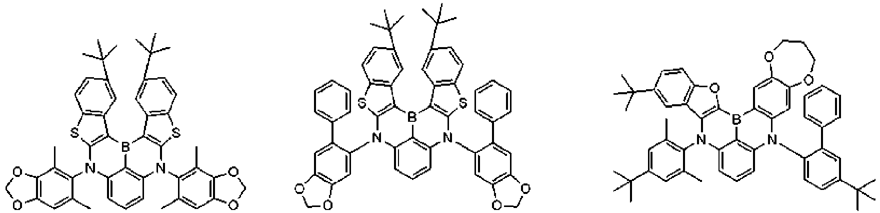

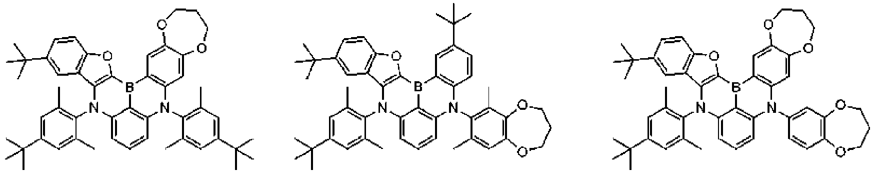

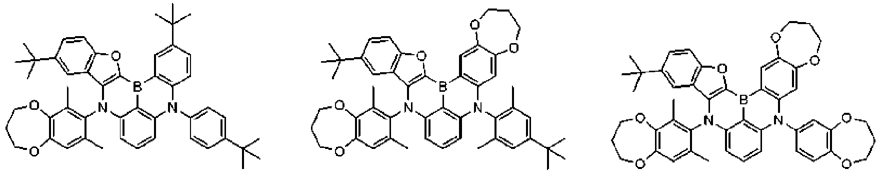

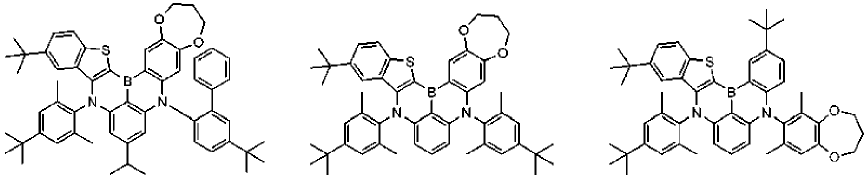

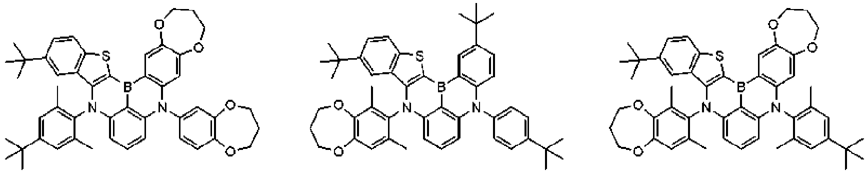

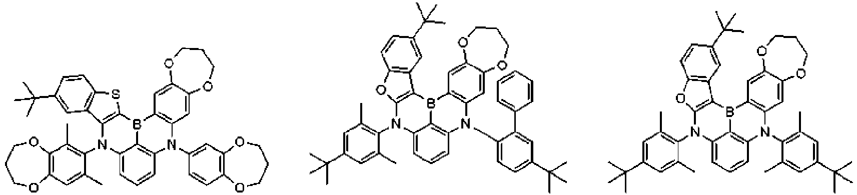

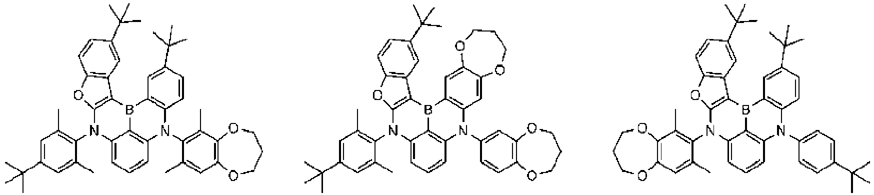

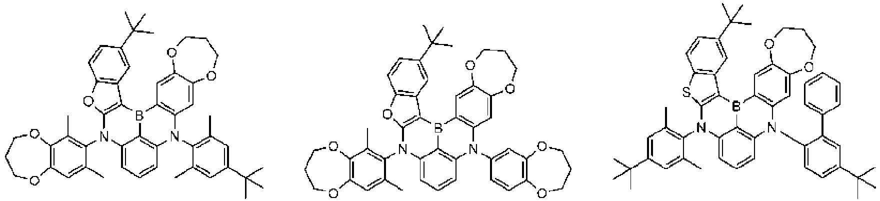

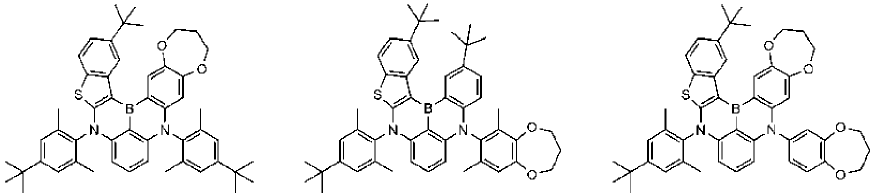

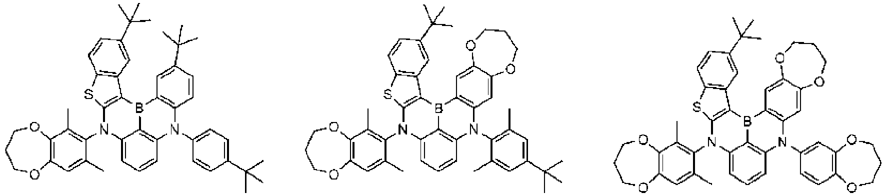

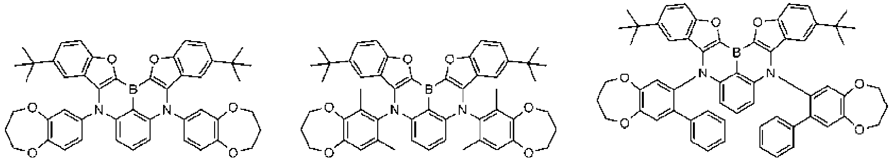

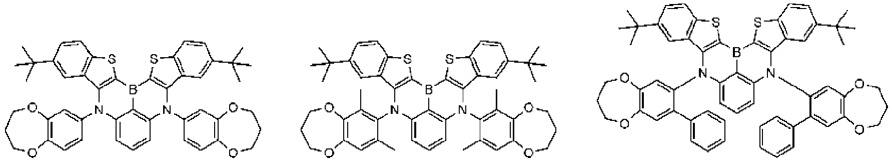

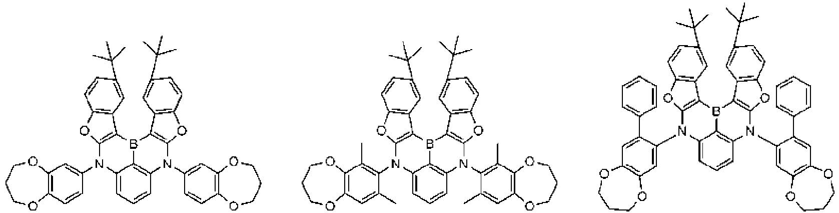

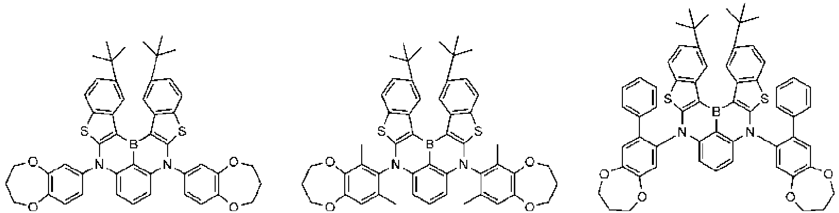

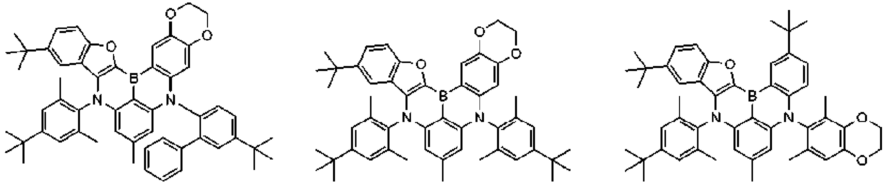

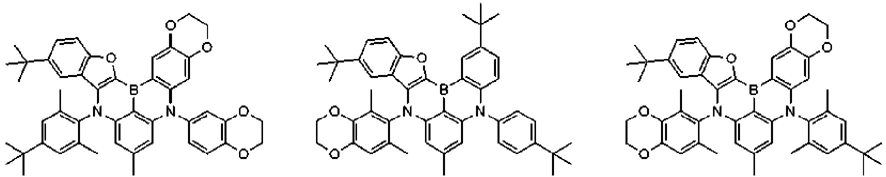

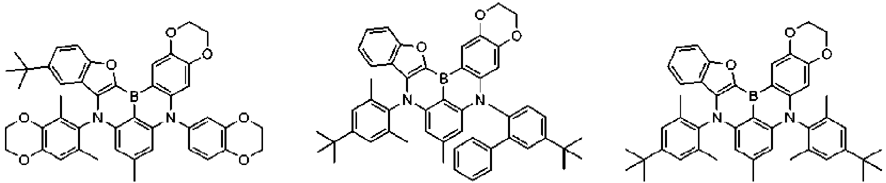

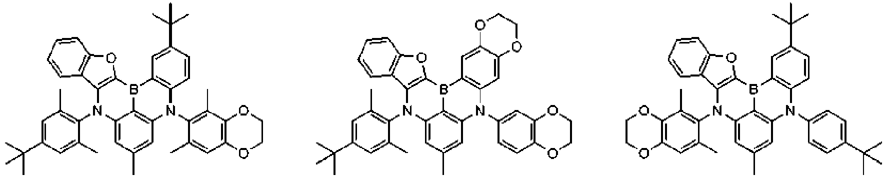

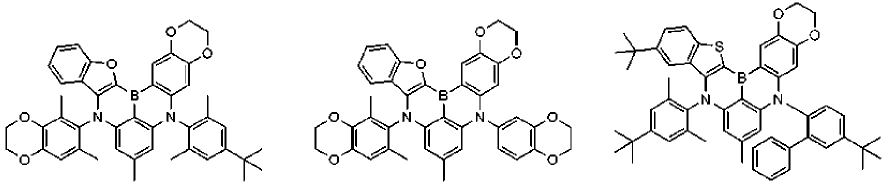

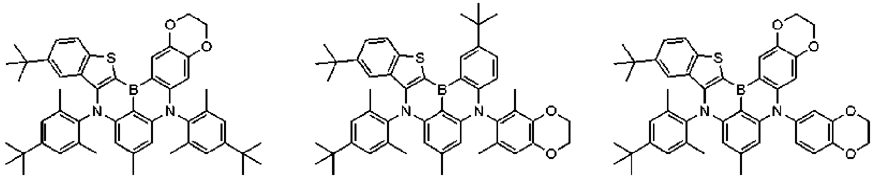

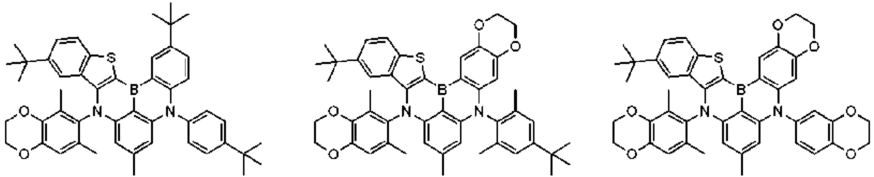

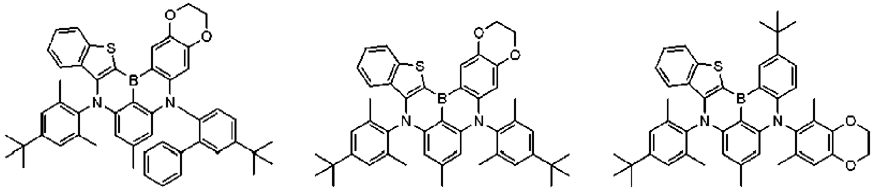

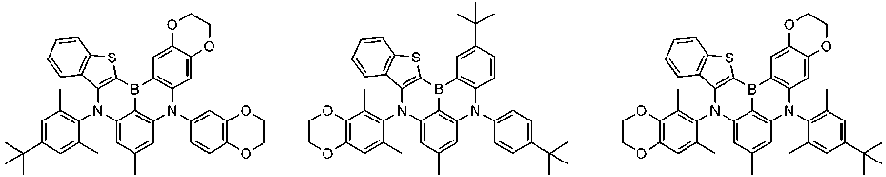

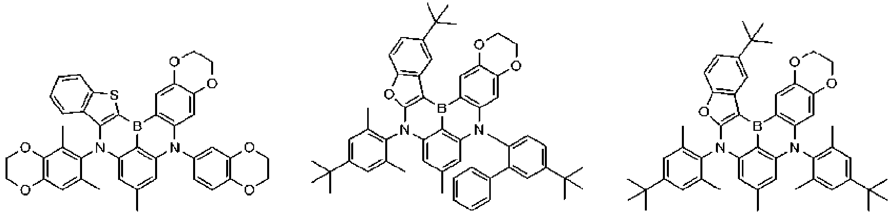

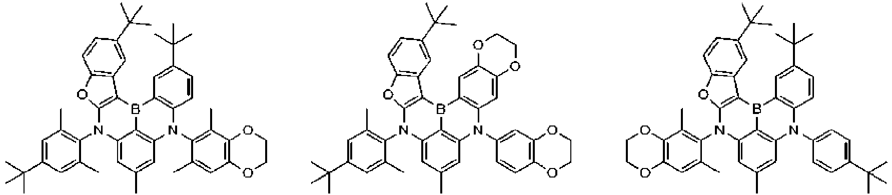

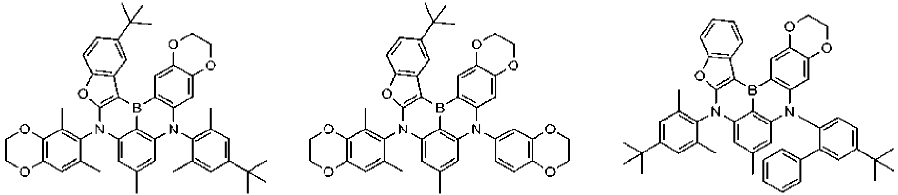

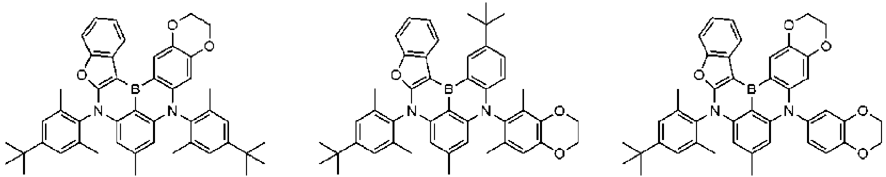

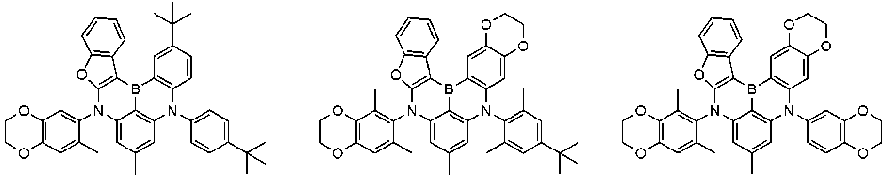

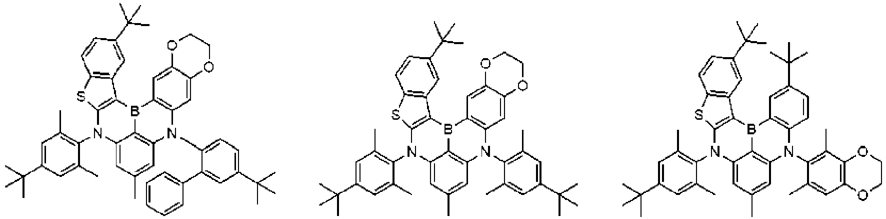

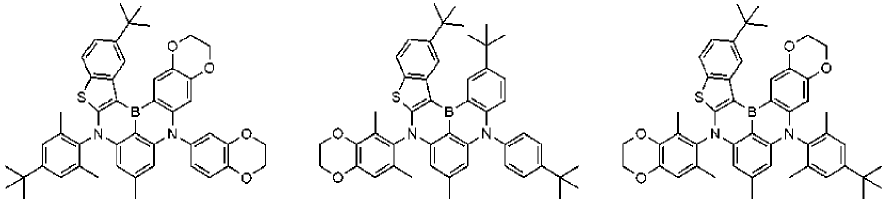

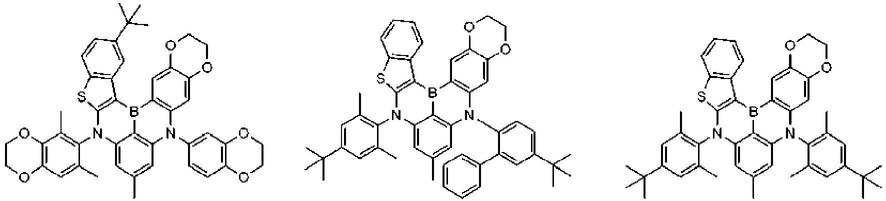

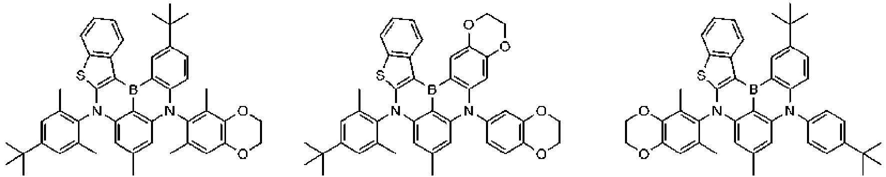

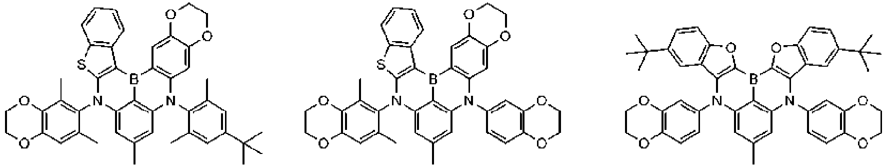

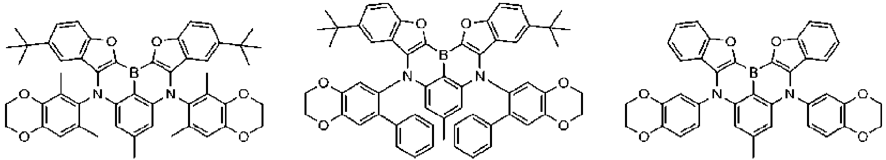

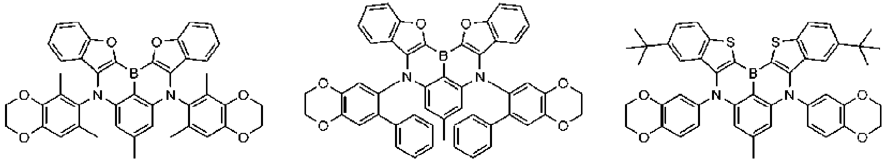

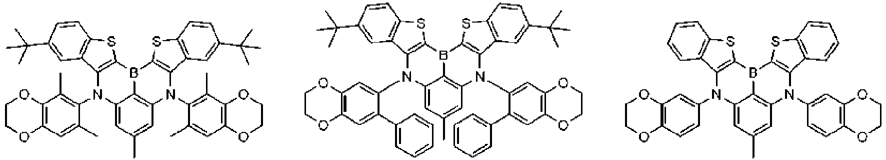

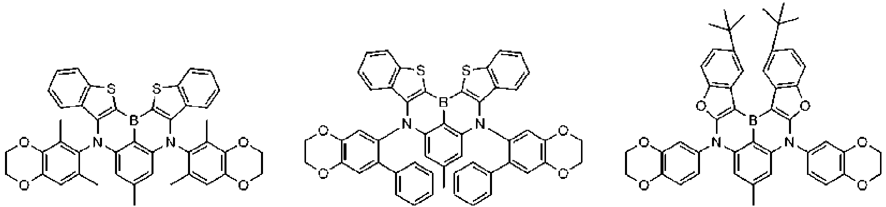

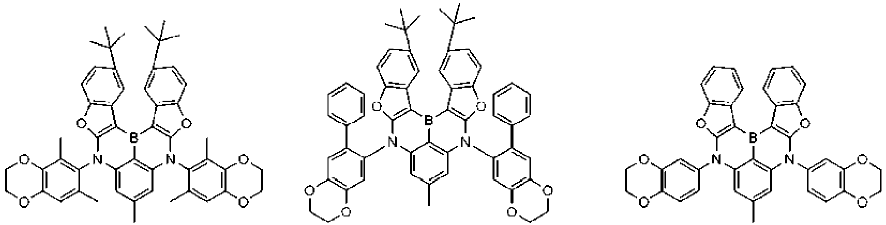

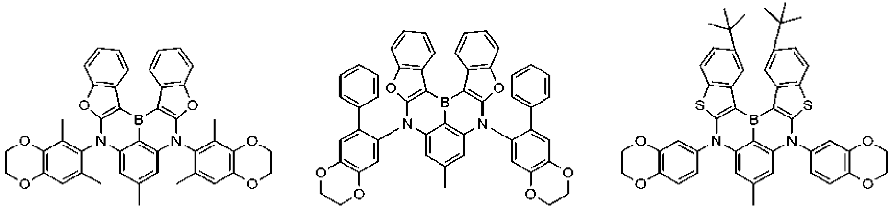

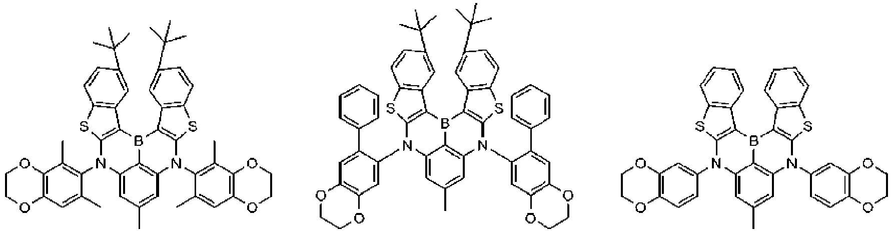

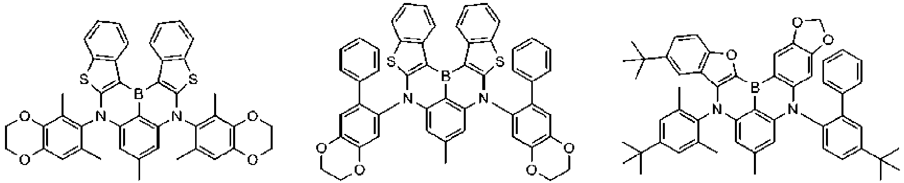

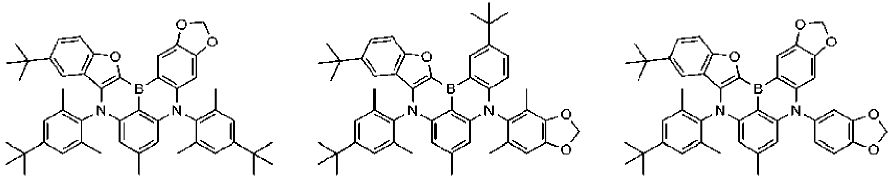

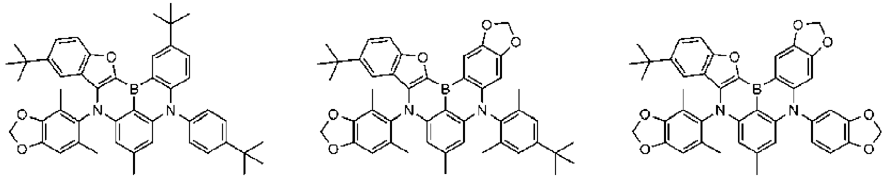

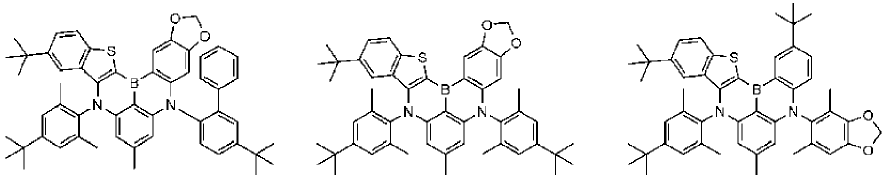

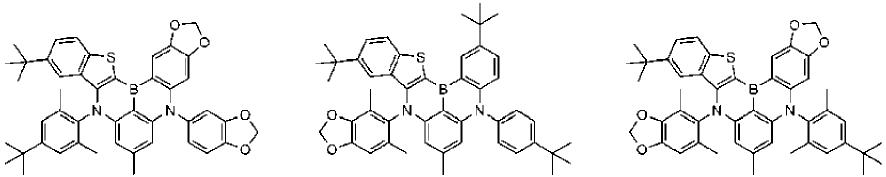

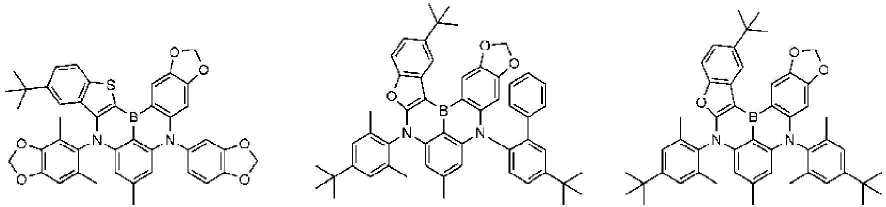

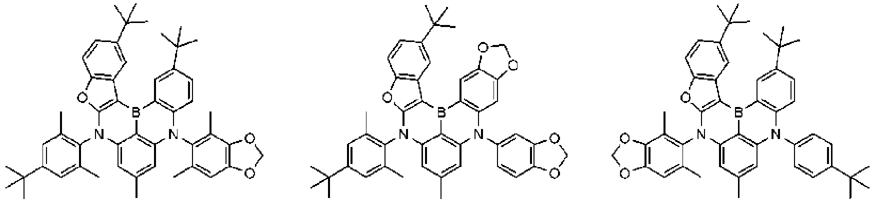

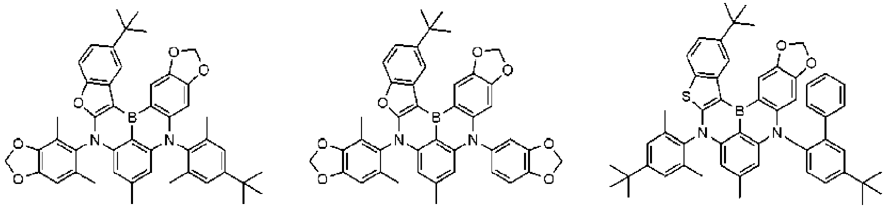

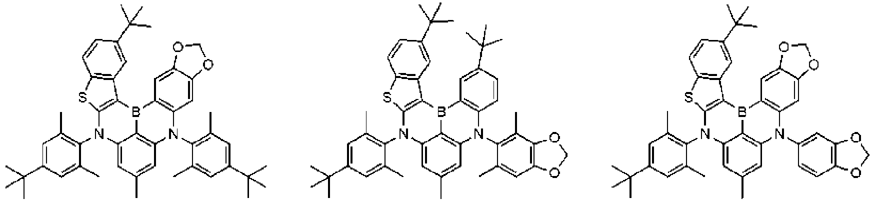

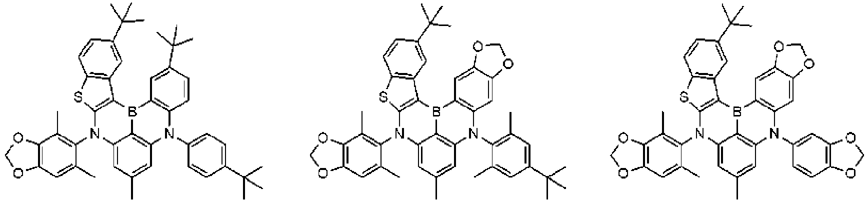

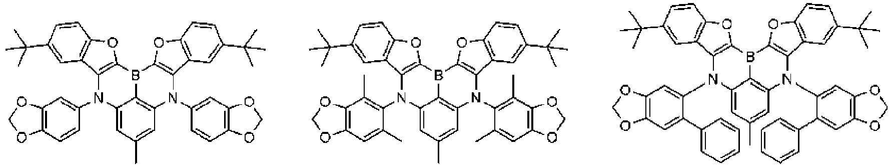

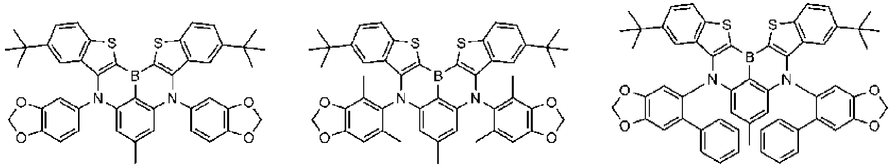

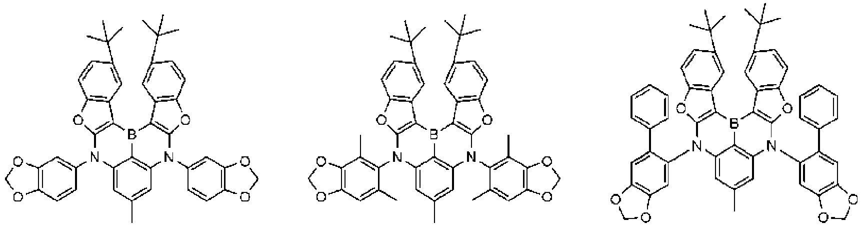

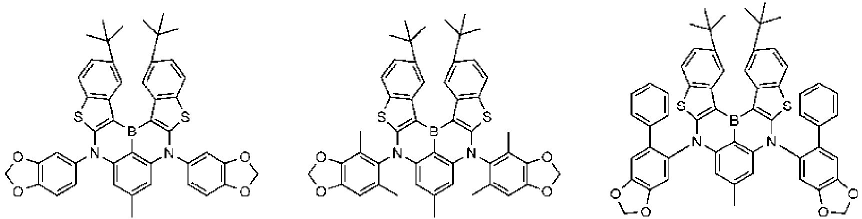

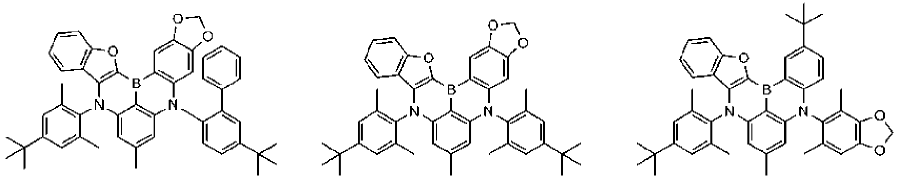

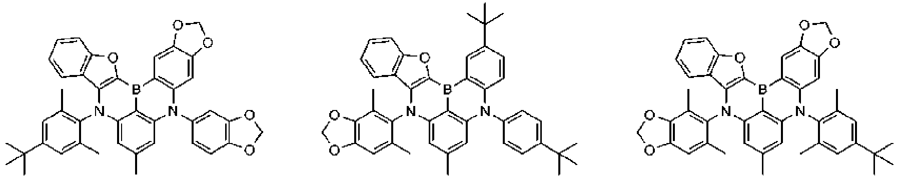

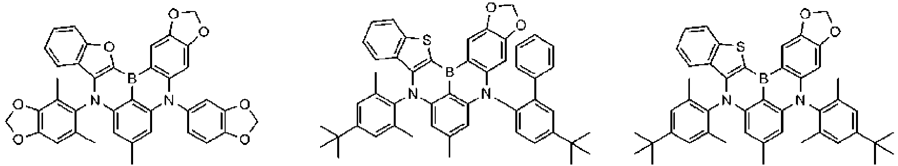

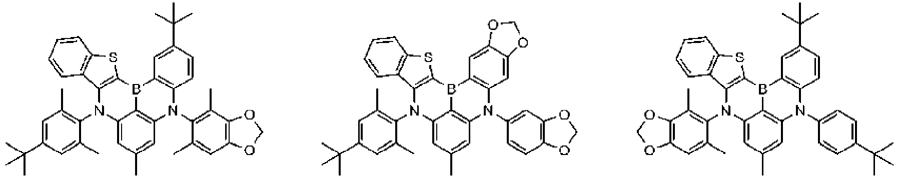

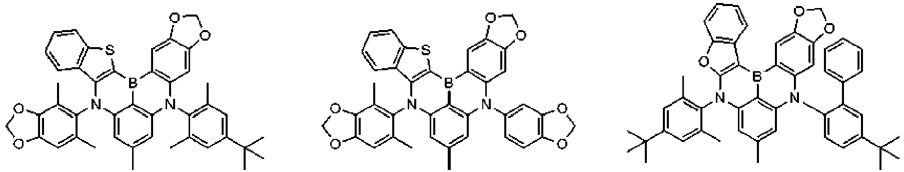

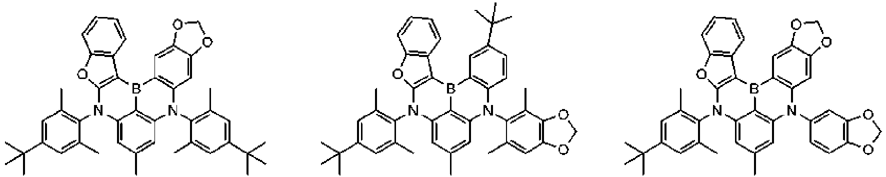

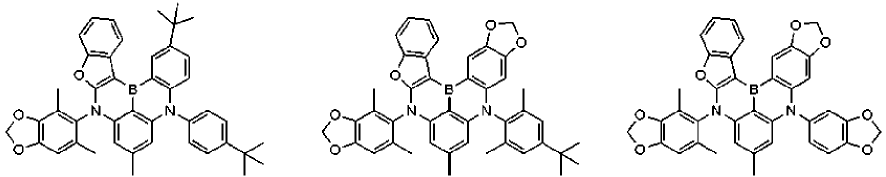

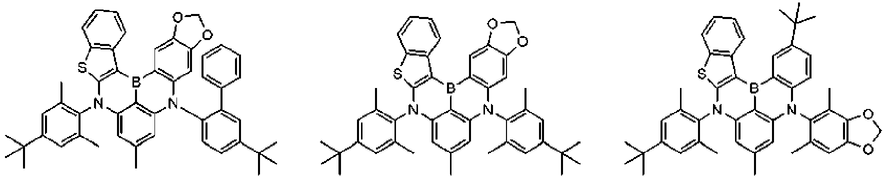

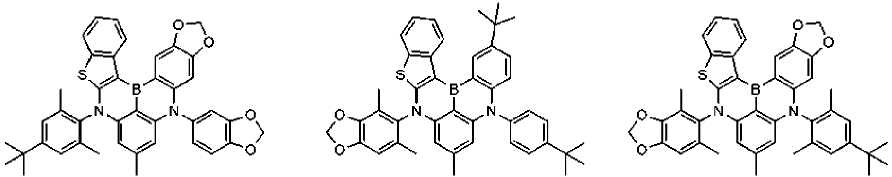

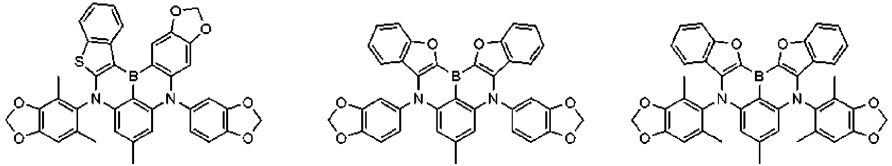

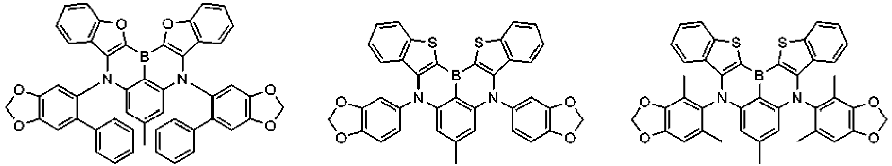

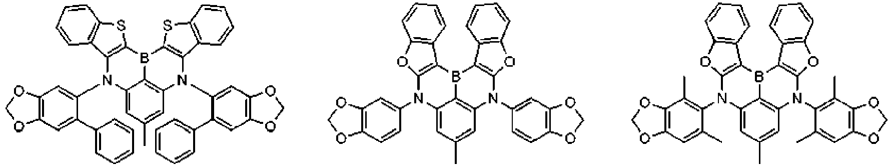

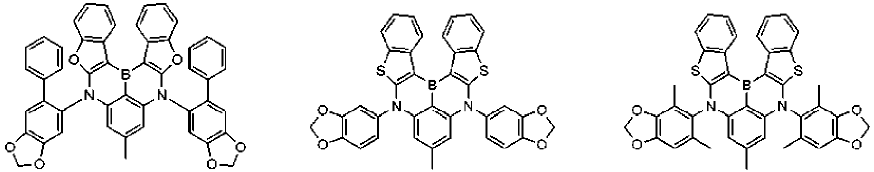

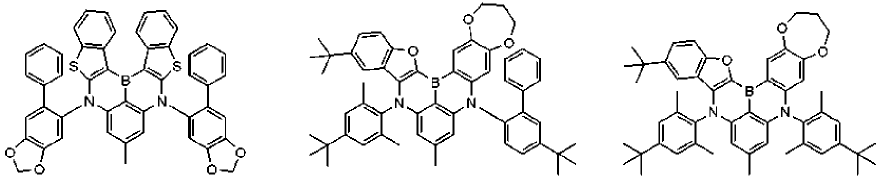

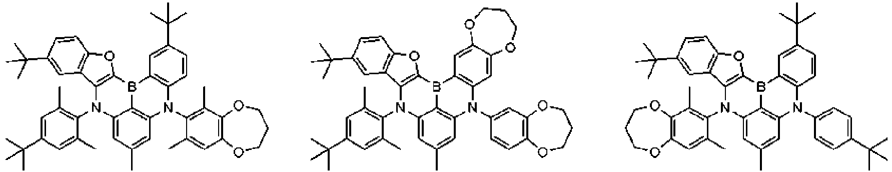

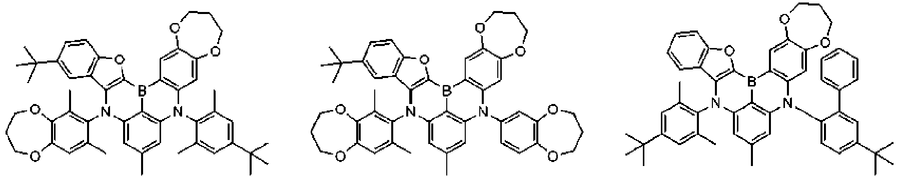

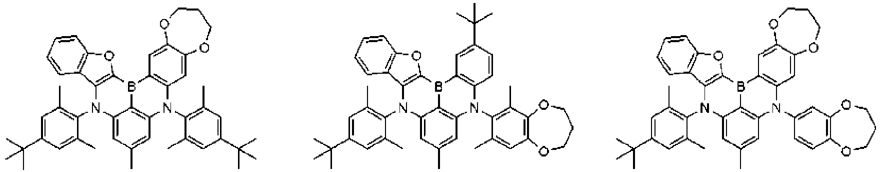

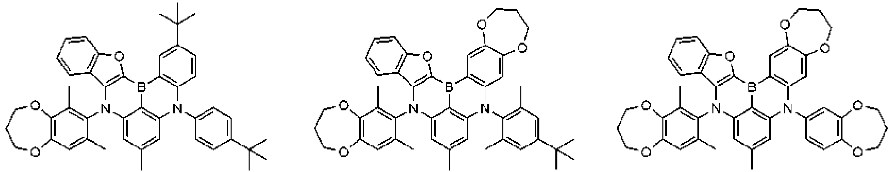

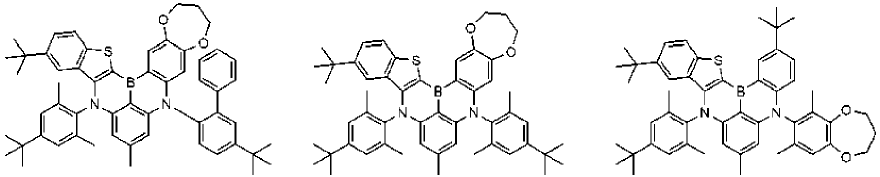

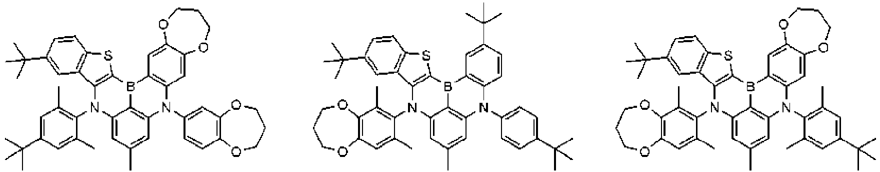

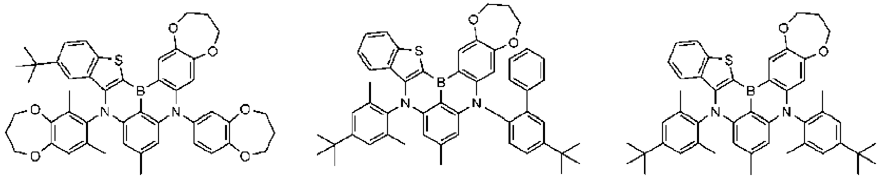

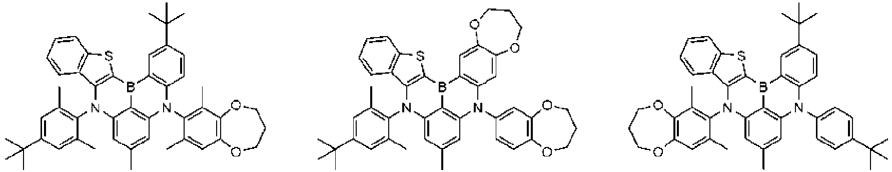

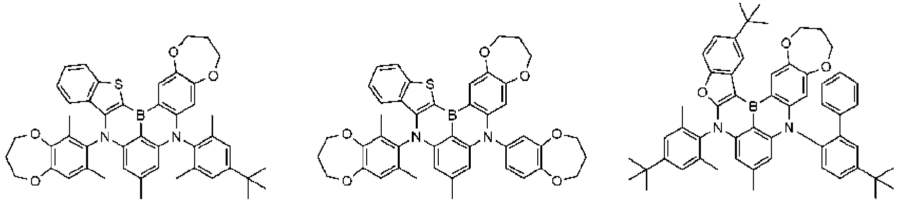

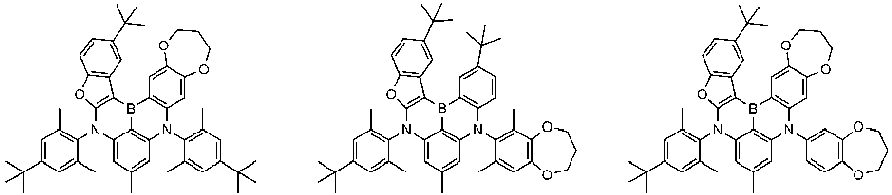

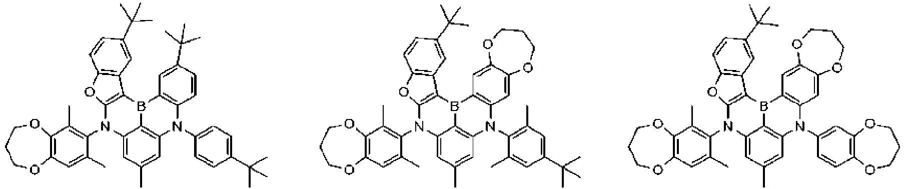

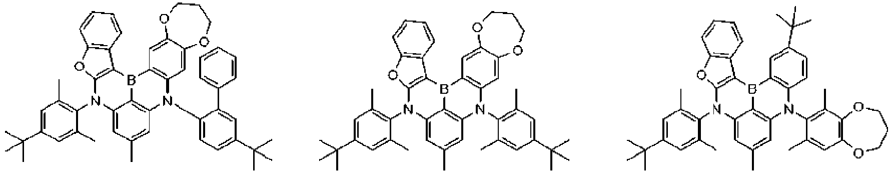

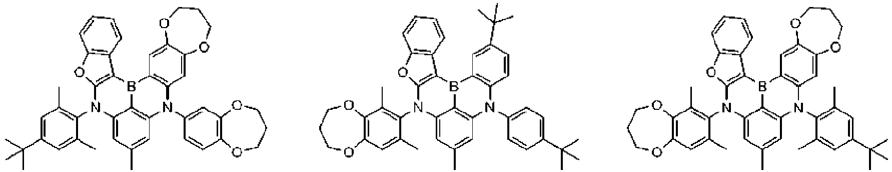

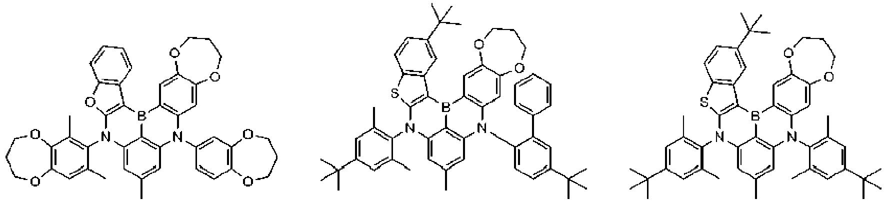

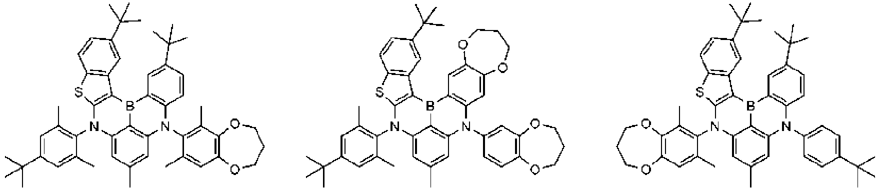

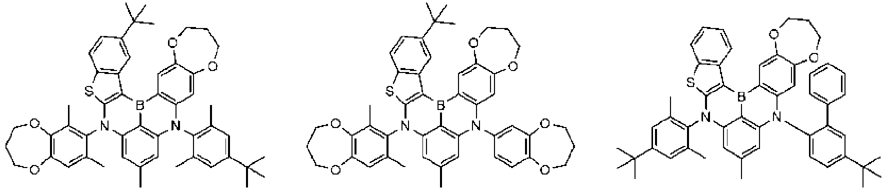

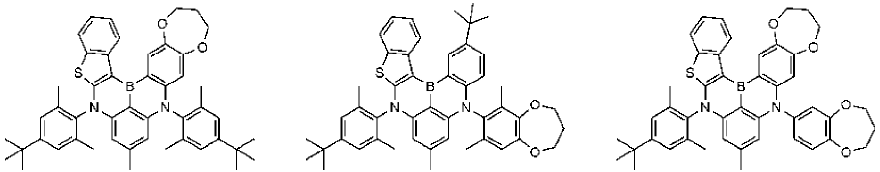

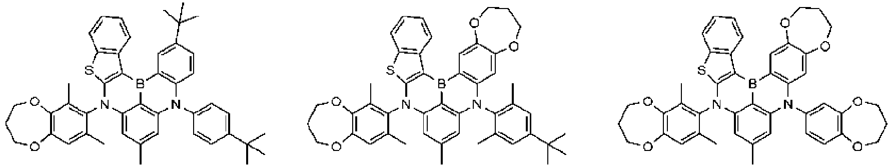

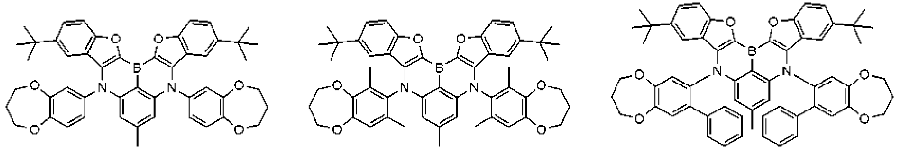

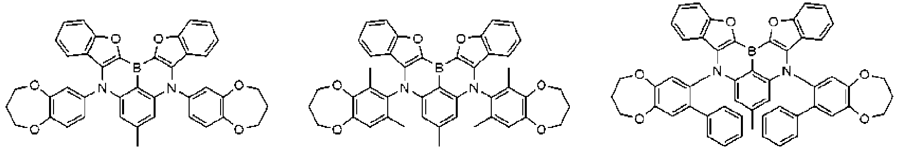

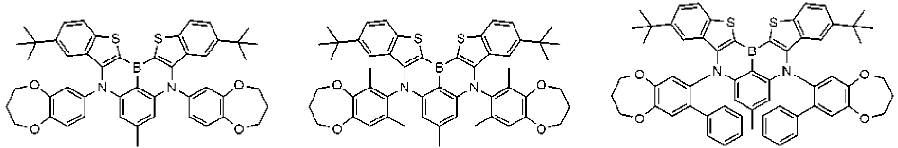

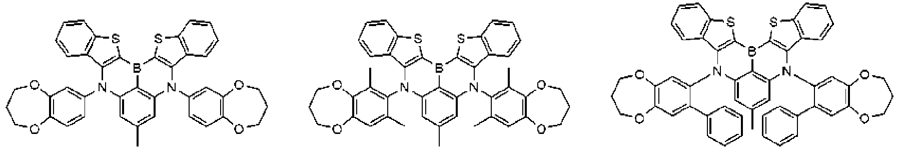

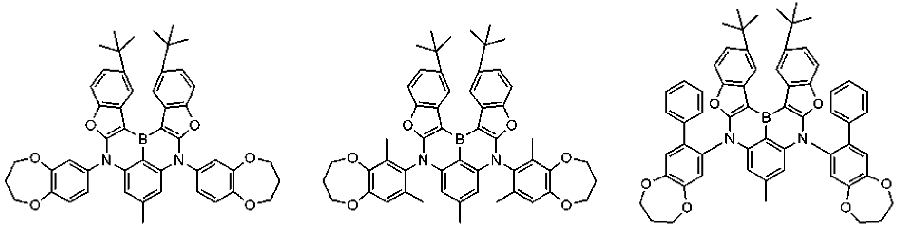

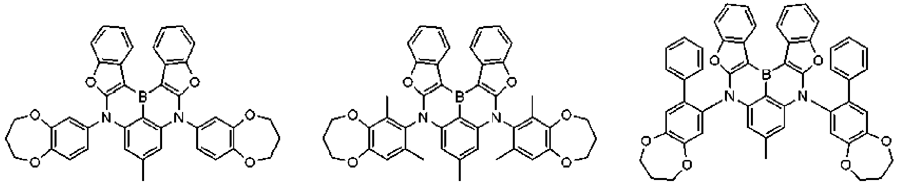

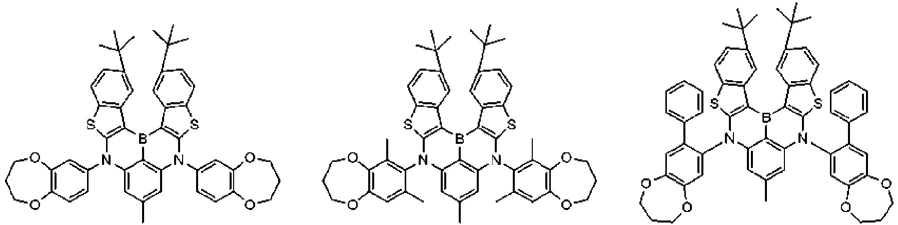

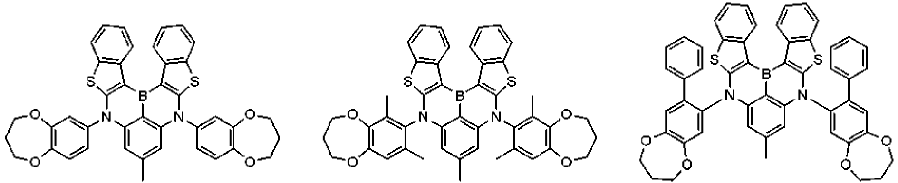

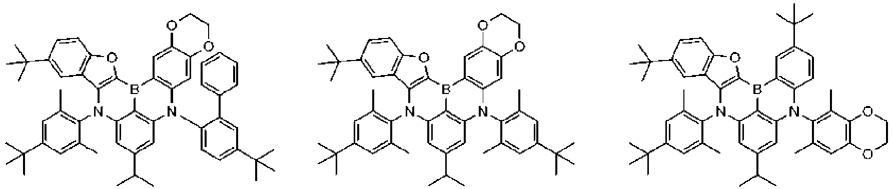

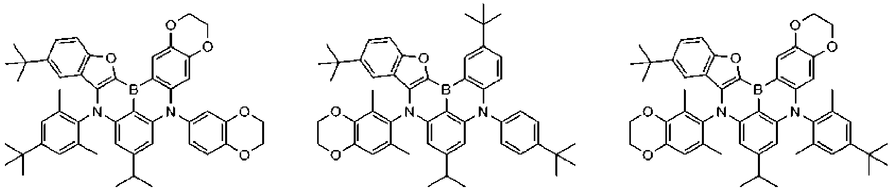

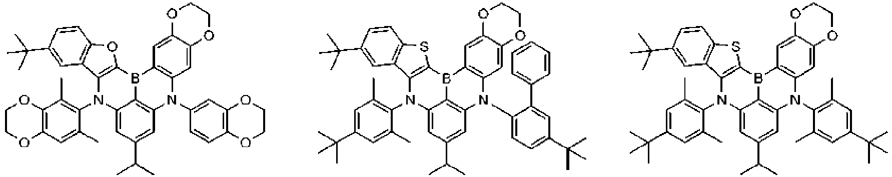

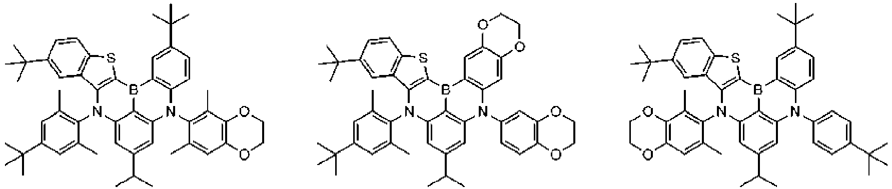

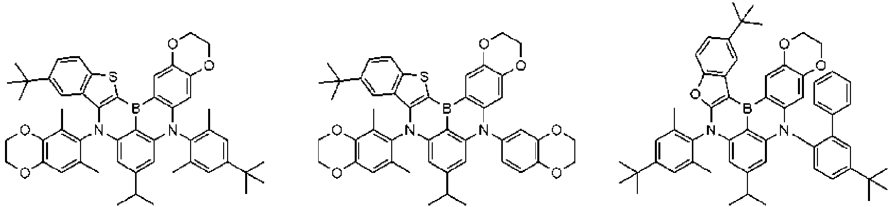

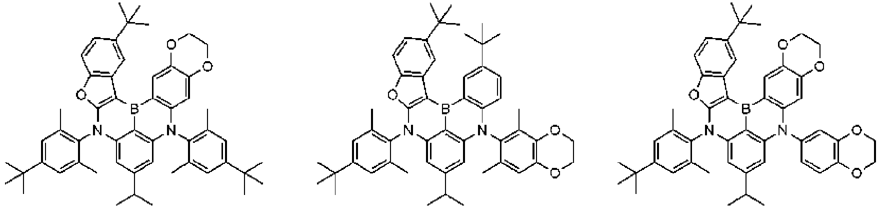

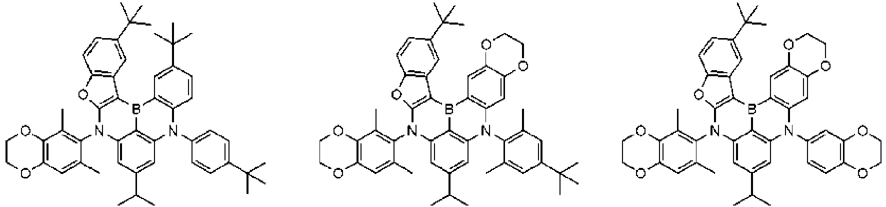

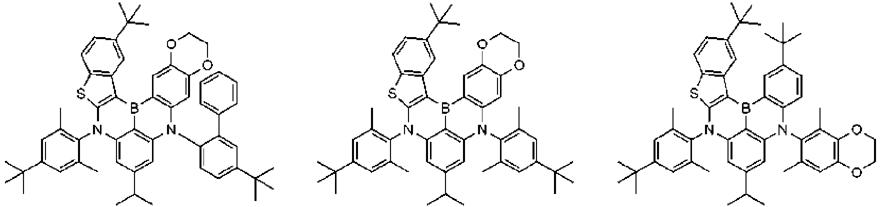

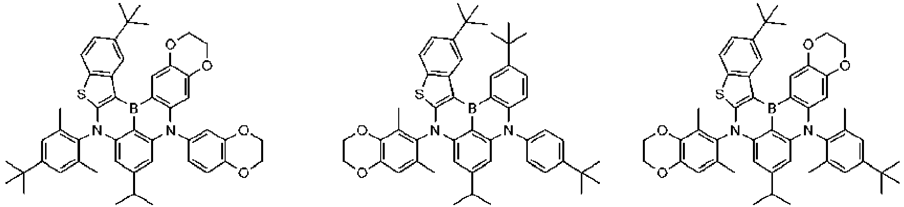

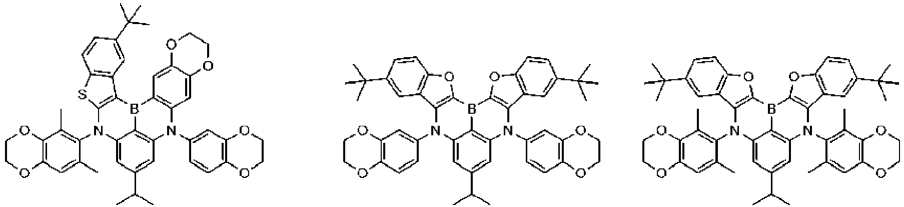

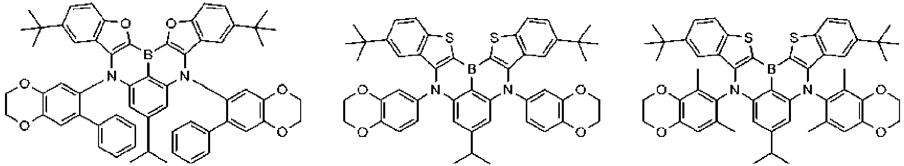

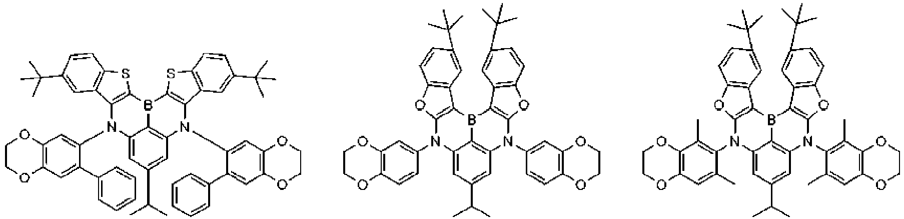

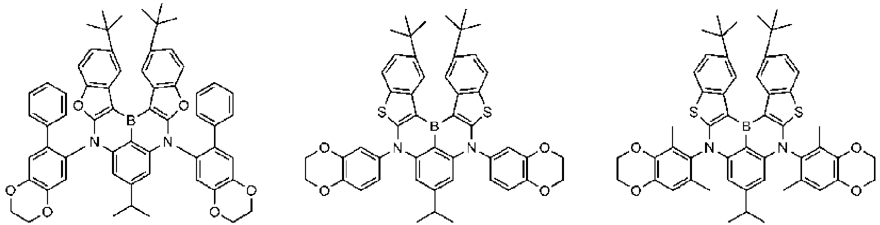

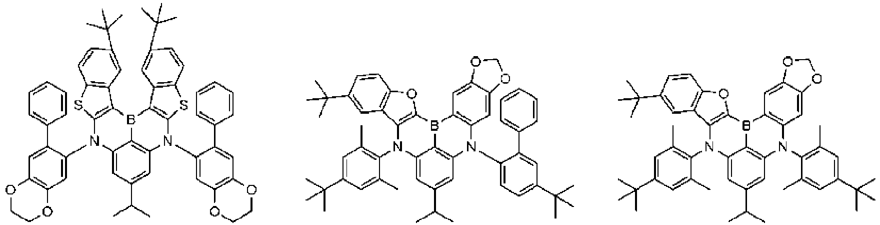

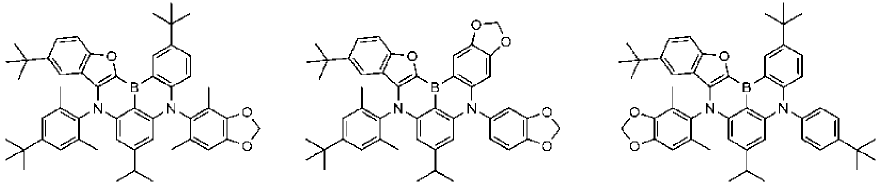

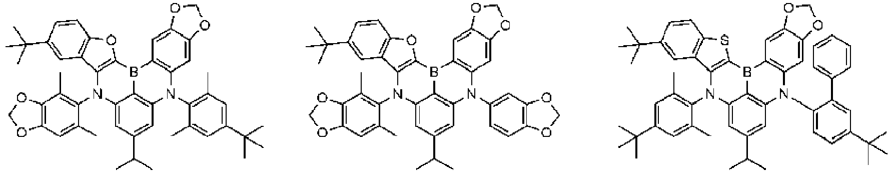

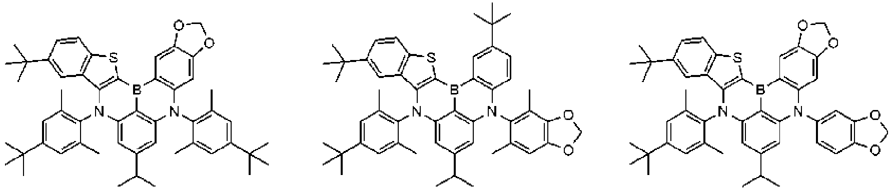

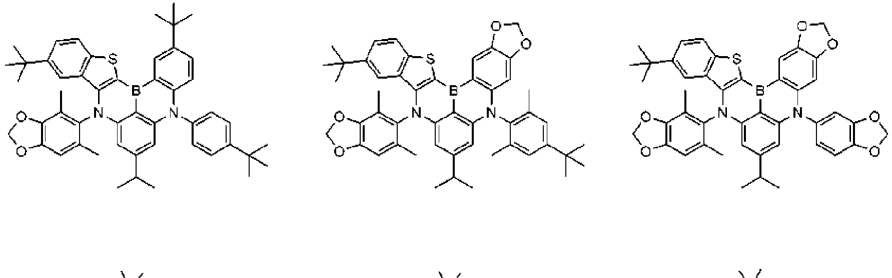

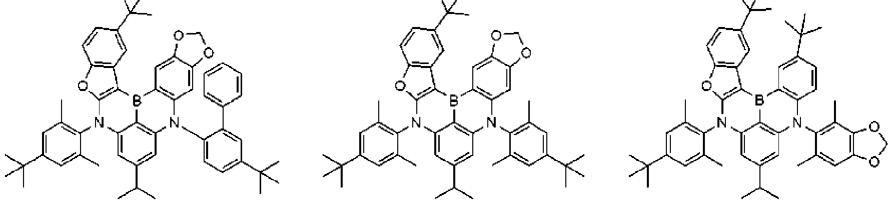

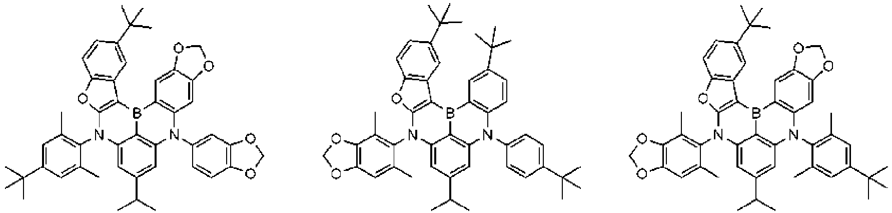

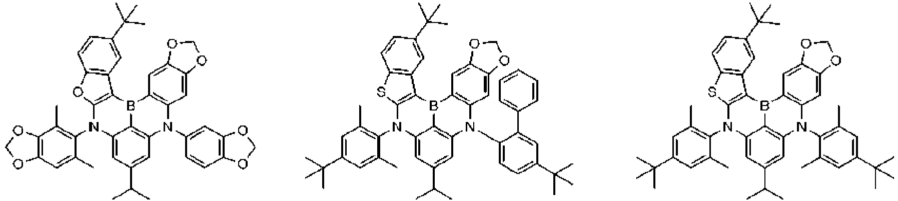

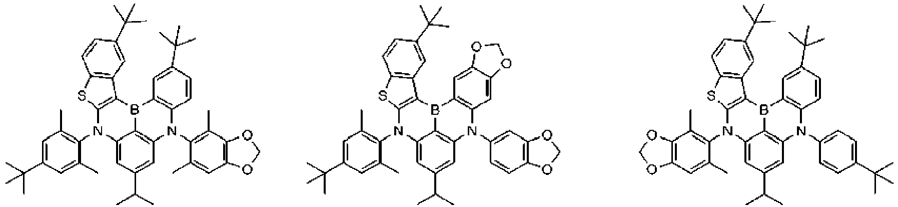

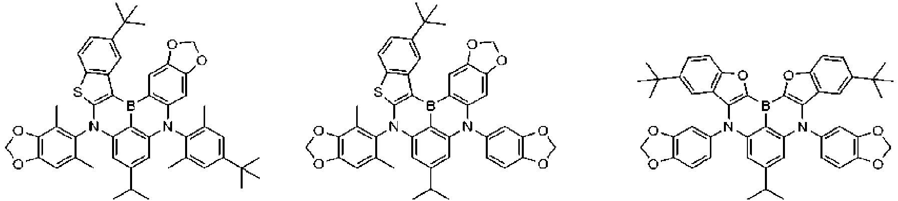

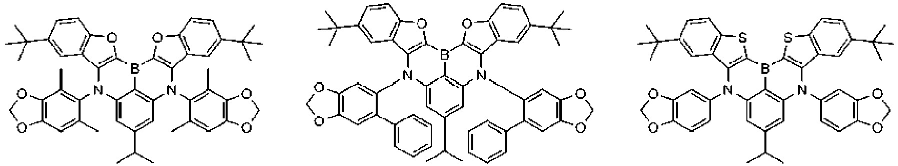

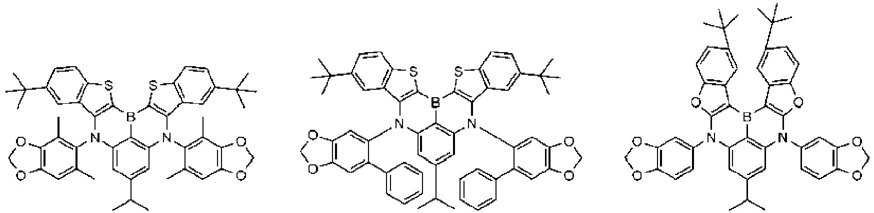

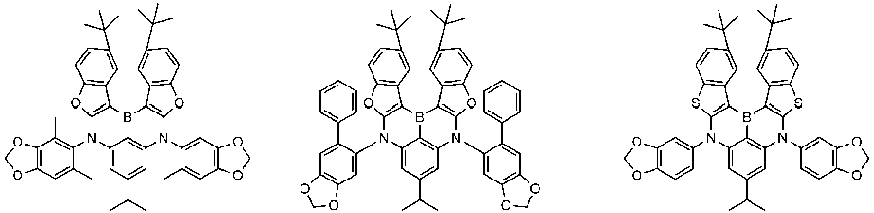

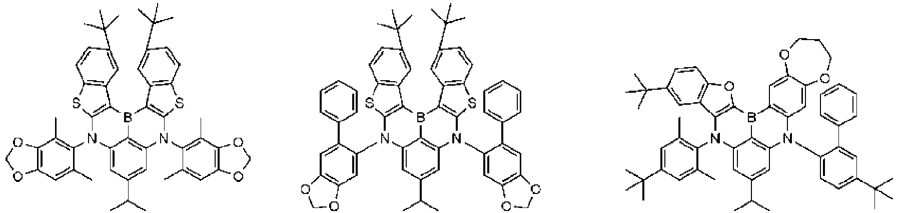

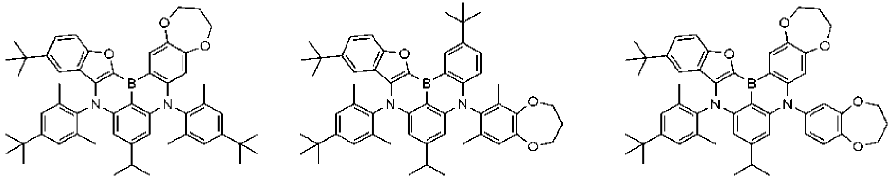

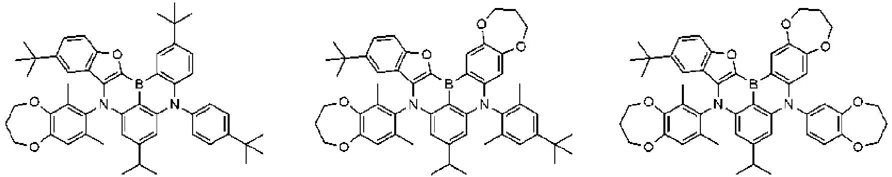

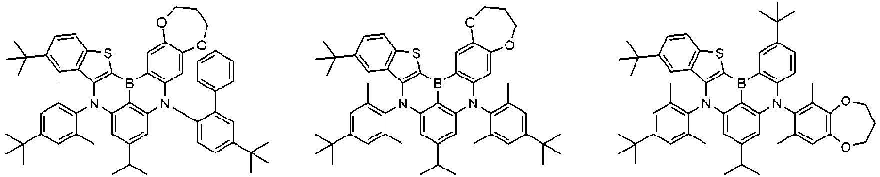

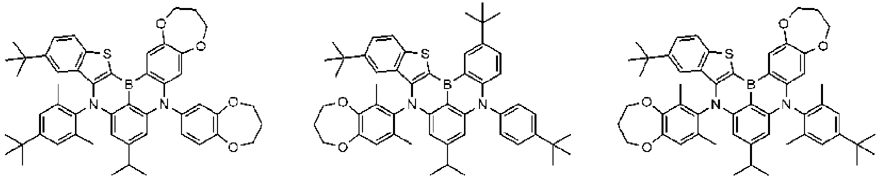

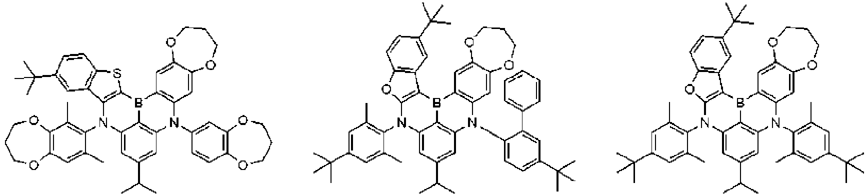

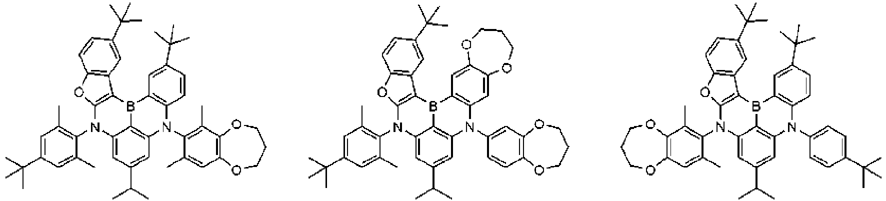

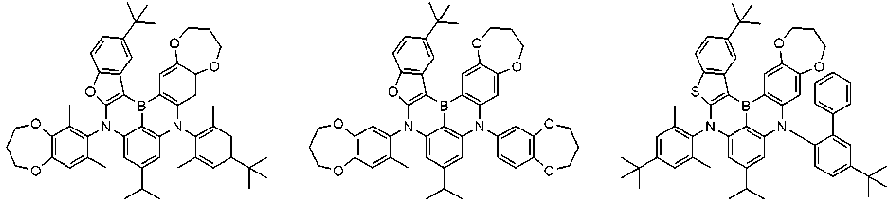

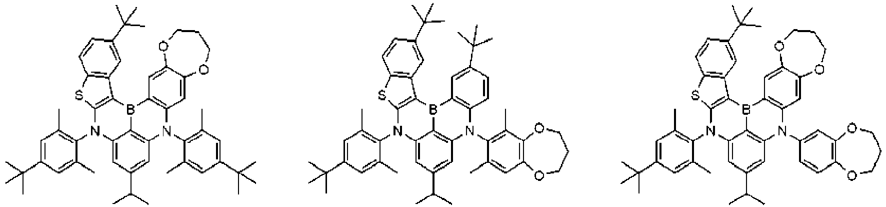

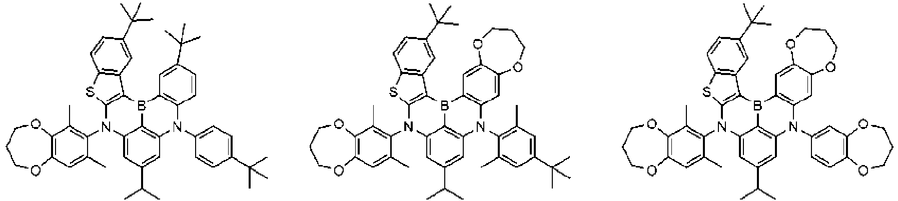

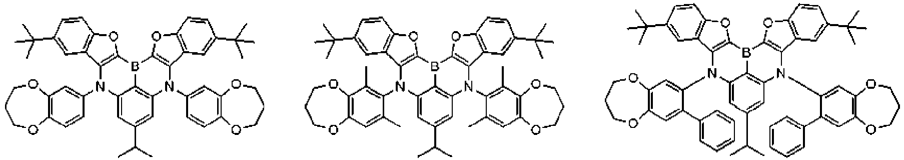

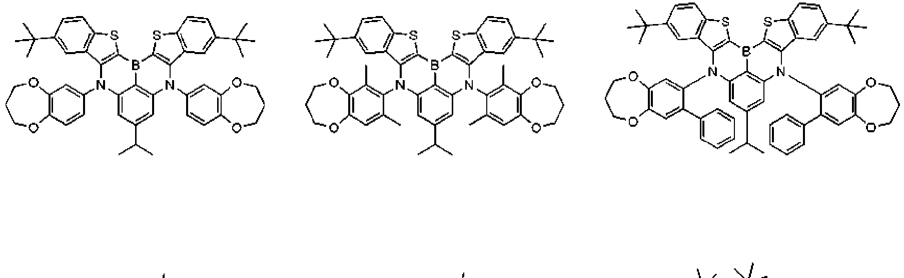

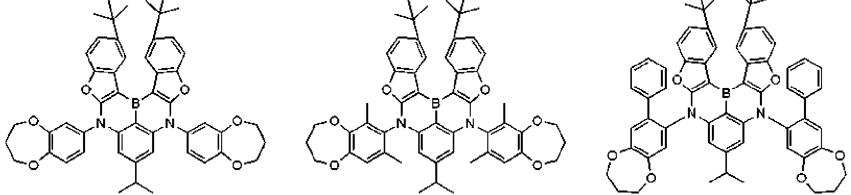

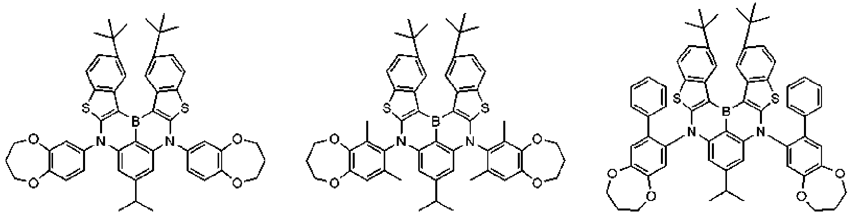

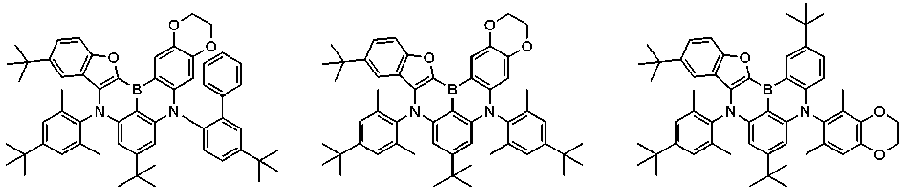

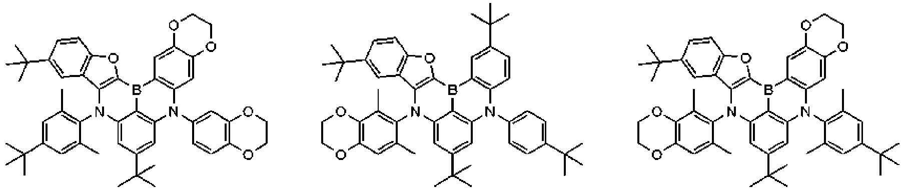

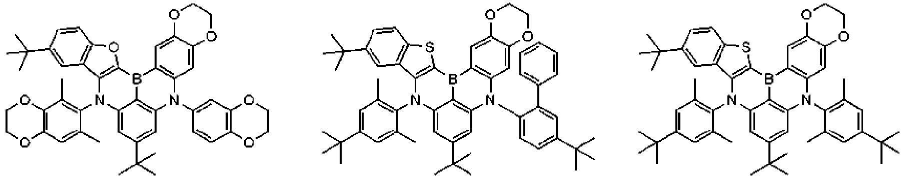

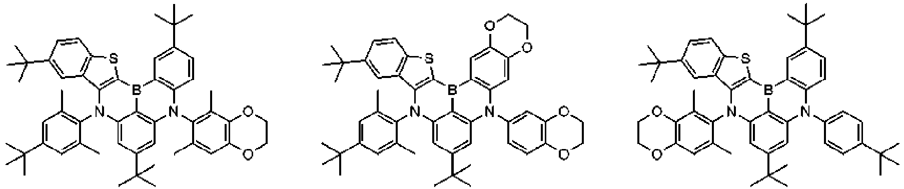

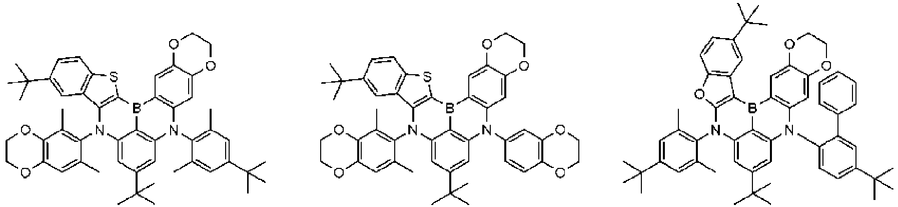

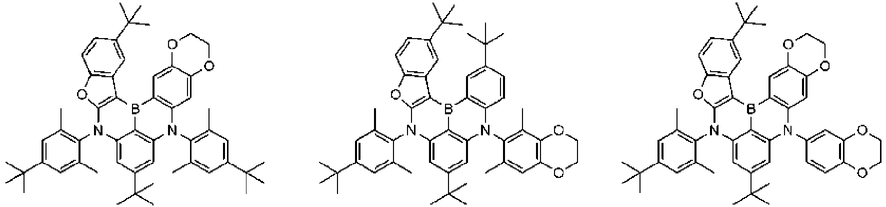

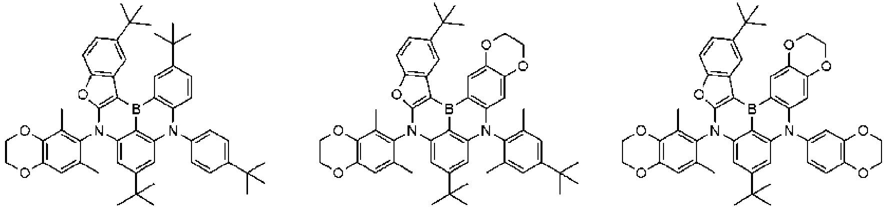

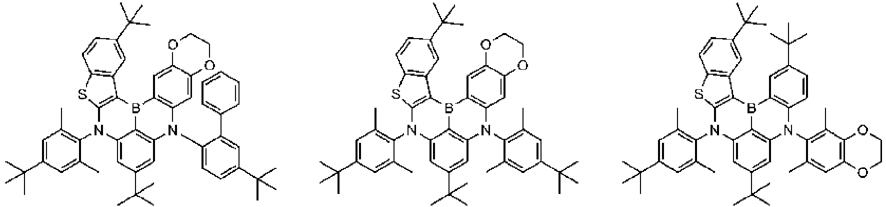

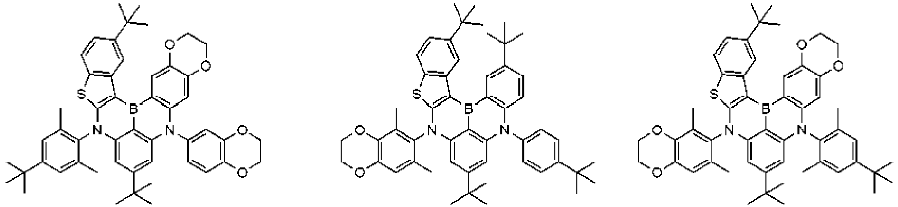

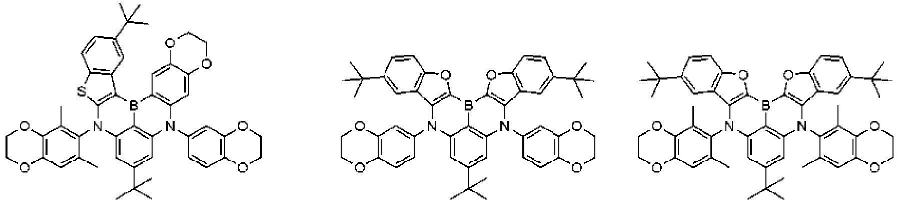

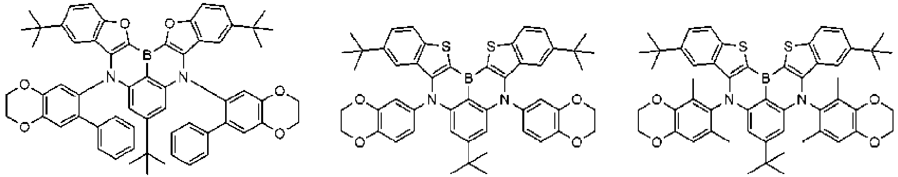

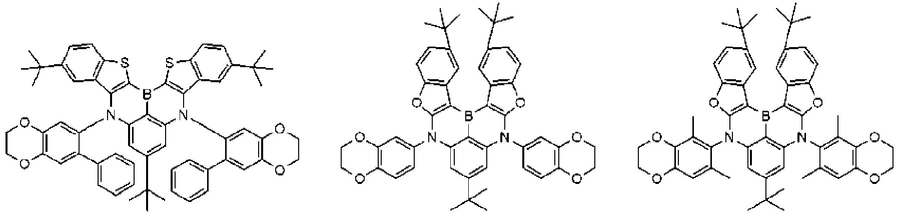

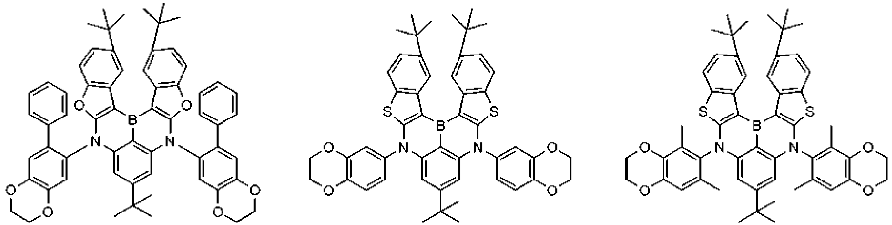

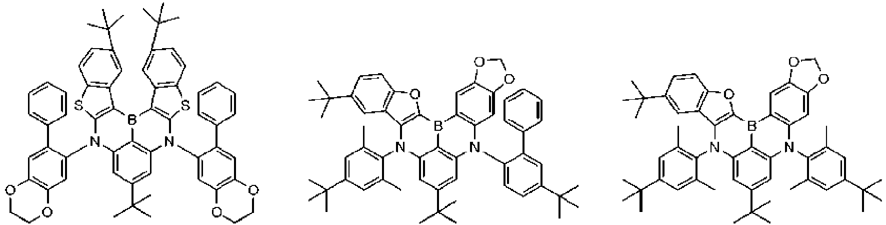

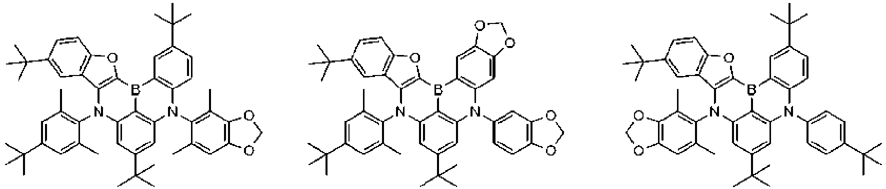

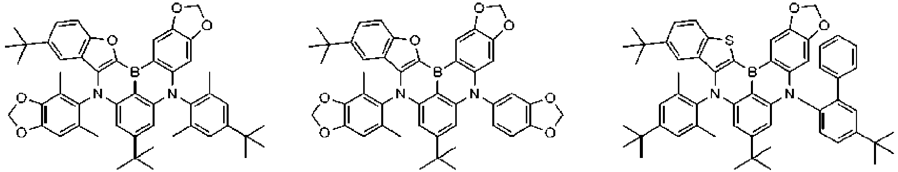

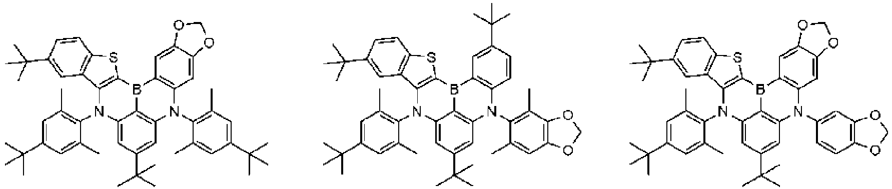

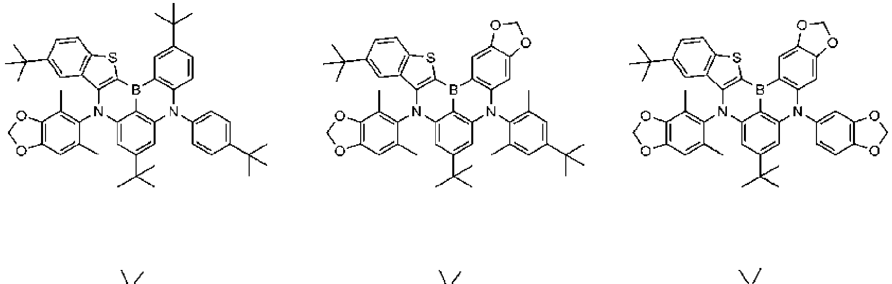

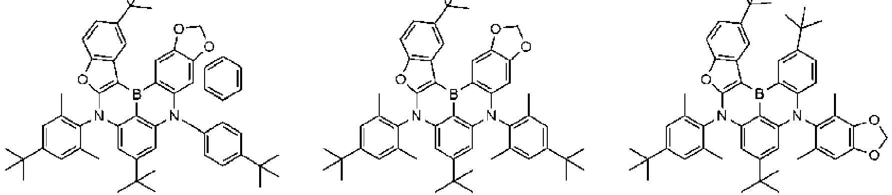

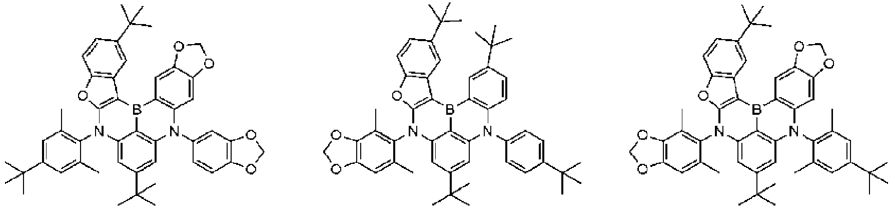

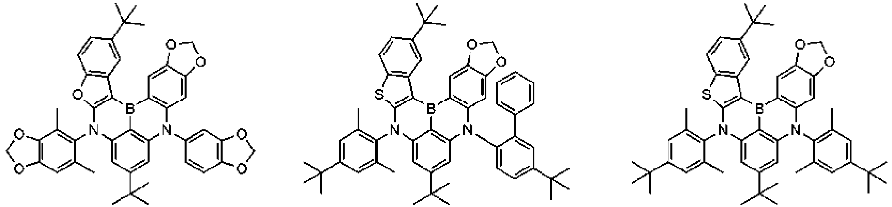

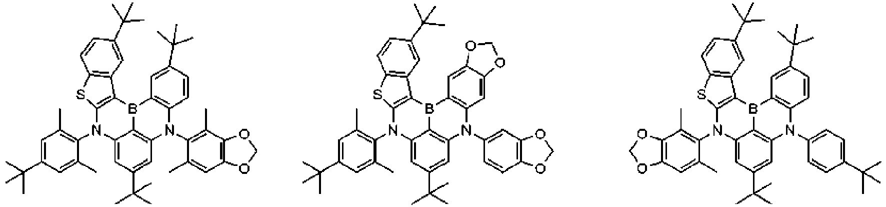

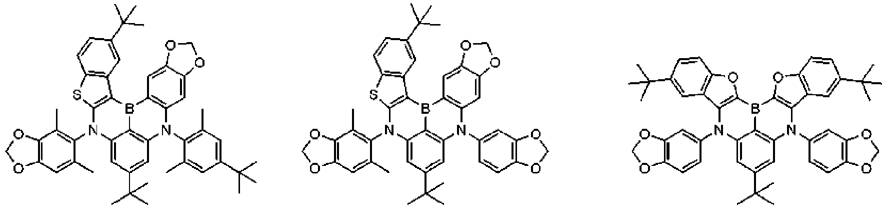

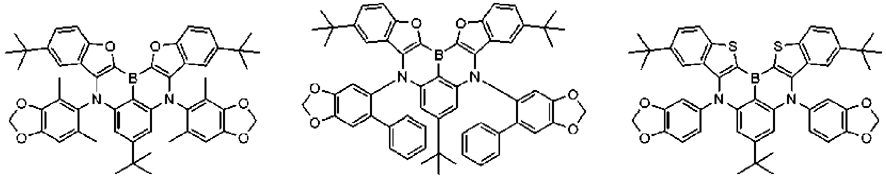

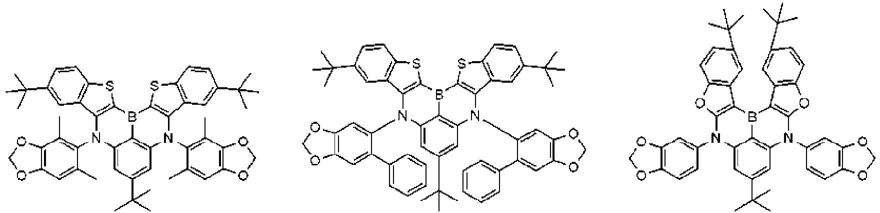

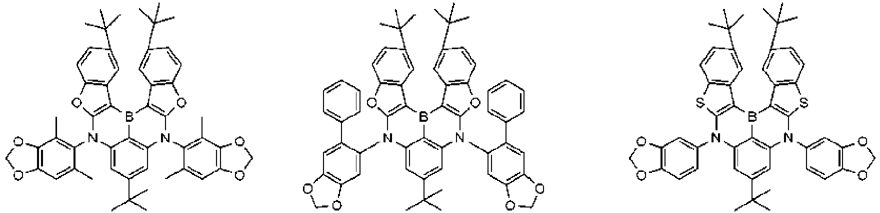

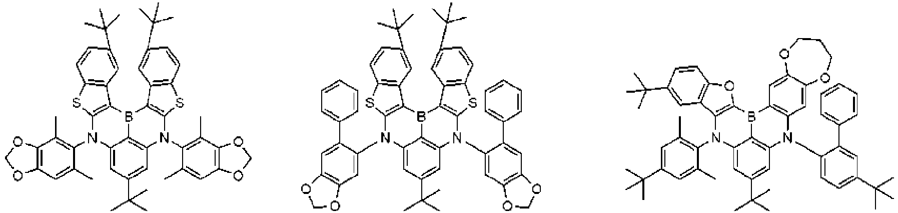

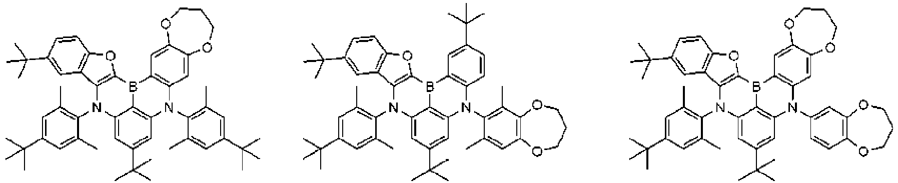

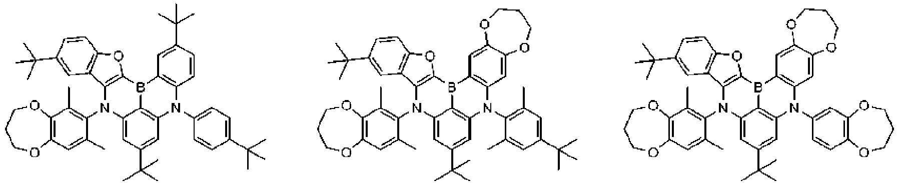

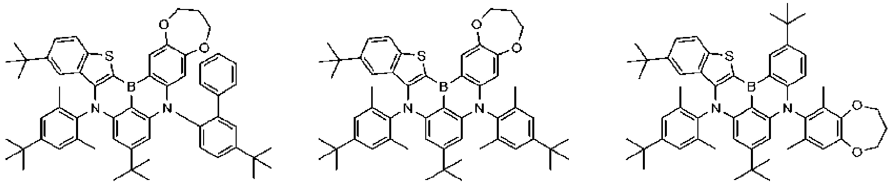

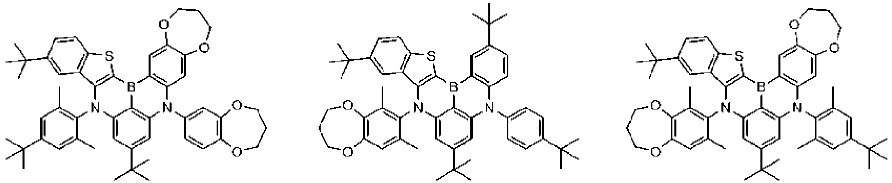

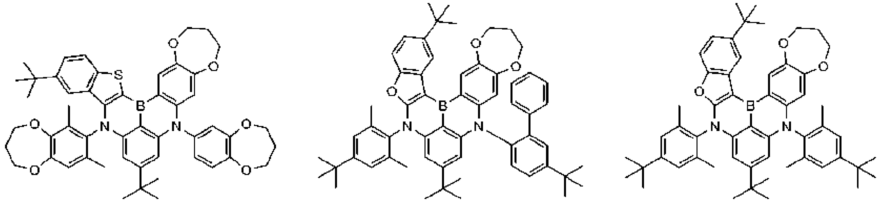

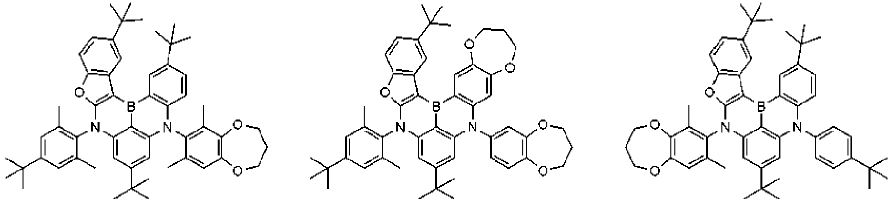

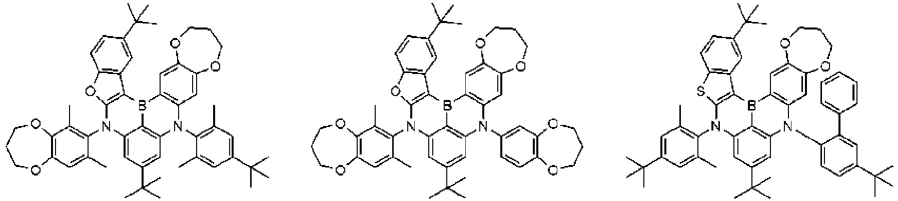

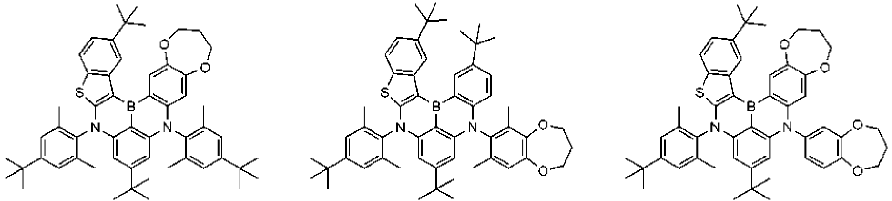

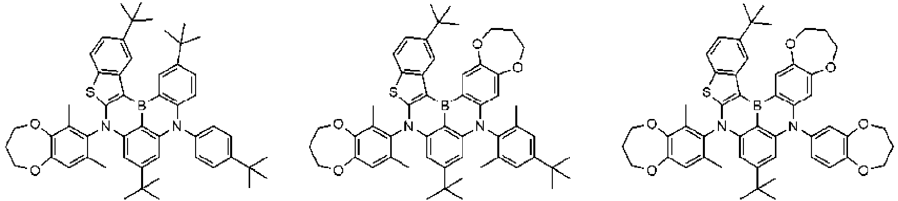

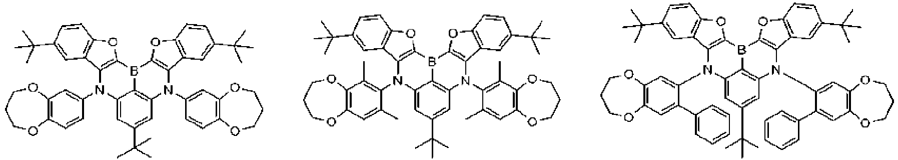

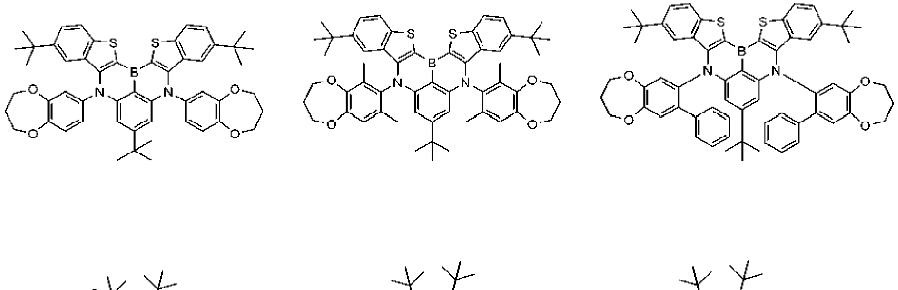

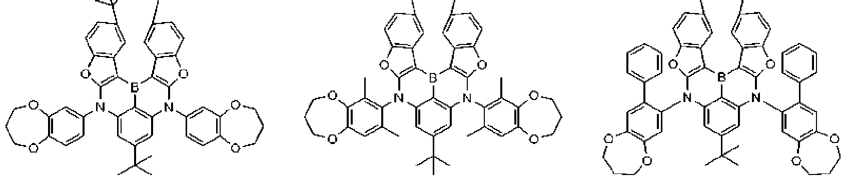

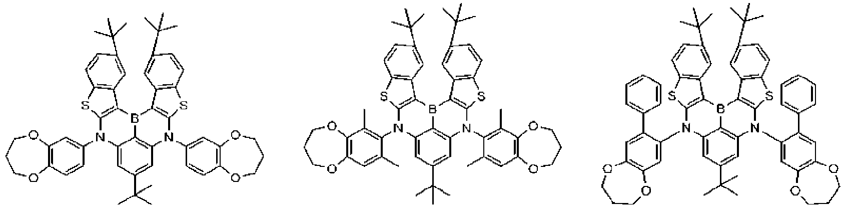

10. Dispositif électroluminescent organique comprenant : une première électrode ; une seconde électrode opposée à la première électrode ; et une ou plusieurs couches de
5 matériau organique qui sont placées entre la première électrode et la seconde électrode, dans lequel au moins une couche parmi les couches de matériau organique comprend le composé selon l'une quelconque des revendications 1 à 9.

11. Dispositif électroluminescent organique selon la revendication 10,
dans lequel la couche de matériau organique comprenant le composé est une couche électroluminescente.
